# EUROPEAN PATENT APPLICATION

(11) **EP 4 137 551 A1**
(43) Date of publication of application: **22.02.2023**
(21) Application number: 22191270.2
(22) Date of filing: 19.08.2022
(51) Int. Cl.: C09K 11/00, C07F 15/00

(54) **ORGANIC ELECTROLUMINESCENT MATERIAL AND DEVICE THEREOF**

(30) Priority: 20.08.2021 CN 202110940504; 29.06.2022 CN 202210747647
(71) Applicant: Beijing Summer Sprout Technology Co., Ltd., Beijing 102308 (CN)
(72) Inventor: Li, Hongbo, Mentougou District, 102308 (CN); Wang, Zheng, Mentougou District, 102308 (CN); Cai, Wei, Mentougou District, 102308 (CN); Wang, Zhen, Mentougou District, 102308 (CN); Sang, Ming, Mentougou District, 102308 (CN); Kwong, Chi Yuen Raymond, Mentougou District, 102308 (CN); Xia, Chuanjun, Mentougou District, 102308 (CN)
(74) Representative: Grünecker Patent- und Rechtsanwälte PartG mbB

(57) **Abstract**

Provided are an organic electroluminescent material and a device comprising the same. The organic electroluminescent material is a metal complex comprising a ligand Lₐ having a structure of Formula 1. These new compounds, when applied to an electroluminescent device, can obtain very excellent device performance, such as a reduced device voltage and improved current efficiency, power efficiency and external quantum efficiency. These new compounds can comprehensively improve the device performance in various aspects and finally significantly improves overall device performance. Further provided are an organic electroluminescent device comprising the metal complex and a composition comprising the metal complex.

## Description

### TECHNICAL FIELD

The present disclosure relates to compounds for organic electronic devices such as organic light-emitting devices. In particular, the present disclosure relates to a metal complex comprising a ligand Lₐ having a structure of Formula 1 and an electroluminescent device and composition comprising the metal complex.

### BACKGROUND

Organic electronic devices include, but are not limited to, the following types: organic light-emitting diodes (OLEDs), organic field-effect transistors (O-FETs), organic light-emitting transistors (OLETs), organic photovoltaic devices (OPVs), dye-sensitized solar cells (DSSCs), organic optical detectors, organic photoreceptors, organic field-quench devices (OFQDs), light-emitting electrochemical cells (LECs), organic laser diodes and organic plasmon emitting devices.

In 1987, Tang and Van Slyke of Eastman Kodak reported a bilayer organic electroluminescent device, which includes an arylamine hole transporting layer and a tris-8-hydroxyquinolato-aluminum layer as the electron and emitting layer (Applied Physics Letters, 1987, 51 (12): 913-915). Once a bias is applied to the device, green light was emitted from the device. This device laid the foundation for the development of modern organic light-emitting diodes (OLEDs). State-of-the-art OLEDs may include multiple layers such as charge injection and transporting layers, charge and exciton blocking layers, and one or multiple emissive layers between the cathode and anode. Since the OLED is a self-emitting solid state device, it offers tremendous potential for display and lighting applications. In addition, the inherent properties of organic materials, such as their flexibility, may make them well suited for particular applications such as fabrication on flexible substrates.

The OLED can be categorized as three different types according to its emitting mechanism. The OLED invented by Tang and van Slyke is a fluorescent OLED. It only utilizes singlet emission. The triplets generated in the device are wasted through nonradiative decay channels. Therefore, the internal quantum efficiency (IQE) of the fluorescent OLED is only 25%. This limitation hindered the commercialization of OLED. In 1997, Forrest and Thompson reported phosphorescent OLED, which uses triplet emission from heavy metal containing complexes as the emitter. As a result, both singlet and triplets can be harvested, achieving 100% IQE. The discovery and development of phosphorescent OLED contributed directly to the commercialization of active-matrix OLED (AMOLED) due to its high efficiency. Recently, Adachi achieved high efficiency through thermally activated delayed fluorescence (TADF) of organic compounds. These emitters have small singlet-triplet gap that makes the transition from triplet back to singlet possible. In the TADF device, the triplet excitons can go through reverse intersystem crossing to generate singlet excitons, resulting in high IQE.

OLEDs can also be classified as small molecule and polymer OLEDs according to the forms of the materials used. A small molecule refers to any organic or organometallic material that is not a polymer. The molecular weight of the small molecule can be large as long as it has well defined structure. Dendrimers with well-defined structures are considered as small molecules. Polymer OLEDs include conjugated polymers and non-conjugated polymers with pendant emitting groups. Small molecule OLED can become the polymer OLED if post polymerization occurred during the fabrication process.

There are various methods for OLED fabrication. Small molecule OLEDs are generally fabricated by vacuum thermal evaporation. Polymer OLEDs are fabricated by solution process such as spin-coating, inkjet printing, and slit printing. If the material can be dissolved or dispersed in a solvent, the small molecule OLED can also be produced by solution process.

The emitting color of the OLED can be achieved by emitter structural design. An OLED may include one emitting layer or a plurality of emitting layers to achieve desired spectrum. In the case of green, yellow, and red OLEDs, phosphorescent emitters have successfully reached commercialization. Blue phosphorescent device still suffers from non-saturated blue color, short device lifetime, and high operating voltage. Commercial full-color OLED displays normally adopt a hybrid strategy, using fluorescent blue and phosphorescent yellow, or red and green. At present, efficiency roll-off of phosphorescent OLEDs at high brightness remains a problem. In addition, it is desirable to have more saturated emitting color, higher efficiency, and longer device lifetime.

US2013119354A1 has disclosed a metal complex having a general structure of 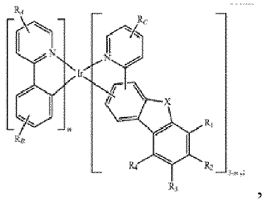 where R₁ to R₄ are selected from hydrogen, deuterium, alkyl, cycloalkyl, aryl, heteroaryl and combinations thereof. This application has disclosed only a metal complex where R₁ is phenyl (as an example of aryl) and an application thereof in a device and has not disclosed and taught a metal complex having a substituent as specified in the present application and an effect thereof on device performance.

CN107236006A has disclosed a red light metal complex having a general structure of 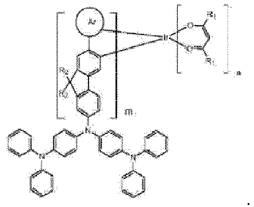 This application has disclosed a metal complex comprising an arylamine-substituted fluorene ligand and an application thereof in a device. This application has disclosed an application of a polyarylamine-substituted fluorene ligand in the metal complex. This application has not disclosed and taught a metal complex containing a ligand having a specific skeleton structure of a specific substituent as contained in the present application and an effect thereof on device performance.

CN101108964A has disclosed a metal complex emitting red light which has a general structure of 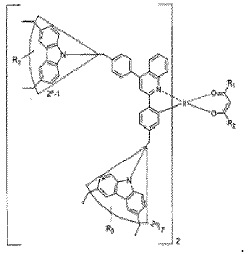 This application has disclosed a metal complex containing a carbazole substituent and containing a dione ligand and an application thereof in an organic electroluminescent device. The metal complex disclosed in this application comprises a phenylquinoline ligand which is substituted with a carbazolyl group and is coordinated to a dione ligand. This application has not disclosed and taught a metal complex containing a ligand having a specific skeleton structure of a specific substituent as contained in the present application and an effect thereof on device performance.

### SUMMARY

The present disclosure aims to provide a series of metal complexes each comprising a ligand Lₐ having a structure of Formula 1 to solve at least part of the above-mentioned problems. These new compounds, when applied to an electroluminescent device, can obtain very excellent device performance, such as a reduced device voltage and improved current efficiency, power efficiency and external quantum efficiency. These new compounds can comprehensively improve the device performance in various aspects and finally significantly improves overall device performance.

According to an embodiment of the present disclosure, disclosed is a metal complex, which comprises a metal M and a ligand Lₐ coordinated to the metal M, wherein Lₐ has a structure represented by Formula 1: 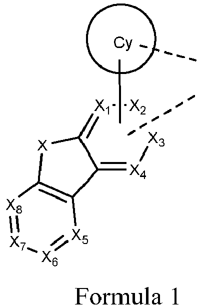 wherein in Formula 1,
the metal M is selected from a metal with a relative atomic mass greater than 40;
the ring Cy is, at each occurrence identically or differently, selected from a substituted or unsubstituted aromatic ring having 6 to 24 ring atoms, a substituted or unsubstituted heteroaromatic ring having 5 to 24 ring atoms or a combination thereof; and the ring Cy comprises at least three carbon atoms;
the ring Cy is joined to the metal M by a metal-carbon bond or a metal-nitrogen bond;
X is, at each occurrence identically or differently, selected from the group consisting of O, S, Se, NR', SiR'R' and GeR'R'; when two R' are present at the same time, the two R' are the same or different;
X₁ to X₈ are, at each occurrence identically or differently, selected from C, CRₓ, CRₓ₁ or N, and at least one of X₁ to X₄ is C and joined to the ring Cy;
X₁, X₂, X₃ or X₄ is joined to the metal M by a metal-carbon bond or a metal-nitrogen bond;
at least one of X₁ to X₈ is selected from CRₓ₁, and Rₓ₁ has a structure represented by Formula 2: 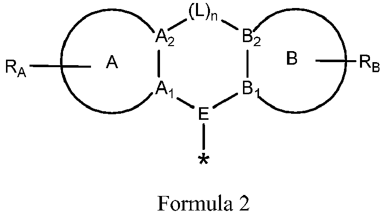 wherein in Formula 2,
R_{A} and R_{B} represent, at each occurrence identically or differently, mono-substitution, multiple substitutions or non-substitution;
the ring A and the ring B are identically or differently selected from a carbocyclic ring having 3 to 30 ring atoms, a heterocyclic ring having 3 to 30 ring atoms or a combination thereof;
n is 0 or 1;
A₁, A₂, B₁, B₂ and E are, at each occurrence identically or differently, selected from C, N, B, P, CR‴, SiR‴ or GeR‴;
L is selected from a single bond, O, S, SO₂, Se, NR", CR"R", SiR"R", GeR"R", BR", PR", P(O)R", R"C=CR", heteroalkylene having 1 to 20 carbon atoms, cycloalkylene having 3 to 20 carbon atoms, heterocyclylene having 3 to 20 ring atoms, arylene having 6 to 30 carbon atoms, heteroarylene having 3 to 30 carbon atoms and combinations thereof;
R', R", R‴, Rₓ, R_{A} and R_{B} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
" * " represents a position where Formula 2 is joined;
adjacent R', Rₓ can be optionally joined to form a ring; and
adjacent R", R‴, R_{A}, R_{B} can be optionally joined to form a ring.

According to another embodiment of the present disclosure, further disclosed is an electroluminescent device, which comprises an anode, a cathode and an organic layer disposed between the anode and the cathode, wherein at least one layer of the organic layer comprises the metal complex in the preceding embodiment.

According to another embodiment of the present disclosure, further disclosed is a composition, which comprises the metal complex in the preceding embodiment.

The present disclosure discloses the series of metal complexes each comprising the ligand Lₐ having the structure of Formula 1. These new compounds, when applied to the electroluminescent device, can obtain very excellent device performance, such as the reduced device voltage and the improved current efficiency, power efficiency and external quantum efficiency. These new compounds can comprehensively improve the device performance in various aspects and finally significantly improves the overall device performance.

### BRIEF DESCRIPTION OF DRAWINGS

FIG. 1 is a schematic diagram of an organic light-emitting apparatus that may comprise a metal complex and a composition comprising the metal complex disclosed herein.
FIG. 2 is a schematic diagram of another organic light-emitting apparatus that may comprise a metal complex and a composition comprising the metal complex disclosed herein.

### DETAILED DESCRIPTION

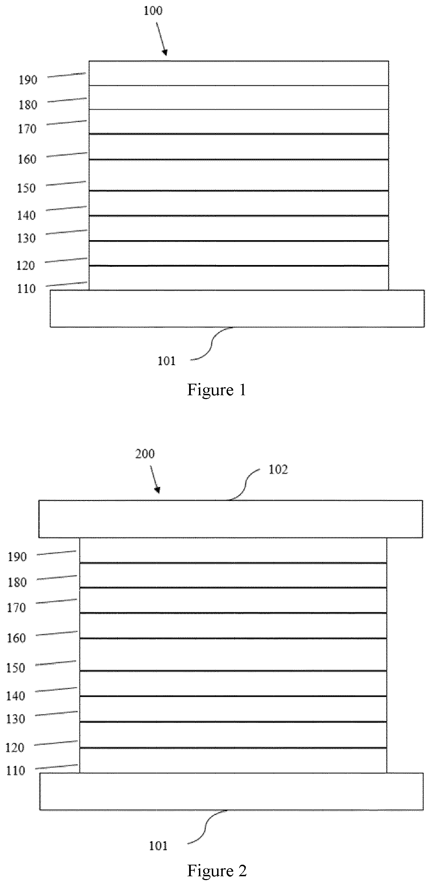

OLEDs can be fabricated on various types of substrates such as glass, plastic, and metal foil. FIG. 1 schematically shows an organic light-emitting device 100 without limitation. The figures are not necessarily drawn to scale. Some of the layers in the figures can also be omitted as needed. Device 100 may include a substrate 101, an anode 110, a hole injection layer 120, a hole transport layer 130, an electron blocking layer 140, an emissive layer 150, a hole blocking layer 160, an electron transport layer 170, an electron injection layer 180 and a cathode 190. Device 100 may be fabricated by depositing the layers described in order. The properties and functions of these various layers, as well as example materials, are described in more detail in U.S. Pat. No. 7,279,704 at cols. 6-10, the contents of which are incorporated by reference herein in its entirety.

More examples for each of these layers are available. For example, a flexible and transparent substrate-anode combination is disclosed in U.S. Pat. No. 5,844,363, which is incorporated by reference herein in its entirety. An example of a p-doped hole transport layer is m-MTDATA doped with F4-TCNQ at a molar ratio of 50:1, as disclosed in U.S. Patent Application Publication No. 2003/0230980, which is incorporated by reference herein in its entirety. Examples of host materials are disclosed in U.S. Pat. No. 6,303,238 to Thompson et al., which is incorporated by reference herein in its entirety. An example of an n-doped electron transport layer is BPhen doped with Li at a molar ratio of 1:1, as disclosed in U.S. Patent Application Publication No. 2003/0230980, which is incorporated by reference herein in its entirety. U.S. Pat. Nos. 5,703,436 and 5,707,745, which are incorporated by reference herein in their entireties, disclose examples of cathodes including composite cathodes having a thin layer of metal such as Mg:Ag with an overlying transparent, electrically-conductive, sputter-deposited ITO layer. The theory and use of blocking layers are described in more detail in U.S. Pat. No. 6,097,147 and U.S. Patent Application Publication No. 2003/0230980, which are incorporated by reference herein in their entireties. Examples of injection layers are provided in U.S. Patent Application Publication No. 2004/0174116, which is incorporated by reference herein in its entirety. A description of protective layers may be found in U.S. Patent Application Publication No. 2004/0174116, which is incorporated by reference herein in its entirety.

The layered structure described above is provided by way of non-limiting examples. Functional OLEDs may be achieved by combining the various layers described in different ways, or layers may be omitted entirely. It may also include other layers not specifically described. Within each layer, a single material or a mixture of multiple materials can be used to achieve optimum performance. Any functional layer may include several sublayers. For example, the emissive layer may have two layers of different emitting materials to achieve desired emission spectrum.

In one embodiment, an OLED may be described as having an "organic layer" disposed between a cathode and an anode. This organic layer may include a single layer or multiple layers.

An OLED can be encapsulated by a barrier layer. FIG. 2 schematically shows an organic light emitting device 200 without limitation. FIG. 2 differs from FIG. 1 in that the organic light emitting device include a barrier layer 102, which is above the cathode 190, to protect it from harmful species from the environment such as moisture and oxygen. Any material that can provide the barrier function can be used as the barrier layer such as glass or organic-inorganic hybrid layers. The barrier layer should be placed directly or indirectly outside of the OLED device. Multilayer thin film encapsulation was described in U.S. Pat. No. 7,968,146, which is incorporated by reference herein in its entirety.

Devices fabricated in accordance with embodiments of the present disclosure can be incorporated into a wide variety of consumer products that have one or more of the electronic component modules (or units) incorporated therein. Some examples of such consumer products include flat panel displays, monitors, medical monitors, televisions, billboards, lights for interior or exterior illumination and/or signaling, heads-up displays, fully or partially transparent displays, flexible displays, smart phones, tablets, phablets, wearable devices, smart watches, laptop computers, digital cameras, camcorders, viewfinders, micro-displays, 3-D displays, vehicles displays, and vehicle tail lights.

The materials and structures described herein may be used in other organic electronic devices listed above.

As used herein, "top" means furthest away from the substrate, while "bottom" means closest to the substrate. Where a first layer is described as "disposed over" a second layer, the first layer is disposed further away from the substrate. There may be other layers between the first and second layers, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

It is believed that the internal quantum efficiency (IQE) of fluorescent OLEDs can exceed the 25% spin statistics limit through delayed fluorescence. As used herein, there are two types of delayed fluorescence, i.e. P-type delayed fluorescence and E-type delayed fluorescence. P-type delayed fluorescence is generated from triplet-triplet annihilation (TTA).

On the other hand, E-type delayed fluorescence does not rely on the collision of two triplets, but rather on the transition between the triplet states and the singlet excited states. Compounds that are capable of generating E-type delayed fluorescence are required to have very small singlet-triplet gaps to convert between energy states. Thermal energy can activate the transition from the triplet state back to the singlet state. This type of delayed fluorescence is also known as thermally activated delayed fluorescence (TADF). A distinctive feature of TADF is that the delayed component increases as temperature rises. If the reverse intersystem crossing (RISC) rate is fast enough to minimize the non-radiative decay from the triplet state, the fraction of back populated singlet excited states can potentially reach 75%. The total singlet fraction can be 100%, far exceeding 25% of the spin statistics limit for electrically generated excitons.

E-type delayed fluorescence characteristics can be found in an exciplex system or in a single compound. Without being bound by theory, it is believed that E-type delayed fluorescence requires the luminescent material to have a small singlet-triplet energy gap (ΔE_{S-T}). Organic, non-metal containing, donor-acceptor luminescent materials may be able to achieve this. The emission in these materials is generally characterized as a donor-acceptor charge-transfer (CT) type emission. The spatial separation of the HOMO and LUMO in these donor-acceptor type compounds generally results in small Δ_{ES-T}. These states may involve CT states. Generally, donor-acceptor luminescent materials are constructed by connecting an electron donor moiety such as amino- or carbazole-derivatives and an electron acceptor moiety such as N-containing six-membered aromatic rings.

### Definition of terms of substituents

Halogen or halide - as used herein includes fluorine, chlorine, bromine, and iodine.

Alkyl - as used herein includes both straight and branched chain alkyl groups. Alkyl may be alkyl having 1 to 20 carbon atoms, preferably alkyl having 1 to 12 carbon atoms, and more preferably alkyl having 1 to 6 carbon atoms. Examples of alkyl groups include a methyl group, an ethyl group, a propyl group, an isopropyl group, an n-butyl group, an s-butyl group, an isobutyl group, a t-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, a neopentyl group, a 1-methylpentyl group, a 2-methylpentyl group, a 1-pentylhexyl group, a 1-butylpentyl group, a 1-heptyloctyl group, and a 3-methylpentyl group. Of the above, preferred are a methyl group, an ethyl group, a propyl group, an isopropyl group, a n-butyl group, an s-butyl group, an isobutyl group, a t-butyl group, an n-pentyl group, a neopentyl group, and an n-hexyl group. Additionally, the alkyl group may be optionally substituted.

Cycloalkyl - as used herein includes cyclic alkyl groups. The cycloalkyl groups may be those having 3 to 20 ring carbon atoms, preferably those having 4 to 10 carbon atoms. Examples of cycloalkyl include cyclobutyl, cyclopentyl, cyclohexyl, 4-methylcyclohexyl, 4,4-dimethylcylcohexyl, 1-adamantyl, 2-adamantyl, 1-norbornyl, 2-norbornyl, and the like. Of the above, preferred are cyclopentyl, cyclohexyl, 4-methylcyclohexyl, and 4,4-dimethylcylcohexyl. Additionally, the cycloalkyl group may be optionally substituted.

Heteroalkyl - as used herein, includes a group formed by replacing one or more carbons in an alkyl chain with a hetero-atom(s) selected from the group consisting of a nitrogen atom, an oxygen atom, a sulfur atom, a selenium atom, a phosphorus atom, a silicon atom, a germanium atom, and a boron atom. Heteroalkyl may be those having 1 to 20 carbon atoms, preferably those having 1 to 10 carbon atoms, and more preferably those having 1 to 6 carbon atoms. Examples of heteroalkyl include methoxymethyl, ethoxymethyl, ethoxyethyl, methylthiomethyl, ethylthiomethyl, ethylthioethyl, methoxymethoxymethyl, ethoxymethoxymethyl, ethoxyethoxyethyl, hydroxymethyl, hydroxyethyl, hydroxypropyl, mercaptomethyl, mercaptoethyl, mercaptopropyl, aminomethyl, aminoethyl, aminopropyl, dimethylaminomethyl, trimethylgermanylmethyl, trimethylgermanylethyl, trimethylgermanylisopropyl, dimethylethylgermanylmethyl, dimethylisopropylgermanylmethyl, tert-butylmethylgermanylmethyl, triethylgermanylmethyl, triethylgermanylethyl, triisopropylgermanylmethyl, triisopropylgermanylethyl, trimethylsilylmethyl, trimethylsilylethyl, and trimethylsilylisopropyl, triisopropylsilylmethyl, triisopropylsilylethyl. Additionally, the heteroalkyl group may be optionally substituted.

Alkenyl - as used herein includes straight chain, branched chain, and cyclic alkene groups. Alkenyl may be those having 2 to 20 carbon atoms, preferably those having 2 to 10 carbon atoms. Examples of alkenyl include vinyl, 1-propenyl group, 1-butenyl, 2-butenyl, 3-butenyl, 1,3-butandienyl, 1-methylvinyl, styryl, 2,2-diphenylvinyl, 1,2-diphenylvinyl, 1-methylallyl, 1,1-dimethylallyl, 2-methylallyl, 1-phenylallyl, 2-phenylallyl, 3-phenylallyl, 3,3-diphenylallyl, 1,2-dimethylallyl, 1-phenyl-1-butenyl, 3-phenyl-1-butenyl, cyclopentenyl, cyclopentadienyl, cyclohexenyl, cycloheptenyl, cycloheptatrienyl, cyclooctenyl, cyclooctatetraenyl, and norbornenyl. Additionally, the alkenyl group may be optionally substituted.

Alkynyl - as used herein includes straight chain alkynyl groups. Alkynyl may be those having 2 to 20 carbon atoms, preferably those having 2 to 10 carbon atoms. Examples of alkynyl groups include ethynyl, propynyl, propargyl, 1-butynyl, 2-butynyl, 3-butynyl, 1-pentynyl, 2-pentynyl, 3,3-dimethyl-1-butynyl, 3-ethyl-3-methyl-1-pentynyl, 3,3-diisopropyl-1-pentynyl, phenylethynyl, phenylpropynyl, etc. Of the above, preferred are ethynyl, propynyl, propargyl, 1-butynyl, 2-butynyl, 3-butynyl, 1-pentynyl, and phenylethynyl. Additionally, the alkynyl group may be optionally substituted.

Aryl or an aromatic group - as used herein includes non-condensed and condensed systems. Aryl may be those having 6 to 30 carbon atoms, preferably those having 6 to 20 carbon atoms, and more preferably those having 6 to 12 carbon atoms. Examples of aryl groups include phenyl, biphenyl, terphenyl, triphenylene, tetraphenylene, naphthalene, anthracene, phenalene, phenanthrene, fluorene, pyrene, chrysene, perylene, and azulene, preferably phenyl, biphenyl, terphenyl, triphenylene, fluorene, and naphthalene. Examples of non-condensed aryl groups include phenyl, biphenyl-2-yl, biphenyl-3-yl, biphenyl-4-yl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-(2-phenylpropyl)phenyl, 4'-methylbiphenylyl, 4"-t-butyl-p-terphenyl-4-yl, o-cumenyl, m-cumenyl, p-cumenyl, 2,3-xylyl, 3,4-xylyl, 2,5-xylyl, mesityl, and m-quarterphenyl. Additionally, the aryl group may be optionally substituted.

Heterocyclic groups or heterocycle - as used herein include non-aromatic cyclic groups. Non-aromatic heterocyclic groups include saturated heterocyclic groups having 3 to 20 ring atoms and unsaturated non-aromatic heterocyclic groups having 3 to 20 ring atoms, where at least one ring atom is selected from the group consisting of a nitrogen atom, an oxygen atom, a sulfur atom, a selenium atom, a silicon atom, a phosphorus atom, a germanium atom, and a boron atom. Preferred non-aromatic heterocyclic groups are those having 3 to 7 ring atoms, each of which includes at least one hetero-atom such as nitrogen, oxygen, silicon, or sulfur. Examples of non-aromatic heterocyclic groups include oxiranyl, oxetanyl, tetrahydrofuranyl, tetrahydropyranyl, dioxolanyl, dioxanyl, aziridinyl, dihydropyrrolyl, tetrahydropyrrolyl, piperidinyl, oxazolidinyl, morpholinyl, piperazinyl, oxepinyl, thiepinyl, azepinyl, and tetrahydrosilolyl. Additionally, the heterocyclic group may be optionally substituted.

Heteroaryl - as used herein, includes non-condensed and condensed hetero-aromatic groups having 1 to 5 hetero-atoms, where at least one hetero-atom is selected from the group consisting of a nitrogen atom, an oxygen atom, a sulfur atom, a selenium atom, a silicon atom, a phosphorus atom, a germanium atom, and a boron atom. A hetero-aromatic group is also referred to as heteroaryl. Heteroaryl may be those having 3 to 30 carbon atoms, preferably those having 3 to 20 carbon atoms, and more preferably those having 3 to 12 carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridoindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

Alkoxy - as used herein, is represented by -O-alkyl, -O-cycloalkyl, -O-heteroalkyl, or -O-heterocyclic group. Examples and preferred examples of alkyl, cycloalkyl, heteroalkyl, and heterocyclic groups are the same as those described above. Alkoxy groups may be those having 1 to 20 carbon atoms, preferably those having 1 to 6 carbon atoms. Examples of alkoxy groups include methoxy, ethoxy, propoxy, butoxy, pentyloxy, hexyloxy, cyclopropyloxy, cyclobutyloxy, cyclopentyloxy, cyclohexyloxy, tetrahydrofuranyloxy, tetrahydropyranyloxy, methoxypropyloxy, ethoxyethyloxy, methoxymethyloxy, and ethoxymethyloxy. Additionally, the alkoxy group may be optionally substituted.

Aryloxy - as used herein, is represented by -O-aryl or -O-heteroaryl. Examples and preferred examples of aryl and heteroaryl are the same as those described above. Aryloxy groups may be those having 6 to 30 carbon atoms, preferably those having 6 to 20 carbon atoms. Examples of aryloxy groups include phenoxy and biphenyloxy. Additionally, the aryloxy group may be optionally substituted.

Arylalkyl - as used herein, contemplates alkyl substituted with an aryl group. Arylalkyl may be those having 7 to 30 carbon atoms, preferably those having 7 to 20 carbon atoms, and more preferably those having 7 to 13 carbon atoms. Examples of arylalkyl groups include benzyl, 1-phenylethyl, 2-phenylethyl, 1-phenylisopropyl, 2-phenylisopropyl, phenyl-t-butyl, alpha-naphthylmethyl, 1-alpha-naphthylethyl, 2-alpha-naphthylethyl, 1-alpha-naphthylisopropyl, 2-alpha-naphthylisopropyl, beta-naphthylmethyl, 1-beta-naphthylethyl, 2-beta-naphthylethyl, 1-beta-naphthylisopropyl, 2-beta-naphthylisopropyl, p-methylbenzyl, m-methylbenzyl, o-methylbenzyl, p-chlorobenzyl, m-chlorobenzyl, o-chlorobenzyl, p-bromobenzyl, m-bromobenzyl, o-bromobenzyl, p-iodobenzyl, m-iodobenzyl, o-iodobenzyl, p-hydroxybenzyl, m-hydroxybenzyl, o-hydroxybenzyl, p-aminobenzyl, m-aminobenzyl, o-aminobenzyl, p-nitrobenzyl, m-nitrobenzyl, o-nitrobenzyl, p-cyanobenzyl, m-cyanobenzyl, o-cyanobenzyl, 1-hydroxy-2-phenylisopropyl, and 1-chloro-2-phenylisopropyl. Of the above, preferred are benzyl, p-cyanobenzyl, m-cyanobenzyl, o-cyanobenzyl, 1-phenylethyl, 2-phenylethyl, 1-phenylisopropyl, and 2-phenylisopropyl. Additionally, the arylalkyl group may be optionally substituted.

Alkylsilyl - as used herein, contemplates a silyl group substituted with an alkyl group. Alkylsilyl groups may be those having 3 to 20 carbon atoms, preferably those having 3 to 10 carbon atoms. Examples of alkylsilyl groups include trimethylsilyl, triethylsilyl, methyldiethylsilyl, ethyldimethylsilyl, tripropylsilyl, tributylsilyl, triisopropylsilyl, methyldiisopropylsilyl, dimethylisopropylsilyl, tri-t-butylsilyl, triisobutylsilyl, dimethyl t-butylsilyl, and methyldi-t-butylsilyl. Additionally, the alkylsilyl group may be optionally substituted.

Arylsilyl - as used herein, contemplates a silyl group substituted with an aryl group. Arylsilyl groups may be those having 6 to 30 carbon atoms, preferably those having 8 to 20 carbon atoms. Examples of arylsilyl groups include triphenylsilyl, phenyldibiphenylylsilyl, diphenylbiphenylsilyl, phenyldiethylsilyl, diphenylethylsilyl, phenyldimethylsilyl, diphenylmethylsilyl, phenyldiisopropylsilyl, diphenylisopropylsilyl, diphenylbutylsilyl, diphenylisobutylsilyl, diphenyl t-butylsilyl. Additionally, the arylsilyl group may be optionally substituted.

Alkylgermanyl - as used herein contemplates germanyl substituted with an alkyl group. The alkylgermanyl may be those having 3 to 20 carbon atoms, preferably those having 3 to 10 carbon atoms. Examples of alkylgermanyl include trimethylgermanyl, triethylgermanyl, methyldiethylgermanyl, ethyldimethylgermanyl, tripropylgermanyl, tributylgermanyl, triisopropylgermanyl, methyldiisopropylgermanyl, dimethylisopropylgermanyl, tri-t-butylgermanyl, triisobutylgermanyl, dimethyl-t-butylgermanyl, and methyldi-t-butylgermanyl. Additionally, the alkylgermanyl may be optionally substituted.

Arylgermanyl - as used herein contemplates a germanyl substituted with at least one aryl group or heteroaryl group. Arylgermanyl may be those having 6 to 30 carbon atoms, preferably those having 8 to 20 carbon atoms. Examples of arylgermanyl include triphenylgermanyl, phenyldibiphenylylgermanyl, diphenylbiphenylgermanyl, phenyldiethylgermanyl, diphenylethylgermanyl, phenyldimethylgermanyl, diphenylmethylgermanyl, phenyldiisopropylgermanyl, diphenylisopropylgermanyl, diphenylbutylgermanyl, diphenylisobutylgermanyl, and diphenyl-t-butylgermanyl. Additionally, the arylgermanyl may be optionally substituted.

The term "aza" in azadibenzofuran, azadibenzothiophene, etc. means that one or more of C-H groups in the respective aromatic fragment are replaced by a nitrogen atom. For example, azatriphenylene encompasses dibenzo[f,h]quinoxaline, dibenzo[f,h]quinoline and other analogs with two or more nitrogens in the ring system. One of ordinary skill in the art can readily envision other nitrogen analogs of the aza-derivatives described above, and all such analogs are intended to be encompassed by the terms as set forth herein.

In the present disclosure, unless otherwise defined, when any term of the group consisting of substituted alkyl, substituted cycloalkyl, substituted heteroalkyl, substituted heterocyclic group, substituted arylalkyl, substituted alkoxy, substituted aryloxy, substituted alkenyl, substituted alkynyl, substituted aryl, substituted heteroaryl, substituted alkylsilyl, substituted arylsilyl, substituted alkylgermanyl, substituted arylgermanyl, substituted amino, substituted acyl, substituted carbonyl, a substituted carboxylic acid group, a substituted ester group, substituted sulfinyl, substituted sulfonyl, and substituted phosphino is used, it means that any group of alkyl, cycloalkyl, heteroalkyl, heterocyclic group, arylalkyl, alkoxy, aryloxy, alkenyl, alkynyl, aryl, heteroaryl, alkylsilyl, arylsilyl, amino, acyl, carbonyl, a carboxylic acid group, an ester group, sulfinyl, sulfonyl, and phosphino may be substituted with one or more moieties selected from the group consisting of deuterium, halogen, unsubstituted alkyl having 1 to 20 carbon atoms, unsubstituted cycloalkyl having 3 to 20 ring carbon atoms, unsubstituted heteroalkyl having 1 to 20 carbon atoms, an unsubstituted heterocyclic group having 3 to 20 ring atoms, unsubstituted arylalkyl having 7 to 30 carbon atoms, unsubstituted alkoxy having 1 to 20 carbon atoms, unsubstituted aryloxy having 6 to 30 carbon atoms, unsubstituted alkenyl having 2 to 20 carbon atoms, unsubstituted alkynyl having 2 to 20 carbon atoms, unsubstituted aryl having 6 to 30 carbon atoms, unsubstituted heteroaryl having 3 to 30 carbon atoms, unsubstituted alkylsilyl having 3 to 20 carbon atoms, unsubstituted arylsilyl having 6 to 20 carbon atoms, unsubstituted alkylgermanyl having 3 to 20 carbon atoms, unsubstituted arylgermanyl group having 6 to 20 carbon atoms, unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group, and combinations thereof.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or an attached fragment are considered to be equivalent.

In the compounds mentioned in the present disclosure, hydrogen atoms may be partially or fully replaced by deuterium. Other atoms such as carbon and nitrogen can also be replaced by their other stable isotopes. The replacement by other stable isotopes in the compounds may be preferred due to its enhancements of device efficiency and stability.

In the compounds mentioned in the present disclosure, multiple substitution refers to a range that includes a di-substitution, up to the maximum available substitution. When substitution in the compounds mentioned in the present disclosure represents multiple substitution (including di-, tri-, and tetra-substitutions, etc.), that means the substituent may exist at a plurality of available substitution positions on its linking structure, the substituents present at a plurality of available substitution positions may be the same structure or different structures.

In the compounds mentioned in the present disclosure, adjacent substituents in the compounds cannot be joined to form a ring unless otherwise explicitly defined, for example, adjacent substituents can be optionally joined to form a ring. In the compounds mentioned in the present disclosure, the expression that adjacent substituents can be optionally joined to form a ring includes a case where adjacent substituents may be joined to form a ring and a case where adjacent substituents are not joined to form a ring. When adjacent substituents can be optionally joined to form a ring, the ring formed may be monocyclic or polycyclic (including spirocyclic, endocyclic, fusedcyclic, and etc.), as well as alicyclic, heteroalicyclic, aromatic, or heteroaromatic. In such expression, adjacent substituents may refer to substituents bonded to the same atom, substituents bonded to carbon atoms which are directly bonded to each other, or substituents bonded to carbon atoms which are more distant from each other. Preferably, adjacent substituents refer to substituents bonded to the same carbon atom and substituents bonded to carbon atoms which are directly bonded to each other.

The expression that adjacent substituents can be optionally joined to form a ring is also intended to mean that two substituents bonded to the same carbon atom are joined to each other via a chemical bond to form a ring, which can be exemplified by the following formula:

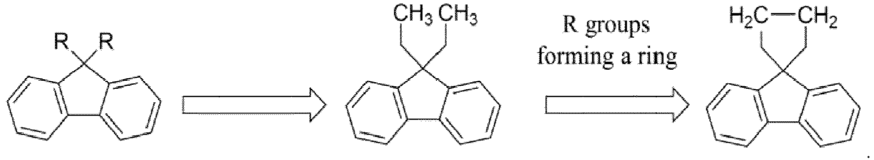

The expression that adjacent substituents can be optionally joined to form a ring is also intended to mean that two substituents bonded to carbon atoms which are directly bonded to each other are joined to each other via a chemical bond to form a ring, which can be exemplified by the following formula:

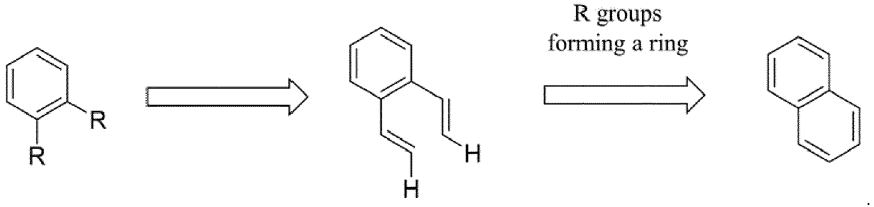

The expression that adjacent substituents can be optionally joined to form a ring is also intended to mean that two substituents bonded to a further distant carbon atom are joined to each other via a chemical bond to form a ring, which can be exemplified by the following formula:

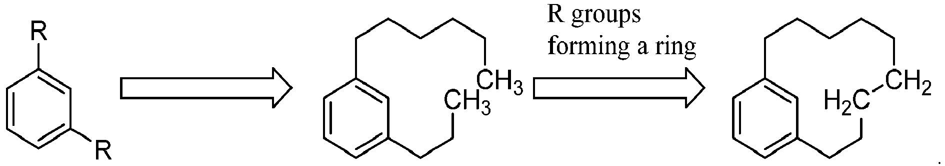

Furthermore, the expression that adjacent substituents can be optionally joined to form a ring is also intended to mean that, in the case where one of the two substituents bonded to carbon atoms which are directly bonded to each other represents hydrogen, the second substituent is bonded at a position at which the hydrogen atom is bonded, thereby forming a ring. This is exemplified by the following formula:

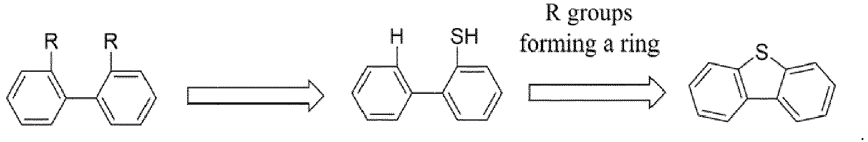

According to an embodiment of the present disclosure, disclosed is a metal complex, which comprises a metal M and a ligand Lₐ coordinated to the metal M, wherein Lₐ has a structure represented by Formula 1: 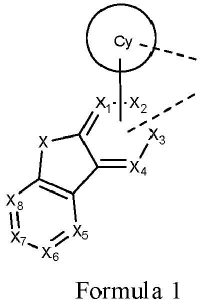 wherein in Formula 1,
the metal M is selected from a metal with a relative atomic mass greater than 40;
the ring Cy is, at each occurrence identically or differently, selected from a substituted or unsubstituted aromatic ring having 6 to 24 ring atoms, a substituted or unsubstituted heteroaromatic ring having 5 to 24 ring atoms or a combination thereof; and the ring Cy comprises at least three carbon atoms;
the ring Cy is joined to the metal M by a metal-carbon bond or a metal-nitrogen bond;
X is, at each occurrence identically or differently, selected from the group consisting of O, S, Se, NR', SiR'R' and GeR'R'; when two R' are present at the same time, the two R' are the same or different;
X₁ to X₈ are, at each occurrence identically or differently, selected from C, CRₓ, CRₓ₁ or N, and at least one of X₁ to X₄ is C and joined to the ring Cy;
X₁, X₂, X₃ or X₄ is joined to the metal M by a metal-carbon bond or a metal-nitrogen bond;
when X₁, X₂, X₃ or X₄ is joined to the metal M by the metal-carbon bond, X₁, X₂, X₃ or X₄ is selected from C;
at least one of X₁ to X₈ is selected from CRₓ₁, and Rₓ₁ has a structure represented by Formula 2: 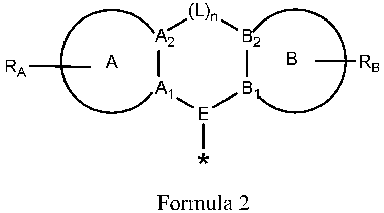 wherein in Formula 2,
R_{A} and R_{B} represent, at each occurrence identically or differently, mono-substitution, multiple substitutions or non-substitution;
the ring A and the ring B are identically or differently selected from a carbocyclic ring having 3 to 30 ring atoms, a heterocyclic ring having 3 to 30 ring atoms or a combination thereof;
n is 0 or 1;
A₁, A₂, B₁, B₂ and E are, at each occurrence identically or differently, selected from C, N, B, P, CR‴, SiR‴ or GeR‴;
L is selected from a single bond, O, S, SO₂, Se, NR", CR"R", SiR"R", GeR"R", BR", PR", P(O)R", R"C=CR", heteroalkylene having 1 to 20 carbon atoms, cycloalkylene having 3 to 20 carbon atoms, heterocyclylene having 3 to 20 ring atoms, arylene having 6 to 30 carbon atoms, heteroarylene having 3 to 30 carbon atoms and combinations thereof;
R', R", R‴, Rₓ, R_{A} and R_{B} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
" * " represents a position where Formula 2 is joined;
adjacent R', Rₓ can be optionally joined to form a ring; and
adjacent R", R‴, R_{A}, R_{B} can be optionally joined to form a ring.

In the present disclosure, the expression that R', Rₓ can be optionally joined to form a ring is intended to mean that any one or more of groups of adjacent substituents, such as two substituents R', two substituents Rₓ, and substituents R' and Rₓ, can be joined to form a ring. Obviously, it is possible that none of these substituents are joined to form a ring.

In the present disclosure, the expression that R", R‴, R_{A}, R_{B} can be optionally joined to form a ring is intended to mean that any one or more of groups of adjacent substituents, such as two substituents R", two substituents R_{A}, two substituents R_{B}, substituents R_{A} and R", substituents R_{B} and R", substituents R_{A} and R‴, substituents R_{B} and R‴, and substituents R" and R‴, can be joined to form a ring. Obviously, it is possible that none of these substituents are joined to form a ring.

In this embodiment, the ligand Lₐ having the structure of Formula 1 is a bidentate ligand, that is, Lₐ is coordinated to the metal only by the dashed bond shown in Formula 1. In Formula 1, no other manners or sites are for the coordination to the metal. For example, Rₓ₁ is not coordinated to the metal M.

In the present disclosure, "carbocyclic ring" means that ring atoms constituting a cyclic group contain only carbon atoms and no heteroatoms. The cyclic group contains a monocyclic ring and a polycyclic ring (including a spirocyclic ring, an endocyclic ring, a fusedcyclic ring and the like). "Carbocyclic ring" contains a saturated carbocyclic ring or an unsaturated carbocyclic ring, for example, both an alicyclic ring (such as cycloalkyl, cycloalkenyl and cycloalkynyl) and an aromatic ring are carbocyclic rings.

In the present disclosure, "heterocyclic ring" means that ring atoms constituting a cyclic group containing one or more heteroatoms. The one or more heteroatoms may be selected from a nitrogen atom, an oxygen atom, a sulfur atom, a selenium atom, a phosphorus atom, a silicon atom, a germanium atom, a boron atom and the like. The cyclic group contains a monocyclic ring and a polycyclic ring (including a spirocyclic ring, an endocyclic ring, a fusedcyclic ring and the like). "Heterocyclic ring" contains a saturated carbocyclic ring or an unsaturated carbocyclic ring, for example, both a heteroalicyclic ring and a heteroaromatic ring are heterocyclic rings.

In the present disclosure, when n is 0, it means that no L is present in Formula 2; that is, Formula 2 has a structure of 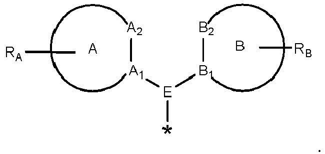 When n is 1 and L is selected from a single bond, Formula 2 has a structure of

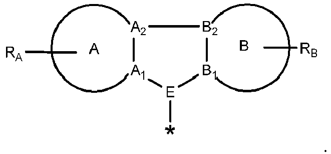

According to an embodiment of the present disclosure, the ring Cy is, at each occurrence identically or differently, selected from any structure of the group consisting of the following: 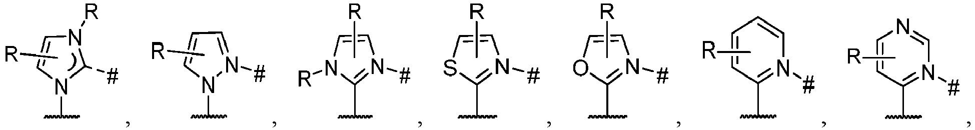 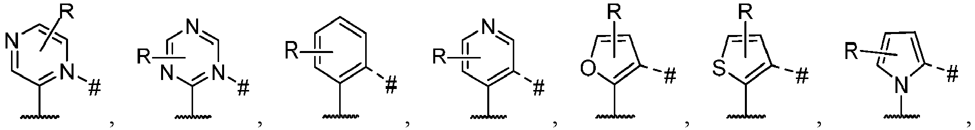 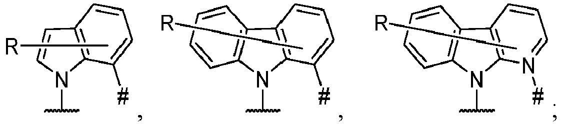 wherein,
R represents, at each occurrence identically or differently, mono-substitution, multiple substitutions or non-substitution; when multiple R are present at the same time in any structure, the multiple R are the same or different;
R is, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent substituents R can be optionally joined to form a ring; and
"#" represents a position where the ring Cy is joined to the metal M, and " 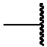 " represents a position where the ring Cy is joined to X₁, X₂, X₃ or X₄.

In the present disclosure, the expression that adjacent substituents R can be optionally joined to form a ring is intended to mean that any one or more of groups of any two adjacent substituents R can be joined to form a ring. Obviously, it is possible that none of these substituents are joined to form a ring.

According to an embodiment of the present disclosure, the metal complex has a general formula of M(Lₐ)ₘ(L_{b})ₙ(L_{c})_{q};
wherein M is, at each occurrence identically or differently, selected from the group consisting of Cu, Ag, Au, Ru, Rh, Pd, Os, Ir and Pt; preferably, M is, at each occurrence identically or differently, selected from Pt or Ir;
Lₐ, L_{b} and L_{c} are a first ligand, a second ligand and a third ligand coordinated to the metal M, respectively, and L_{c} is the same as or different from Lₐ or L_{b}; wherein Lₐ, L_{b} and L_{c} can be optionally joined to form a multidentate ligand;
m is selected from 1, 2 or 3, n is selected from 0, 1 or 2, q is selected from 0, 1 or 2, and m+n+q equals an oxidation state of the metal M; when m is greater than or equal to 2, multiple Lₐ are the same or different; when n is equal to 2, two L_{b} are the same or different; when q is equal to 2, two L_{c} are the same or different;
Lₐ is, at each occurrence identically or differently, selected from the group consisting of the following: 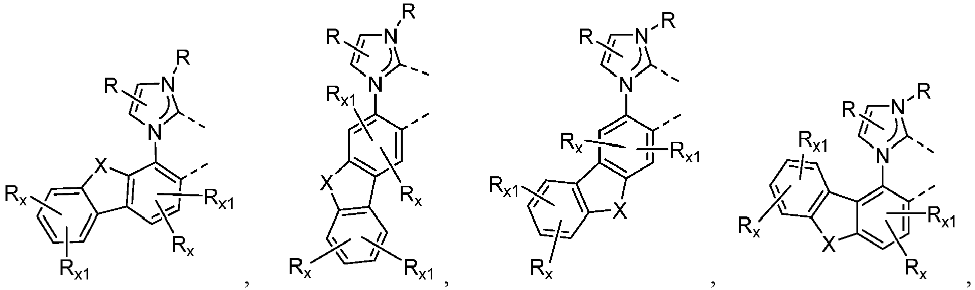 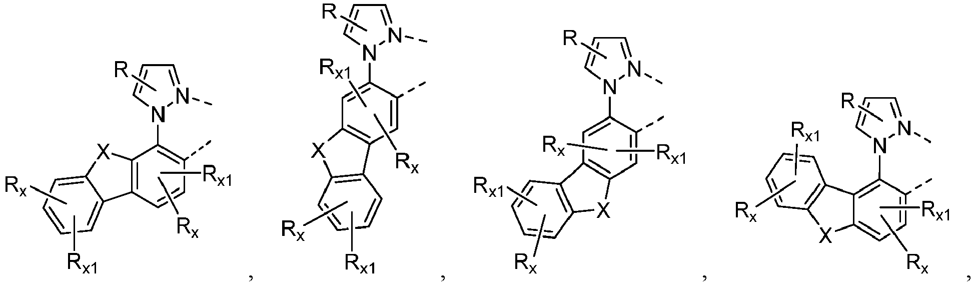 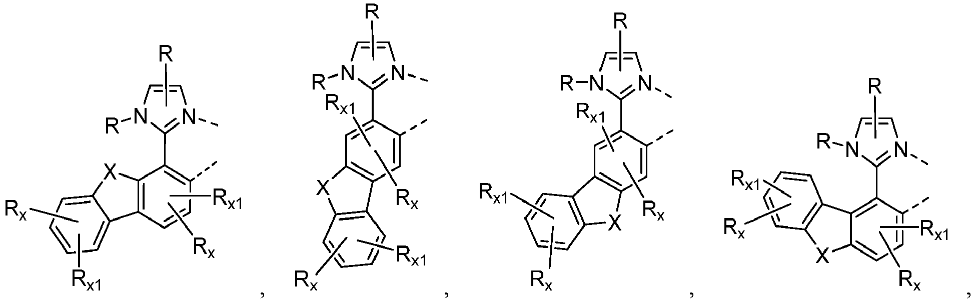 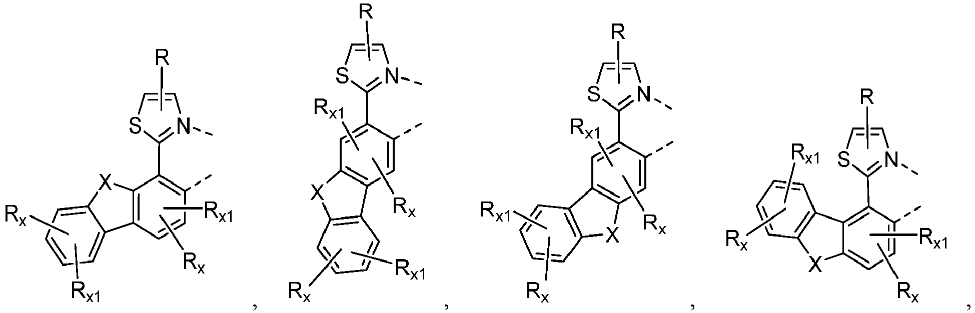 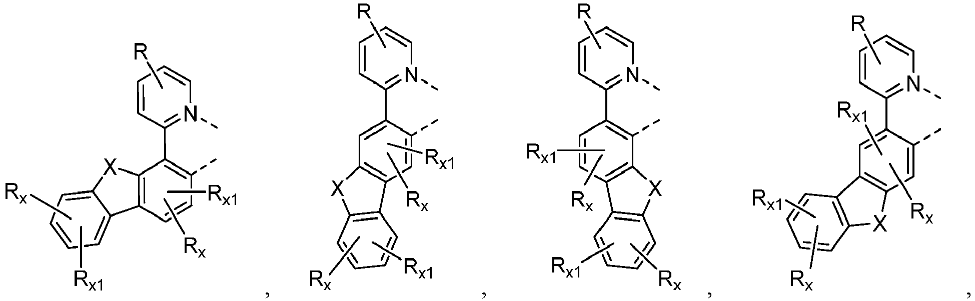 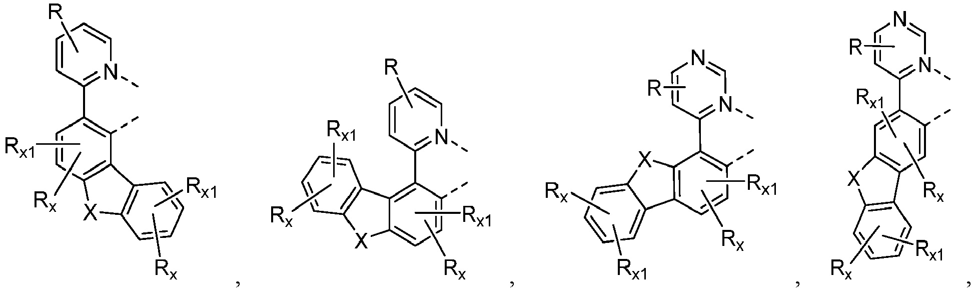 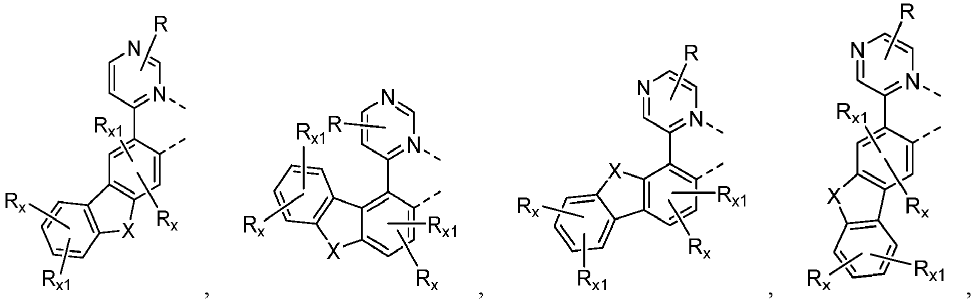 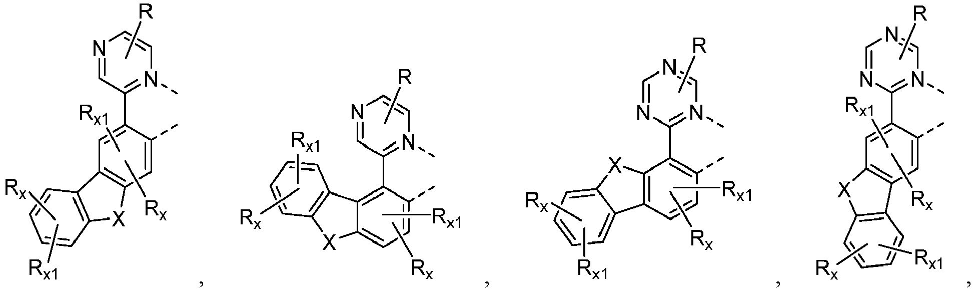 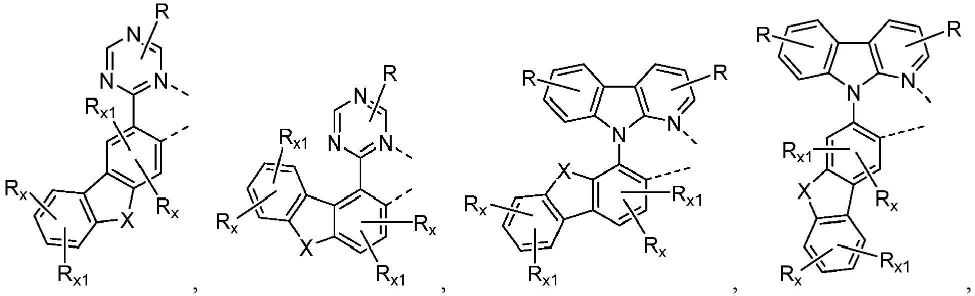 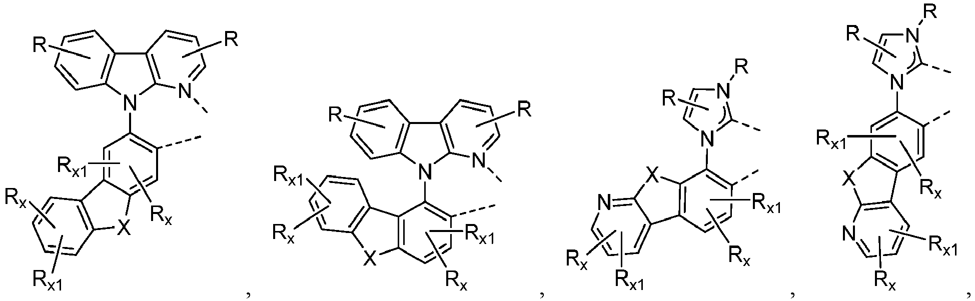 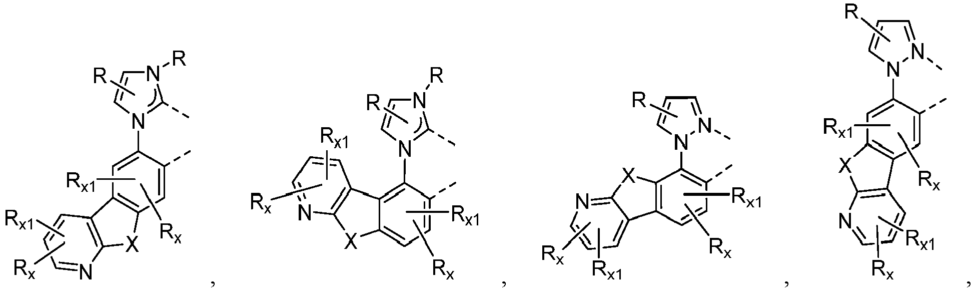 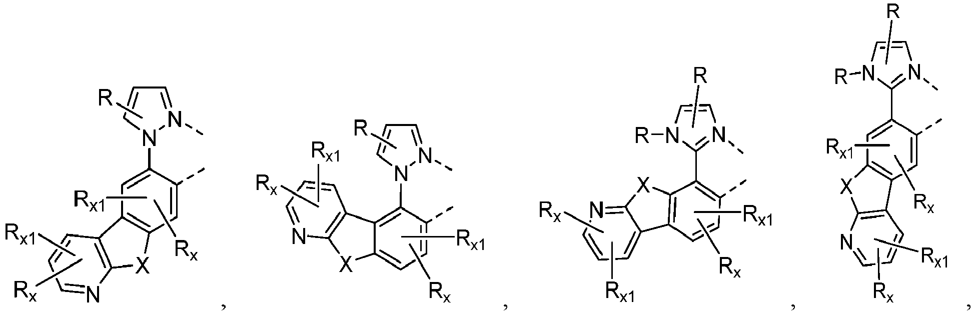 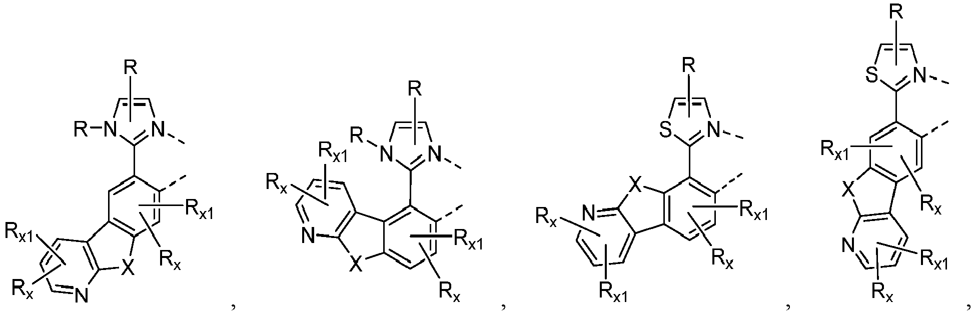 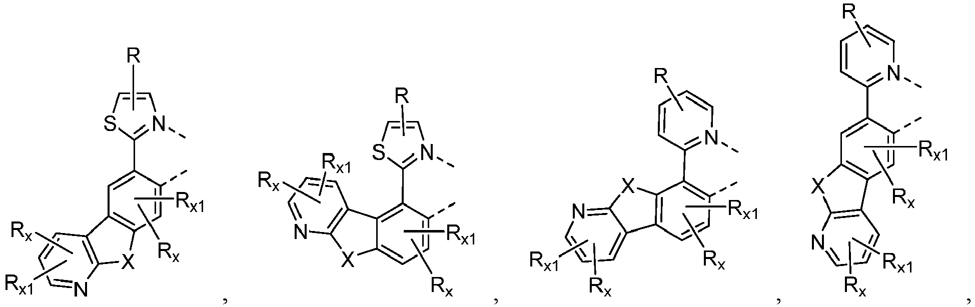 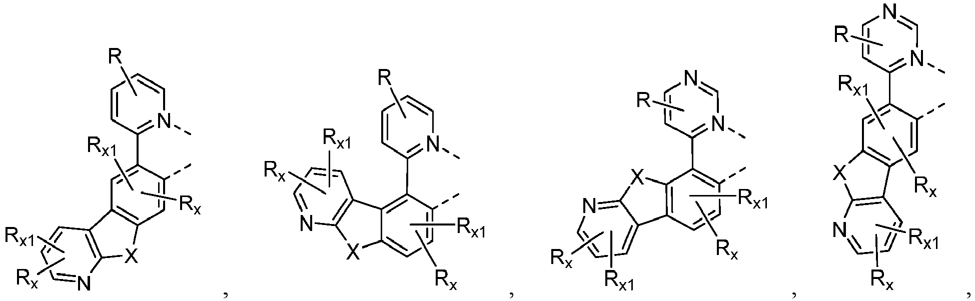 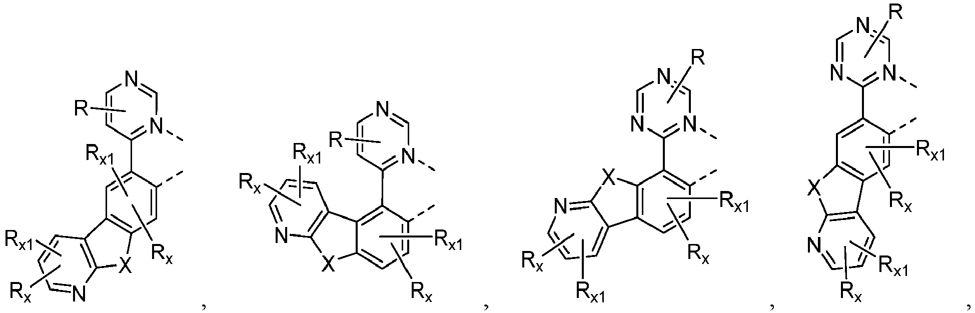 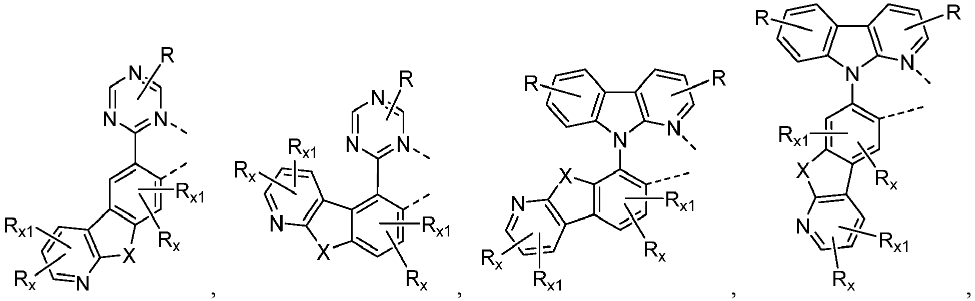 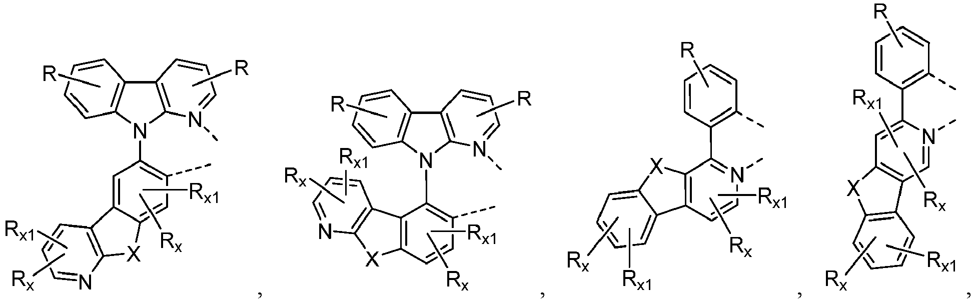 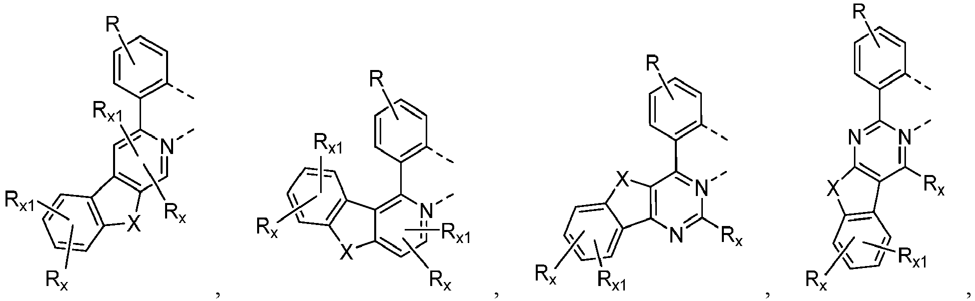 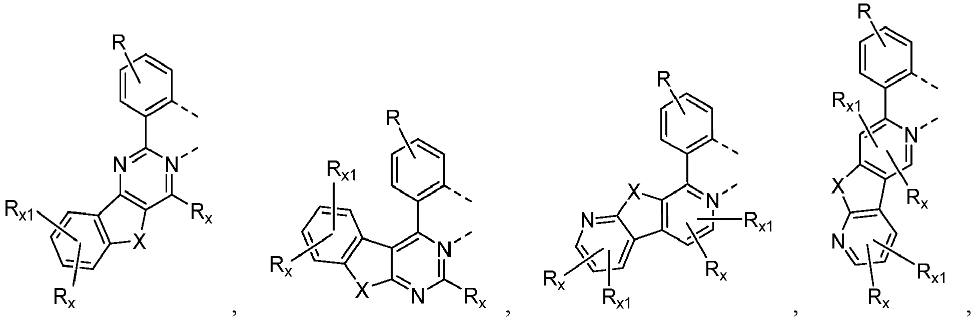 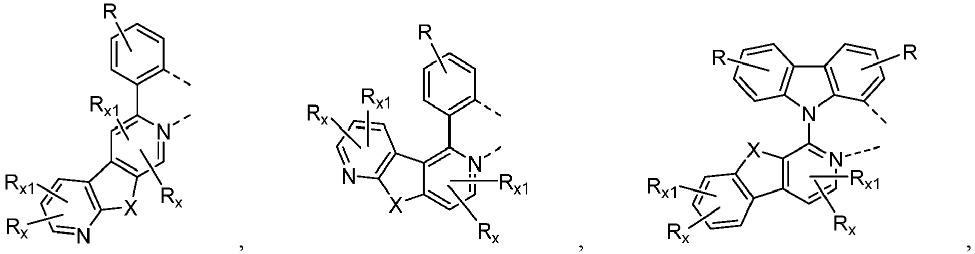 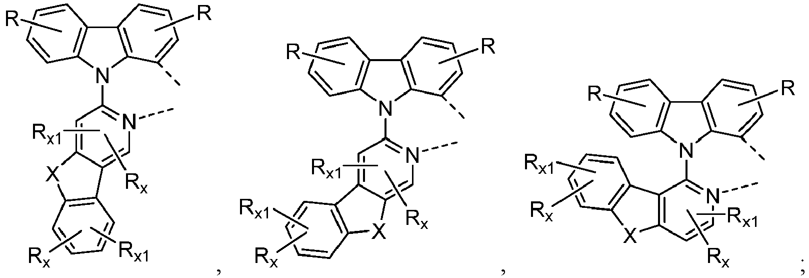
X is selected from the group consisting of O, S, Se, NR', SiR'R' and GeR'R'; when two R' are present at the same time, the two R' are the same or different;
R, Rₓ and Rₓ₁ represent, at each occurrence identically or differently, mono-substitution, multiple substitutions or non-substitution;
Rₓ₁ has a structure represented by Formula 2: 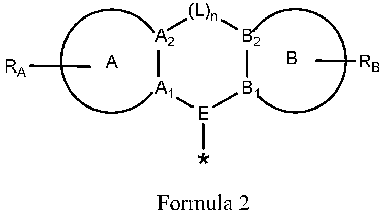
R_{A} and R_{B} represent, at each occurrence identically or differently, mono-substitution, multiple substitutions or non-substitution;
the ring A and the ring B are identically or differently selected from a carbocyclic ring having 3 to 30 ring atoms, a heterocyclic ring having 3 to 30 ring atoms or a combination thereof;
A₁, A₂, B₁, B₂ and E are, at each occurrence identically or differently, selected from C, N, B, P, CR‴, SiR‴ or GeR‴;
n is 0 or 1;
L is selected from a single bond, O, S, SO₂, Se, NR", CR"R", SiR"R", GeR"R", BR", PR", P(O)R", R"C=CR", heteroalkylene having 1 to 20 carbon atoms, cycloalkylene having 3 to 20 carbon atoms, heterocyclylene having 3 to 20 ring atoms, arylene having 6 to 30 carbon atoms, heteroarylene having 3 to 30 carbon atoms and combinations thereof;
" * " represents a position where Formula 2 is joined;
adjacent R', Rₓ can be optionally joined to form a ring;
adjacent R can be optionally joined to form a ring;
adjacent R", R‴, R_{A}, R_{B} can be optionally joined to form a ring;
L_{b} and L_{c} are, at each occurrence identically or differently, selected from a structure represented by any one of the group consisting of the following: 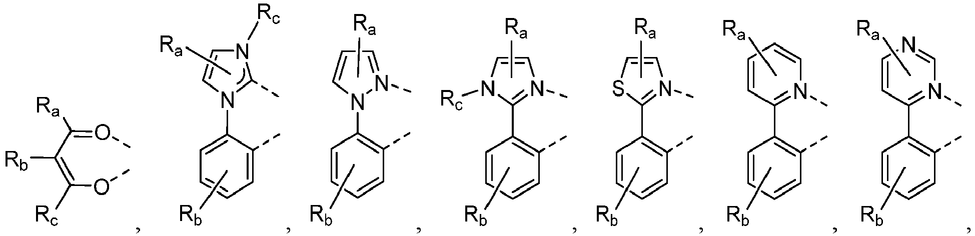 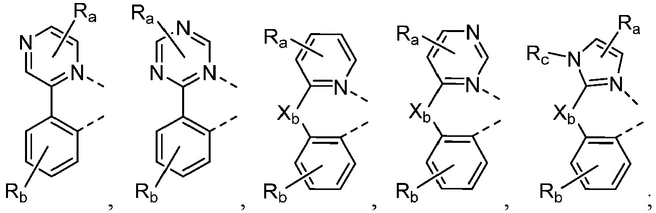 wherein,
X_{b} is, at each occurrence identically or differently, selected from the group consisting of: O, S, Se, NR_{N1} and CR_{C1}R_{C2};
Rₐ and R_{b} represent, at each occurrence identically or differently, mono-substitution, multiple substitutions or non-substitution;
adjacent substituents Rₐ, R_{b}, R_{c}, R_{N1}, R_{C1} and R_{C2} can be optionally joined to form a ring; and
R', R", R‴, R, Rₓ, R_{A}, R_{B}, Rₐ, R_{b}, R_{c}, R_{N1}, R_{C1} and R_{C2} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof.

In the present disclosure, the expression that adjacent substituents Rₐ, R_{b}, R_{c}, R_{N1}, R_{C1} and R_{C2} can be optionally joined to form a ring is intended to mean that any one or more of groups of adjacent substituents, such as two substituents Rₐ, two substituents R_{b}, substituents Rₐ and R_{b}, substituents Rₐ and R_{c}, substituents R_{b} and R_{c}, substituents Rₐ and R_{N1}, substituents R_{b} and R_{N1}, substituents Rₐ and R_{C1}, substituents Rₐ and R_{C2}, substituents R_{b} and R_{C1}, substituents R_{b} and R_{C2}, and substituents R_{C1} and R_{C2}, can be joined to form a ring. Obviously, it is possible that none of these substituents are joined to form a ring. For example, adjacent substituents Rₐ, R_{b} in 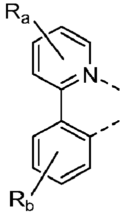 can be optionally joined to form a ring. When Rₐ is optionally joined to form a ring, 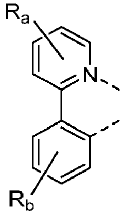 may form a structure of

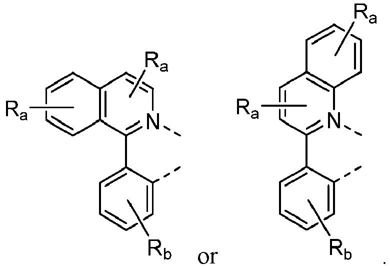

According to an embodiment of the present disclosure, the metal complex has a structure of Ir(Lₐ)ₘ(L_{b})₃₋ₘ which is represented by Formula 3: 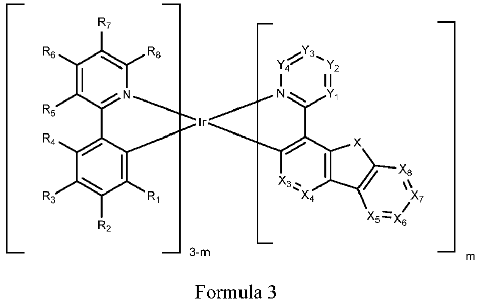 wherein,
m is selected from 1, 2 or 3; when m is selected from 1, two L_{b} are the same or different; when m is selected from 2 or 3, multiple Lₐ are the same or different;
X is selected from the group consisting of O, S, Se, NR', SiR'R' and GeR'R'; when two R' are present at the same time, the two R' are the same or different;
Y₁ to Y₄ are, at each occurrence identically or differently, selected from CR or N;
X₃ to X₈ are, at each occurrence identically or differently, selected from CRₓ, CRₓ₁ or N;
at least one of X₃ to X₈ is selected from CRₓ₁, and Rₓ₁ has a structure represented by Formula 2: 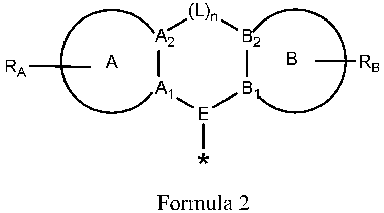
R_{A} and R_{B} represent, at each occurrence identically or differently, mono-substitution, multiple substitutions or non-substitution;
the ring A and the ring B are identically or differently selected from a carbocyclic ring having 3 to 30 ring atoms, a heterocyclic ring having 3 to 30 ring atoms or a combination thereof;
A₁, A₂, B₁, B₂ and E are, at each occurrence identically or differently, selected from C, N, B, P, CR‴, SiR‴ or GeR‴;
n is 0 or 1;
L is selected from a single bond, O, S, SO₂, Se, NR", CR"R", SiR"R", GeR"R", BR", PR", P(O)R", R"C=CR", heteroalkylene having 1 to 20 carbon atoms, cycloalkylene having 3 to 20 carbon atoms, heterocyclylene having 3 to 20 ring atoms, arylene having 6 to 30 carbon atoms, heteroarylene having 3 to 30 carbon atoms and combinations thereof;
R', R", R‴, R, Rₓ, R_{A}, R_{B} and R₁ to R₈ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent R₁ to R₈ can be optionally joined to form a ring;
adjacent R', Rₓ can be optionally joined to form a ring;
adjacent R can be optionally joined to form a ring; and
adjacent R", R‴, R_{A}, R_{B} can be optionally joined to form a ring.

In the present disclosure, the expression that adjacent R₁ to R₈ can be optionally joined to form a ring is intended to mean that any one or more groups of the group consisting of any two adjacent substituents of R₁ to R₈ can be joined to form a ring. Obviously, it is possible that none of these substituents are joined to form a ring.

According to an embodiment of the present disclosure, X₁ to X₈ are, at each occurrence identically or differently, selected from CRₓ or CRₓ₁.

According to an embodiment of the present disclosure, X₁ to X₈ are, at each occurrence identically or differently, selected from CRₓ or CRₓ₁, and only one of X₁ to X₈ is selected from CRₓ₁.

According to an embodiment of the present disclosure, X₃ to X₈ are, at each occurrence identically or differently, selected from CRₓ or CRₓ₁.

According to an embodiment of the present disclosure, X₃ to X₈ are, at each occurrence identically or differently, selected from CRₓ or CRₓ₁, and only one of X₃ to X₈ is selected from CRₓ₁.

According to an embodiment of the present disclosure, Y₁ to Y₄ are, at each occurrence identically or differently, selected from CR.

According to an embodiment of the present disclosure, at least one of X₃ to X₈ is N. For example, one of X₃ to X₈ is selected from N, or two of X₃ to X₈ are selected from N.

According to an embodiment of the present disclosure, at least one of X₁ to X₈ is N. For example, one of X₁ to X₈ is selected from N, or two of X₁ to X₈ are selected from N.

According to an embodiment of the present disclosure, at least one of Y₁ to Y₄ is N. For example, one of Y₁ to Y₄ is selected from N, or two of Y₁ to Y₄ are selected from N.

According to an embodiment of the present disclosure, the metal complex has a structure of Ir(Lₐ)ₘ(L_{b})₃₋ₘ which is represented by Formula 3A: 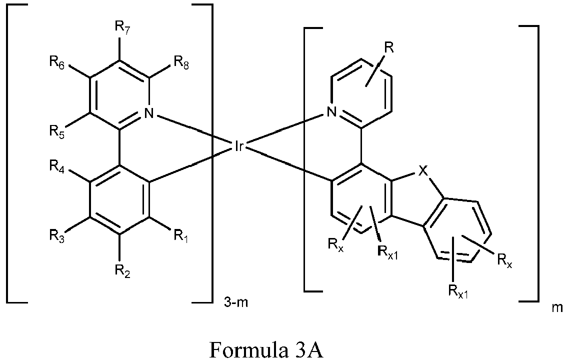 wherein,
m is selected from 1, 2 or 3; when m is selected from 1, two L_{b} are the same or different; when m is selected from 2 or 3, multiple Lₐ are the same or different;
X is selected from the group consisting of O, S, Se, NR', SiR'R' and GeR'R'; when two R' are present at the same time, the two R' are the same or different;
R, Rₓ and Rₓ₁ represent, at each occurrence identically or differently, mono-substitution, multiple substitutions or non-substitution;
Rₓ₁ has a structure represented by Formula 2: 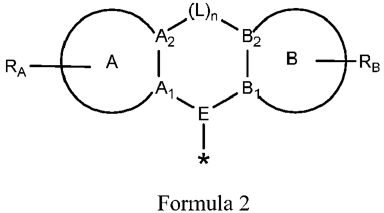
R_{A} and R_{B} represent, at each occurrence identically or differently, mono-substitution, multiple substitutions or non-substitution;
the ring A and the ring B are identically or differently selected from a carbocyclic ring having 3 to 30 ring atoms, a heterocyclic ring having 3 to 30 ring atoms or a combination thereof;
A₁, A₂, B₁, B₂ and E are, at each occurrence identically or differently, selected from C, N, B, P, CR‴, SiR‴ or GeR‴;
n is 0 or 1;
L is selected from a single bond, O, S, SO₂, Se, NR", CR"R", SiR"R", GeR"R", BR", PR", P(O)R", R"C=CR", heteroalkylene having 1 to 20 carbon atoms, cycloalkylene having 3 to 20 carbon atoms, heterocyclylene having 3 to 20 ring atoms, arylene having 6 to 30 carbon atoms, heteroarylene having 3 to 30 carbon atoms and combinations thereof;
R', R", R‴, R, Rₓ, R_{A}, R_{B} and R₁ to R₈ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent R₁ to R₈ can be optionally joined to form a ring;
adjacent R', Rₓ can be optionally joined to form a ring;
adjacent R can be optionally joined to form a ring; and
adjacent R", R‴, R_{A}, R_{B} can be optionally joined to form a ring.

According to an embodiment of the present disclosure, X is selected from O or S.

According to an embodiment of the present disclosure, X is selected from O.

According to an embodiment of the present disclosure, A₁, A₂, B₁ and B₂ are, at each occurrence identically or differently, selected from C.

According to an embodiment of the present disclosure, E is, at each occurrence identically or differently, selected from N.

According to an embodiment of the present disclosure, Rₓ is, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted alkylgermanyl having 3 to 20 carbon atoms, a cyano group and combinations thereof.

According to an embodiment of the present disclosure, Rₓ is, at each occurrence identically or differently, selected from the group consisting of: hydrogen, deuterium, fluorine, substituted or unsubstituted alkyl having 1 to 6 carbon atoms, substituted or unsubstituted cycloalkyl having 3 to 6 ring carbon atoms, substituted or unsubstituted aryl having 6 to 12 carbon atoms, substituted or unsubstituted heteroaryl having 3 to 12 carbon atoms, substituted or unsubstituted alkylsilyl having 3 to 6 carbon atoms, substituted or unsubstituted alkylgermanyl having 3 to 6 carbon atoms, a cyano group and combinations thereof.

According to an embodiment of the present disclosure, Rₓ is, at each occurrence identically or differently, selected from the group consisting of: hydrogen, deuterium, fluorine, cyano, methyl, ethyl, propyl, isopropyl, n-butyl, isobutyl, t-butyl, cyclopentyl, cyclohexyl, deuterated methyl, deuterated ethyl, deuterated propyl, deuterated isopropyl, deuterated n-butyl, deuterated isobutyl, deuterated t-butyl, deuterated cyclopentyl, deuterated cyclohexyl, phenyl, pyridyl, trimethylsilyl, trimethylgermanyl and combinations thereof.

According to an embodiment of the present disclosure, the ring A and the ring B are, at each occurrence identically or differently, selected from a carbocyclic ring having 5 to 12 ring atoms, a heterocyclic ring having 5 to 12 ring atoms or a combination thereof.

According to an embodiment of the present disclosure, the ring A and the ring B are, at each occurrence identically or differently, selected from a carbocyclic ring having 5 to 6 ring atoms, a heterocyclic ring having 5 to 6 ring atoms or a combination thereof.

According to an embodiment of the present disclosure, Rₓ₁ has a structure represented by Formula 4: 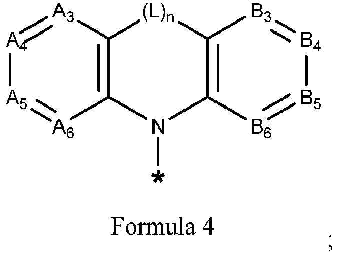
A₃ to A₆ are, at each occurrence identically or differently, selected from CR_{A} or N;
B₃ to B₆ are, at each occurrence identically or differently, selected from CR_{B} or N;
n is 0 or 1;
L is selected from a single bond, O, S, SO₂, Se, NR", CR"R", SiR"R", GeR"R", BR", PR", P(O)R", R"C=CR", heteroalkylene having 1 to 20 carbon atoms, cycloalkylene having 3 to 20 carbon atoms, heterocyclylene having 3 to 20 ring atoms, arylene having 6 to 30 carbon atoms, heteroarylene having 3 to 30 carbon atoms and combinations thereof;
R_{A}, R_{B} and R" are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent R", R_{A}, R_{B} can be optionally joined to form a ring; and
" * " represents a position where Formula 4 is joined.

In this embodiment, when n is 0, it means that no L is present in Formula 4; that is, Formula 4 has a structure of 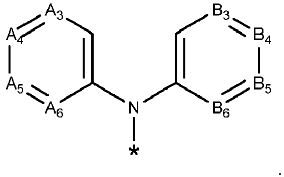 When n is 1 and L is selected from a single bond, Formula 4 has a structure of

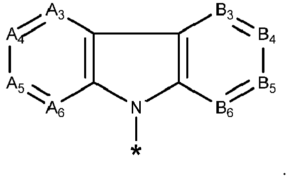

According to an embodiment of the present disclosure, A₃ to A₆ are, at each occurrence identically or differently, selected from CR_{A}.

According to an embodiment of the present disclosure, B₃ to B₆ are, at each occurrence identically or differently, selected from CR_{B}.

According to an embodiment of the present disclosure, at least one of A₃ to A₆ is selected from N. For example, one of A₃ to A₆ is selected from N, or two of A₃ to A₆ are selected from N.

According to an embodiment of the present disclosure, at least one of B₃ to B₆ is selected from N. For example, one of B₃ to B₆ is selected from N, or two of B₃ to B₆ are selected from N.

According to an embodiment of the present disclosure, R_{A} and R_{B} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted alkylgermanyl having 3 to 20 carbon atoms, a cyano group and combinations thereof.

According to an embodiment of the present disclosure, at least one of R_{A} and R_{B} is selected from the group consisting of: hydrogen, deuterium, fluorine, substituted or unsubstituted alkyl having 1 to 6 carbon atoms, substituted or unsubstituted cycloalkyl having 3 to 6 ring carbon atoms, substituted or unsubstituted aryl having 6 to 12 carbon atoms, substituted or unsubstituted heteroaryl having 3 to 12 carbon atoms, substituted or unsubstituted alkylsilyl having 3 to 6 carbon atoms, substituted or unsubstituted alkylgermanyl having 3 to 6 carbon atoms, a cyano group and combinations thereof.

According to an embodiment of the present disclosure, R_{A} and R_{B} are, at each occurrence identically or differently, selected from the group consisting of: hydrogen, deuterium, fluorine, substituted or unsubstituted alkyl having 1 to 6 carbon atoms, substituted or unsubstituted cycloalkyl having 3 to 6 ring carbon atoms, substituted or unsubstituted aryl having 6 to 12 carbon atoms, substituted or unsubstituted heteroaryl having 3 to 12 carbon atoms, substituted or unsubstituted alkylsilyl having 3 to 6 carbon atoms, substituted or unsubstituted alkylgermanyl having 3 to 6 carbon atoms, a cyano group and combinations thereof.

According to an embodiment of the present disclosure, R_{A} and R_{B} are, at each occurrence identically or differently, selected from the group consisting of: hydrogen, deuterium, fluorine, cyano, methyl, ethyl, propyl, isopropyl, n-butyl, isobutyl, t-butyl, cyclopentyl, cyclohexyl, deuterated methyl, deuterated ethyl, deuterated propyl, deuterated isopropyl, deuterated n-butyl, deuterated isobutyl, deuterated t-butyl, deuterated cyclopentyl, deuterated cyclohexyl, phenyl, pyridyl, trimethylsilyl, trimethylgermanyl and combinations thereof.

According to an embodiment of the present disclosure, L is selected from a single bond, O, S, Se, NR", CR"R", SiR"R", GeR"R", BR", PR", P(O)R", R"C=CR", heteroalkylene having 1 to 10 carbon atoms, cycloalkylene having 3 to 10 carbon atoms, heterocyclylene having 3 to 10 ring atoms, arylene having 6 to 10 carbon atoms, heteroarylene having 3 to 10 carbon atoms and combinations thereof.

According to an embodiment of the present disclosure, L is selected from a single bond, O, S, NR", R"C=CR" and phenylene.

According to an embodiment of the present disclosure, L is selected from a single bond.

According to an embodiment of the present disclosure, R" is, at each occurrence identically or differently, selected from the group consisting of: hydrogen, deuterium, fluorine, substituted or unsubstituted alkyl having 1 to 6 carbon atoms, substituted or unsubstituted cycloalkyl having 3 to 6 ring carbon atoms, substituted or unsubstituted aryl having 6 to 12 carbon atoms, substituted or unsubstituted heteroaryl having 3 to 12 carbon atoms, substituted or unsubstituted alkylsilyl having 3 to 6 carbon atoms, substituted or unsubstituted alkylgermanyl having 3 to 6 carbon atoms and combinations thereof.

According to an embodiment of the present disclosure, R" is, at each occurrence identically or differently, selected from the group consisting of: hydrogen, deuterium, fluorine, cyano, methyl, ethyl, propyl, isopropyl, n-butyl, isobutyl, t-butyl, cyclopentyl, cyclohexyl, deuterated methyl, deuterated ethyl, deuterated propyl, deuterated isopropyl, deuterated n-butyl, deuterated isobutyl, deuterated t-butyl, deuterated cyclopentyl, deuterated cyclohexyl, phenyl, pyridyl, trimethylsilyl, trimethylgermanyl and combinations thereof.

According to an embodiment of the present disclosure, at least one of X₃ to X₈ is selected from CRₓ₁.

According to an embodiment of the present disclosure, at least one of X₄ to X₈ is selected from CRₓ₁.

According to an embodiment of the present disclosure, X₄ is selected from CRₓ₁.

According to an embodiment of the present disclosure, at least one of X₅ to X₈ is selected from CRₓ₁.

According to an embodiment of the present disclosure, X₇ or X₈ is selected from CRₓ₁.

According to an embodiment of the present disclosure, X₈ is selected from CRₓ₁.

According to an embodiment of the present disclosure, at least one of X₁ to X₈ is selected from CRₓ, and the Rₓ is selected from cyano or fluorine, and at least one of X₅ to X₈ is selected from CRₓ₁.

According to an embodiment of the present disclosure, at least one of X₃ to X₈ is selected from CRₓ, and the Rₓ is selected from cyano or fluorine, and at least one of X₅ to X₈ is selected from CRₓ₁.

According to an embodiment of the present disclosure, at least one of X₅ to X₈ is selected from CRₓ, and the Rₓ is selected from cyano or fluorine, and at least one of X₅ to X₈ is selected from CRₓ₁.

According to an embodiment of the present disclosure, X₇ is selected from CRₓ, and the Rₓ is cyano or fluorine, and X₈ is selected from CRₓ₁.

According to an embodiment of the present disclosure, X₈ is selected from CRₓ, and the Rₓ is cyano or fluorine, and X₇ is selected from CRₓ₁.

According to an embodiment of the present disclosure, Rₓ₁ is, at each occurrence identically or differently, selected from the group consisting of the following:

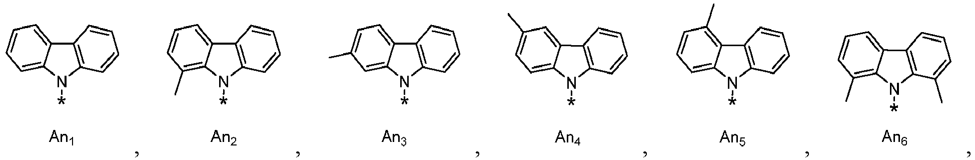

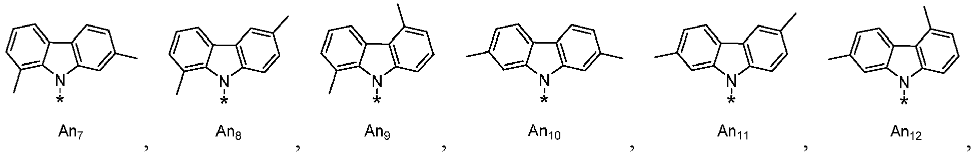

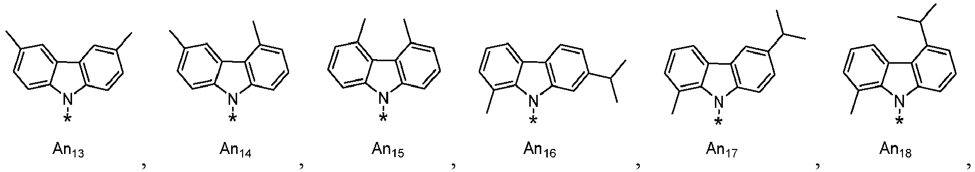

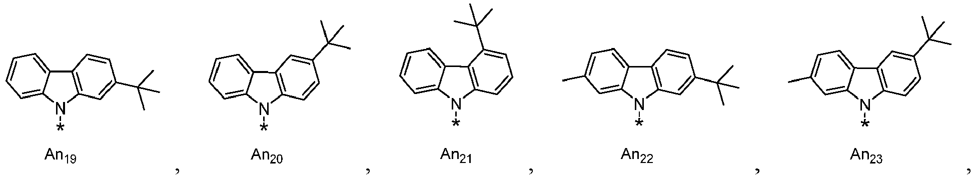

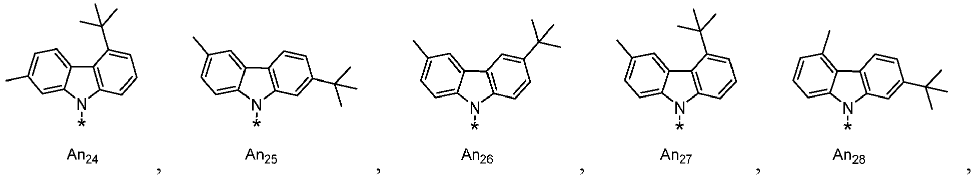

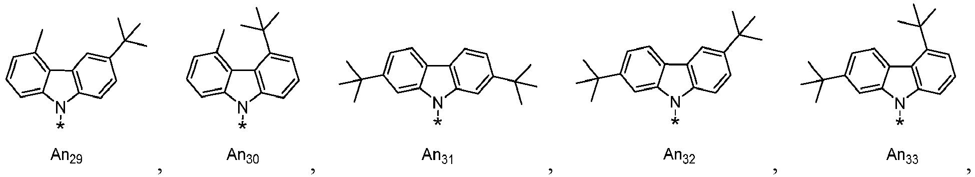

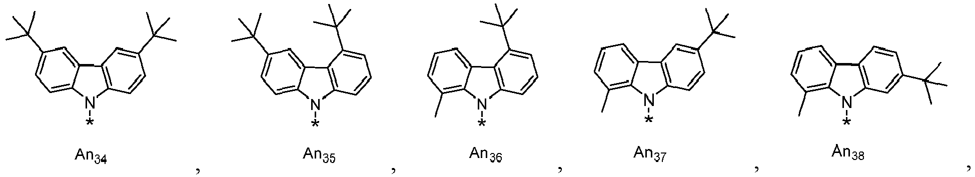

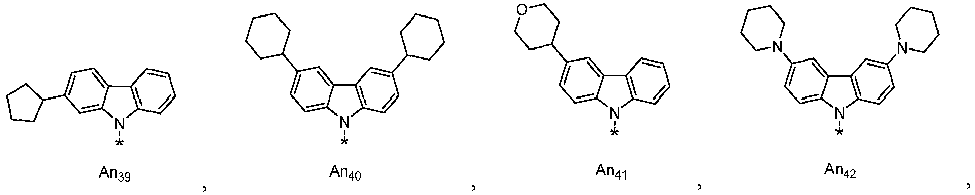

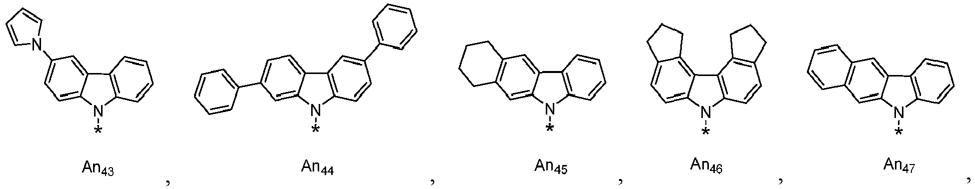

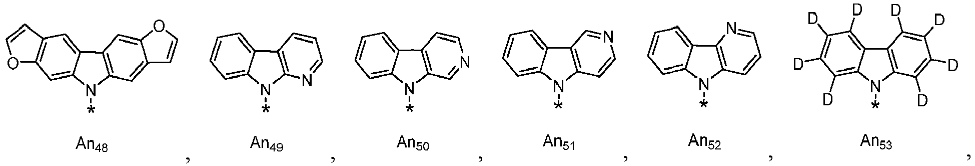

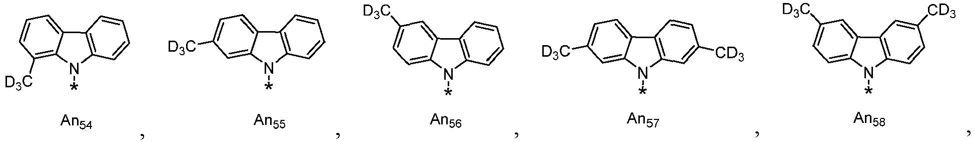

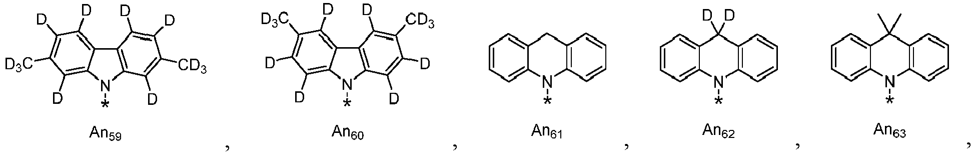

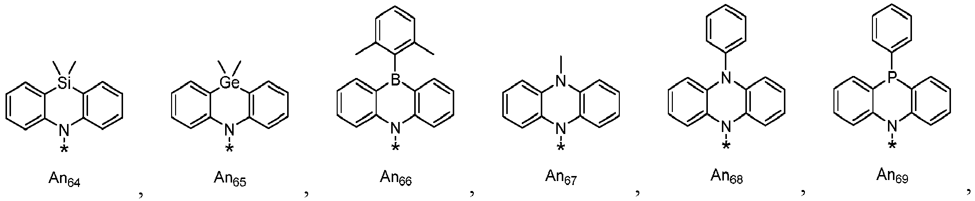

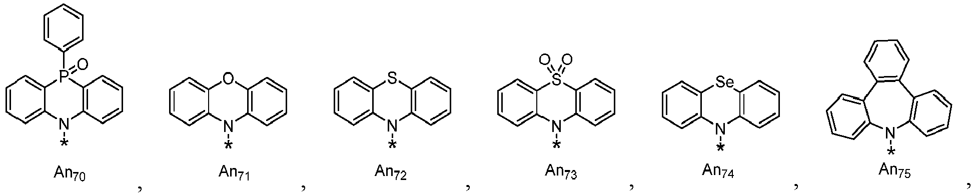

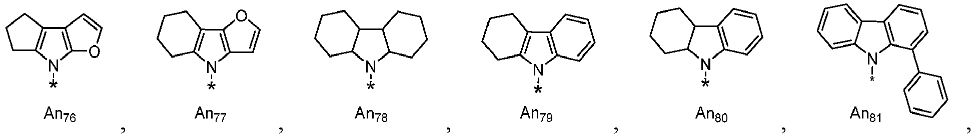

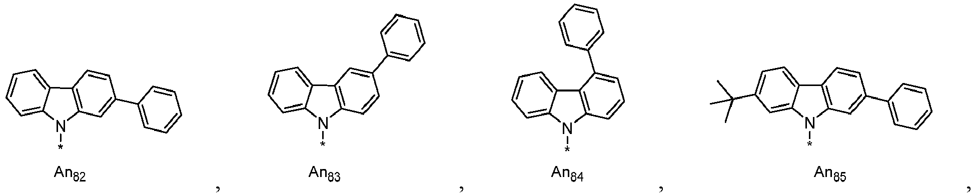

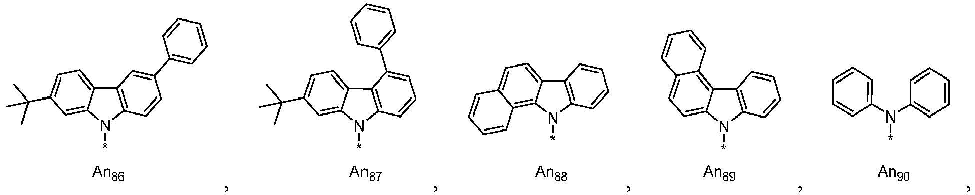

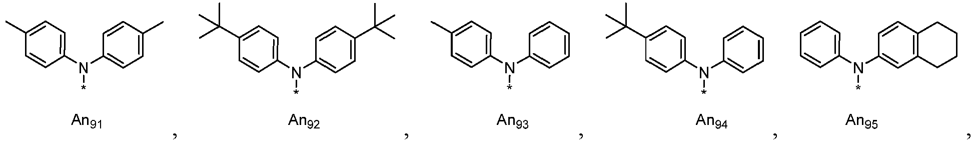

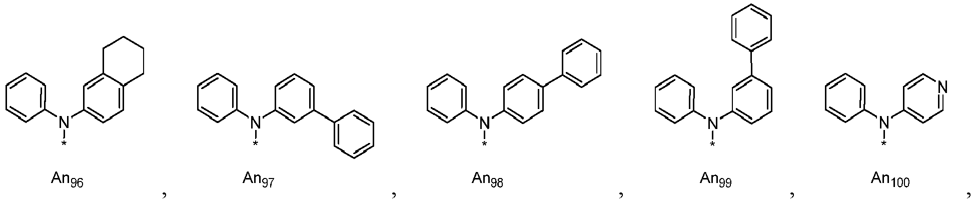

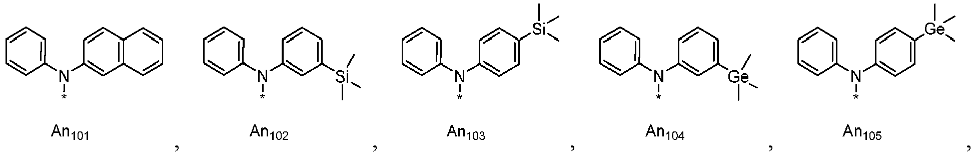

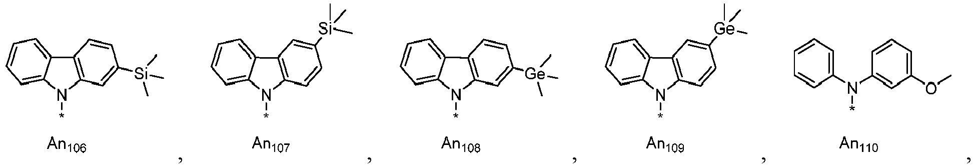

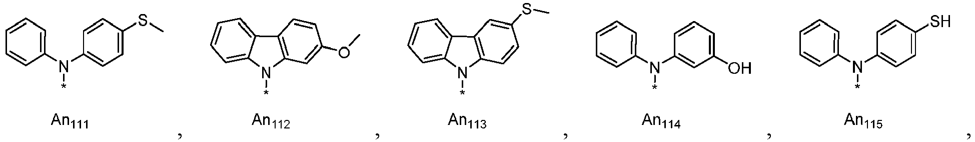

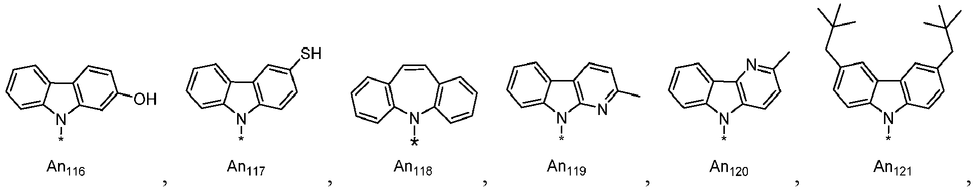

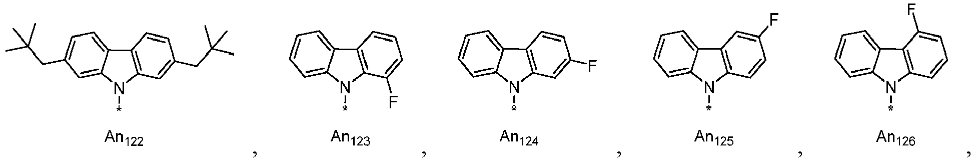

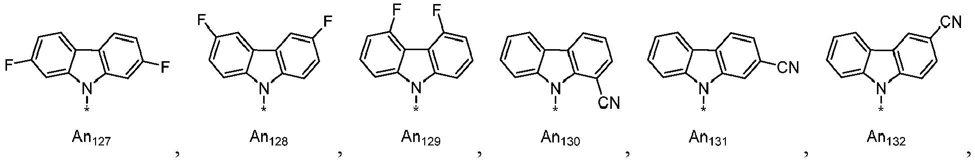

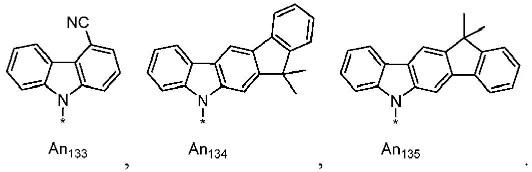

According to an embodiment of the present disclosure, hydrogens in An₁ to An₁₁₈ can be partially or fully substituted with deuterium.

According to an embodiment of the present disclosure, hydrogens in An₁ to An₁₃₅ can be partially or fully substituted with deuterium.

According to an embodiment of the present disclosure, R is, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted arylalkyl having 7 to 30 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted amino having 6 to 20 carbon atoms and combinations thereof.

According to an embodiment of the present disclosure, R is, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms and combinations thereof.

According to an embodiment of the present disclosure, at least one R is selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted arylalkyl having 7 to 30 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted amino having 6 to 20 carbon atoms and combinations thereof.

According to an embodiment of the present disclosure, at least one R is selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms and combinations thereof.

According to an embodiment of the present disclosure, at least one or at least two of R₁ to R₈ are selected from substituted or unsubstituted alkyl having 1 to 20 carbon atoms, substituted or unsubstituted cycloalkyl having 3 to 20 ring carbon atoms or a combination thereof, and the total number of carbon atoms in all of R₁ to R₄ and/or R₅ to R₈ is at least 4.

According to an embodiment of the present disclosure, at least one or at least two of R₁ to R₄ are selected from substituted or unsubstituted alkyl having 1 to 20 carbon atoms, substituted or unsubstituted cycloalkyl having 3 to 20 ring carbon atoms or a combination thereof, and the total number of carbon atoms in all of R₁ to R₄ is at least 4.

According to an embodiment of the present disclosure, at least one or at least two of R₅ to R₈ are selected from substituted or unsubstituted alkyl having 1 to 20 carbon atoms, substituted or unsubstituted cycloalkyl having 3 to 20 ring carbon atoms or a combination thereof, and the total number of carbon atoms in all of R₅ to R₈ is at least 4.

According to an embodiment of the present disclosure, at least one, at least two, at least three or all of R₂, R₃, R₆ and R₇ are selected from the group consisting of: deuterium, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms and combinations thereof.

According to an embodiment of the present disclosure, at least one, at least two, at least three or all of R₂, R₃, R₆ and R₇ are selected from the group consisting of: deuterium, substituted or unsubstituted alkyl having 1 to 20 carbon atoms, substituted or unsubstituted cycloalkyl having 3 to 20 ring carbon atoms and combinations thereof.

According to an embodiment of the present disclosure, at least one, at least two, at least three or all of R₂, R₃, R₆ and R₇ are selected from the group consisting of: methyl, ethyl, propyl, isopropyl, n-butyl, isobutyl, t-butyl, cyclopentyl, cyclohexyl, neopentyl, t-pentyl, any preceding group which is partially or fully deuterated and deuterium.

According to an embodiment of the present disclosure, Lₐ is, at each occurrence identically or differently, selected from the group consisting of Lₐ₁ to Lₐ₁₈₃₂, wherein the specific structures of Lₐ₁ to Lₐ₁₈₃₂ are referred to claim 11.

According to an embodiment of the present disclosure, hydrogen atoms in Lₐ₁ to Lₐ₁₈₃₂ can be partially or fully substituted with deuterium.

According to an embodiment of the present disclosure, L_{b} is, at each occurrence identically or differently, selected from the group consisting of L_{b1} to L_{b334}, wherein the specific structures of L_{b1} to L_{b334} are referred to claim 12.

According to an embodiment of the present disclosure, hydrogen atoms in L_{b1} to L_{b334} can be partially or fully substituted with deuterium.

According to an embodiment of the present disclosure, L_{c} is, at each occurrence identically or differently, selected from the group consisting of L_{c1} to L_{c360}, wherein the specific structures of L_{c1} to L_{c360} are referred to claim 12.

According to an embodiment of the present disclosure, the metal complex has a structure of Ir(Lₐ)₃, Ir(Lₐ)₂(L_{b}), IrLₐ(L_{b})₂, Ir(Lₐ)₂L_{c}, IrLₐ(L_{c})₂ or Ir(Lₐ)(L_{b})(L_{c}), wherein Lₐ is, at each occurrence identically or differently, selected from the group consisting of Lₐ₁ to Lₐ₁₈₃₂, L_{b} is, at each occurrence identically or differently, selected from the group consisting of L_{b1} to L_{b334}, and L_{c} is, at each occurrence identically or differently, selected from the group consisting of L_{c1} to L_{c360}, wherein the specific structures of Lₐ₁ to Lₐ₁₈₃₂ are referred to claim 11, the specific structures of L_{b1} to L_{b334} are referred to claim 12, and the specific structures of L_{c1} to L_{c360} are referred to claim 12.

According to an embodiment of the present disclosure, the metal complex is selected from the group consisting of Metal Complex 1 to Metal Complex 1576, wherein the specific structures of Metal Complex 1 to Metal Complex 1576 are referred to claim 13

According to an embodiment of the present disclosure, hydrogens in Metal Complex 1 to Metal Complex 1576 can be partially or fully substituted with deuterium.

According to an embodiment of the present disclosure, Lₐ is, at each occurrence identically or differently, selected from the group consisting of Lₐ₁ to Lₐ₁₈₉₁, wherein the specific structures of Lₐ₁ to Lₐ₁₈₉₁ are referred to claim 11.

According to an embodiment of the present disclosure, hydrogen atoms in Lₐ₁ to Lₐ₁₈₉₁ can be partially or fully substituted with deuterium.

According to an embodiment of the present disclosure, L_{b} is, at each occurrence identically or differently, selected from the group consisting of L_{b1} to L_{b341}, wherein the specific structures of L_{b1} to L_{b341} are referred to claim 12.

According to an embodiment of the present disclosure, hydrogen atoms in L_{b1} to L_{b341} can be partially or fully substituted with deuterium.

According to an embodiment of the present disclosure, L_{c} is, at each occurrence identically or differently, selected from the group consisting of L_{c1} to L_{c360}, wherein the specific structures of L_{c1} to L_{c360} are referred to claim 12.

According to an embodiment of the present disclosure, the metal complex has a structure of Ir(Lₐ)₃, Ir(Lₐ)₂(L_{b}), IrLₐ(L_{b})₂, Ir(Lₐ)₂L_{c}, IrLₐ(L_{c})₂ or Ir(Lₐ)(L_{b})(L_{c}), wherein Lₐ is, at each occurrence identically or differently, selected from the group consisting of Lₐ₁ to Lₐ₁₈₉₁, L_{b} is, at each occurrence identically or differently, selected from the group consisting of L_{b1} to L_{b341}, and L_{c} is, at each occurrence identically or differently, selected from the group consisting of L_{c1} to L_{c360}, wherein the specific structures of Lₐ₁ to Lₐ₁₈₉₁ are referred to claim 11, the specific structures of L_{b1} to L_{b341} are referred to claim 12, and the specific structures of L_{c1} to L_{c360} are referred to claim 12.

According to an embodiment of the present disclosure, the metal complex is selected from the group consisting of Metal Complex 1 to Metal Complex 1646, wherein the specific structures of Metal Complex 1 to Metal Complex 1646 are referred to claim 13.

According to an embodiment of the present disclosure, hydrogens in Metal Complex 1 to Metal Complex 1646 can be partially or fully substituted with deuterium.

According to an embodiment of the present disclosure, further disclosed is an electroluminescent device, which comprises an anode, a cathode and an organic layer disposed between the anode and the cathode, wherein at least one layer of the organic layer comprises the metal complex in any one of the preceding embodiments.

According to an embodiment of the present disclosure, the organic layer comprising the metal complex in the electroluminescent device is an emissive layer.

According to an embodiment of the present disclosure, the emissive layer in the electroluminescent device emits green light.

According to an embodiment of the present disclosure, the emissive layer of the electroluminescent device comprises a host compound, and the host compound comprises one or more compounds. When the host compound is a combination of multiple compounds, the host compound comprises at least one n-type host compound and at least one p-type host compound.

According to an embodiment of the present disclosure, the emissive layer of the electroluminescent device further comprises a first host compound.

According to an embodiment of the present disclosure, the emissive layer of the electroluminescent device further comprises a first host compound and a second host compound.

According to an embodiment of the present disclosure, the first host compound and/or the second host compound in the electroluminescent device comprises at least one chemical group selected from the group consisting of: benzene, pyridine, pyrimidine, triazine, carbazole, azacarbazole, indolocarbazole, dibenzothiophene, azadibenzothiophene, dibenzofuran, azadibenzofuran, dibenzoselenophene, triphenylene, azatriphenylene, fluorene, silafluorene, naphthalene, quinoline, isoquinoline, quinazoline, quinoxaline, phenanthrene, azaphenanthrene, and combinations thereof.

According to an embodiment of the present disclosure, the first host compound in the electroluminescent device has a structure represented by Formula X: 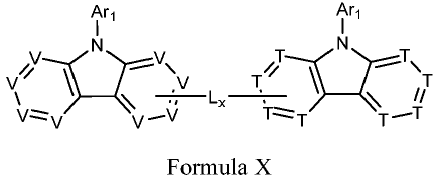 wherein,
Lₓ is, at each occurrence identically or differently, selected from a single bond, substituted or unsubstituted alkylene having 1 to 20 carbon atoms, substituted or unsubstituted cycloalkylene having 3 to 20 carbon atoms, substituted or unsubstituted arylene having 6 to 20 carbon atoms, substituted or unsubstituted heteroarylene having 3 to 20 carbon atoms or combinations thereof;
V is, at each occurrence identically or differently, selected from C, CRᵥ or N, and at least one of V is C and is attached to Lₓ;
T is, at each occurrence identically or differently, selected from C, CRₜ or N, and at least one of T is C and is attached to Lₓ;
Rᵥ and Rₜ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group, and combinations thereof;
Ar₁ is, at each occurrence identically or differently, selected from substituted or unsubstituted aryl having 6 to 30 carbon atoms, substituted or unsubstituted heteroaryl having 3 to 30 carbon atoms or combinations thereof;
adjacent substituents Rᵥ and Rₜ can be optionally joined to form a ring.

Herein, the expression that adjacent substituents Rᵥ and Rₜ can be optionally joined to form a ring is intended to mean that any one or more of groups of adjacent substituents, such as two substituents Rᵥ, two substituents Rₜ, and substituents Rᵥ and Rₜ, can be joined to form a ring. Obviously, it is possible that none of these substituents are joined to form a ring.

According to an embodiment of the present disclosure, the first host compound in the electroluminescent device has a structure represented by one of Formula X-a to Formula X-j: 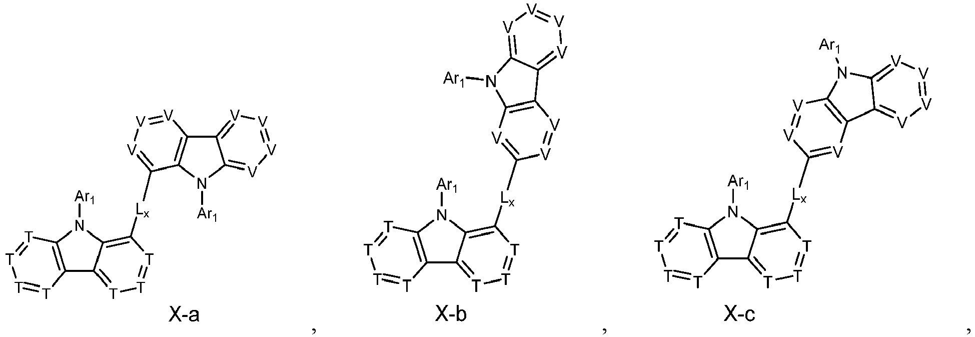 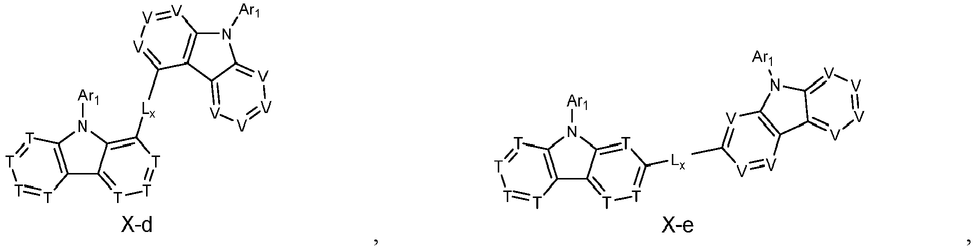 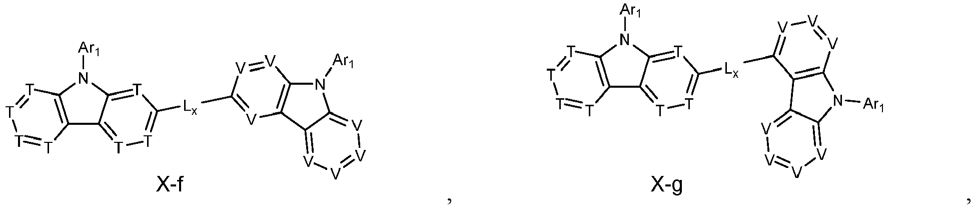 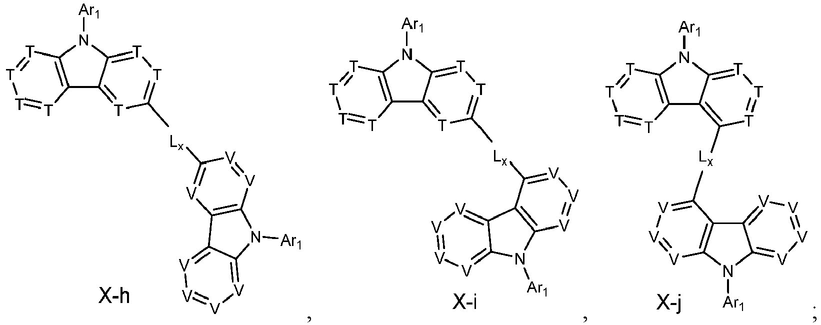 wherein,
Lₓ is, at each occurrence identically or differently, selected from a single bond, substituted or unsubstituted alkylene having 1 to 20 carbon atoms, substituted or unsubstituted cycloalkylene having 3 to 20 carbon atoms, substituted or unsubstituted arylene having 6 to 20 carbon atoms, substituted or unsubstituted heteroarylene having 3 to 20 carbon atoms or combinations thereof;
V is, at each occurrence identically or differently, selected from CRᵥ or N;
T is, at each occurrence identically or differently, selected from CRₜ or N;
Rᵥ and Rₜ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group, and combinations thereof;
Ar₁ is, at each occurrence identically or differently, selected from substituted or unsubstituted aryl having 6 to 30 carbon atoms, substituted or unsubstituted heteroaryl having 3 to 30 carbon atoms or combinations thereof;
adjacent substituents Rᵥ and Rₜ can be optionally joined to form a ring.

According to an embodiment of the present disclosure, wherein the second host compound has a structure represented by Formula 5: 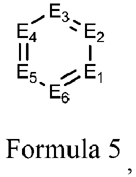 wherein
E₁ to E₆ are, at each occurrence identically or differently, selected from C, CRₑ or N, at least two of E₁ to E₆ are N, and at least one of E₁ to E₆ is C and is attached to Formula A: 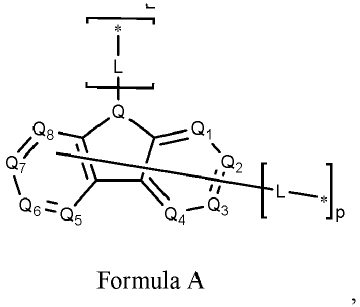 wherein,
Q is, at each occurrence identically or differently, selected from the group consisting of O, S, Se, N, NR_{Q}, CR_{Q}R_{Q}, SIR_{Q}R_{Q}, GER_{Q}R_{Q}, and R_{Q}C=CR_{Q}; when two R_{Q} are present, the two R_{Q} can be the same or different;
p is 0 or 1; r is 0 or 1;
when Q is selected from N, p is 0, and r is 1;
when Q is selected from the group consisting of O, S, Se, NR_{Q}, CR_{Q}R_{Q}, SIR_{Q}R_{Q}, GER_{Q}R_{Q}, and R_{Q}C=CR_{Q}, p is 1, and r is 0;
L is, at each occurrence identically or differently, selected from a single bond, substituted or unsubstituted alkylene having 1 to 20 carbon atoms, substituted or unsubstituted cycloalkylene having 3 to 20 carbon atoms, substituted or unsubstituted arylene having 6 to 20 carbon atoms, substituted or unsubstituted heteroarylene having 3 to 20 carbon atoms or combinations thereof;
Q₁ to Q₈ are, at each occurrence identically or differently, selected from C, CR_{q} or N;
Rₑ, R_{Q}, and R_{q} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, a substituted or unsubstituted alkylgermanyl having 3 to 20 carbon atoms, a substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group, and combinations thereof;
"^{∗}" represents a position where Formula A is attached to Formula 5;
adjacent substituents Rₑ, R_{Q}, R_{q} can be optionally joined to form a ring.

Herein, the expression that adjacent substituents Rₑ, R_{Q}, R_{q} can be optionally joined to form a ring is intended to mean that any one or more of groups of adjacent substituents, such as two substituents Rₑ, two substituents R_{Q}, two substituents R_{q}, and two substituents R_{Q} and R_{q}, can be joined to form a ring. Obviously, it is possible that none of these substituents are joined to form a ring.

According to an embodiment of the present disclosure, in the electroluminescent device, the metal complex is doped in the first host compound and the second host compound, and the weight of the metal complex accounts for 1% to 30% of the total weight of the emissive layer.

According to an embodiment of the present disclosure, in the electroluminescent device, the metal complex is doped in the first host compound and the second host compound, and the weight of the metal complex accounts for 3% to 13% of the total weight of the emissive layer.

According to an embodiment of the present disclosure, the organic electroluminescent device further comprises a hole injection layer. The hole injection layer may be a functional layer containing a single material or a functional layer containing multiple materials, wherein the contained multiple materials which are the most commonly used are hole transport materials doped with a certain proportion of p-type conductive doped material. Common p-type doped materials are as follows:

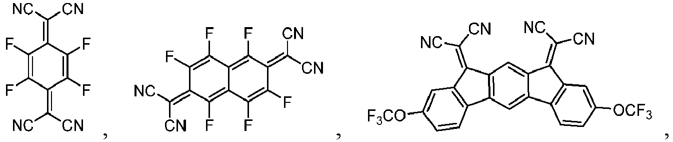

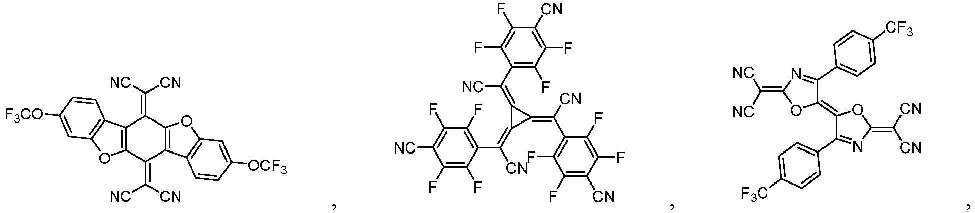

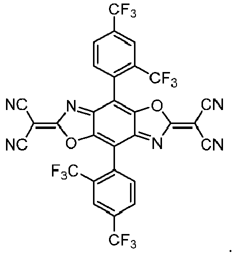

According to another embodiment of the present disclosure, further disclosed is a composition, which comprises a metal complex whose specific structure is as shown in any one of the preceding embodiments.

### Combination with Other Materials

The materials described in the present disclosure for a particular layer in an organic light-emitting device can be used in combination with various other materials present in the device. The combinations of these materials are described in more detail in U.S. Pat. App. No. 20160359122 at paragraphs 0132-0161, which is incorporated by reference herein in its entirety. The materials described or referred to the disclosure are non-limiting examples of materials that may be useful in combination with the compounds disclosed herein, and one of skill in the art can readily consult the literature to identify other materials that may be useful in combination.

The materials described herein as useful for a particular layer in an organic light-emitting device may be used in combination with a variety of other materials present in the device. For example, dopants disclosed herein may be used in combination with a wide variety of hosts, transport layers, blocking layers, injection layers, electrodes and other layers that may be present. The combination of these materials is described in detail in paragraphs 0080-0101 of U.S. Pat. App. No. 20150349273, which is incorporated by reference herein in its entirety. The materials described or referred to the disclosure are non-limiting examples of materials that may be useful in combination with the compounds disclosed herein, and one of skill in the art can readily consult the literature to identify other materials that may be useful in combination.

In the embodiments of material synthesis, all reactions were performed under nitrogen protection unless otherwise stated. All reaction solvents were anhydrous and used as received from commercial sources. Synthetic products were structurally confirmed and tested for properties using one or more conventional equipment in the art (including, but not limited to, nuclear magnetic resonance instrument produced by BRUKER, liquid chromatograph produced by SHIMADZU, liquid chromatograph-mass spectrometry produced by SHIMADZU, gas chromatograph-mass spectrometry produced by SHIMADZU, differential Scanning calorimeters produced by SHIMADZU, fluorescence spectrophotometer produced by SHANGHAI LENGGUANG TECH., electrochemical workstation produced by WUHAN CORRTEST, and sublimation apparatus produced by ANHUI BEQ, etc.) by methods well known to the persons skilled in the art. In the embodiments of the device, the characteristics of the device were also tested using conventional equipment in the art (including, but not limited to, evaporator produced by ANGSTROM ENGINEERING, optical testing system produced by SUZHOU FATAR, life testing system produced by SUZHOU FATAR, and ellipsometer produced by BEIJING ELLITOP, etc.) by methods well-known to the persons skilled in the art. As the persons skilled in the art are aware of the above-mentioned equipment use, test methods and other related contents, the inherent data of the sample can be obtained with certainty and without influence, so the above related contents are not further described in this patent.

### Material Synthesis Example

### Synthesis Example 1: Synthesis of Metal Complex 765

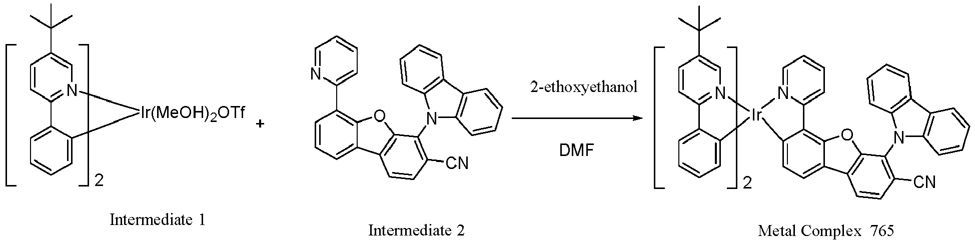

At room temperature and under nitrogen protection, Intermediate 1 (2.0 g, 2.2 mmol) and Intermediate 2 (1.2 g, 2.7 mmol) were added to a mixed solvent of 2-ethoxyethanol (30.0 mL) and DMF (30.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 765 as a yellow solid (1.0 g, 0.9 mmol, 40%). The product was confirmed as the target product with a molecular weight of 1047.3.

### Synthesis Example 2: Synthesis of Metal Complex 785

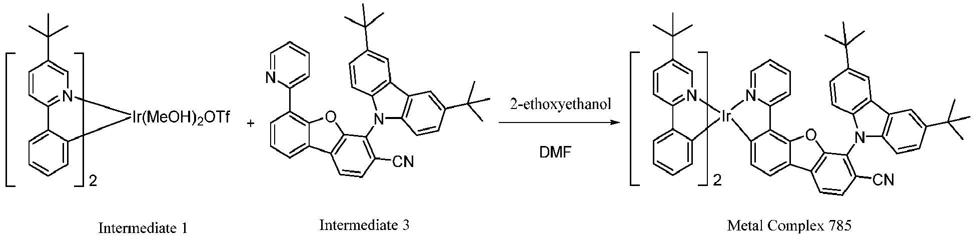

At room temperature and under nitrogen protection, Intermediate 1 (2.0 g, 2.2 mmol) and Intermediate 3 (1.3 g, 2.7 mmol) were added to a mixed solvent of 2-ethoxyethanol (20.0 mL) and DMF (20.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 785 as a yellow solid (1.0 g, 0.8 mmol, 36%). The product was confirmed as the target product with a molecular weight of 1159.5.

### Synthesis Example 3: Synthesis of Metal Complex 773

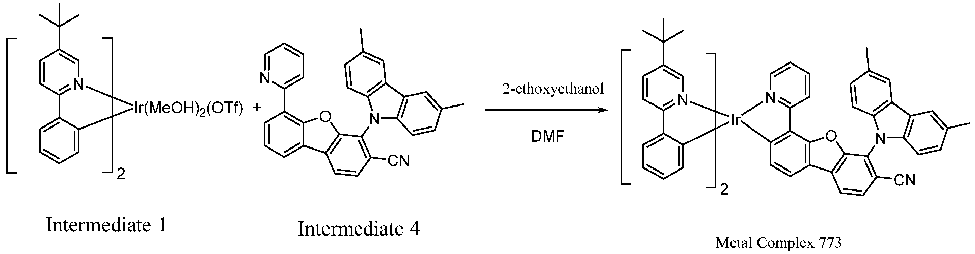

At room temperature and under nitrogen protection, Intermediate 1 (2.1 g, 2.5 mmol) and Intermediate 4 (1.3 g, 2.8 mmol) were added to a mixed solvent of 2-ethoxyethanol (20.0 mL) and DMF (20.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 773 as a yellow solid (0.5 g, 0.5 mmol, 20%). The product was confirmed as the target product with a molecular weight of 1075.4.

### Synthesis Example 4: Synthesis of Metal Complex 697

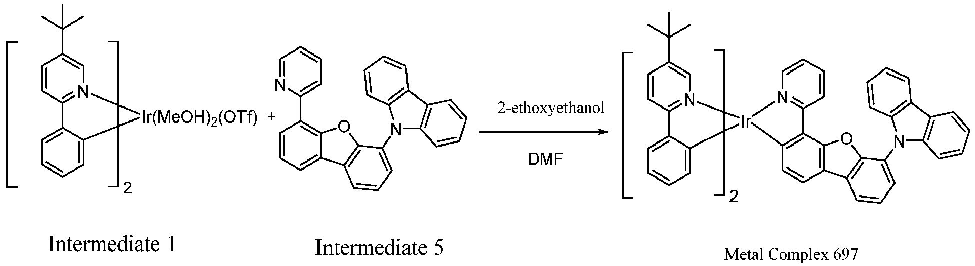

At room temperature and under nitrogen protection, Intermediate 1 (2.5 g, 3.0 mmol) and Intermediate 5 (1.6 g, 4.0 mmol) were added to a mixed solvent of 2-ethoxyethanol (30.0 mL) and DMF (30.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 697 as a yellow solid (1.0 g, 1.0 mmol, 33%). The product was confirmed as the target product with a molecular weight of 1022.3.

### Synthesis Example 5: Synthesis of Metal Complex 778

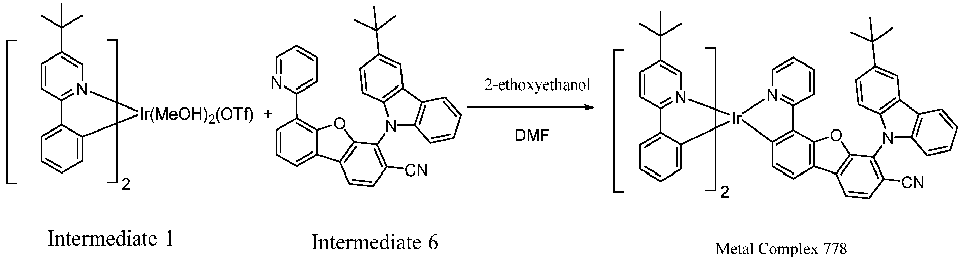

At room temperature and under nitrogen protection, Intermediate 1 (3.0 g, 3.7 mmol) and Intermediate 6 (2.8 g, 5.7 mmol) were added to a mixed solvent of 2-ethoxyethanol (30.0 mL) and DMF (30.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 778 as a yellow solid (1.5 g, 1.4 mmol, 38%). The product was confirmed as the target product with a molecular weight of 1103.4.

### Synthesis Example 6: Synthesis of Metal Complex 782

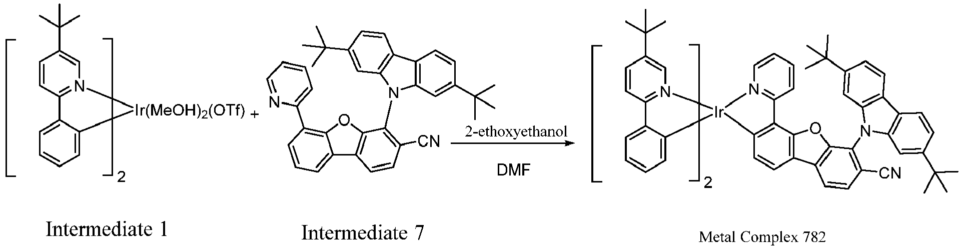

At room temperature and under nitrogen protection, Intermediate 1 (1.4 g, 1.7 mmol) and Intermediate 7 (1.1 g, 2.0 mmol) were added to a mixed solvent of 2-ethoxyethanol (20.0 mL) and DMF (20.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 782 as a yellow solid (0.5 g, 0.4 mmol, 24%). The product was confirmed as the target product with a molecular weight of 1159.5.

### Synthesis Example 7: Synthesis of Metal Complex 777

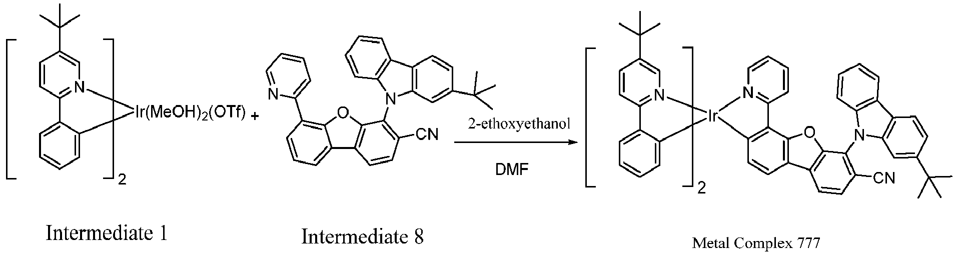

At room temperature and under nitrogen protection, Intermediate 1 (1.0 g, 1.2 mmol) and Intermediate 8 (0.7 g, 1.5 mmol) were added to a mixed solvent of 2-ethoxyethanol (20.0 mL) and DMF (20.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 777 as a yellow solid (0.3 g, 0.3 mmol, 25%). The product was confirmed as the target product with a molecular weight of 1103.4.

### Synthesis Example 8: Synthesis of Metal Complex 867

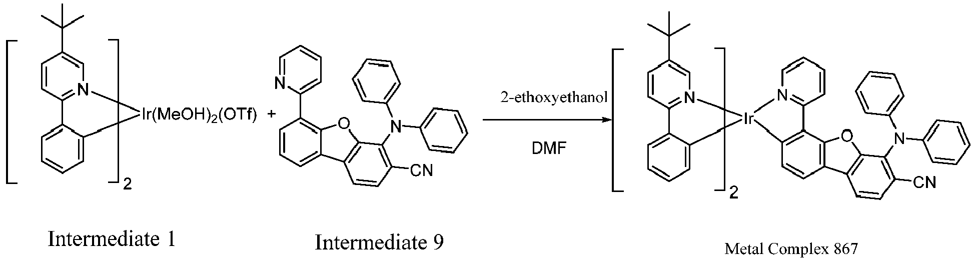

At room temperature and under nitrogen protection, Intermediate 1 (1.7 g, 2.1 mmol) and Intermediate 9 (1.2 g, 2.7 mmol) were added to a mixed solvent of 2-ethoxyethanol (30.0 mL) and DMF (30.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 867 as a yellow solid (1.0 g, 0.9 mmol, 43%). The product was confirmed as the target product with a molecular weight of 1049.4.

### Synthesis Example 9: Synthesis of Metal Complex 799

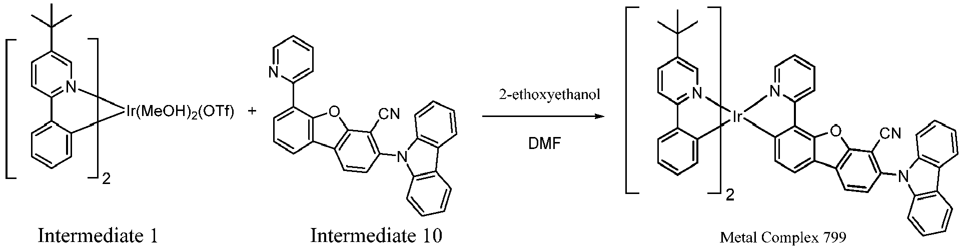

At room temperature and under nitrogen protection, Intermediate 1 (1.9 g, 2.3 mmol) and Intermediate 10 (1.5 g, 3.5 mmol) were added to a mixed solvent of 2-ethoxyethanol (20.0 mL) and DMF (20.0 mL) in sequence, heated to 100°C and reacted for 96 h. After the reaction was cooled, the reaction solution was concentrated under reduced pressure and purified through column chromatography (dichloromethane/petroleum ether=1/1) to obtain Metal Complex 799 as a yellow solid (1.55 g, 1.48 mmol, 64%). The product was confirmed as the target product with a molecular weight of 1047.3.

### Synthesis Example 10: Synthesis of Metal Complex 839

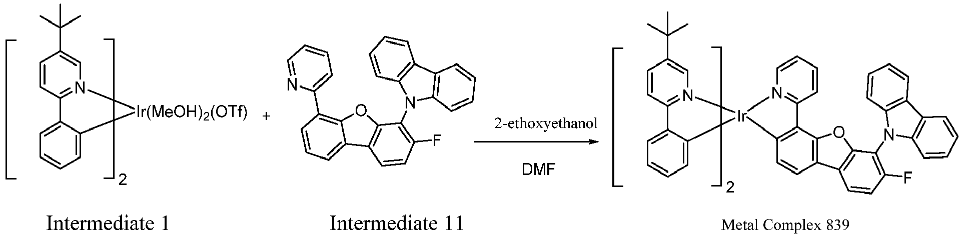

At room temperature and under nitrogen protection, Intermediate 1 (1.9 g, 2.3 mmol) and Intermediate 11 (1.3 g, 3.1 mmol) were added to a mixed solvent of 2-ethoxyethanol (20.0 mL) and DMF (20.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 839 as a yellow solid (1.3 g, 1.27 mmol, 55%). The product was confirmed as the target product with a molecular weight of 1040.3.

### Synthesis Example 11: Synthesis of Metal Complex 1577

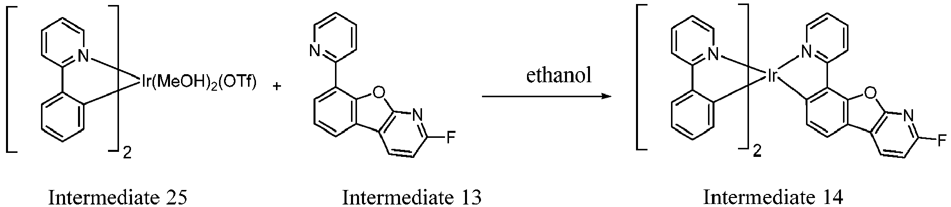

At room temperature and under nitrogen protection, Intermediate 25 (3.7 g, 5.1 mmol) and Intermediate 13 (2.0 g, 7.6 mmol) were added to ethanol (290 mL) in sequence, heated to 80°C and reacted for 24 h. After the reaction was cooled, the reaction solution was concentrated under reduced pressure and purified through column chromatography (dichloromethane/petroleum ether=1/1) to obtain Intermediate 14 (1.75 g, 2.3 mmol, 45%).

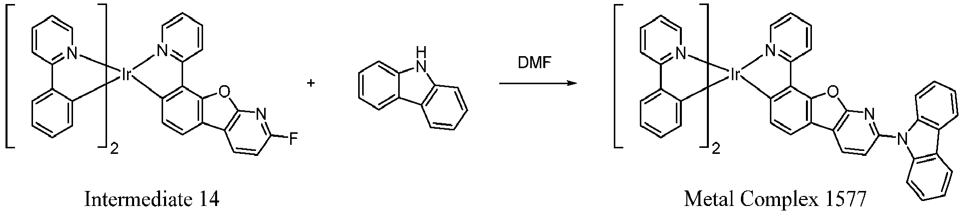

At room temperature and under nitrogen protection, Intermediate 14 (0.6 g, 0.7 mmol) and carbazole (0.33 g, 2.0 mmol) were added to a DMF solvent (30 mL) in sequence, heated to 100°C and reacted for 24 h. After the reaction was cooled, the reaction solution was concentrated under reduced pressure and purified through column chromatography (dichloromethane/petroleum ether=1/1) to obtain Metal Complex 1577 (0.45 g, 0.42 mmol, 60%). The product was confirmed as the target product with a molecular weight of 911.2.

### Synthesis Example 12: Synthesis of Metal Complex 789

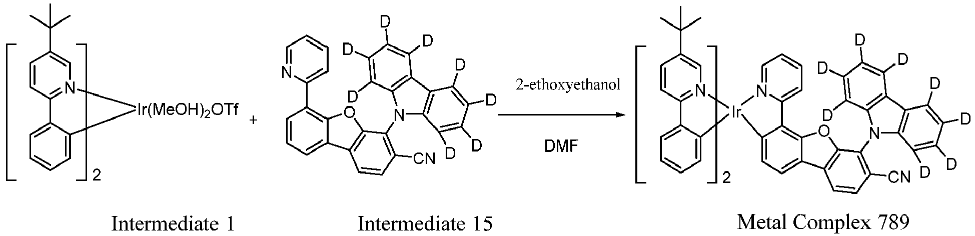

At room temperature and under nitrogen protection, Intermediate 1 (2.5 g, 3.0 mmol) and Intermediate 15 (1.6 g, 3.6 mmol) were added to a mixed solvent of 2-ethoxyethanol (30.0 mL) and DMF (30.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 789 (1.66 g, 1.6 mmol, 52%). The product was confirmed as the target product with a molecular weight of 1055.4.

### Synthesis Example 13: Synthesis of Metal Complex 725

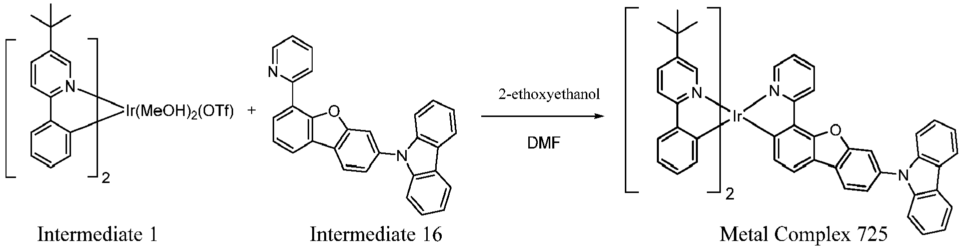

At room temperature and under nitrogen protection, Intermediate 1 (2.5 g, 3.0 mmol) and Intermediate 16 (1.7 g, 4.1 mmol) were added to a mixed solvent of 2-ethoxyethanol (50.0 mL) and DMF (50.0 mL) in sequence, heated to 100°C and reacted for 72 h. After the reaction was cooled, the reaction solution was concentrated under reduced pressure and purified through column chromatography (dichloromethane/petroleum ether=1/1) to obtain Metal Complex 725 as a yellow solid (0.9 g, 0.88 mmol, 29%). The product was confirmed as the target product with a molecular weight of 1022.4.

### Synthesis Example 14: Synthesis of Metal Complex 797

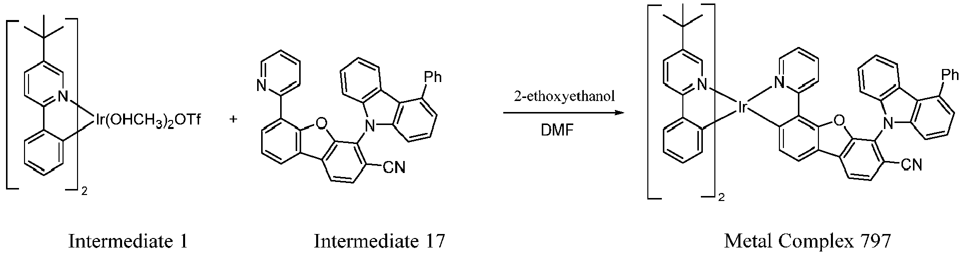

At room temperature and under nitrogen protection, Intermediate 1 (0.88 g, 1.1 mmol) and Intermediate 17 (0.6 g, 1.2 mmol) were added to a mixed solvent of 2-ethoxyethanol (20.0 mL) and DMF (20.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 797 as a yellow solid (0.36 g, 0.32 mmol, 29%). The product was confirmed as the target product with a molecular weight of 1123.4.

### Synthesis Example 15: Synthesis of Metal Complex 1584

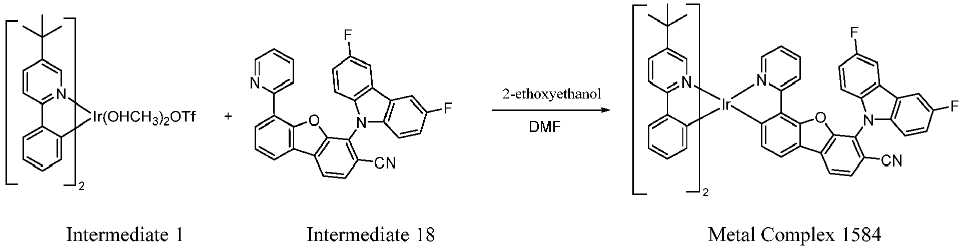

At room temperature and under nitrogen protection, Intermediate 1 (2.1 g, 2.5 mmol) and Intermediate 18 (1.3 g, 2.8 mmol) were added to a mixed solvent of 2-ethoxyethanol (30.0 mL) and DMF (30.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 1584 as a yellow solid (0.54 g, 0.50 mmol, 20%). The product was confirmed as the target product with a molecular weight of 1083.3.

### Synthesis Example 16: Synthesis of Metal Complex 1606

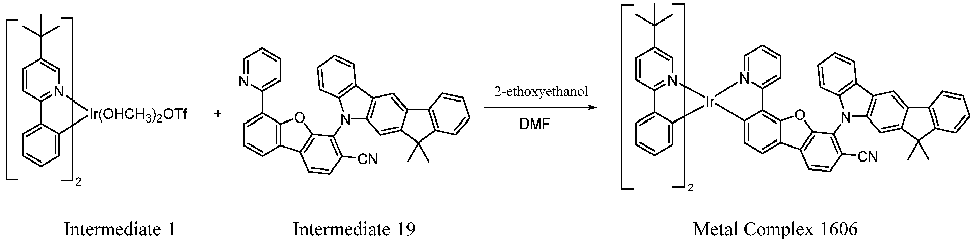

At room temperature and under nitrogen protection, Intermediate 1 (2.0 g, 2.5 mmol) and Intermediate 19 (1.8 g, 3.3 mmol) were added to a mixed solvent of 2-ethoxyethanol (30.0 mL) and DMF (30.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 1606 as a yellow solid (1.0 g, 0.85 mmol, 34%). The product was confirmed as the target product with a molecular weight of 1163.4.

### Synthesis Example 17: Synthesis of Metal Complex 1598

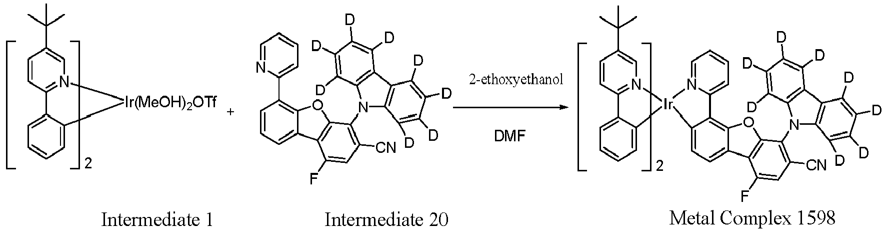

At room temperature and under nitrogen protection, Intermediate 1 (0.5 g, 0.6 mmol) and Intermediate 20 (0.3 g, 0.7 mmol) were added to a mixed solvent of 2-ethoxyethanol (20.0 mL) and DMF (20.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 1598 as a yellow solid (0.3 g, 0.28 mmol, 47%). The product was confirmed as the target product with a molecular weight of 1065.3.

### Synthesis Example 18: Synthesis of Metal Complex 959

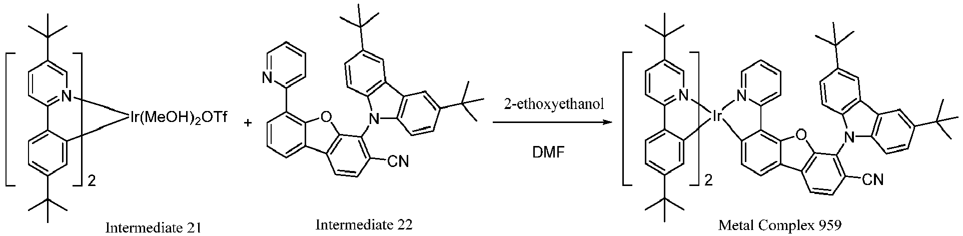

At room temperature and under nitrogen protection, Intermediate 21 (1.5 g, 1.61 mmol) and Intermediate 22 (1.05 g, 1.93 mmol) were added to a mixed solvent of 2-ethoxyethanol (20.0 mL) and DMF (20.0 mL) in sequence, heated to 100°C and reacted for 120 h. After the reaction was cooled, the reaction solution was concentrated under reduced pressure and purified through column chromatography (dichloromethane/petroleum ethet=1/1) to obtain Metal Complex 959 as a yellow solid (0.61 g, 0.54 mmol, 33%). The product was confirmed as the target product with a molecular weight of 1271.6.

### Synthesis Example 19: Synthesis of Metal Complex 1612

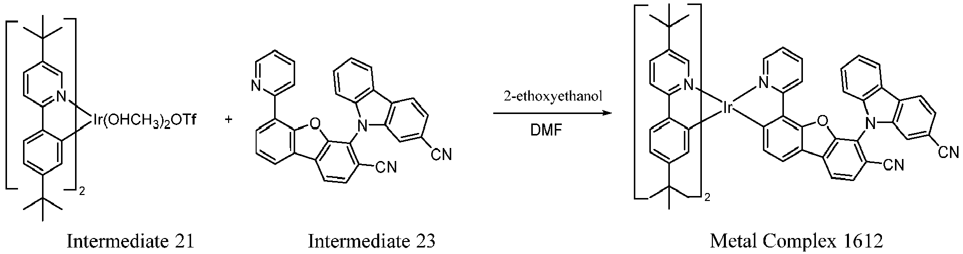

At room temperature and under nitrogen protection, Intermediate 21 (2.0 g, 2.2 mmol) and Intermediate 23 (1.3 g, 2.8 mmol) were added to a mixed solvent of 2-ethoxyethanol (30.0 mL) and DMF (30.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 1612 as a yellow solid (0.47 g, 0.45 mmol, 20%). The product was confirmed as the target product with a molecular weight of 1184.5.

### Synthesis Example 20: Synthesis of Metal Complex 1643

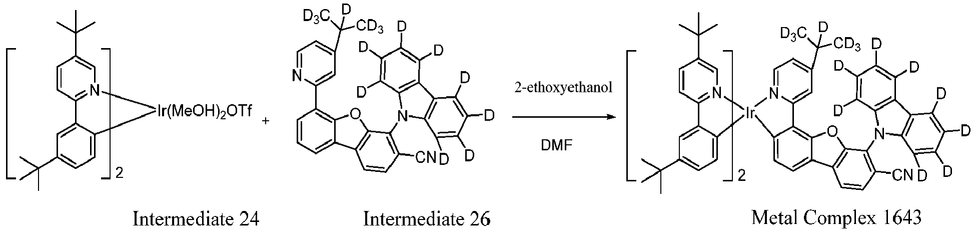

At room temperature and under nitrogen protection, Intermediate 24 (2.0 g, 2.2 mmol) and Intermediate 26 (1.3g, 2.6 mmol) were added to a mixed solvent of 2-ethoxyethanol (30.0 mL) and DMF (30.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 1643 as a yellow solid (0.75 g, 0.4 mmol, 28%). The product was confirmed as the target product with a molecular weight of 1216.6.

### Synthesis Example 21: Synthesis of Metal Complex 1645

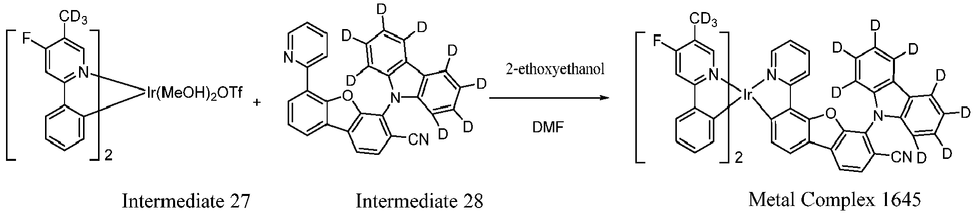

At room temperature and under nitrogen protection, Intermediate 27 (2.0 g, 2.5 mmol) and Intermediate 28 (1.6 g, 3.6 mmol) were added to a mixed solvent of 2-ethoxyethanol (30.0 mL) and DMF (30.0 mL) in sequence, heated to 100°C and reacted for 120 h. After the reaction was cooled, the reaction solution was concentrated under reduced pressure and purified through column chromatography (dichloromethane/petroleum ether=1/1) to obtain Metal Complex 1645 as a yellow solid (0.75 g, 0.4 mmol, 28%). The product was confirmed as the target product with a molecular weight of 1013.3.

### Device Example

### Device Example 1

First, a glass substrate having an indium tin oxide (ITO) anode with a thickness of 80 nm was cleaned and then treated with oxygen plasma and UV ozone. After the treatment, the substrate was dried in a glovebox to remove moisture. Then, the substrate was mounted on a substrate holder and placed in a vacuum chamber. Organic layers specified below were sequentially deposited through vacuum thermal evaporation on the ITO anode at a rate of 0.2 to 2 Angstroms per second and a vacuum degree of about 10⁻⁸ torr. Compound HI was used as a hole injection layer (HIL). Compound HT was used as a hole transporting layer (HTL). Compound H1 was used as an electron blocking layer (EBL). Metal Complex 697 of the present disclosure was doped in Compound H1 and Compound H2 as a dopant, and the resulting mixture was deposited for use as an emissive layer (EML). On the EML, Compound HB was used as a hole blocking layer (HBL). On the HBL, Compound ET and 8-hydroxyquinolinolato-lithium (Liq) were co-deposited for use as an electron transporting layer (ETL). Finally, 8-hydroxyquinolinolato-lithium (Liq) was deposited as an electron injection layer with a thickness of 1 nm and Al was deposited as a cathode with a thickness of 120 nm. The device was transferred back to the glovebox and encapsulated with a glass lid to complete the device.

### Device Comparative Example 1

The implementation mode in Device Comparative Example 1 was the same as that in Device Example 1, except that in the emissive layer (EML), Metal Complex 697 of the present disclosure was replaced with Compound GD1.

Detailed structures and thicknesses of layers of the devices are shown in the following table. A layer using more than one material is obtained by doping different compounds at their weight ratio as recorded.

**Table 1 Part of device structures in Example 1 and Comparative Example 1**

| Device ID | HIL | HTL | EBL | EML | HBL | ETL |
|---|---|---|---|---|---|---|
| Example 1 | Compound HI (100 Å) | Compound HT (350 Å) | Compound HI (50 Å) | Compound H1 :Compound H2:Metal Complex 697 (47:47:6) (400 Å) | Compound HB (50 Å) | Compound ET: Liq (40:60) (350 Å) |
| Comparative Example 1 | Compound HI (100 Å) | Compound HT (350 Å) | Compound HI (50 Å) | Compound H1 :Compound H2:Compound GD1 (47:47:6) (400 Å) | Compound HB (50 Å) | Compound ET: Liq (40:60) (350 Å) |

The structures of the materials used in the devices are shown as follows:

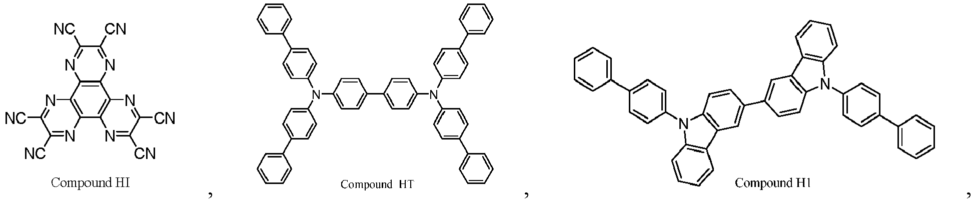

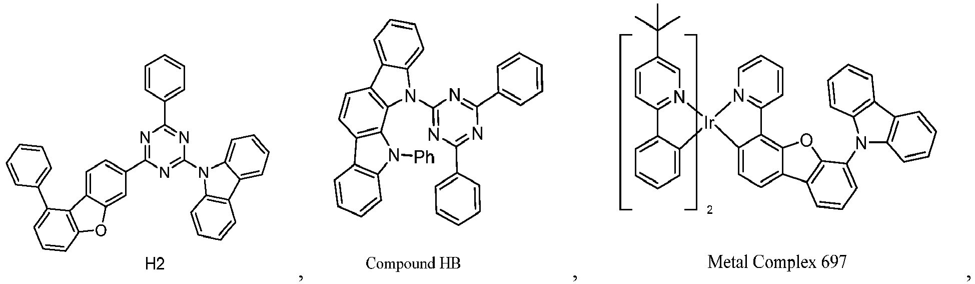

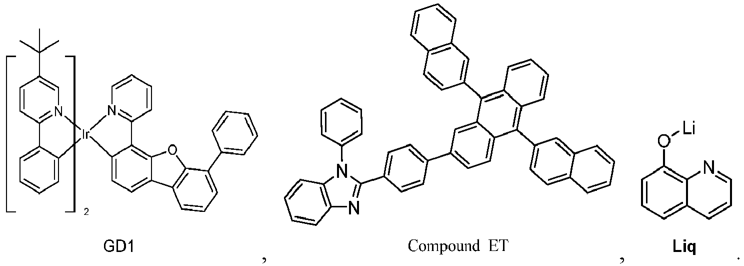

IVL characteristics of the devices were measured. Under a current density of 15 mA/cm², CIE data, maximum emission wavelength (λₘₐₓ), full width at half maximum (FWHM), device voltage (V), current efficiency (CE), power efficiency (PE) and external quantum efficiency (EQE) of the devices were measured. The data was recorded and shown in Table 2.

**Table 2 Device data in Example 1 and Comparative Example 1**

| Device ID | CIE (x, y) | λₘₐₓ (nm) | FWHM (nm) | Voltage (V) | CE (cd/A) | PE (lm/W) | EQE (%) |
|---|---|---|---|---|---|---|---|
| Example 1 | (0.343,0.627) | 526 | 60.4 | 3.91 | 90 | 72 | 23.62 |
| Comparative Example 1 | (0.354,0.621) | 531 | 59.5 | 4.17 | 83 | 62 | 21.54 |

As can be seen from the comparison between the data in Example 1 and the data in Comparative Example 1 in Table 2: Metal Complex 697 of the present disclosure differs from Compound GD1 of the comparative example only in that the carbazole substituent on the ligand Lₐ is replaced with phenyl. When Metal Complex 697 is applied to the same organic electroluminescent device as Compound GD1, the voltage is reduced by 0.26 V, the CE is improved by 8.4%, the PE is improved by 16.1% and the EQE is improved by 9.7%. It proves that a device with better performance can be obtained through the use of the metal complex provided by the present disclosure containing a ligand Lₐ having an Rₓ₁ substituent, which can comprehensively improve the device performance in various aspects and finally significantly improves overall device performance.

### Device Example 2

The implementation mode in Device Example 2 was the same as that in Device Example 1, except that in the emissive layer (EML), Metal Complex 697 of the present disclosure was replaced with Metal Complex 867.

### Device Comparative Example 2

The implementation mode in Device Comparative Example 2 was the same as that in Device Example 1, except that in the emissive layer (EML), Metal Complex 697 of the present disclosure was replaced with Compound GD2.

Detailed structures and thicknesses of layers of the devices are shown in Table 3. A layer using more than one material is obtained by doping different compounds at their weight ratio as recorded.

**Table 3 Part of device structures in Example 2 and Comparative Example 2**

| Device ID | HIL | HTL | EBL | EML | HBL | ETL |
|---|---|---|---|---|---|---|
| Example 2 | Compound HI (100 Å) | Compound HT (350 Å) | Compound HI (50 Å) | Compound H1 :Compound H2:Metal Complex 867 (47:47:6) (400 Å) | Compound HB (50 Å) | Compound ET: Liq (40:60) (350 Å) |
| Comparative Example 2 | Compound HI (100 Å) | Compound HT (350 Å) | Compound HI (50 Å) | Compound H1 :Compound H2:Compound GD2 (47:47:6) (400 Å) | Compound HB (50 Å) | Compound ET: Liq (40:60) (350 Å) |

The structures of the new materials used in the devices are shown as follows:

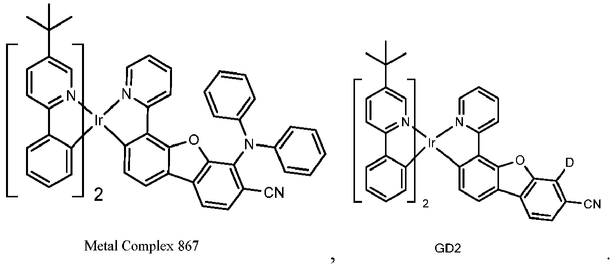

IVL characteristics of the devices were measured. Under a current density of 15 mA/cm², CIE data, maximum emission wavelength (λₘₐₓ), full width at half maximum (FWHM), device voltage (V), current efficiency (CE), power efficiency (PE) and external quantum efficiency (EQE) of the devices were measured. The data was recorded and shown in Table 4.

**Table 4 Device data in Example 2 and Comparative Example 2**

| Device ID | CIE (x, y) | λₘₐₓ (nm) | FWHM (nm) | Voltage (V) | CE (cd/A) | PE (lm/W) | EQE (%) |
|---|---|---|---|---|---|---|---|
| Example 2 | (0.344,0.631) | 529 | 51.2 | 3.62 | 96 | 83 | 24.68 |
| Comparative Example 2 | (0.342,0.633) | 530 | 44.1 | 3.82 | 90 | 75 | 22.82 |

As can be seen from the comparison between the data in Example 2 and the data in Comparative Example 2 in Table 4: Metal Complex 867 of the present disclosure differs from Compound GD2 of the comparative example only in that the diphenylamino substituent on the ligand Lₐ is replaced with deuterium. When Metal Complex 867 is applied to the same organic electroluminescent device as Compound GD2, the voltage is reduced by 0.2 V, the CE is improved by 6.7%, the PE is improved by 10.7% and the EQE is improved by 8.2%. It proves that a device with better performance can be obtained through the use of the metal complex provided by the present disclosure containing a ligand Lₐ having an Rₓ₁ substituent, which can comprehensively improve the device performance in various aspects and finally significantly improves overall device performance.

### Device Example 3

The implementation mode in Device Example 3 was the same as that in Device Example 1, except that in the emissive layer (EML), Metal Complex 697 of the present disclosure was replaced with Metal Complex 765.

### Device Example 4

The implementation mode in Device Example 4 was the same as that in Device Example 1, except that in the emissive layer (EML), Metal Complex 697 of the present disclosure was replaced with Metal Complex 785.

### Device Comparative Example 3

The implementation mode in Device Comparative Example 3 was the same as that in Device Example 1, except that in the emissive layer (EML), Metal Complex 697 of the present disclosure was replaced with Compound GD3.

Detailed structures and thicknesses of layers of the devices are shown in Table 5. A layer using more than one material is obtained by doping different compounds at their weight ratio as recorded.

**Table 5 Part of device structures in Examples 3 and 4 and Comparative Example 3**

| Device ID | HIL | HTL | EBL | EML | HBL | ETL |
|---|---|---|---|---|---|---|
| Example 3 | Compound HI (100 Å) | Compound HT (350 Å) | Compound HI (50 Å) | Compound H1 :Compound H2:Metal Complex 765 (47:47:6) (400 Å) | Compound HB (50 Å) | Compound ET: Liq (40:60) (350 Å) |
| Example 4 | Compound HI (100 Å) | Compound HT (350 Å) | Compound HI (50 Å) | Compound H1 :Compound H2:Metal Complex 785 (47:47:6) (400 Å) | Compound HB (50 Å) | Compound ET: Liq (40:60) (350 Å) |
| Comparative Example 3 | Compound HI (100 Å) | Compound HT (350 Å) | Compound HI (50 Å) | Compound H1 :Compound H2:Compound GD3 (47:47:6) (400 Å) | Compound HB (50 Å) | Compound ET: Liq (40:60) (350 Å) |

The structures of the materials used in the devices are shown as follows:

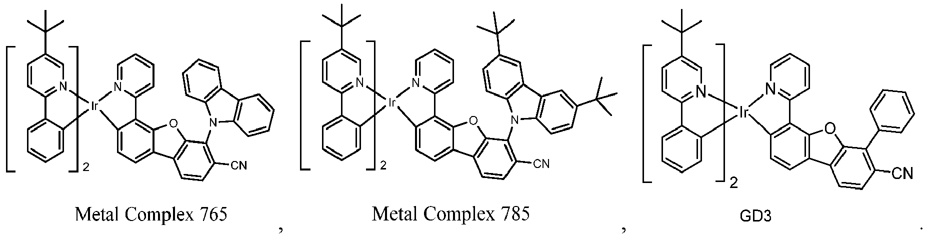

IVL characteristics of the devices were measured. Under a current density of 15 mA/cm², CIE data, maximum emission wavelength (λₘₐₓ), full width at half maximum (FWHM), device voltage (V), current efficiency (CE), power efficiency (PE) and external quantum efficiency (EQE) of the devices were measured. The data was recorded and shown in Table 6.

**Table 6 Device data in Examples 3 and 4 and Comparative Example 3**

| Device ID | CIE (x, y) | λₘₐₓ (nm) | FWHM (nm) | Voltage (V) | CE (cd/A) | PE (lm/W) | EQE (%) |
|---|---|---|---|---|---|---|---|
| Example 3 | (0.345,0.632) | 531 | 36.6 | 3.54 | 99 | 85 | 25.28 |
| Example 4 | (0.344, 0.632) | 531 | 37.5 | 3.48 | 104 | 94 | 26.48 |
| Comparative Example 3 | (0.348,0.630) | 531 | 38.0 | 3.83 | 94 | 77 | 23.89 |

As can be seen from the comparison between the data in Example 3, the data in Example 4 and the data in Comparative Example 3 in Table 6: on the basis that the ligand Lₐ comprises a cyano substituent, Metal Complex 765 or Metal Complex 785 of the present disclosure differs from Compound GD3 of the comparative example only in that the substituted or unsubstituted carbazole substituent on the ligand Lₐ is replaced with phenyl. When Metal Complexes 765 and 785 are applied to the same organic electroluminescent device as Compound GD3, the voltage is reduced by 0.29 V and 0.35 V, respectively, the CE is improved by 5.3% and 10.6%, respectively, the PE is improved by 10.4% and 22.1%, respectively, and the EQE is improved by 5.8% and 10.8%, respectively. Moreover, in Examples 3 and 4 compared to Comparative Example 3, the maximum emission wavelengths are not changed, and the full widths at half maximum are narrowed by 1.4 nm and 0.5 nm, respectively, indicating that more saturated green emission is obtained. The above proves that a device with better performance can be obtained through the use of the metal complex provided by the present disclosure containing a ligand Lₐ having an Rₓ₁ substituent, which can comprehensively improve the device performance in various aspects and finally significantly improves overall device performance.

To conclude, the device with better performance can be obtained through the metal complex provided by the present disclosure containing the ligand Lₐ having the Rₓ₁ substituent, such as a reduced device voltage and improved CE, PE and EQE. The metal complex can comprehensively improve the device performance in various aspects and finally significantly improves the overall device performance.

### Device Example 5

The implementation mode in Device Example 5 was the same as that in Device Example 1, except that in the emissive layer (EML), Metal Complex 697 of the present disclosure was replaced with Metal Complex 725.

### Device Comparative Example 4

The implementation mode in Device Comparative Example 4 was the same as that in Device Example 1, except that in the emissive layer (EML), Metal Complex 697 of the present disclosure was replaced with Compound GD4.

### Device Example 6

The implementation mode in Device Example 6 was the same as that in Device Example 1, except that in the emissive layer (EML), Metal Complex 697 of the present disclosure was replaced with Metal Complex 1577, and the ratio of Compound H1, Compound H2 and Metal Complex 1577 was 56:38:6.

### Device Comparative Example 5

The implementation mode in Device Comparative Example 5 was the same as that in Device Example 6, except that in the emissive layer (EML), Metal Complex 1577 of the present disclosure was replaced with Compound GD5.

Detailed structures and thicknesses of layers of the devices are shown in Table 7. A layer using more than one material is obtained by doping different compounds at their weight ratio as recorded.

**Table 7 Part of device structures in Examples 5 and 6 and Comparative Examples 4 and 5**

| Device ID | HIL | HTL | EBL | EML | HBL | ETL |
|---|---|---|---|---|---|---|
| Example 5 | Compound HI | Compound HT | Compound HI | Compound H1: Compound | Compound HB | Compound ET: Liq |
| | (100 Å) | (350 Å) | (50 Å) | H2:Metal Complex 725 (47:47:6) (400 Å) | (50 Å) | (40:60) (350 Å) |
| Comparative Example 4 | Compound HI (100 Å) | Compound HT (350 Å) | Compound HI (50 Å) | Compound H1: Compound H2: Compound GD4 (47:47:6) (400 Å) | Compound HB (50 Å) | Compound ET: Liq (40:60) (350 Å) |
| Example 6 | Compound HI (100 Å) | Compound HT (350 Å) | Compound HI (50 Å) | Compound H1: Compound H2:Metal Complex 1577 (56:38:6) (400 Å) | Compound HB (50 Å) | Compound ET: Liq (40:60) (350 Å) |
| Comparative Example 5 | Compound HI (100 Å) | Compound HT (350 Å) | Compound HI (50 Å) | Compound H1: Compound H2: Compound GD5 (56:38:6) (400 Å) | Compound HB (50 Å) | Compound ET: Liq (40:60) (350 Å) |

The structures of the new materials used in the devices are shown as follows:

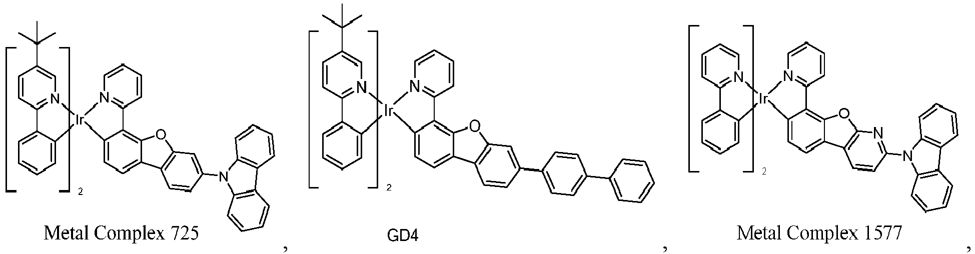

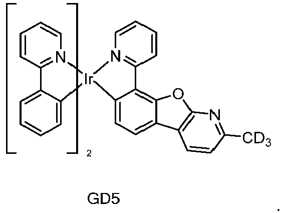

IVL characteristics of the devices were measured. Under a current density of 15 mA/cm², CIE data, maximum emission wavelength (λₘₐₓ), full width at half maximum (FWHM), device voltage (V), current efficiency (CE), power efficiency (PE) and external quantum efficiency (EQE) of the devices were measured. The data was recorded and shown in Table 8.

**Table 8 Device data in Examples 5 and 6 and Comparative Examples 4 and 5**

| Device ID | CIE (x, y) | λₘₐₓ (nm) | FWHM (nm) | Voltage (V) | CE (cd/A) | PE (lm/W) | EQE (%) |
|---|---|---|---|---|---|---|---|
| Example 5 | (0.360,0.618) | 532 | 58.6 | 4.09 | 82 | 63 | 21.26 |
| Comparative Example 4 | (0.371,0.611) | 536 | 50.2 | 4.39 | 80 | 57 | 20.52 |
| Example 6 | (0.338,0.634) | 528 | 52.3 | 4.11 | 87 | 67 | 22.59 |
| Comparative Example 5 | (0.330,0.635) | 525 | 57.0 | 4.26 | 77 | 57 | 20.20 |

As can be seen from the data in Table 8: compared Example 5 to Comparative Example 4, Metal Complex 725 of the present disclosure differs from Compound GD4 of the comparative example only in that the carbazole substituent on a ligand Lₐ is replaced with biphenyl. In Example 5, Metal Complex 725 is applied to the same organic electroluminescent device as Compound GD4. Compared to Comparative Example 4, Example 5 has a voltage reduced by 0.30 V, CE improved by 2.5%, PE improved by 10.5% and EQE improved by 3.6%.

Compared Example 6 to Comparative Example 5, Metal Complex 1577 of the present disclosure differs from Compound GD5 of the comparative example only in that the carbazole substituent on a ligand Lₐ is replaced with deuterated methyl. In Example 6, Metal Complex 1577 is applied to the same organic electroluminescent device as Compound GD5. Compared to Comparative Example 5, Example 6 has a voltage reduced by 0.15 V, CE improved by 13.0%, PE improved by 17.5% and EQE improved by 11.8%.

It proves that a device with better performance can be obtained through the use of the metal complex provided by the present disclosure containing a ligand Lₐ having an Rₓ₁ substituent, which can comprehensively improve the device performance in various aspects and finally significantly improves overall device performance.

### Device Example 7

The implementation mode in Device Example 7 was the same as that in Device Example 1, except that in the emissive layer (EML), Metal Complex 697 of the present disclosure was replaced with Metal Complex 789.

### Device Example 8

The implementation mode in Device Example 8 was the same as that in Device Example 1, except that in the emissive layer (EML), Metal Complex 697 of the present disclosure was replaced with Metal Complex 1584.

### Device Example 9

The implementation mode in Device Example 9 was the same as that in Device Example 1, except that in the emissive layer (EML), Metal Complex 697 of the present disclosure was replaced with Metal Complex 797.

### Device Example 10

The implementation mode in Device Example 10 was the same as that in Device Example 1, except that in the emissive layer (EML), Metal Complex 697 of the present disclosure was replaced with Metal Complex 1606.

### Device Example 11

The implementation mode in Device Example 11 was the same as that in Device Example 1, except that in the emissive layer (EML), Metal Complex 697 of the present disclosure was replaced with Metal Complex 959.

### Device Example 12

The implementation mode in Device Example 12 was the same as that in Device Example 1, except that in the emissive layer (EML), Metal Complex 697 of the present disclosure was replaced with Metal Complex 1643, and the ratio of Compound H1, Compound H2 and Metal Complex 1643 was 71:23:6.

Detailed structures and thicknesses of layers of the devices are shown in Table 9. A layer using more than one material is obtained by doping different compounds at their weight ratio as recorded.

**Table 9 Part of device structures in Examples 7 to 12**

| Device ID | HIL | HTL | EBL | EML | HBL | ETL |
|---|---|---|---|---|---|---|
| Example 7 | Compound HI (100 Å) | Compound HT (350 Å) | Compound HI (50 Å) | Compound H1:Compound H2:Metal Complex 789 (47:47:6) (400 Å) | Compound HB (50 Å) | Compound ET: Liq (40:60) (350 Å) |
| Example 8 | Compound HI (100 Å) | Compound HT (350 Å) | Compound HI (50 Å) | Compound H1:Compound H2:Metal Complex 1584 (47:47:6) (400 Å) | Compound HB (50 Å) | Compound ET: Liq (40:60) (350 Å) |
| Example 9 | Compound HI (100 Å) | Compound HT (350 Å) | Compound HI (50 Å) | Compound H1:Compound H2:Metal Complex 797 (47:47:6) (400 Å) | Compound HB (50 Å) | Compound ET: Liq (40:60) (350 Å) |
| Example 10 | Compound HI (100 Å) | Compound HT (350 Å) | Compound HI (50 Å) | Compound H1:Compound H2:Metal Complex 1606 (47:47:6) (400 Å) | Compound HB (50 Å) | Compound ET: Liq (40:60) (350 Å) |
| Example 11 | Compound HI (100 Å) | Compound HT (350 Å) | Compound HI (50 Å) | Compound H1:Compound H2:Metal Complex 959 (47:47:6) (400 Å) | Compound HB (50 Å) | Compound ET: Liq (40:60) (350 Å) |
| Example 12 | Compound HI (100 Å) | Compound HT (350 Å) | Compound HI (50 Å) | Compound H1:Compound H2:Metal Complex 1643 (71:23:6) (400 Å) | Compound HB (50 Å) | Compound ET: Liq (40:60) (350 Å) |

The structures of the new materials used in the devices are shown as follows:

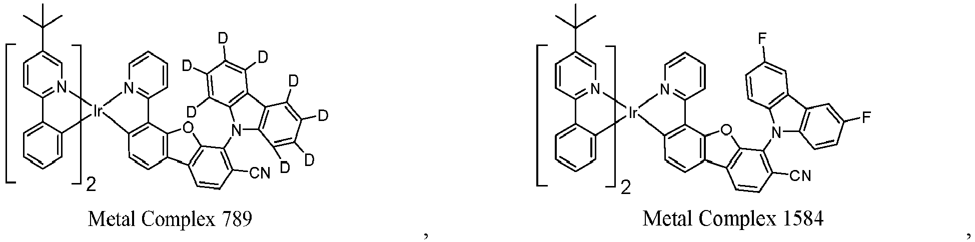

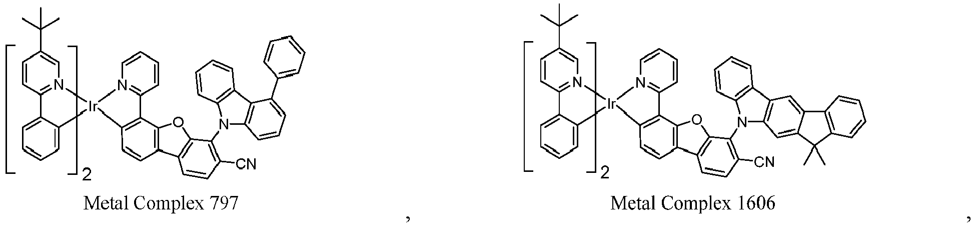

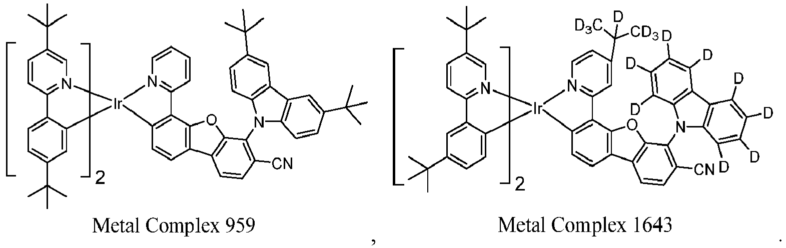

IVL characteristics of the devices were measured. Under a current density of 15 mA/cm², CIE data, maximum emission wavelength (λₘₐₓ), full width at half maximum (FWHM), device voltage (V), current efficiency (CE), power efficiency (PE) and external quantum efficiency (EQE) of the devices were measured. The data was recorded and shown in Table 10.

**Table 10 Device data in Examples 7 and 12 and Comparative Example 3**

| Device ID | CIE (x, y) | λₘₐₓ (nm) | FWHM (nm) | Voltage (V) | CE (cd/A) | PE (lm/W) | EQE (%) |
|---|---|---|---|---|---|---|---|
| Example 7 | (0.346,0.631) | 531 | 37.5 | 3.43 | 98 | 89 | 24.78 |
| Example 8 | (0.351,0.628) | 534 | 35.9 | 3.37 | 101 | 94 | 25.44 |
| Example 9 | (0.346,0.631) | 532 | 37.0 | 3.57 | 98 | 86 | 25.09 |
| Example 10 | (0.345,0.631) | 532 | 35.7 | 3.54 | 97 | 86 | 24.81 |
| Example 11 | (0.362,0.620) | 535 | 38.7 | 3.64 | 104 | 90 | 26.55 |
| Example 12 | (0.343,0.634) | 532 | 35.2 | 3.76 | 99 | 82 | 25.01 |
| Comparative Example 3 | (0.348,0.630) | 531 | 38.0 | 3.83 | 94 | 77 | 23.89 |

As can be seen from the data in Table 10: comparing Examples 7 to 10 to Comparative Example 3, on the basis that a ligand Lₐ has a cyano substituent, Metal Complexes 789, 1584, 797 and 1606 of the present disclosure differ from Compound GD3 of the comparative example only in that different the substituted carbazole substituents on the ligands Lₐ are replaced with phenyl. When Metal Complexes 789, 1584, 797 or 1606 is applied to the same organic electroluminescent device as Compound GD3, the full width at half maximum is narrowed by 0.5 nm, 2.1 nm, 1.0 nm and 2.3 nm, respectively, the voltage is reduced by 0.4 V, 0.46 V, 0.26 V and 0.29 V, respectively, the CE is improved by 4.3%, 7.4%, 4.3% and 3.2%, respectively, the PE is improved by 15.6%, 22.1%, 11.7% and 11.7%, respectively, and the EQE is improved by 3.7%, 6.5%, 5.0% and 3.9%, respectively. It proves that a device with better performance can be obtained through the use of the metal complex provided by the present disclosure containing a ligand Lₐ having an Rₓ₁ substituent, which can comprehensively improve the device performance in various aspects and finally significantly improves overall device performance.As can be seen from the data in Examples 11 and 12: in the case where Metal Complexes 959 and 1643 of the present disclosure each comprise the ligand Lₐ having the Rₓ₁ substituent, Metal Complexes 959 and 1643 of the present disclosure have different substituents on the ligands Lₐ and ligands L_{b}, respectively. As can be seen from the device results, Examples 11 and 12 each have EQE of above 25% and CE of about 100 cd/A, among which the EQE in Example 11 even reaches 26.55%. Moreover, the PE and voltages in Examples 11 and 12 are also at a relatively high level, exhibiting very good overall device performance.

The above indicates that the device with better performance can be obtained through the use of the metal complex provided by the present disclosure containing the ligand Lₐ having the Rₓ₁ substituent, which can comprehensively improve the device performance in various aspects and finally significantly improves the overall device performance.

### Device Example 13

The implementation mode in Device Example 13 was the same as that in Device Example 1, except that in the emissive layer (EML), Metal Complex 697 of the present disclosure was replaced with Metal Complex 799.

### Device Comparative Example 6

The implementation mode in Device Comparative Example 6 was the same as that in Device Example 1, except that in the emissive layer (EML), Metal Complex 697 of the present disclosure was replaced with Compound GD6.

Detailed structures and thicknesses of layers of the devices are shown in Table 11. A layer using more than one material is obtained by doping different compounds at their weight ratio as recorded.

**Table 11 Part of device structures in Example 13 and Comparative Example 6**

| Device ID | HIL | HTL | EBL | EML | HBL | ETL |
|---|---|---|---|---|---|---|
| Example 13 | Compound HI (100 Å) | Compound HT (350 Å) | Compound HI (50 Å) | Compound H1 :Compound H2:Metal Complex 799 (47:47:6) (400 Å) | Compound HB (50 Å) | Compound ET: Liq (40:60) (350 Å) |
| Comparative Example 6 | Compound HI (100 Å) | Compound HT (350 Å) | Compound HI (50 Å) | Compound H1 :Compound H2:Compound GD6 (47:47:6) (400 Å) | Compound HB (50 Å) | Compound ET: Liq (40:60) (350 Å) |

The structures of the new materials used in the devices are shown as follows:

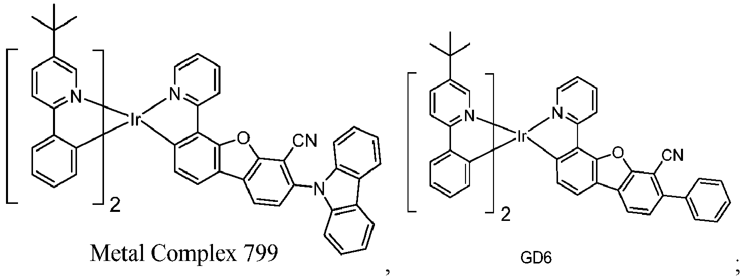

IVL characteristics of the devices were measured. Under a current density of 15 mA/cm², CIE data, maximum emission wavelength (λₘₐₓ), full width at half maximum (FWHM), device voltage (V), current efficiency (CE), power efficiency (PE) and external quantum efficiency (EQE) of the devices were measured. The data was recorded and shown in Table 12.

**Table 12 Device data in Example 13 and Comparative Example 6**

| Device ID | CIE (x, y) | λₘₐₓ (nm) | FWHM (nm) | Voltage (V) | CE (cd/A) | PE (lm/W) | EQE (%) |
|---|---|---|---|---|---|---|---|
| Example 13 | (0.348,0.629) | 531 | 43.5 | 3.55 | 91 | 81 | 23.39 |
| Comparative Example 6 | (0.352,0.627) | 534 | 45.5 | 3.66 | 86 | 74 | 21.97 |

As can be seen from the comparison between Example 13 and Comparative Example 6: Metal Complex 799 of the present disclosure differs from Compound GD6 of the comparative example only in that the carbazole substituent on the ligand Lₐ is replaced with phenyl. When Metal Complex 799 is applied to the same organic electroluminescent device as Compound GD6, Example 13 has a full width at half maximum narrowed by 2.0 nm, a voltage reduced by 0.11 V, CE improved by 5.8%, PE improved by 9.5% and EQE improved by 6.5%.

The above indicates that a device with better performance can be obtained through the use of the metal complex provided by the present disclosure containing a ligand Lₐ having an Rₓ₁ substituent, which can comprehensively improve the device performance in various aspects and finally significantly improves overall device performance.

### Device Example 14

The implementation mode in Device Example 14 was the same as that in Device Example 1, except that in the emissive layer (EML), Metal Complex 697 of the present disclosure was replaced with Metal Complex 839, and the ratio of Compound H1, Compound H2 and Metal Complex 839 was 71:23:6.

### Device Comparative Example 7

The implementation mode in Device Comparative Example 7 was the same as that in Device Example 14, except that in the emissive layer (EML), Metal Complex 839 of the present disclosure was replaced with Compound GD7.

Detailed structures and thicknesses of layers of the devices are shown in Table 13. A layer using more than one material is obtained by doping different compounds at their weight ratio as recorded.

**Table 13 Part of device structures in Example 14 and Comparative Example 7**

| Device ID | HIL | HTL | EBL | EML | HBL | ETL |
|---|---|---|---|---|---|---|
| Example 14 | Compound HI (100 Å) | Compound HT (350 Å) | Compound HI (50 Å) | Compound H1 :Compound H2:Metal Complex 839 (71:23:6) (400 Å) | Compound HB (50 Å) | Compound ET: Liq (40:60) (350 Å) |
| Comparative Example 7 | Compound HI (100 Å) | Compound HT (350 Å) | Compound HI (50 Å) | Compound H1 :Compound H2: Compound GD7 (71:23:6) (400 Å) | Compound HB (50 Å) | Compound ET: Liq (40:60) (350 Å) |

The structures of the new materials used in the devices are shown as follows:

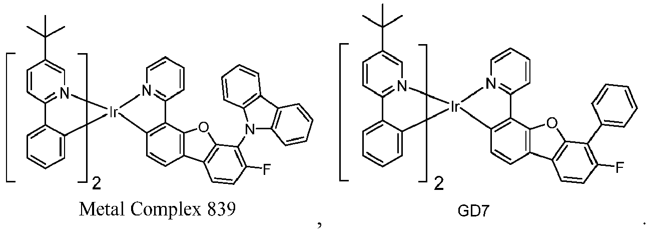

IVL characteristics of the devices were measured. Under a current density of 15 mA/cm², CIE data, maximum emission wavelength (λₘₐₓ), full width at half maximum (FWHM), device voltage (V), current efficiency (CE), power efficiency (PE) and external quantum efficiency (EQE) of the devices were measured. The data was recorded and shown in Table 14.

**Table 14 Device data in Example 14 and Comparative Example 7**

| Device ID | CIE (x, y) | λₘₐₓ (nm) | FWHM (nm) | Voltage (V) | CE (cd/A) | PE (lm/W) | EQE (%) |
|---|---|---|---|---|---|---|---|
| Example 14 | (0.339,0.630) | 526 | 59.2 | 3.85 | 90 | 74 | 23.65 |
| Comparative Example 7 | (0.347,0.627) | 530 | 57.8 | 4.51 | 86 | 60 | 22.42 |

As can be seen from the device data in Table 14: comparing Example 14 to Comparative Example 7, on the basis that the ligand Lₐ has a fluorine substituent, Metal Complex 839 of the present disclosure differs from Compound GD7 of the comparative example only in that the carbazole substituent on the ligand Lₐ is replaced with phenyl. When Metal Complex 839 is applied to the same organic electroluminescent device as Compound GD7, the voltage is reduced by 0.66 V, the CE is improved by 4.6%, the PE is improved by 23.3% and the EQE is improved by 5.5%. The above proves that a device with better performance can be obtained through the use of the metal complex provided by the present disclosure containing a ligand Lₐ having an Rₓ₁ substituent, which can comprehensively improve the device performance in various aspects and finally significantly improves overall device performance.

To conclude, the device with better performance can be obtained through the metal complex provided by the present disclosure containing the ligand Lₐ having the Rₓ₁ substituent, such as a reduced device voltage and improved CE, PE and EQE. The metal complex can comprehensively improve the device performance in various aspects and finally significantly improves the overall device performance.

It is to be understood that various embodiments described herein are merely examples and not intended to limit the scope of the present disclosure. Therefore, it is apparent to the persons skilled in the art that the present disclosure as claimed may include variations of specific embodiments and preferred embodiments described herein. Many of materials and structures described herein may be substituted with other materials and structures without departing from the spirit of the present disclosure. It is to be understood that various theories as to why the present disclosure works are not intended to be limitative.

## Claims

1. A metal complex, comprising a metal M and a ligand Lₐ coordinated to the metal M, wherein Lₐ has a structure represented by Formula 1: 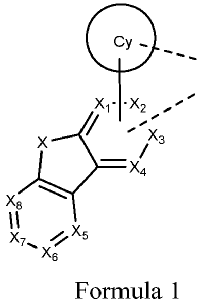 wherein in Formula 1,
the metal M is selected from a metal with a relative atomic mass greater than 40;
the ring Cy is, at each occurrence identically or differently, selected from a substituted or unsubstituted aromatic ring having 6 to 24 ring atoms, a substituted or unsubstituted heteroaromatic ring having 5 to 24 ring atoms or a combination thereof; and the ring Cy comprises at least three carbon atoms;
Cy is joined to the metal M by a metal-carbon bond or a metal-nitrogen bond;
X is, at each occurrence identically or differently, selected from the group consisting of O, S, Se, NR', SiR'R' and GeR'R'; when two R' are present at the same time, the two R' are the same or different;
X₁ to X₈ are, at each occurrence identically or differently, selected from C, CRₓ, CRₓ₁ or N, and at least one of X₁ to X₄ is C and joined to the ring Cy;
X₁, X₂, X₃ or X₄ is joined to the metal M by a metal-carbon bond or a metal-nitrogen bond;
at least one of X₁ to X₈ is selected from CRₓ₁, and Rₓ₁ has a structure represented by Formula 2: 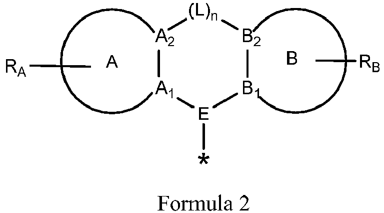 wherein in Formula 2,
R_{A} and R_{B} represent, at each occurrence identically or differently, mono-substitution, multiple substitutions or non-substitution;
the ring A and the ring B are identically or differently selected from a carbocyclic ring having 3 to 30 ring atoms, a heterocyclic ring having 3 to 30 ring atoms or a combination thereof;
n is 0 or 1;
A₁, A₂, B₁, B₂ and E are, at each occurrence identically or differently, selected from C, N, B, P, CR‴, SiR‴ or GeR‴;
L is selected from a single bond, O, S, SO₂, Se, NR", CR"R", SiR"R", GeR"R", BR", PR", P(O)R", R"C=CR", heteroalkylene having 1 to 20 carbon atoms, cycloalkylene having 3 to 20 carbon atoms, heterocyclylene having 3 to 20 ring atoms, arylene having 6 to 30 carbon atoms, heteroarylene having 3 to 30 carbon atoms and combinations thereof;
R', R", R‴, Rₓ, R_{A} and R_{B} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
" * " represents a position where Formula 2 is joined;
adjacent R', Rₓ can be optionally joined to form a ring; and
adjacent R", R‴, R_{A}, R_{B} can be optionally joined to form a ring.

2. The metal complex according to claim 1, wherein the ring Cy is, at each occurrence identically or differently, selected from any structure of the group consisting of the following: 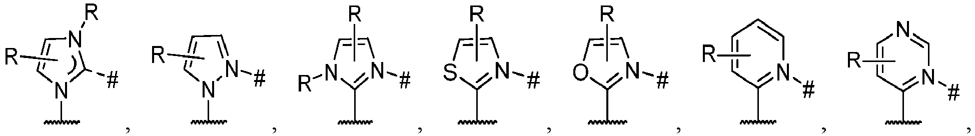 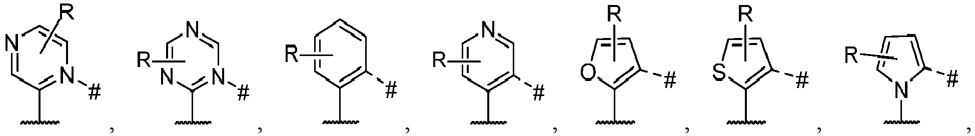 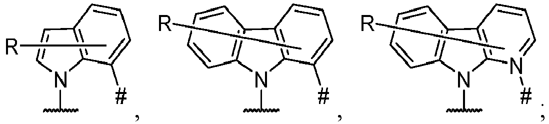 wherein,
R represents, at each occurrence identically or differently, mono-substitution, multiple substitutions or non-substitution; when multiple R are present at the same time in any structure, the multiple R are the same or different;
R is, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent substituents R can be optionally joined to form a ring; and
"#" represents a position where the ring Cy is joined to the metal M, and " 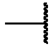 " represents a position where the ring Cy is joined to X₁, X₂, X₃ or X₄.

3. The metal complex according to claim 1, wherein the metal complex has a general formula of M(Lₐ)ₘ(L_{b})ₙ(L_{c})_{q};
wherein M is, at each occurrence identically or differently, selected from the group consisting of Cu, Ag, Au, Ru, Rh, Pd, Os, Ir and Pt; preferably, M is, at each occurrence identically or differently, selected from Pt or Ir;
Lₐ, L_{b} and L_{c} are a first ligand, a second ligand and a third ligand coordinated to the metal M, respectively, and L_{c} is the same as or different from Lₐ or L_{b}; wherein Lₐ, L_{b} and L_{c} can be optionally joined to form a multidentate ligand;
m is selected from 1, 2 or 3, n is selected from 0, 1 or 2, q is selected from 0, 1 or 2, and m+n+q equals an oxidation state of the metal M; when m is greater than or equal to 2, multiple Lₐ are the same or different; when n is equal to 2, two L_{b} are the same or different; when q is equal to 2, two L_{c} are the same or different;
Lₐ is, at each occurrence identically or differently, selected from the group consisting of the following: 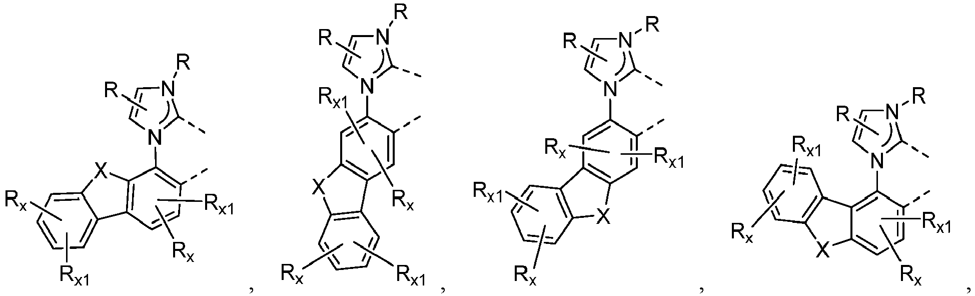 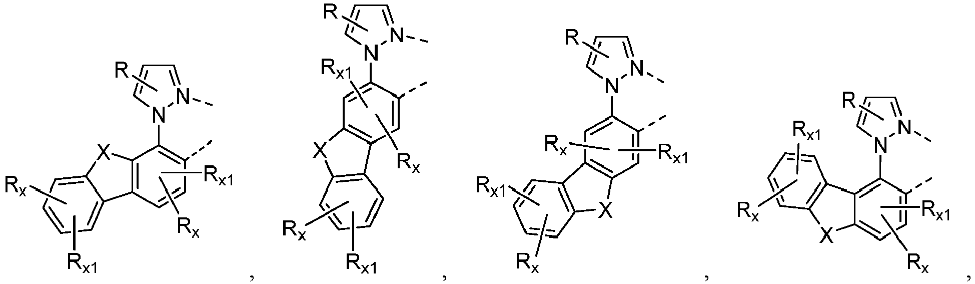 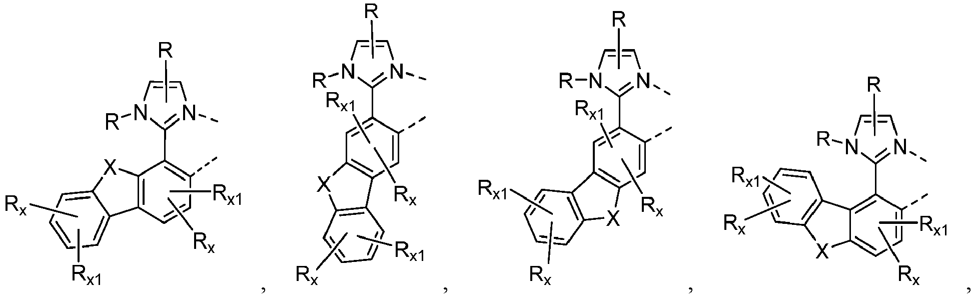 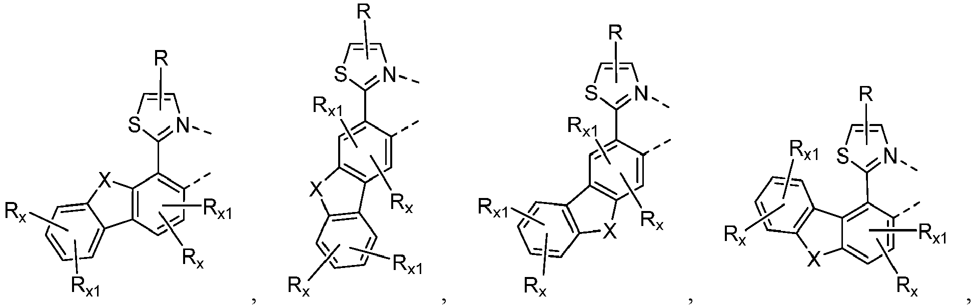 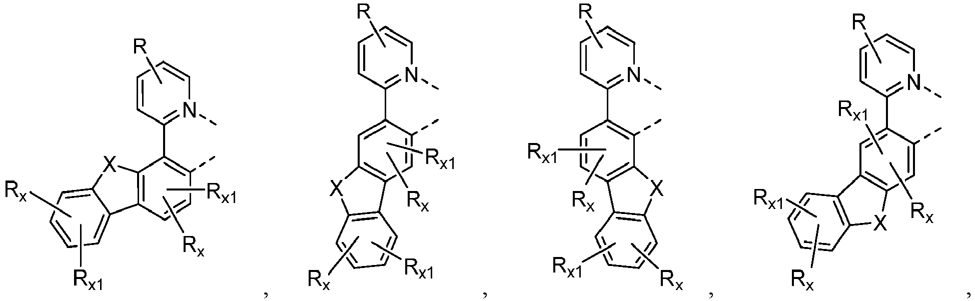 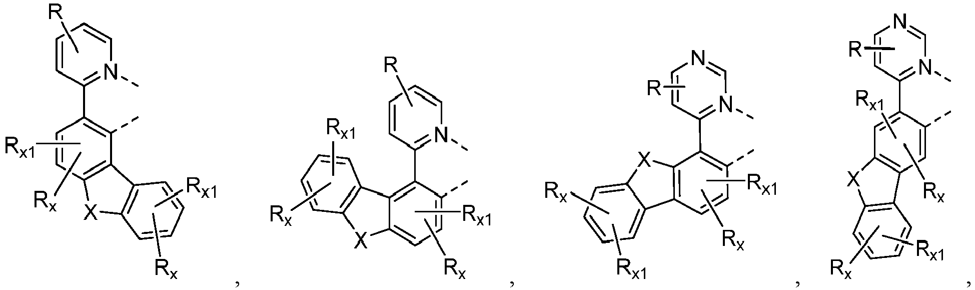 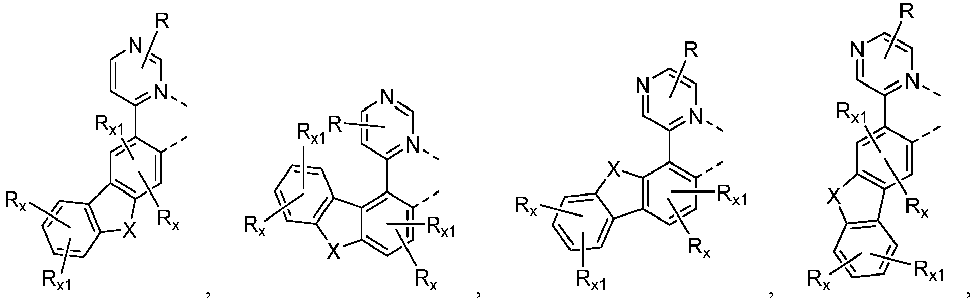 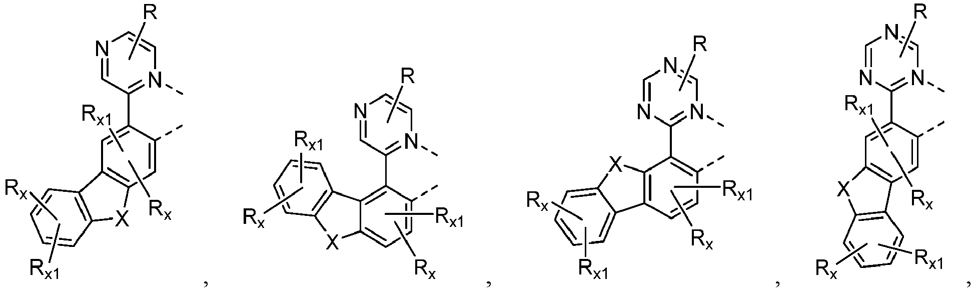 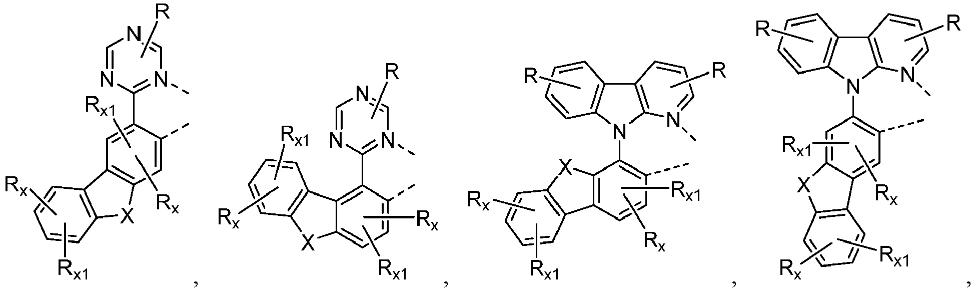 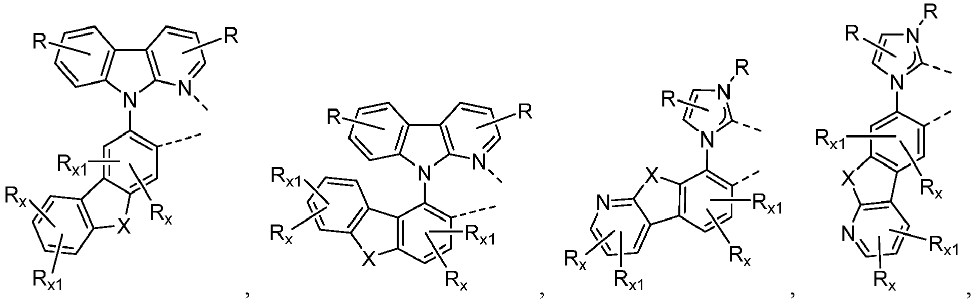 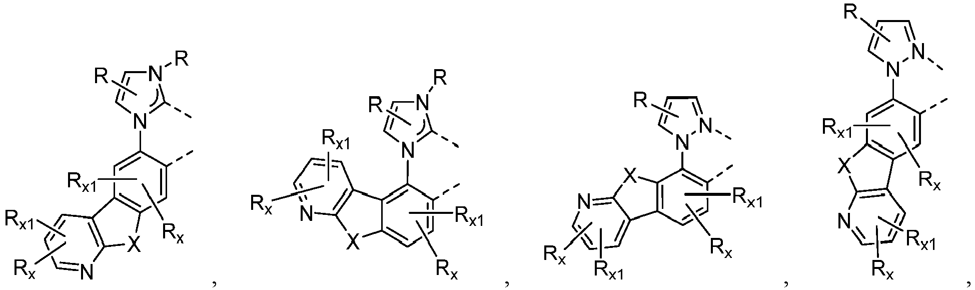 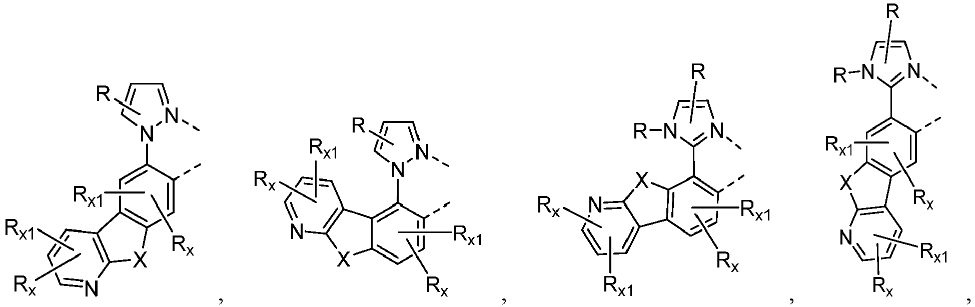 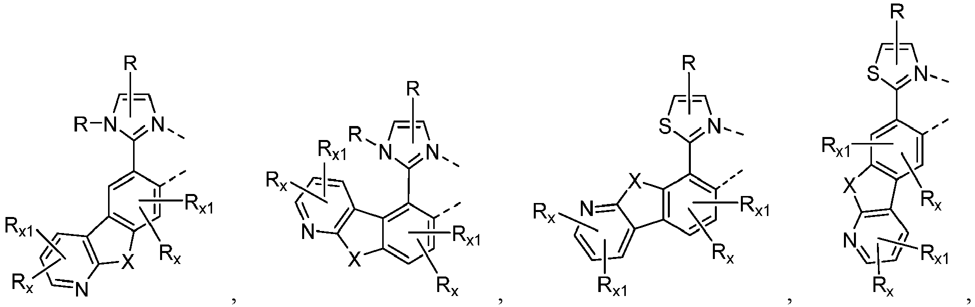 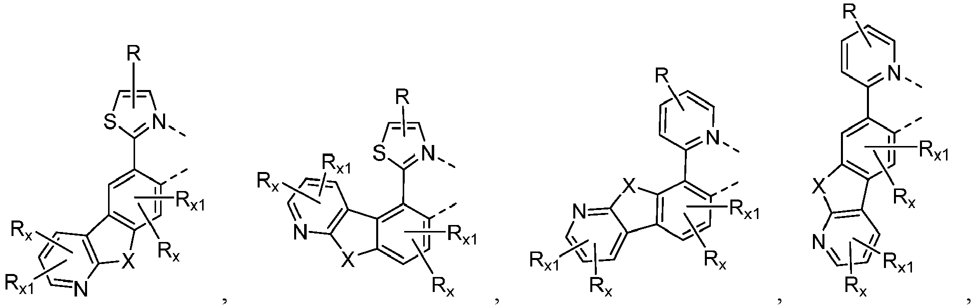 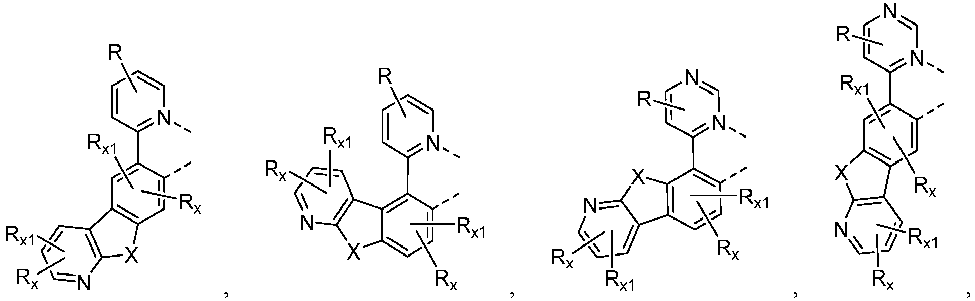 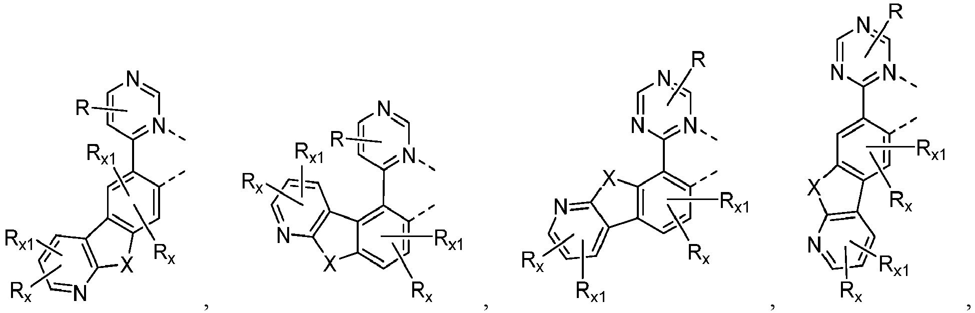 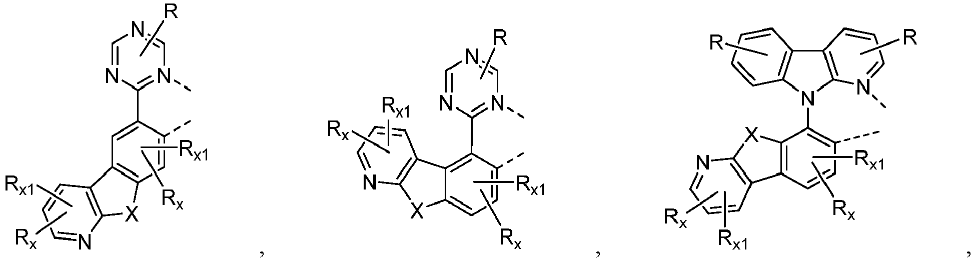 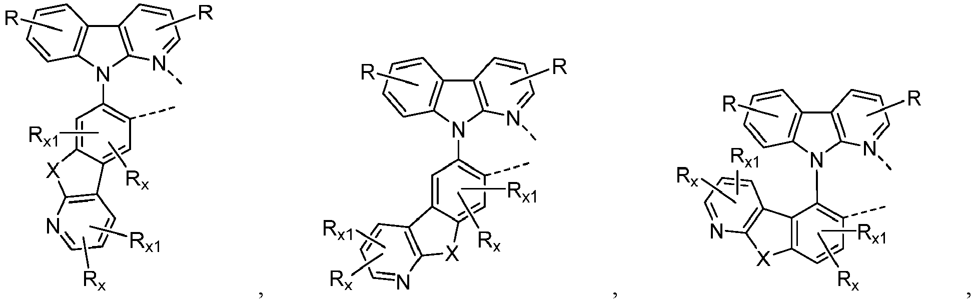 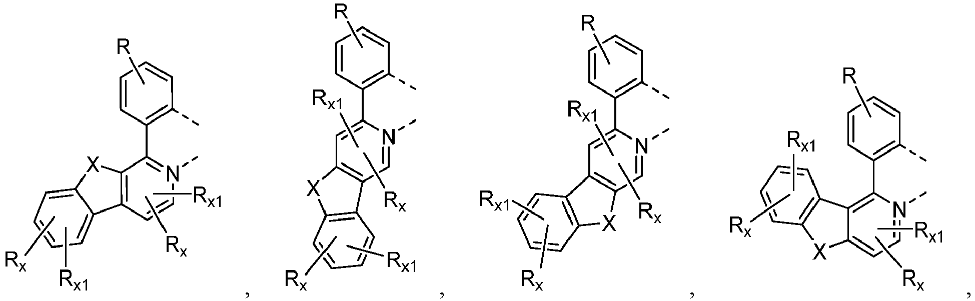 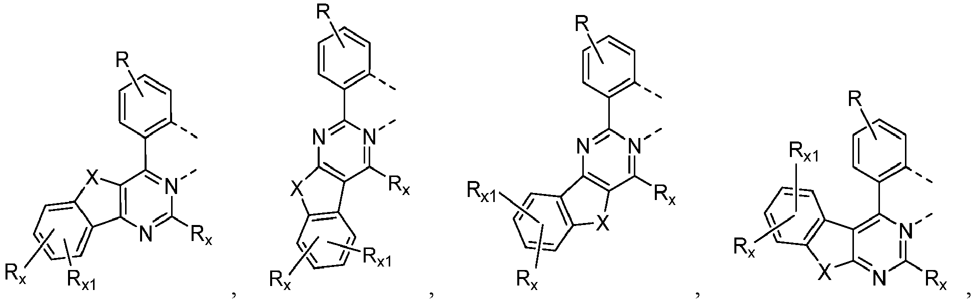 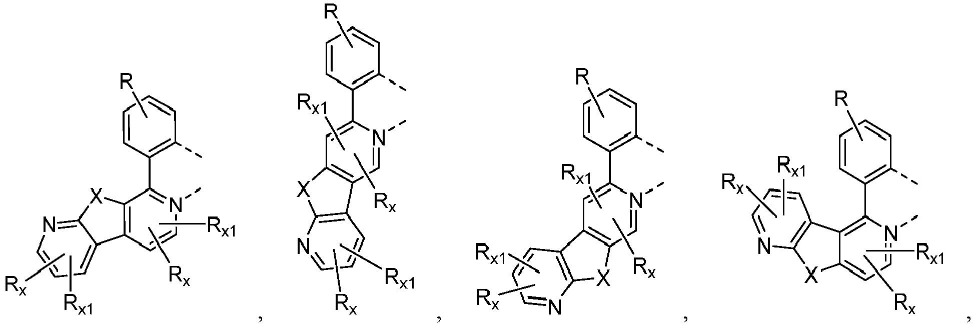 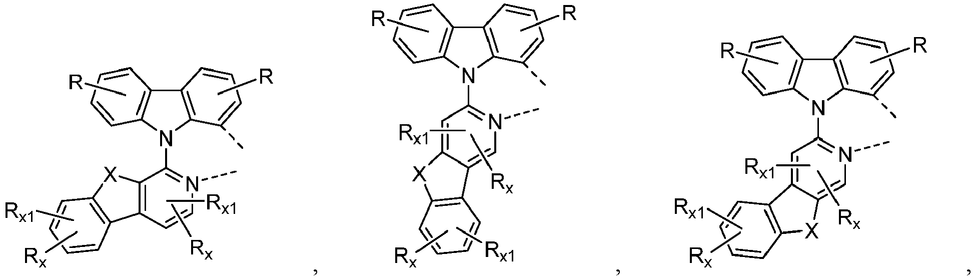 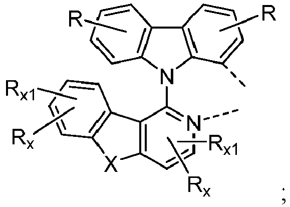
X is selected from the group consisting of O, S, Se, NR', SiR'R' and GeR'R'; when two R' are present at the same time, the two R' are the same or different;
R, Rₓ and Rₓ₁ represent, at each occurrence identically or differently, mono-substitution, multiple substitutions or non-substitution;
Rₓ₁ has a structure represented by Formula 2: 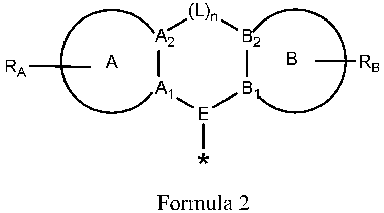
R_{A} and R_{B} represent, at each occurrence identically or differently, mono-substitution, multiple substitutions or non-substitution;
the ring A and the ring B are identically or differently selected from a carbocyclic ring having 3 to 30 ring atoms, a heterocyclic ring having 3 to 30 ring atoms or a combination thereof;
A₁, A₂, B₁, B₂ and E are, at each occurrence identically or differently, selected from C, N, B, P, CR‴, SiR‴ or GeR‴;
n is 0 or 1;
L is selected from a single bond, O, S, SO₂, Se, NR", CR"R", SiR"R", GeR"R", BR", PR", P(O)R", R"C=CR", heteroalkylene having 1 to 20 carbon atoms, cycloalkylene having 3 to 20 carbon atoms, heterocyclylene having 3 to 20 ring atoms, arylene having 6 to 30 carbon atoms, heteroarylene having 3 to 30 carbon atoms and combinations thereof;
" * " represents a position where Formula 2 is joined;
adjacent R', Rₓ can be optionally joined to form a ring;
adjacent R can be optionally joined to form a ring;
adjacent R", R‴, R_{A}, R_{B} can be optionally joined to form a ring;
L_{b} and L_{c} are, at each occurrence identically or differently, selected from a structure represented by any one of the group consisting of the following: 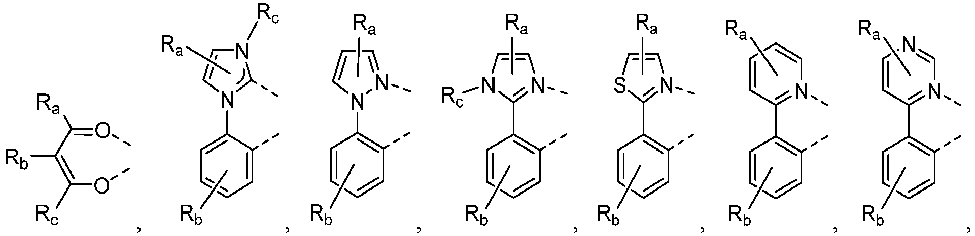 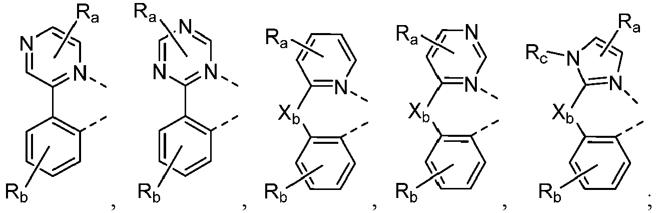 wherein,
X_{b} is, at each occurrence identically or differently, selected from the group consisting of: O, S, Se, NR_{N1} and CR_{C1}R_{C2};
Rₐ and R_{b} represent, at each occurrence identically or differently, mono-substitution, multiple substitutions or non-substitution;
adjacent substituents Rₐ, R_{b}, R_{c}, R_{N1}, R_{C1} and R_{C2} can be optionally joined to form a ring; and
R', R", R‴, R, Rₓ, R_{A}, R_{B}, Rₐ, R_{b}, R_{c}, R_{N1}, R_{C1} and R_{C2} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof.

4. The metal complex according to claim 1, wherein the metal complex has a structure of Ir(Lₐ)ₘ(L_{b})₃₋ₘ which is represented by Formula 3: 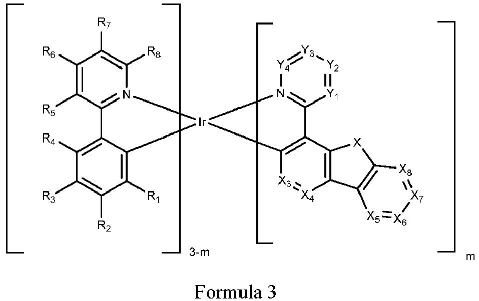 wherein,
m is selected from 1, 2 or 3; when m is selected from 1, two L_{b} are the same or different; when m is selected from 2 or 3, multiple Lₐ are the same or different;
X is selected from the group consisting of O, S, Se, NR', SiR'R' and GeR'R'; when two R' are present at the same time, the two R' are the same or different;
Y₁ to Y₄ are, at each occurrence identically or differently, selected from CR or N;
X₃ to X₈ are, at each occurrence identically or differently, selected from CRₓ, CRₓ₁ or N;
at least one of X₃ to X₈ is selected from CRₓ₁, and Rₓ₁ has a structure represented by Formula 2: 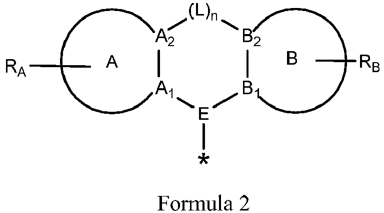
R_{A} and R_{B} represent, at each occurrence identically or differently, mono-substitution, multiple substitutions or non-substitution;
the ring A and the ring B are identically or differently selected from a carbocyclic ring having 3 to 30 ring atoms, a heterocyclic ring having 3 to 30 ring atoms or a combination thereof;
A₁, A₂, B₁, B₂ and E are, at each occurrence identically or differently, selected from C, N, B, P, CR‴, SiR‴ or GeR‴;
n is 0 or 1;
L is selected from a single bond, O, S, SO₂, Se, NR", CR"R", SiR"R", GeR"R", BR", PR", P(O)R", R"C=CR", heteroalkylene having 1 to 20 carbon atoms, cycloalkylene having 3 to 20 carbon atoms, heterocyclylene having 3 to 20 ring atoms, arylene having 6 to 30 carbon atoms, heteroarylene having 3 to 30 carbon atoms and combinations thereof;
R', R", R‴, R, Rₓ, R_{A}, R_{B} and R₁ to R₈ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
preferably, at least one R is selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms and combinations thereof;
and preferably, wherein at least one, at least two, at least three or all of R₂, R₃, R₆ and R₇ are selected from the group consisting of: deuterium, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms and combinations thereof;
adjacent R₁ to R₈ can be optionally joined to form a ring;
adjacent R', Rₓ can be optionally joined to form a ring;
adjacent R can be optionally joined to form a ring; and
adjacent R", R‴, R_{A}, R_{B} can be optionally joined to form a ring.

5. The metal complex according to claim 4, wherein at least one of X₃ to X₈ is N, and/or at least one of Y₁ to Y₄ is N.

6. The metal complex according to any one of claims 1 to 4, wherein Rₓ₁ has a structure represented by Formula 4: 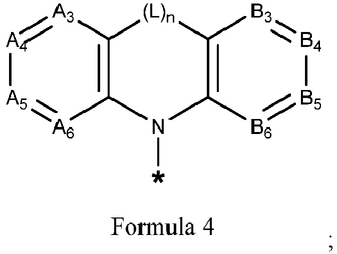
A₃ to A₆ are, at each occurrence identically or differently, selected from CR_{A} or N;
B₃ to B₆ are, at each occurrence identically or differently, selected from CR_{B} or N;
n is 0 or 1;
L is selected from a single bond, O, S, SO₂, Se, NR", CR"R", SiR"R", GeR"R", BR", PR", P(O)R", R"C=CR", heteroalkylene having 1 to 20 carbon atoms, cycloalkylene having 3 to 20 carbon atoms, heterocyclylene having 3 to 20 ring atoms, arylene having 6 to 30 carbon atoms, heteroarylene having 3 to 30 carbon atoms and combinations thereof;
preferably, wherein L is selected from a single bond, O, S, Se, NR", CR"R", SiR"R", GeR"R", BR", PR", P(O)R", R"C=CR", heteroalkylene having 1 to 10 carbon atoms, cycloalkylene having 3 to 10 carbon atoms, heterocyclylene having 3 to 10 ring atoms, arylene having 6 to 10 carbon atoms, heteroarylene having 3 to 10 carbon atoms and combinations thereof;
more preferably, L is selected from a single bond, O, S, NR", R"C=CR" and phenylene; R_{A}, R_{B} and R" are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
preferably, at least one of R_{A} and R_{B} is selected from the group consisting of: deuterium, fluorine, substituted or unsubstituted alkyl having 1 to 6 carbon atoms, substituted or unsubstituted cycloalkyl having 3 to 6 ring carbon atoms, substituted or unsubstituted aryl having 6 to 12 carbon atoms, substituted or unsubstituted heteroaryl having 3 to 12 carbon atoms, substituted or unsubstituted alkylsilyl having 3 to 6 carbon atoms, substituted or unsubstituted alkylgermanyl having 3 to 6 carbon atoms, a cyano group and combinations thereof;
adjacent R", R_{A}, R_{B} can be optionally joined to form a ring; and
" * " represents a position where Formula 4 is joined.

7. The metal complex according to claim 1 or 4, wherein at least one of X₅ to X₈ is selected from CRₓ₁;
preferably, at least one of X₇ and X₈ is selected from CRₓ₁; and
more preferably, X₈ is selected from CRₓ₁.

8. The metal complex according to claim 1 or 4, wherein at least one of X₅ to X₈ is selected from CRₓ, and the Rₓ is selected from cyano or fluorine, and at least one of X₅ to X₈ is selected from CRₓ₁;
preferably, X₇ is selected from CRₓ, and the Rₓ is cyano or fluorine, and X₈ is selected from CRₓ₁; and/or X₈ is selected from CRₓ, and the Rₓ is cyano or fluorine, and X₇ is selected from CRₓ₁.

9. The metal complex according to any one of claims 1 to 4, wherein Rₓ₁ is, at each occurrence identically or differently, selected from the group consisting of An₁ to An₁₃₅: 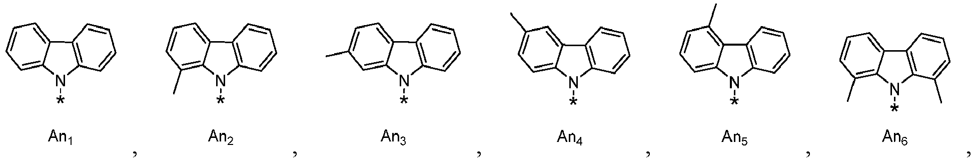 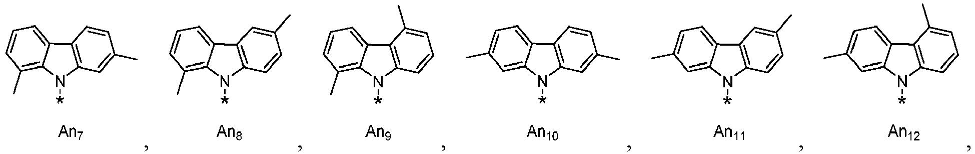 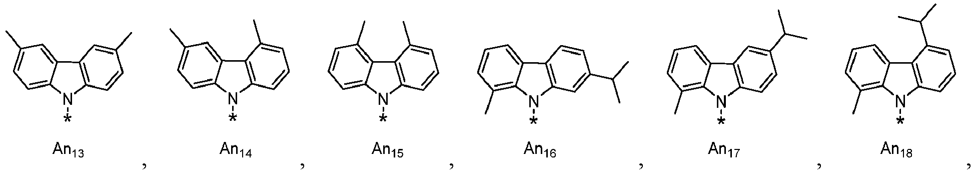 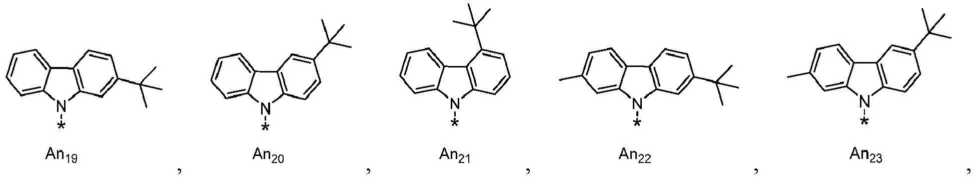 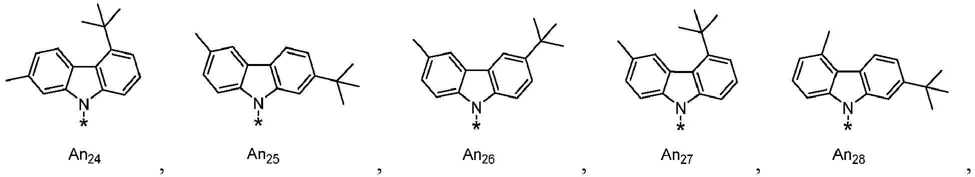 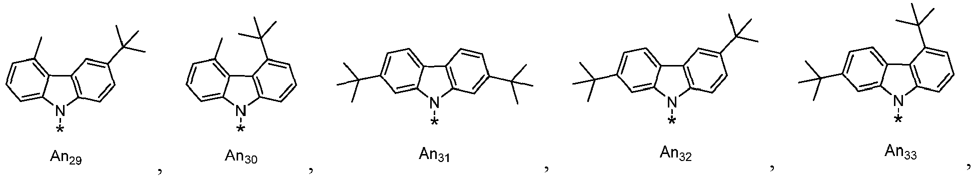 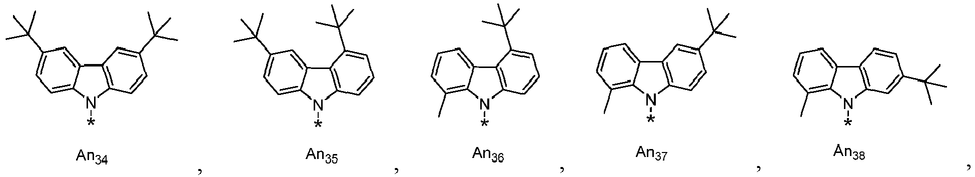 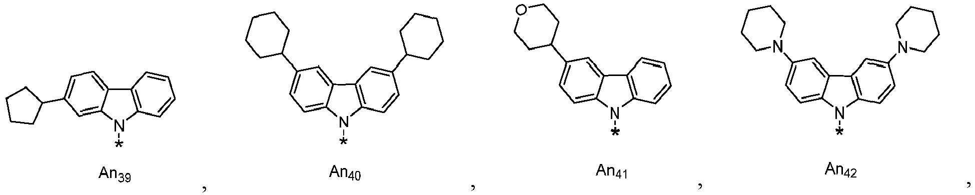 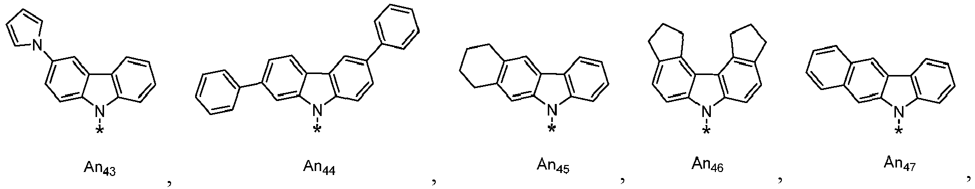 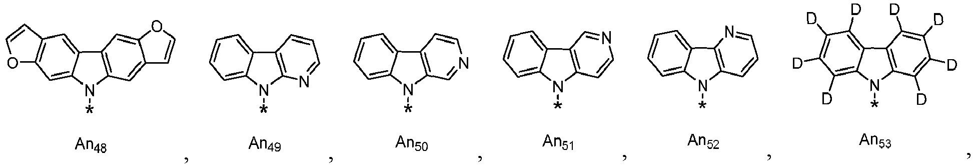 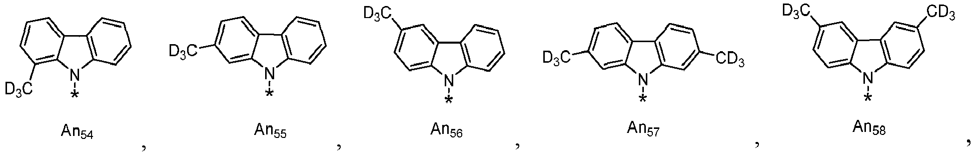 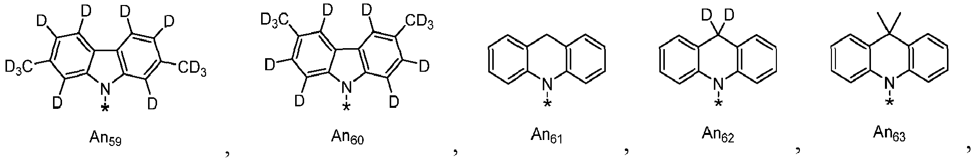 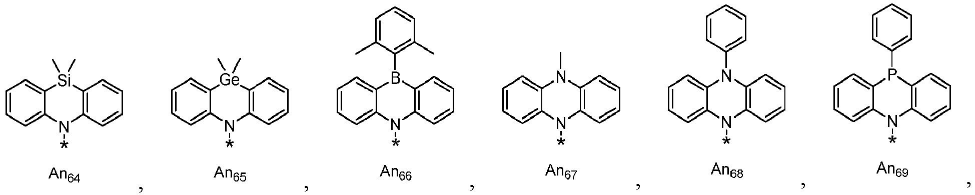 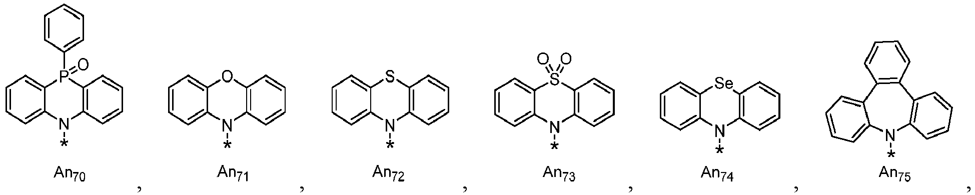 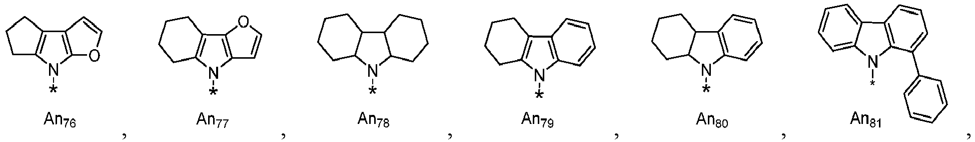 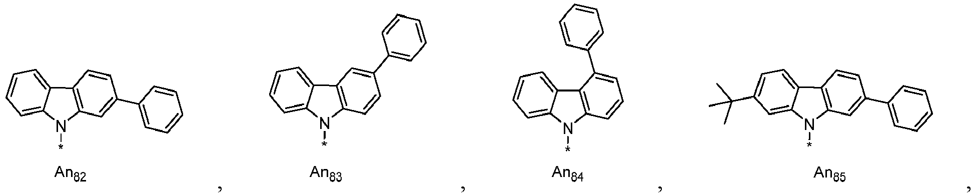 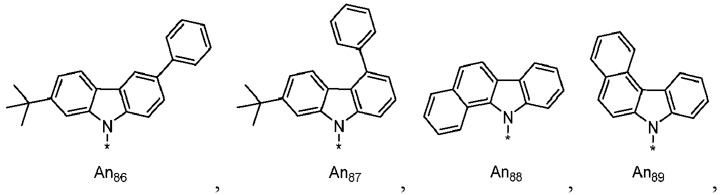 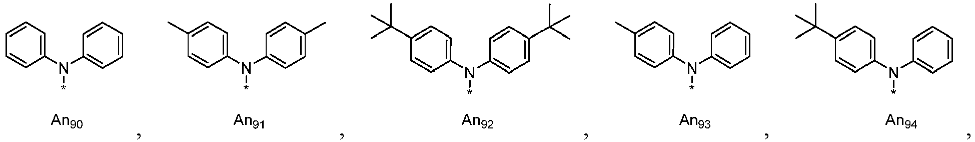 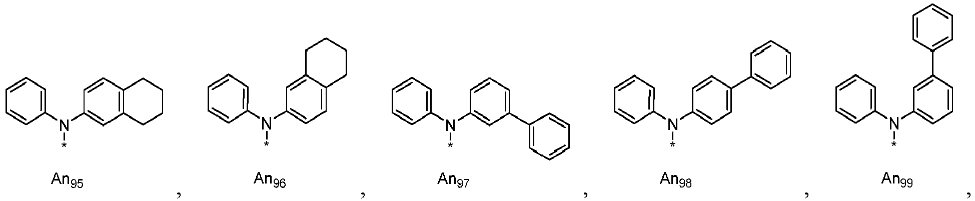 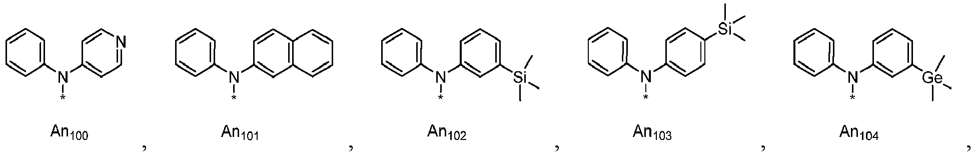 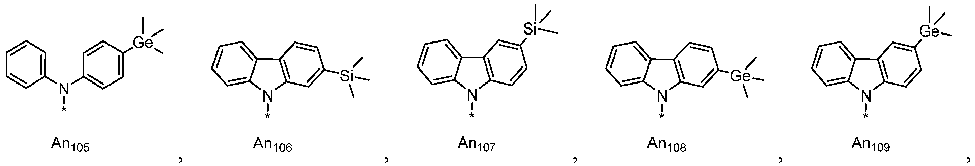 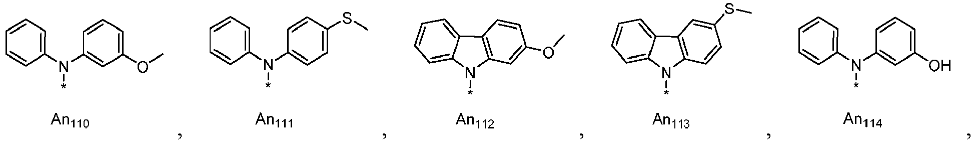 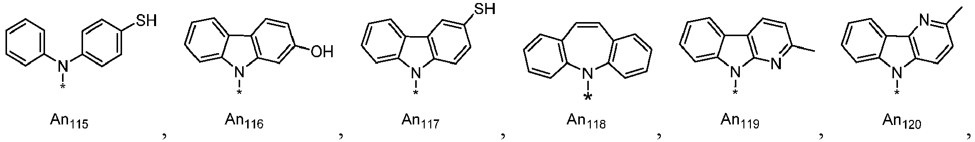 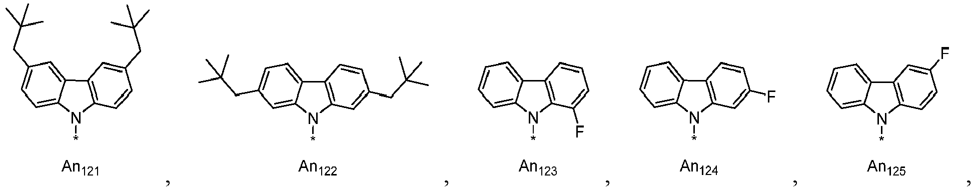 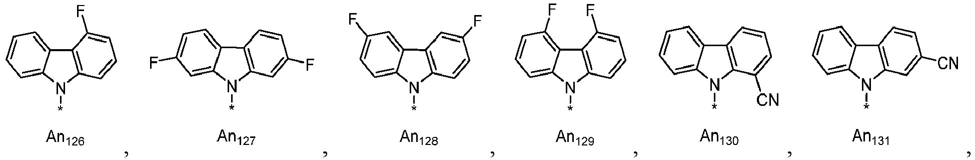 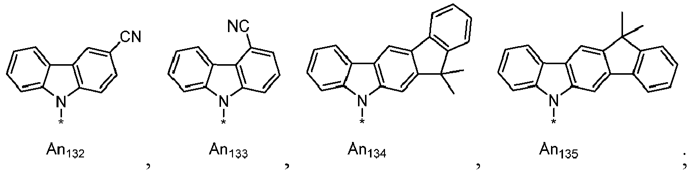 wherein optionally, hydrogens in An₁ to An₁₃₅ can be partially or fully substituted with deuterium.

10. The metal complex according to claim 4, wherein at least one or at least two of R₁ to R₈ are selected from substituted or unsubstituted alkyl having 1 to 20 carbon atoms, substituted or unsubstituted cycloalkyl having 3 to 20 ring carbon atoms or a combination thereof, and the total number of carbon atoms in all of R₁ to R₄ and/or R₅ to R₈ is at least 4; and
at least one or at least two of R₁ to R₄ are selected from substituted or unsubstituted alkyl having 1 to 20 carbon atoms, substituted or unsubstituted cycloalkyl having 3 to 20 ring carbon atoms or a combination thereof, and the total number of carbon atoms in all of R₁ to R₄ is at least 4; and/or at least one or at least two of R₅ to R₈ are selected from substituted or unsubstituted alkyl having 1 to 20 carbon atoms, substituted or unsubstituted cycloalkyl having 3 to 20 ring carbon atoms or a combination thereof, and the total number of carbon atoms in all of R₅ to R₈ is at least 4.

11. The metal complex according to claim 1, 3 or 9, wherein Lₐ is, at each occurrence identically or differently, selected from the group consisting of Lₐ₁ to Lₐ₁₈₉₁, wherein specific structures of Lₐ₁ to Lₐ₁₈₉₁ are shown as follows:
Lₐ₁ to Lₐ₁₄₄₀ each have a structure of 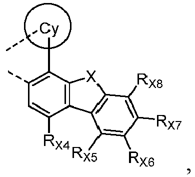 wherein X, Cy and R_{X4} to R_{X8} are selected from the atoms or groups listed in the following table:
| Lₐ No. | Cy | Cy | | R_{X4} | R_{X5} | R_{X6} | R_{X7} | Rₓ₈ | X |
|---|---|---|---|---|---|---|---|---|---|
| | | R_{Y2} | R_{Y3} | | | | | | |
| 1 | Cy1 | H | H | H | H | H | H | An₁ | O |
| 2 | Cy1 | H | H | H | H | H | H | An₂ | O |
| 3 | Cy1 | H | H | H | H | H | H | An₃ | O |
| 4 | Cy1 | H | H | H | H | H | H | An₄ | O |
| 5 | Cy1 | H | H | H | H | H | H | An₅ | O |
| 6 | Cy1 | H | H | H | H | H | H | An₆ | O |
| 7 | Cy1 | H | H | H | H | H | H | An₇ | O |
| 8 | Cy1 | H | H | H | H | H | H | An₈ | O |
| 9 | Cy1 | H | H | H | H | H | H | An₉ | O |
| 10 | Cy1 | H | H | H | H | H | H | An₁₀ | O |
| 11 | Cy1 | H | H | H | H | H | H | An₁₁ | O |
| 12 | Cy1 | H | H | H | H | H | H | An₁₂ | O |
| 13 | Cy1 | H | H | H | H | H | H | An₁₃ | O |
| 14 | Cy1 | H | H | H | H | H | H | An₁₄ | O |
| 15 | Cy1 | H | H | H | H | H | H | An₁₅ | o |
| 16 | Cy1 | H | H | H | H | H | H | An₁₆ | o |
| 17 | Cy1 | H | H | H | H | H | H | An₁₇ | O |
| 18 | Cy1 | H | H | H | H | H | H | An₁₈ | O |
| 19 | Cy1 | H | H | H | H | H | H | An₁₉ | O |
| 20 | Cy1 | H | H | H | H | H | H | An₂₀ | O |
| 21 | Cy1 | H | H | H | H | H | H | An₂₁ | O |
| 22 | Cy1 | H | H | H | H | H | H | An₂₂ | O |
| 23 | Cy1 | H | H | H | H | H | H | An₂₃ | O |
| 24 | Cy1 | H | H | H | H | H | H | An₂₄ | O |
| 25 | Cy1 | H | H | H | H | H | H | An₂₅ | O |
| 26 | Cy1 | H | H | H | H | H | H | An₂₆ | O |
| 27 | Cy1 | H | H | H | H | H | H | An₂₇ | O |
| 28 | Cy1 | H | H | H | H | H | H | An₂₈ | O |
| 29 | Cy1 | H | H | H | H | H | H | An₂₉ | O |
| 30 | Cy1 | H | H | H | H | H | H | An₃₀ | O |
| 31 | Cy1 | H | H | H | H | H | H | An₃₁ | O |
| 32 | Cy1 | H | H | H | H | H | H | An₃₂ | O |
| 33 | Cy1 | H | H | H | H | H | H | An₃₃ | O |
| 34 | Cy1 | H | H | H | H | H | H | An₃₄ | O |
| 35 | Cy1 | H | H | H | H | H | H | An₃₅ | O |
| 36 | Cy1 | H | H | H | H | H | H | An₃₆ | O |
| 37 | Cy1 | H | H | H | H | H | H | An₃₇ | O |
| 38 | Cy1 | H | H | H | H | H | H | An₃₈ | O |
| 39 | Cy1 | H | H | H | H | H | H | An₃₉ | O |
| 40 | Cy1 | H | H | H | H | H | H | An₄₀ | O |
| 41 | Cy1 | H | H | H | H | H | H | An₄₁ | O |
| 42 | Cy1 | H | H | H | H | H | H | An₄₂ | O |
| 43 | Cy1 | H | H | H | H | H | H | An₄₃ | O |
| 44 | Cy1 | H | H | H | H | H | H | An₄₄ | O |
| 45 | Cy1 | H | H | H | H | H | H | An₄₅ | O |
| 46 | Cy1 | H | H | H | H | H | H | An₄₆ | O |
| 47 | Cy1 | H | H | H | H | H | H | An₄₇ | O |
| 48 | Cy1 | H | H | H | H | H | H | An₄₈ | O |
| 49 | Cy1 | H | H | H | H | H | H | An₄₉ | O |
| 50 | Cy1 | H | H | H | H | H | H | An₅₀ | O |
| 51 | Cy1 | H | H | H | H | H | H | An₅₁ | O |
| 52 | Cy1 | H | H | H | H | H | H | An₅₂ | O |
| 53 | Cy1 | H | H | H | H | H | H | An₅₃ | O |
| 54 | Cy1 | H | H | H | H | H | H | An₅₄ | O |
| 55 | Cy1 | H | H | H | H | H | H | An₅₅ | O |
| 56 | Cy1 | H | H | H | H | H | H | An₅₆ | O |
| 57 | Cy1 | H | H | H | H | H | H | An₅₇ | O |
| 58 | Cy1 | H | H | H | H | H | H | An₅₈ | O |
| 59 | Cy1 | H | H | H | H | H | H | An₅₉ | O |
| 60 | Cy1 | H | H | H | H | H | H | An₆₀ | O |
| 61 | Cy1 | H | H | H | H | H | H | An₆₁ | O |
| 62 | Cy1 | H | H | H | H | H | H | An₆₂ | O |
| 63 | Cy1 | H | H | H | H | H | H | An₆₃ | O |
| 64 | Cy1 | H | H | H | H | H | H | An₆₄ | O |
| 65 | Cy1 | H | H | H | H | H | H | An₆₅ | O |
| 66 | Cy1 | H | H | H | H | H | H | An₆₆ | O |
| 67 | Cy1 | H | H | H | H | H | H | An₆₇ | O |
| 68 | Cy1 | H | H | H | H | H | H | An₆₈ | O |
| 69 | Cy1 | H | H | H | H | H | H | An₆₉ | O |
| 70 | Cy1 | H | H | H | H | H | H | An₇₀ | O |
| 71 | Cy1 | H | H | H | H | H | H | An₇₁ | O |
| 72 | Cy1 | H | H | H | H | H | H | An₇₂ | O |
| 73 | Cy1 | H | H | H | H | H | H | An₇₃ | O |
| 74 | Cy1 | H | H | H | H | H | H | An₇₄ | O |
| 75 | Cy1 | H | H | H | H | H | H | An₇₅ | O |
| 76 | Cy1 | H | H | H | H | H | H | An₇₆ | O |
| 77 | Cy1 | H | H | H | H | H | H | An₇₇ | O |
| 78 | Cy1 | H | H | H | H | H | H | An₇₈ | O |
| 79 | Cy1 | H | H | H | H | H | H | An₇₉ | O |
| 80 | Cy1 | H | H | H | H | H | H | An₈₀ | O |
| 81 | Cy1 | H | H | H | H | H | H | An₈₁ | O |
| 82 | Cy1 | H | H | H | H | H | H | An₈₂ | O |
| 83 | Cy1 | H | H | H | H | H | H | An₈₃ | O |
| 84 | Cy1 | H | H | H | H | H | H | An₈₄ | O |
| 85 | Cy1 | H | H | H | H | H | H | An₈₅ | O |
| 86 | Cy1 | H | H | H | H | H | H | An₈₆ | O |
| 87 | Cy1 | H | H | H | H | H | H | An₈₇ | O |
| 88 | Cy1 | H | H | H | H | H | H | An₈₈ | O |
| 89 | Cy1 | H | H | H | H | H | H | An₈₉ | O |
| 90 | Cy1 | H | H | H | H | H | An₁ | H | O |
| 91 | Cy1 | H | H | H | H | H | An₂ | H | O |
| 92 | Cy1 | H | H | H | H | H | An₃ | H | O |
| 93 | Cy1 | H | H | H | H | H | An₄ | H | O |
| 94 | Cy1 | H | H | H | H | H | An₅ | H | O |
| 95 | Cy1 | H | H | H | H | H | An₆ | H | O |
| 96 | Cy1 | H | H | H | H | H | An₇ | H | O |
| 97 | Cy1 | H | H | H | H | H | An₈ | H | O |
| 98 | Cy1 | H | H | H | H | H | An₉ | H | O |
| 99 | Cy1 | H | H | H | H | H | An₁₀ | H | O |
| 100 | Cy1 | H | H | H | H | H | An₁₁ | H | O |
| 101 | Cy1 | H | H | H | H | H | An₁₂ | H | O |
| 102 | Cy1 | H | H | H | H | H | An₁₃ | H | O |
| 103 | Cy1 | H | H | H | H | H | An₁₄ | H | O |
| 104 | Cy1 | H | H | H | H | H | An₁₅ | H | O |
| 105 | Cy1 | H | H | H | H | H | An₁₆ | H | O |
| 106 | Cy1 | H | H | H | H | H | An₁₇ | H | O |
| 107 | Cy1 | H | H | H | H | H | An₁₈ | H | O |
| 108 | Cy1 | H | H | H | H | H | An₁₉ | H | O |
| 109 | Cy1 | H | H | H | H | H | An₂₀ | H | O |
| 110 | Cy1 | H | H | H | H | H | An₂₁ | H | O |
| 111 | Cy1 | H | H | H | H | H | An₂₂ | H | O |
| 112 | Cy1 | H | H | H | H | H | An₂₃ | H | O |
| 113 | Cy1 | H | H | H | H | H | An₂₄ | H | O |
| 114 | Cy1 | H | H | H | H | H | An₂₅ | H | O |
| 115 | Cy1 | H | H | H | H | H | An₂₆ | H | O |
| 116 | Cy1 | H | H | H | H | H | An₂₇ | H | O |
| 117 | Cy1 | H | H | H | H | H | An₂₈ | H | O |
| 118 | Cy1 | H | H | H | H | H | An₂₉ | H | O |
| 119 | Cy1 | H | H | H | H | H | An₃₀ | H | O |
| 120 | Cy1 | H | H | H | H | H | An₃₁ | H | O |
| 121 | Cy1 | H | H | H | H | H | An₃₂ | H | O |
| 122 | Cy1 | H | H | H | H | H | An₃₃ | H | O |
| 123 | Cy1 | H | H | H | H | H | An₃₄ | H | O |
| 124 | Cy1 | H | H | H | H | H | An₃₅ | H | O |
| 125 | Cy1 | H | H | H | H | H | An₃₆ | H | O |
| 126 | Cy1 | H | H | H | H | H | An₃₇ | H | O |
| 127 | Cy1 | H | H | H | H | H | An₃₈ | H | O |
| 128 | Cy1 | H | H | H | H | H | An₃₉ | H | O |
| 129 | Cy1 | H | H | H | H | H | An₄₀ | H | O |
| 130 | Cy1 | H | H | H | H | H | An₄₁ | H | O |
| 131 | Cy1 | H | H | H | H | H | An₄₂ | H | O |
| 132 | Cy1 | H | H | H | H | H | An₄₃ | H | O |
| 133 | Cy1 | H | H | H | H | H | An₄₄ | H | O |
| 134 | Cy1 | H | H | H | H | H | An₄₅ | H | O |
| 135 | Cy1 | H | H | H | H | H | An₄₆ | H | O |
| 136 | Cy1 | H | H | H | H | H | An₄₇ | H | O |
| 137 | Cy1 | H | H | H | H | H | An₄₈ | H | O |
| 138 | Cy1 | H | H | H | H | H | An₄₉ | H | O |
| 139 | Cy1 | H | H | H | H | H | An₅₀ | H | O |
| 140 | Cy1 | H | H | H | H | H | An₅₁ | H | O |
| 141 | Cy1 | H | H | H | H | H | An₅₂ | H | O |
| 142 | Cy1 | H | H | H | H | H | An₅₃ | H | O |
| 143 | Cy1 | H | H | H | H | H | An₅₄ | H | O |
| 144 | Cy1 | H | H | H | H | H | An₅₅ | H | O |
| 145 | Cy1 | H | H | H | H | H | An₅₆ | H | O |
| 146 | Cy1 | H | H | H | H | H | An₅₇ | H | O |
| 147 | Cy1 | H | H | H | H | H | An₅₈ | H | O |
| 148 | Cy1 | H | H | H | H | H | An₅₉ | H | O |
| 149 | Cy1 | H | H | H | H | H | An₆₀ | H | O |
| 150 | Cy1 | H | H | H | H | H | An₆₁ | H | O |
| 151 | Cy1 | H | H | H | H | H | An₆₂ | H | O |
| 152 | Cy1 | H | H | H | H | H | An₆₃ | H | O |
| 153 | Cy1 | H | H | H | H | H | An₆₄ | H | O |
| 154 | Cy1 | H | H | H | H | H | An₆₅ | H | O |
| 155 | Cy1 | H | H | H | H | H | An₆₆ | H | O |
| 156 | Cy1 | H | H | H | H | H | An₆₇ | H | O |
| 157 | Cy1 | H | H | H | H | H | An₆₈ | H | O |
| 158 | Cy1 | H | H | H | H | H | An₆₉ | H | O |
| 159 | Cy1 | H | H | H | H | H | An₇₀ | H | O |
| 160 | Cy1 | H | H | H | H | H | An₇₁ | H | O |
| 161 | Cy1 | H | H | H | H | H | An₇₂ | H | O |
| 162 | Cy1 | H | H | H | H | H | An₇₃ | H | O |
| 163 | Cy1 | H | H | H | H | H | An₇₄ | H | O |
| 164 | Cy1 | H | H | H | H | H | An₇₅ | H | O |
| 165 | Cy1 | H | H | H | H | H | An₇₆ | H | O |
| 166 | Cy1 | H | H | H | H | H | An₇₇ | H | O |
| 167 | Cy1 | H | H | H | H | H | An₇₈ | H | O |
| 168 | Cy1 | H | H | H | H | H | An₇₉ | H | O |
| 169 | Cy1 | H | H | H | H | H | An₈₀ | H | O |
| 170 | Cy1 | H | H | H | H | H | An₈₁ | H | O |
| 171 | Cy1 | H | H | H | H | H | An₈₂ | H | O |
| 172 | Cy1 | H | H | H | H | H | An₈₃ | H | O |
| 173 | Cy1 | H | H | H | H | H | An₈₄ | H | O |
| 174 | Cy1 | H | H | H | H | H | An₈₅ | H | O |
| 175 | Cy1 | H | H | H | H | H | An₈₆ | H | O |
| 176 | Cy1 | H | H | H | H | H | An₈₇ | H | O |
| 177 | Cy1 | H | H | H | H | H | An₈₈ | H | O |
| 178 | Cy1 | H | H | H | H | H | An₈₉ | H | O |
| 179 | Cy1 | H | H | H | H | An₁ | H | H | O |
| 180 | Cy1 | H | H | H | H | An₂ | H | H | O |
| 181 | Cy1 | H | H | H | H | An₃ | H | H | O |
| 182 | Cy1 | H | H | H | H | An₄ | H | H | O |
| 183 | Cy1 | H | H | H | H | An₅ | H | H | O |
| 184 | Cy1 | H | H | H | H | An₆ | H | H | O |
| 185 | Cy1 | H | H | H | H | An₇ | H | H | O |
| 186 | Cy1 | H | H | H | H | An₈ | H | H | O |
| 187 | Cy1 | H | H | H | H | An₉ | H | H | O |
| 188 | Cy1 | H | H | H | H | An₁₀ | H | H | O |
| 189 | Cy1 | H | H | H | H | An₁₁ | H | H | O |
| 190 | Cy1 | H | H | H | H | An₁₂ | H | H | O |
| 191 | Cy1 | H | H | H | H | An₁₃ | H | H | O |
| 192 | Cy1 | H | H | H | H | An₁₄ | H | H | O |
| 193 | Cy1 | H | H | H | H | An₁₅ | H | H | O |
| 194 | Cy1 | H | H | H | H | An₁₆ | H | H | O |
| 195 | Cy1 | H | H | H | H | An₁₇ | H | H | O |
| 196 | Cy1 | H | H | H | H | An₁₈ | H | H | O |
| 197 | Cy1 | H | H | H | H | An₁₉ | H | H | O |
| 198 | Cy1 | H | H | H | H | An₂₀ | H | H | O |
| 199 | Cy1 | H | H | H | H | An₂₁ | H | H | O |
| 200 | Cy1 | H | H | H | H | An₂₂ | H | H | O |
| 201 | Cy1 | H | H | H | H | An₂₃ | H | H | O |
| 202 | Cy1 | H | H | H | H | An₂₄ | H | H | O |
| 203 | Cy1 | H | H | H | H | An₂₅ | H | H | O |
| 204 | Cy1 | H | H | H | H | An₂₆ | H | H | O |
| 205 | Cy1 | H | H | H | H | An₂₇ | H | H | O |
| 206 | Cy1 | H | H | H | H | An₂₈ | H | H | O |
| 207 | Cy1 | H | H | H | H | An₂₉ | H | H | O |
| 208 | Cy1 | H | H | H | H | An₃₀ | H | H | O |
| 209 | Cy1 | H | H | H | H | An₃₁ | H | H | O |
| 210 | Cy1 | H | H | H | H | An₃₂ | H | H | O |
| 211 | Cy1 | H | H | H | H | An₃₃ | H | H | O |
| 212 | Cy1 | H | H | H | H | An₃₄ | H | H | O |
| 213 | Cy1 | H | H | H | H | An₃₅ | H | H | O |
| 214 | Cy1 | H | H | H | H | An₃₆ | H | H | O |
| 215 | Cy1 | H | H | H | H | An₃₇ | H | H | O |
| 216 | Cy1 | H | H | H | H | An₃₈ | H | H | O |
| 217 | Cy1 | H | H | H | H | An₃₉ | H | H | O |
| 218 | Cy1 | H | H | H | H | An₄₀ | H | H | O |
| 219 | Cy1 | H | H | H | H | An₄₁ | H | H | O |
| 220 | Cy1 | H | H | H | H | An₄₂ | H | H | O |
| 221 | Cy1 | H | H | H | H | An₄₃ | H | H | O |
| 222 | Cy1 | H | H | H | H | An₄₄ | H | H | O |
| 223 | Cy1 | H | H | H | H | An₄₅ | H | H | O |
| 224 | Cy1 | H | H | H | H | An₄₆ | H | H | O |
| 225 | Cy1 | H | H | H | H | An₄₇ | H | H | O |
| 226 | Cy1 | H | H | H | H | An₄₈ | H | H | O |
| 227 | Cy1 | H | H | H | H | An₄₉ | H | H | O |
| 228 | Cy1 | H | H | H | H | An₅₀ | H | H | O |
| 229 | Cy1 | H | H | H | H | An₅₁ | H | H | O |
| 230 | Cy1 | H | H | H | H | An₅₂ | H | H | O |
| 231 | Cy1 | H | H | H | H | An₅₃ | H | H | O |
| 232 | Cy1 | H | H | H | H | An₅₄ | H | H | O |
| 233 | Cy1 | H | H | H | H | An₅₅ | H | H | O |
| 234 | Cy1 | H | H | H | H | An₅₆ | H | H | O |
| 235 | Cy1 | H | H | H | H | An₅₇ | H | H | O |
| 236 | Cy1 | H | H | H | H | An₅₈ | H | H | O |
| 237 | Cy1 | H | H | H | H | An₅₉ | H | H | O |
| 238 | Cy1 | H | H | H | H | An₆₀ | H | H | O |
| 239 | Cy1 | H | H | H | H | An₆₁ | H | H | O |
| 240 | Cy1 | H | H | H | H | An₆₂ | H | H | O |
| 241 | Cy1 | H | H | H | H | An₆₃ | H | H | O |
| 242 | Cy1 | H | H | H | H | An₆₄ | H | H | O |
| 243 | Cy1 | H | H | H | H | An₆₅ | H | H | O |
| 244 | Cy1 | H | H | H | H | An₆₆ | H | H | O |
| 245 | Cy1 | H | H | H | H | An₆₇ | H | H | O |
| 246 | Cy1 | H | H | H | H | An₆₈ | H | H | O |
| 247 | Cy1 | H | H | H | H | An₆₉ | H | H | O |
| 248 | Cy1 | H | H | H | H | An₇₀ | H | H | O |
| 249 | Cy1 | H | H | H | H | An₇₁ | H | H | O |
| 250 | Cy1 | H | H | H | H | An₇₂ | H | H | O |
| 251 | Cy1 | H | H | H | H | An₇₃ | H | H | O |
| 252 | Cy1 | H | H | H | H | An₇₄ | H | H | O |
| 253 | Cy1 | H | H | H | H | An₇₅ | H | H | O |
| 254 | Cy1 | H | H | H | H | An₇₆ | H | H | O |
| 255 | Cy1 | H | H | H | H | An₇₇ | H | H | O |
| 256 | Cy1 | H | H | H | H | An₇₈ | H | H | O |
| 257 | Cy1 | H | H | H | H | An₇₉ | H | H | O |
| 258 | Cy1 | H | H | H | H | An₈₀ | H | H | O |
| 259 | Cy1 | H | H | H | H | An₈₁ | H | H | O |
| 260 | Cy1 | H | H | H | H | An₈₂ | H | H | O |
| 261 | Cy1 | H | H | H | H | An₈₃ | H | H | O |
| 262 | Cy1 | H | H | H | H | An₈₄ | H | H | O |
| 263 | Cy1 | H | H | H | H | An₈₅ | H | H | O |
| 264 | Cy1 | H | H | H | H | An₈₆ | H | H | O |
| 265 | Cy1 | H | H | H | H | An₈₇ | H | H | O |
| 266 | Cy1 | H | H | H | H | An₈₈ | H | H | O |
| 267 | Cy1 | H | H | H | H | An₈₉ | H | H | O |
| 268 | Cy1 | H | H | H | An₁ | H | H | H | O |
| 269 | Cy1 | H | H | H | An₁₀ | H | H | H | O |
| 270 | Cy1 | H | H | H | An₁₃ | H | H | H | O |
| 271 | Cy1 | H | H | H | An₃₁ | H | H | H | O |
| 272 | Cy1 | H | H | H | An₃₅ | H | H | H | O |
| 273 | Cy1 | H | H | An₁ | H | H | H | H | O |
| 274 | Cy1 | H | H | An₂ | H | H | H | H | O |
| 275 | Cy1 | H | H | An₃ | H | H | H | H | O |
| 276 | Cy1 | H | H | An₄ | H | H | H | H | O |
| 277 | Cy1 | H | H | An₅ | H | H | H | H | O |
| 278 | Cy1 | H | H | An₆ | H | H | H | H | O |
| 279 | Cy1 | H | H | An₇ | H | H | H | H | O |
| 280 | Cy1 | H | H | An₈ | H | H | H | H | O |
| 281 | Cy1 | H | H | An₉ | H | H | H | H | O |
| 282 | Cy1 | H | H | An₁₀ | H | H | H | H | O |
| 283 | Cy1 | H | H | An₁₁ | H | H | H | H | O |
| 284 | Cy1 | H | H | An₁₂ | H | H | H | H | O |
| 285 | Cy1 | H | H | An₁₃ | H | H | H | H | O |
| 286 | Cy1 | H | H | An₁₄ | H | H | H | H | O |
| 287 | Cy1 | H | H | An₁₅ | H | H | H | H | O |
| 288 | Cy1 | H | H | An₁₆ | H | H | H | H | O |
| 289 | Cy1 | H | H | An₁₇ | H | H | H | H | O |
| 290 | Cy1 | H | H | An₁₈ | H | H | H | H | O |
| 291 | Cy1 | H | H | An₁₉ | H | H | H | H | O |
| 292 | Cy1 | H | H | An₂₀ | H | H | H | H | O |
| 293 | Cy1 | H | H | An₂₁ | H | H | H | H | O |
| 294 | Cy1 | H | H | An₂₂ | H | H | H | H | O |
| 295 | Cy1 | H | H | An₂₃ | H | H | H | H | O |
| 296 | Cy1 | H | H | An₂₄ | H | H | H | H | O |
| 297 | Cy1 | H | H | An₂₅ | H | H | H | H | O |
| 298 | Cy1 | H | H | An₂₆ | H | H | H | H | O |
| 299 | Cy1 | H | H | An₂₇ | H | H | H | H | O |
| 300 | Cy1 | H | H | An₂₈ | H | H | H | H | O |
| 301 | Cy1 | H | H | An₂₉ | H | H | H | H | O |
| 302 | Cy1 | H | H | An₃₀ | H | H | H | H | O |
| 303 | Cy1 | H | H | An₃₁ | H | H | H | H | O |
| 304 | Cy1 | H | H | An₃₂ | H | H | H | H | O |
| 305 | Cy1 | H | H | An₃₃ | H | H | H | H | O |
| 306 | Cy1 | H | H | An₃₄ | H | H | H | H | O |
| 307 | Cy1 | H | H | An₃₅ | H | H | H | H | O |
| 308 | Cy1 | H | H | An₃₆ | H | H | H | H | O |
| 309 | Cy1 | H | H | An₃₇ | H | H | H | H | O |
| 310 | Cy1 | H | H | An₃₈ | H | H | H | H | O |
| 311 | Cy1 | H | H | An₃₉ | H | H | H | H | O |
| 312 | Cy1 | H | H | An₄₀ | H | H | H | H | O |
| 313 | Cy1 | H | H | An₄₁ | H | H | H | H | O |
| 314 | Cy1 | H | H | An₄₂ | H | H | H | H | O |
| 315 | Cy1 | H | H | An₄₃ | H | H | H | H | O |
| 316 | Cy1 | H | H | An₄₄ | H | H | H | H | O |
| 317 | Cy1 | H | H | An₄₅ | H | H | H | H | O |
| 318 | Cy1 | H | H | An₄₆ | H | H | H | H | O |
| 319 | Cy1 | H | H | An₄₇ | H | H | H | H | O |
| 320 | Cy1 | H | H | An₄₈ | H | H | H | H | O |
| 321 | Cy1 | H | H | An₄₉ | H | H | H | H | O |
| 322 | Cy1 | H | H | An₅₀ | H | H | H | H | O |
| 323 | Cy1 | H | H | An₅₁ | H | H | H | H | O |
| 324 | Cy1 | H | H | An₅₂ | H | H | H | H | O |
| 325 | Cy1 | H | H | An₅₃ | H | H | H | H | O |
| 326 | Cy1 | H | H | An₅₄ | H | H | H | H | O |
| 327 | Cy1 | H | H | An₅₅ | H | H | H | H | O |
| 328 | Cy1 | H | H | An₅₆ | H | H | H | H | O |
| 329 | Cy1 | H | H | An₅₇ | H | H | H | H | O |
| 330 | Cy1 | H | H | An₅₈ | H | H | H | H | O |
| 331 | Cy1 | H | H | An₅₉ | H | H | H | H | O |
| 332 | Cy1 | H | H | An₆₀ | H | H | H | H | O |
| 333 | Cy1 | H | H | An₆₁ | H | H | H | H | O |
| 334 | Cy1 | H | H | An₆₂ | H | H | H | H | O |
| 335 | Cy1 | H | H | An₆₃ | H | H | H | H | O |
| 336 | Cy1 | H | H | An₆₄ | H | H | H | H | O |
| 337 | Cy1 | H | H | An₆₅ | H | H | H | H | O |
| 338 | Cy1 | H | H | An₆₆ | H | H | H | H | O |
| 339 | Cy1 | H | H | An₆₇ | H | H | H | H | O |
| 340 | Cy1 | H | H | An₆₈ | H | H | H | H | O |
| 341 | Cy1 | H | H | An₆₉ | H | H | H | H | O |
| 342 | Cy1 | H | H | An₇₀ | H | H | H | H | O |
| 343 | Cy1 | H | H | An₇₁ | H | H | H | H | O |
| 344 | Cy1 | H | H | An₇₂ | H | H | H | H | O |
| 345 | Cy1 | H | H | An₇₃ | H | H | H | H | O |
| 346 | Cy1 | H | H | An₇₄ | H | H | H | H | O |
| 347 | Cy1 | H | H | An₇₅ | H | H | H | H | O |
| 348 | Cy1 | H | H | An₇₆ | H | H | H | H | O |
| 349 | Cy1 | H | H | An₇₇ | H | H | H | H | O |
| 350 | Cy1 | H | H | An₇₈ | H | H | H | H | O |
| 351 | Cy1 | H | H | An₇₉ | H | H | H | H | O |
| 352 | Cy1 | H | H | An₈₀ | H | H | H | H | O |
| 353 | Cy1 | H | H | An₈₁ | H | H | H | H | O |
| 354 | Cy1 | H | H | An₈₂ | H | H | H | H | O |
| 355 | Cy1 | H | H | An₈₃ | H | H | H | H | O |
| 356 | Cy1 | H | H | An₈₄ | H | H | H | H | O |
| 357 | Cy1 | H | H | An₈₅ | H | H | H | H | O |
| 358 | Cy1 | H | H | An₈₆ | H | H | H | H | O |
| 359 | Cy1 | H | H | An₈₇ | H | H | H | H | O |
| 360 | Cy1 | H | H | An₈₈ | H | H | H | H | O |
| 361 | Cy1 | H | H | An₈₉ | H | H | H | H | O |
| 362 | Cy1 | CH₃ | H | H | H | H | H | An₁ | O |
| 363 | Cy1 | CH₃ | H | H | H | H | H | An₁₀ | O |
| 364 | Cy1 | CH₃ | H | H | H | H | H | An₁₃ | O |
| 365 | Cy1 | CH₃ | H | H | H | H | H | An₃₁ | O |
| 366 | Cy1 | CH₃ | H | H | H | H | H | An₃₅ | O |
| 367 | Cy1 | H | CH₃ | H | H | H | H | An₁ | O |
| 368 | Cy1 | H | CH₃ | H | H | H | H | An₁₀ | O |
| 369 | Cy1 | H | CH₃ | H | H | H | H | An₁₃ | O |
| 370 | Cy1 | H | CH₃ | H | H | H | H | An₃₁ | O |
| 371 | Cy1 | H | CH₃ | H | H | H | H | An₃₅ | O |
| 372 | Cy1 | CH₃ | CH₃ | H | H | H | H | An₁ | O |
| 373 | Cy1 | CH₃ | CH₃ | H | H | H | H | An₁₀ | O |
| 374 | Cy1 | CH₃ | CH₃ | H | H | H | H | An₁₃ | O |
| 375 | Cy1 | CH₃ | CH₃ | H | H | H | H | An₃₁ | O |
| 376 | Cy1 | CH₃ | CH₃ | H | H | H | H | An₃₅ | O |
| 377 | Cy1 | CH₃ | H | H | H | H | An₁ | H | O |
| 378 | Cy1 | CH₃ | H | H | H | H | An₁₀ | H | O |
| 379 | Cy1 | CH₃ | H | H | H | H | An₁₃ | H | O |
| 380 | Cy1 | CH₃ | H | H | H | H | An₃₁ | H | O |
| 381 | Cy1 | CH₃ | H | H | H | H | An₃₅ | H | O |
| 382 | Cy1 | H | CH₃ | H | H | H | An₁ | H | O |
| 383 | Cy1 | H | CH₃ | H | H | H | An₁₀ | H | O |
| 384 | Cy1 | H | CH₃ | H | H | H | An₁₃ | H | O |
| 385 | Cy1 | H | CH₃ | H | H | H | An₃₁ | H | O |
| 386 | Cy1 | H | CH₃ | H | H | H | An₃₅ | H | O |
| 387 | Cy1 | CH₃ | CH₃ | H | H | H | An₁ | H | O |
| 388 | Cy1 | CH₃ | CH₃ | H | H | H | An₁₀ | H | O |
| 389 | Cy1 | CH₃ | CH₃ | H | H | H | An₁₃ | H | O |
| 390 | Cy1 | CH₃ | CH₃ | H | H | H | An₃₁ | H | O |
| 391 | Cy1 | CH₃ | CH₃ | H | H | H | An₃₅ | H | O |
| 392 | Cy1 | *t*-Bu | H | H | H | H | H | An₁ | O |
| 393 | Cy1 | *t*-Bu | H | H | H | H | H | An₁₀ | O |
| 394 | Cy1 | *t*-Bu | H | H | H | H | H | An₁₃ | O |
| 395 | Cy1 | *t*-Bu | H | H | H | H | H | An₃₁ | O |
| 396 | Cy1 | *t*-Bu | H | H | H | H | H | An₃₅ | O |
| 397 | Cy1 | H | *t*-Bu | H | H | H | H | An₁ | O |
| 398 | Cy1 | H | *t*-Bu | H | H | H | H | An₁₀ | O |
| 399 | Cy1 | H | *t*-Bu | H | H | H | H | An₁₃ | O |
| 400 | Cy1 | H | *t*-Bu | H | H | H | H | An₃₁ | O |
| 401 | Cy1 | H | *t*-Bu | H | H | H | H | An₃₅ | O |
| 402 | Cy1 | *t*-Bu | H | H | H | H | An₁ | H | O |
| 403 | Cy1 | *t*-Bu | H | H | H | H | An₁₀ | H | O |
| 404 | Cy1 | *t*-Bu | H | H | H | H | An₁₃ | H | O |
| 405 | Cy1 | *t*-Bu | H | H | H | H | An₃₁ | H | O |
| 406 | Cy1 | *t*-Bu | H | H | H | H | An₃₅ | H | O |
| 407 | Cy1 | H | *t*-Bu | H | H | H | An₁ | H | O |
| 408 | Cy1 | H | *t*-Bu | H | H | H | An₁₀ | H | O |
| 409 | Cy1 | H | *t*-Bu | H | H | H | An₁₃ | H | O |
| 410 | Cy1 | H | *t*-Bu | H | H | H | An₃₁ | H | O |
| 411 | Cy1 | H | *t*-Bu | H | H | H | An₃₅ | H | O |
| 412 | Cy1 | *neo*-pent | H | H | H | H | H | An₁ | O |
| 413 | Cy1 | *neo*-pent | H | H | H | H | H | An₁₀ | O |
| 414 | Cy1 | *neo*-pent | H | H | H | H | H | An₁₃ | O |
| 415 | Cy1 | *neo*-pent | H | H | H | H | H | An₃₁ | O |
| 416 | Cy1 | *neo*-pent | H | H | H | H | H | An₃₅ | O |
| 417 | Cy1 | H | *neo*-pent | H | H | H | H | An₁ | O |
| 418 | Cy1 | H | *neo*-pent | H | H | H | H | An₁₀ | O |
| 419 | Cy1 | H | *neo*-pent | H | H | H | H | An₁₃ | O |
| 420 | Cy1 | H | *neo*-pent | H | H | H | H | An₃₁ | O |
| 421 | Cy1 | H | *neo*-pent | H | H | H | H | An₃₅ | O |
| 422 | Cy1 | *neo*-pent | H | H | H | H | An₁ | H | O |
| 423 | Cy1 | *neo*-pent | H | H | H | H | An₁₀ | H | O |
| 424 | Cy1 | *neo*-pent | H | H | H | H | An₁₃ | H | O |
| 425 | Cy1 | *neo*-pent | H | H | H | H | An₃₁ | H | O |
| 426 | Cy1 | *neo*-pent | H | H | H | H | An₃₅ | H | O |
| 427 | Cy1 | H | *neo*-pent | H | H | H | An₁ | H | O |
| 428 | Cy1 | H | *neo*-pent | H | H | H | An₁₀ | H | O |
| 429 | Cy1 | H | *neo*-pent | H | H | H | An₁₃ | H | O |
| 430 | Cy1 | H | *neo*-pent | H | H | H | An₃₁ | H | O |
| 431 | Cy1 | H | *neo*-pent | H | H | H | An₃₅ | H | O |
| 432 | Cy1 | CD₃ | H | H | H | H | H | An₁ | O |
| 433 | Cy1 | H | CD₃ | H | H | H | H | An₁ | O |
| 434 | Cy1 | CD₃ | CD₃ | H | H | H | H | An₁ | O |
| 435 | Cy1 | CD₃ | D | H | H | H | H | An₁ | O |
| 436 | Cy1 | CD₃ | D | H | H | H | H | An₁₀ | O |
| 437 | Cy1 | CD₃ | D | H | H | H | H | An₁₃ | O |
| 438 | Cy1 | CD₃ | D | H | H | H | H | An₃₁ | O |
| 439 | Cy1 | CD₃ | D | H | H | H | H | An₃₅ | O |
| 440 | Cy1 | D | CD₃ | H | H | H | H | An₁ | O |
| 441 | Cy1 | D | CD₃ | H | H | H | H | An₁₀ | O |
| 442 | Cy1 | D | CD₃ | H | H | H | H | An₁₃ | O |
| 443 | Cy1 | D | CD₃ | H | H | H | H | An₃₁ | O |
| 444 | Cy1 | D | CD₃ | H | H | H | H | An₃₅ | O |
| 445 | Cy1 | CD₃ | D | H | H | H | An₁ | H | O |
| 446 | Cy1 | CD₃ | D | H | H | H | An₁₀ | H | O |
| 447 | Cy1 | CD₃ | D | H | H | H | An₁₃ | H | O |
| 448 | Cy1 | CD₃ | D | H | H | H | An₃₁ | H | O |
| 449 | Cy1 | CD₃ | D | H | H | H | An₃₅ | H | O |
| 450 | Cy1 | D | CD₃ | H | H | H | An₁ | H | O |
| 451 | Cy1 | D | CD₃ | H | H | H | An₁₀ | H | O |
| 452 | Cy1 | D | CD₃ | H | H | H | An₁₃ | H | O |
| 453 | Cy1 | D | CD₃ | H | H | H | An₃₁ | H | O |
| 454 | Cy1 | D | CD₃ | H | H | H | An₃₅ | H | O |
| 455 | Cy1 | CD₃ | F | H | H | H | H | An₁ | O |
| 456 | Cy1 | CD₃ | F | H | H | H | H | An₁₀ | O |
| 457 | Cy1 | CD₃ | F | H | H | H | H | An₁₃ | O |
| 458 | Cy1 | CD₃ | F | H | H | H | H | An₃₁ | O |
| 459 | Cy1 | CD₃ | F | H | H | H | H | An₃₅ | O |
| 460 | Cy1 | F | CD₃ | H | H | H | H | An₁ | O |
| 461 | Cy1 | F | CD₃ | H | H | H | H | An₁₀ | O |
| 462 | Cy1 | F | CD₃ | H | H | H | H | An₁₃ | O |
| 463 | Cy1 | F | CD₃ | H | H | H | H | An₃₁ | O |
| 464 | Cy1 | F | CD₃ | H | H | H | H | An₃₅ | O |
| 465 | Cy1 | CD₃ | F | H | H | H | An₁ | H | O |
| 466 | Cy1 | CD₃ | F | H | H | H | An₁₀ | H | O |
| 467 | Cy1 | CD₃ | F | H | H | H | An₁₃ | H | O |
| 468 | Cy1 | CD₃ | F | H | H | H | An₃₁ | H | O |
| 469 | Cy1 | CD₃ | F | H | H | H | An₃₅ | H | O |
| 470 | Cy1 | F | CD₃ | H | H | H | An₁ | H | O |
| 471 | Cy1 | F | CD₃ | H | H | H | An₁₀ | H | O |
| 472 | Cy1 | F | CD₃ | H | H | H | An₁₃ | H | O |
| 473 | Cy1 | F | CD₃ | H | H | H | An₃₁ | H | O |
| 474 | Cy1 | F | CD₃ | H | H | H | An₃₅ | H | O |
| 475 | Cy1 | CD₃ | F | H | H | H | H | An₁ | O |
| 476 | Cy1 | CD₃ | F | H | H | H | H | An₁₀ | O |
| 477 | Cy1 | CD₃ | F | H | H | H | H | An₁₃ | O |
| 478 | Cy1 | CD₃ | F | H | H | H | H | An₃₁ | O |
| 479 | Cy1 | CD₃ | F | H | H | H | H | An₃₅ | O |
| 480 | Cy1 | F | CD₃ | H | H | H | H | An₁ | O |
| 481 | Cy1 | F | CD₃ | H | H | H | H | An₁₀ | O |
| 482 | Cy1 | F | CD₃ | H | H | H | H | An₁₃ | O |
| 483 | Cy1 | F | CD₃ | H | H | H | H | An₃₁ | O |
| 484 | Cy1 | F | CD₃ | H | H | H | H | An₃₅ | O |
| 485 | Cy1 | CD₃ | Ph | H | H | H | An₁ | H | O |
| 486 | Cy1 | CD₃ | Ph | H | H | H | An₁₀ | H | O |
| 487 | Cy1 | CD₃ | Ph | H | H | H | An₁₃ | H | O |
| 488 | Cy1 | CD₃ | Ph | H | H | H | An₃₁ | H | O |
| 489 | Cy1 | CD₃ | Ph | H | H | H | An₃₅ | H | O |
| 490 | Cy1 | Ph | CD₃ | H | H | H | An₁ | H | O |
| 491 | Cy1 | Ph | CD₃ | H | H | H | An₁₀ | H | O |
| 492 | Cy1 | Ph | CD₃ | H | H | H | An₁₃ | H | O |
| 493 | Cy1 | Ph | CD₃ | H | H | H | An₃₁ | H | O |
| 494 | Cy1 | Ph | CD₃ | H | H | H | An₃₅ | H | O |
| 495 | Cy1 | CD₃ | Ph | H | H | H | H | An₁ | O |
| 496 | Cy1 | CD₃ | Ph | H | H | H | H | An₁₀ | O |
| 497 | Cy1 | CD₃ | Ph | H | H | H | H | An₁₃ | O |
| 498 | Cy1 | CD₃ | Ph | H | H | H | H | An₃₁ | O |
| 499 | Cy1 | CD₃ | Ph | H | H | H | H | An₃₅ | O |
| 500 | Cy1 | Ph | CD₃ | H | H | H | H | An₁ | O |
| 501 | Cy1 | Ph | CD₃ | H | H | H | H | An₁₀ | O |
| 502 | Cy1 | Ph | CD₃ | H | H | H | H | An₁₃ | O |
| 503 | Cy1 | Ph | CD₃ | H | H | H | H | An₃₁ | O |
| 504 | Cy1 | Ph | CD₃ | H | H | H | H | An₃₅ | O |
| 505 | Cy1 | H | H | H | H | H | CH₃ | An₁ | O |
| 506 | Cy1 | H | H | H | H | H | CH₃ | An₁₀ | O |
| 507 | Cy1 | H | H | H | H | H | CH₃ | An₁₃ | O |
| 508 | Cy1 | H | H | H | H | H | CH₃ | An₃₁ | O |
| 509 | Cy1 | H | H | H | H | H | CH₃ | An₃₅ | O |
| 510 | Cy1 | H | H | H | H | H | CD₃ | An₁ | O |
| 511 | Cy1 | H | H | H | H | An₁ | CH₃ | H | O |
| 512 | Cy1 | H | H | H | H | An₁₀ | CH₃ | H | O |
| 513 | Cy1 | H | H | H | H | An₁₃ | CH₃ | H | O |
| 514 | Cy1 | H | H | H | H | An₃₁ | CH₃ | H | O |
| 515 | Cy1 | H | H | H | H | An₃₅ | CH₃ | H | O |
| 516 | Cy1 | H | H | H | H | An₁ | CD₃ | H | O |
| 517 | Cy1 | H | H | H | H | H | An₁ | CH₃ | O |
| 518 | Cy1 | H | H | H | H | H | An₁₀ | CH₃ | O |
| 519 | Cy1 | H | H | H | H | H | An₁₃ | CH₃ | O |
| 520 | Cy1 | H | H | H | H | H | An₃₁ | CH₃ | O |
| 521 | Cy1 | H | H | H | H | H | An₃₅ | CH₃ | O |
| 522 | Cy1 | H | H | H | H | H | An₁ | CD₃ | O |
| 523 | Cy1 | H | H | H | H | H | D | An₁ | O |
| 524 | Cy1 | H | H | H | H | H | D | An₁₀ | O |
| 525 | Cy1 | H | H | H | H | H | D | An₁₃ | O |
| 526 | Cy1 | H | H | H | H | H | D | An₃₁ | O |
| 527 | Cy1 | H | H | H | H | H | D | An₃₅ | O |
| 528 | Cy1 | H | H | H | H | D | CD₃ | An₁ | O |
| 529 | Cy1 | H | H | H | H | An₁ | D | H | O |
| 530 | Cy1 | H | H | H | H | An₁₀ | D | H | O |
| 531 | Cy1 | H | H | H | H | An₁₃ | D | H | O |
| 532 | Cy1 | H | H | H | H | An₃₁ | D | H | O |
| 533 | Cy1 | H | H | H | H | An₃₅ | D | H | O |
| 534 | Cy1 | H | H | H | H | An₁ | CD₃ | D | O |
| 535 | Cy1 | H | H | H | H | H | An₁ | D | O |
| 536 | Cy1 | H | H | H | H | H | An₁₀ | D | O |
| 537 | Cy1 | H | H | H | H | H | An₁₃ | D | O |
| 538 | Cy1 | H | H | H | H | H | An₃₁ | D | O |
| 539 | Cy1 | H | H | H | H | H | An₃₅ | CH₃ | O |
| 540 | Cy1 | H | H | H | H | D | An₁ | CD₃ | O |
| 541 | Cy1 | H | H | H | H | H | TMS | An₁ | O |
| 542 | Cy1 | H | H | H | H | H | TMS | An₁₀ | O |
| 543 | Cy1 | H | H | H | H | H | TMS | An₁₃ | O |
| 544 | Cy1 | H | H | H | H | H | TMS | An₃₁ | O |
| 545 | Cy1 | H | H | H | H | H | TMS | An₃₅ | O |
| 546 | Cy1 | H | H | H | H | D | TMS | An₁ | O |
| 547 | Cy1 | H | H | H | H | An₁ | TMS | H | O |
| 548 | Cy1 | H | H | H | H | An₁₀ | TMS | H | O |
| 549 | Cy1 | H | H | H | H | An₁₃ | TMS | H | O |
| 550 | Cy1 | H | H | H | H | An₃₁ | TMS | H | O |
| 551 | Cy1 | H | H | H | H | An₃₅ | TMS | H | O |
| 552 | Cy1 | H | H | H | H | An₁ | D | TMS | O |
| 553 | Cy1 | H | H | H | H | H | An₁ | TMS | O |
| 554 | Cy1 | H | H | H | H | H | An₁₀ | TMS | O |
| 555 | Cy1 | H | H | H | H | H | An₁₃ | TMS | O |
| 556 | Cy1 | H | H | H | H | H | An₃₁ | TMS | O |
| 557 | Cy1 | H | H | H | H | H | An₃₅ | CH₃ | O |
| 558 | Cy1 | H | H | H | H | TMS | An₁ | D | O |
| 559 | Cy1 | H | H | H | H | An₁ | TMG | H | O |
| 560 | Cy1 | H | H | H | H | An₁₀ | TMG | H | O |
| 561 | Cy1 | H | H | H | H | An₁₃ | TMG | H | O |
| 562 | Cy1 | H | H | H | H | An₃₁ | TMG | H | O |
| 563 | Cy1 | H | H | H | H | An₃₅ | TMG | H | O |
| 564 | Cy1 | H | H | H | H | An₁ | D | TMG | O |
| 565 | Cy1 | H | H | H | H | H | An₁ | TMG | O |
| 566 | Cy1 | H | H | H | H | H | An₁₀ | TMG | O |
| 567 | Cy1 | H | H | H | H | H | An₁₃ | TMG | O |
| 568 | Cy1 | H | H | H | H | H | An₃₁ | TMG | O |
| 569 | Cy1 | H | H | H | H | H | An₃₅ | CH₃ | O |
| 570 | Cy1 | H | H | H | H | TMG | An₁ | D | O |
| 571 | Cy1 | H | H | H | H | H | An₁ | An₁ | O |
| 572 | Cy1 | H | H | H | H | An₁ | H | An₁ | O |
| 573 | Cy1 | H | H | H | An₁ | H | H | An₁ | O |
| 574 | Cy1 | H | H | An₁ | H | H | H | An₁ | O |
| 575 | Cy1 | H | H | H | H | An₁ | An₁ | H | O |
| 576 | Cy1 | H | H | H | An₁ | H | An₁ | H | O |
| 577 | Cy1 | H | H | An₁ | H | H | An₁ | H | O |
| 578 | Cy1 | H | H | H | H | H | An₃₁ | An₁ | O |
| 579 | Cy1 | H | H | H | H | An₁ | H | An₃₅ | O |
| 580 | Cy1 | H | H | H | H | H | An₁ | An₃₁ | O |
| 581 | Cy1 | H | H | H | H | 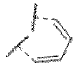 | | An₁ | O |
| 582 | Cy1 | H | H | H | H | 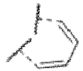 | | An₃₁ | O |
| 583 | Cy1 | H | H | H | H | 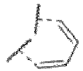 | | An₃₅ | O |
| 584 | Cy1 | H | H | H | 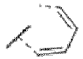 | | An₁ | H | O |
| 585 | Cy1 | H | H | H | 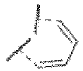 | | An₃₁ | H | O |
| 586 | Cy1 | H | H | H | 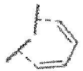 | | An₃₅ | H | O |
| 587 | Cy1 | H | H | H | H | An₁ | 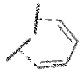 | | O |
| 588 | Cy1 | H | H | H | H | An₃₁ | 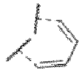 | | O |
| 589 | Cy1 | H | H | H | H | An₃₅ | 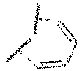 | | O |
| 590 | Cy1 | H | H | H | H | H | H | An₁ | s |
| 591 | Cy1 | H | H | H | H | H | H | An₁₀ | s |
| 592 | Cy1 | H | H | H | H | H | H | An₁₃ | s |
| 593 | Cy1 | H | H | H | H | H | H | An₃₁ | s |
| 594 | Cy1 | H | H | H | H | H | H | An₃₅ | s |
| 595 | Cy1 | H | H | H | H | H | An₁ | H | s |
| 596 | Cy1 | H | H | H | H | H | An₁₀ | H | s |
| 597 | Cy1 | H | H | H | H | H | An₁₃ | H | s |
| 598 | Cy1 | H | H | H | H | H | An₃₁ | H | s |
| 599 | Cy1 | H | H | H | H | H | An₃₅ | H | s |
| 600 | Cy1 | H | H | H | H | H | H | An₁ | Se |
| 601 | Cy1 | H | H | H | H | H | H | An₁₀ | TMS |
| 602 | Cy1 | H | H | H | H | H | H | An₁₃ | TMG |
| 603 | Cy1 | H | H | H | H | H | H | An₃₁ | NPh |
| 604 | Cy1 | H | H | H | H | H | H | An₃₅ | TMS |
| 605 | Cy1 | H | H | H | H | H | An₁ | H | Se |
| 606 | Cy1 | H | H | H | H | H | An₁₀ | H | TMS |
| 607 | Cy1 | H | H | H | H | H | An₁₃ | H | TMG |
| 608 | Cy1 | H | H | H | H | H | An₃₁ | H | NPh |
| 609 | Cy1 | H | H | H | H | H | An₃₅ | H | TMG |
| 610 | Cy1 | H | H | H | H | H | CN | An₁ | O |
| 611 | Cy1 | H | H | H | H | H | CN | An₂ | O |
| 612 | Cy1 | H | H | H | H | H | CN | An₃ | O |
| 613 | Cy1 | H | H | H | H | H | CN | An₄ | O |
| 614 | Cy1 | H | H | H | H | H | CN | An₅ | O |
| 615 | Cy1 | H | H | H | H | H | CN | An₆ | O |
| 616 | Cy1 | H | H | H | H | H | CN | An₇ | O |
| 617 | Cy1 | H | H | H | H | H | CN | An₈ | O |
| 618 | Cy1 | H | H | H | H | H | CN | An₉ | O |
| 619 | Cy1 | H | H | H | H | H | CN | An₁₀ | O |
| 620 | Cy1 | H | H | H | H | H | CN | An₁₁ | O |
| 621 | Cy1 | H | H | H | H | H | CN | An₁₂ | O |
| 622 | Cy1 | H | H | H | H | H | CN | An₁₃ | O |
| 623 | Cy1 | H | H | H | H | H | CN | An₁₄ | O |
| 624 | Cy1 | H | H | H | H | H | CN | An₁₅ | O |
| 625 | Cy1 | H | H | H | H | H | CN | An₁₆ | O |
| 626 | Cy1 | H | H | H | H | H | CN | An₁₇ | O |
| 627 | Cy1 | H | H | H | H | H | CN | An₁₈ | O |
| 628 | Cy1 | H | H | H | H | H | CN | An₁₉ | O |
| 629 | Cy1 | H | H | H | H | H | CN | An₂₀ | O |
| 630 | Cy1 | H | H | H | H | H | CN | An₂₁ | O |
| 631 | Cy1 | H | H | H | H | H | CN | An₂₂ | O |
| 632 | Cy1 | H | H | H | H | H | CN | An₂₃ | O |
| 633 | Cy1 | H | H | H | H | H | CN | An₂₄ | O |
| 634 | Cy1 | H | H | H | H | H | CN | An₂₅ | O |
| 635 | Cy1 | H | H | H | H | H | CN | An₂₆ | O |
| 636 | Cy1 | H | H | H | H | H | CN | An₂₇ | O |
| 637 | Cy1 | H | H | H | H | H | CN | An₂₈ | O |
| 638 | Cy1 | H | H | H | H | H | CN | An₂₉ | O |
| 639 | Cy1 | H | H | H | H | H | CN | An₃₀ | O |
| 640 | Cy1 | H | H | H | H | H | CN | An₃₁ | O |
| 641 | Cy1 | H | H | H | H | H | CN | An₃₂ | O |
| 642 | Cy1 | H | H | H | H | H | CN | An₃₃ | O |
| 643 | Cy1 | H | H | H | H | H | CN | An₃₄ | O |
| 644 | Cy1 | H | H | H | H | H | CN | An₃₅ | O |
| 645 | Cy1 | H | H | H | H | H | CN | An₃₆ | O |
| 646 | Cy1 | H | H | H | H | H | CN | An₃₇ | O |
| 647 | Cy1 | H | H | H | H | H | CN | An₃₈ | O |
| 648 | Cy1 | H | H | H | H | H | CN | An₃₉ | O |
| 649 | Cy1 | H | H | H | H | H | CN | An₄₀ | O |
| 650 | Cy1 | H | H | H | H | H | CN | An₄₁ | O |
| 651 | Cy1 | H | H | H | H | H | CN | An₄₂ | O |
| 652 | Cy1 | H | H | H | H | H | CN | An₄₃ | O |
| 653 | Cy1 | H | H | H | H | H | CN | An₄₄ | O |
| 654 | Cy1 | H | H | H | H | H | CN | An₄₅ | O |
| 655 | Cy1 | H | H | H | H | H | CN | An₄₆ | O |
| 656 | Cy1 | H | H | H | H | H | CN | An₄₇ | O |
| 657 | Cy1 | H | H | H | H | H | CN | An₄₈ | O |
| 658 | Cy1 | H | H | H | H | H | CN | An₄₉ | O |
| 659 | Cy1 | H | H | H | H | H | CN | An₅₀ | O |
| 660 | Cy1 | H | H | H | H | H | CN | An₅₁ | O |
| 661 | Cy1 | H | H | H | H | H | CN | An₅₂ | O |
| 662 | Cy1 | H | H | H | H | H | CN | An₅₃ | O |
| 663 | Cy1 | H | H | H | H | H | CN | An₅₄ | O |
| 664 | Cy1 | H | H | H | H | H | CN | An₅₅ | O |
| 665 | Cy1 | H | H | H | H | H | CN | An₅₆ | O |
| 666 | Cy1 | H | H | H | H | H | CN | An₅₇ | O |
| 667 | Cy1 | H | H | H | H | H | CN | An₅₈ | O |
| 668 | Cy1 | H | H | H | H | H | CN | An₅₉ | O |
| 669 | Cy1 | H | H | H | H | H | CN | An₆₀ | O |
| 670 | Cy1 | H | H | H | H | H | CN | An₆₁ | O |
| 671 | Cy1 | H | H | H | H | H | CN | An₆₂ | O |
| 672 | Cy1 | H | H | H | H | H | CN | An₆₃ | O |
| 673 | Cy1 | H | H | H | H | H | CN | An₆₄ | O |
| 674 | Cy1 | H | H | H | H | H | CN | An₆₅ | O |
| 675 | Cy1 | H | H | H | H | H | CN | An₆₆ | O |
| 676 | Cy1 | H | H | H | H | H | CN | An₆₇ | O |
| 677 | Cy1 | H | H | H | H | H | CN | An₆₈ | O |
| 678 | Cy1 | H | H | H | H | H | CN | An₆₉ | O |
| 679 | Cy1 | H | H | H | H | H | CN | An₇₀ | O |
| 680 | Cy1 | H | H | H | H | H | CN | An₇₁ | O |
| 681 | Cy1 | H | H | H | H | H | CN | An₇₂ | O |
| 682 | Cy1 | H | H | H | H | H | CN | An₇₃ | O |
| 683 | Cy1 | H | H | H | H | H | CN | An₇₄ | O |
| 684 | Cy1 | H | H | H | H | H | CN | An₇₅ | O |
| 685 | Cy1 | H | H | H | H | H | CN | An₇₆ | O |
| 686 | Cy1 | H | H | H | H | H | CN | An₇₇ | O |
| 687 | Cy1 | H | H | H | H | H | CN | An₇₈ | O |
| 688 | Cy1 | H | H | H | H | H | CN | An₇₉ | O |
| 689 | Cy1 | H | H | H | H | H | CN | An₈₀ | O |
| 690 | Cy1 | H | H | H | H | H | CN | An₈₁ | O |
| 691 | Cy1 | H | H | H | H | H | CN | An₈₂ | O |
| 692 | Cy1 | H | H | H | H | H | CN | An₈₃ | O |
| 693 | Cy1 | H | H | H | H | H | CN | An₈₄ | O |
| 694 | Cy1 | H | H | H | H | H | CN | An₈₅ | O |
| 695 | Cy1 | H | H | H | H | H | CN | An₈₆ | O |
| 696 | Cy1 | H | H | H | H | H | CN | An₈₇ | O |
| 697 | Cy1 | H | H | H | H | H | CN | An₈₈ | O |
| 698 | Cy1 | H | H | H | H | H | CN | An₈₉ | O |
| 699 | Cy1 | H | H | H | H | H | An₁ | CN | O |
| 700 | Cy1 | H | H | H | H | H | An₂ | CN | O |
| 701 | Cy1 | H | H | H | H | H | An₃ | CN | O |
| 702 | Cy1 | H | H | H | H | H | An₄ | CN | O |
| 703 | Cy1 | H | H | H | H | H | An₅ | CN | O |
| 704 | Cy1 | H | H | H | H | H | An₆ | CN | O |
| 705 | Cy1 | H | H | H | H | H | An₇ | CN | O |
| 706 | Cy1 | H | H | H | H | H | An₈ | CN | O |
| 707 | Cy1 | H | H | H | H | H | An₉ | CN | O |
| 708 | Cy1 | H | H | H | H | H | An₁₀ | CN | O |
| 709 | Cy1 | H | H | H | H | H | An₁₁ | CN | O |
| 710 | Cy1 | H | H | H | H | H | An₁₂ | CN | O |
| 711 | Cy1 | H | H | H | H | H | An₁₃ | CN | O |
| 712 | Cy1 | H | H | H | H | H | An₁₄ | CN | O |
| 713 | Cy1 | H | H | H | H | H | An₁₅ | CN | O |
| 714 | Cy1 | H | H | H | H | H | An₁₆ | CN | O |
| 715 | Cy1 | H | H | H | H | H | An₁₇ | CN | O |
| 716 | Cy1 | H | H | H | H | H | An₁₈ | CN | O |
| 717 | Cy1 | H | H | H | H | H | An₁₉ | CN | O |
| 718 | Cy1 | H | H | H | H | H | An₂₀ | CN | O |
| 719 | Cy1 | H | H | H | H | H | An₂₁ | CN | O |
| 720 | Cy1 | H | H | H | H | H | An₂₂ | CN | O |
| 721 | Cy1 | H | H | H | H | H | An₂₃ | CN | O |
| 722 | Cy1 | H | H | H | H | H | An₂₄ | CN | O |
| 723 | Cy1 | H | H | H | H | H | An₂₅ | CN | O |
| 724 | Cy1 | H | H | H | H | H | An₂₆ | CN | O |
| 725 | Cy1 | H | H | H | H | H | An₂₇ | CN | O |
| 726 | Cy1 | H | H | H | H | H | An₂₈ | CN | O |
| 727 | Cy1 | H | H | H | H | H | An₂₉ | CN | O |
| 728 | Cy1 | H | H | H | H | H | An₃₀ | CN | O |
| 729 | Cy1 | H | H | H | H | H | An₃₁ | CN | O |
| 730 | Cy1 | H | H | H | H | H | An₃₂ | CN | O |
| 731 | Cy1 | H | H | H | H | H | An₃₃ | CN | O |
| 732 | Cy1 | H | H | H | H | H | An₃₄ | CN | O |
| 733 | Cy1 | H | H | H | H | H | An₃₅ | CN | O |
| 734 | Cy1 | H | H | H | H | H | An₃₆ | CN | O |
| 735 | Cy1 | H | H | H | H | H | An₃₇ | CN | O |
| 736 | Cy1 | H | H | H | H | H | An₃₈ | CN | O |
| 737 | Cy1 | H | H | H | H | H | An₃₉ | CN | O |
| 738 | Cy1 | H | H | H | H | H | An₄₀ | CN | O |
| 739 | Cy1 | H | H | H | H | H | An₄₁ | CN | O |
| 740 | Cy1 | H | H | H | H | H | An₄₂ | CN | O |
| 741 | Cy1 | H | H | H | H | H | An₄₃ | CN | O |
| 742 | Cy1 | H | H | H | H | H | An₄₄ | CN | O |
| 743 | Cy1 | H | H | H | H | H | An₄₅ | CN | O |
| 744 | Cy1 | H | H | H | H | H | An₄₆ | CN | O |
| 745 | Cy1 | H | H | H | H | H | An₄₇ | CN | O |
| 746 | Cy1 | H | H | H | H | H | An₄₈ | CN | O |
| 747 | Cy1 | H | H | H | H | H | An₄₉ | CN | O |
| 748 | Cy1 | H | H | H | H | H | An₅₀ | CN | O |
| 749 | Cy1 | H | H | H | H | H | An₅₁ | CN | O |
| 750 | Cy1 | H | H | H | H | H | An₅₂ | CN | O |
| 751 | Cy1 | H | H | H | H | H | An₅₃ | CN | O |
| 752 | Cy1 | H | H | H | H | H | An₅₄ | CN | O |
| 753 | Cy1 | H | H | H | H | H | An₅₅ | CN | O |
| 754 | Cy1 | H | H | H | H | H | An₅₆ | CN | O |
| 755 | Cy1 | H | H | H | H | H | An₅₇ | CN | O |
| 756 | Cy1 | H | H | H | H | H | An₅₈ | CN | O |
| 757 | Cy1 | H | H | H | H | H | An₅₉ | CN | O |
| 758 | Cy1 | H | H | H | H | H | An₆₀ | CN | O |
| 759 | Cy1 | H | H | H | H | H | An₆₁ | CN | O |
| 760 | Cy1 | H | H | H | H | H | An₆₂ | CN | O |
| 761 | Cy1 | H | H | H | H | H | An₆₃ | CN | O |
| 762 | Cy1 | H | H | H | H | H | An₆₄ | CN | O |
| 763 | Cy1 | H | H | H | H | H | An₆₅ | CN | O |
| 764 | Cy1 | H | H | H | H | H | An₆₆ | CN | O |
| 765 | Cy1 | H | H | H | H | H | An₆₇ | CN | O |
| 766 | Cy1 | H | H | H | H | H | An₆₈ | CN | O |
| 767 | Cy1 | H | H | H | H | H | An₆₉ | CN | O |
| 768 | Cy1 | H | H | H | H | H | An₇₀ | CN | O |
| 769 | Cy1 | H | H | H | H | H | An₇₁ | CN | O |
| 770 | Cy1 | H | H | H | H | H | An₇₂ | CN | O |
| 771 | Cy1 | H | H | H | H | H | An₇₃ | CN | O |
| 772 | Cy1 | H | H | H | H | H | An₇₄ | CN | O |
| 773 | Cy1 | H | H | H | H | H | An₇₅ | CN | O |
| 774 | Cy1 | H | H | H | H | H | An₇₆ | CN | O |
| 775 | Cy1 | H | H | H | H | H | An₇₇ | CN | O |
| 776 | Cy1 | H | H | H | H | H | An₇₈ | CN | O |
| 777 | Cy1 | H | H | H | H | H | An₇₉ | CN | O |
| 778 | Cy1 | H | H | H | H | H | An₈₀ | CN | O |
| 779 | Cy1 | H | H | H | H | H | An₈₁ | CN | O |
| 780 | Cy1 | H | H | H | H | H | An₈₂ | CN | O |
| 781 | Cy1 | H | H | H | H | H | An₈₃ | CN | O |
| 782 | Cy1 | H | H | H | H | H | An₈₄ | CN | O |
| 783 | Cy1 | H | H | H | H | H | An₈₅ | CN | O |
| 784 | Cy1 | H | H | H | H | H | An₈₆ | CN | O |
| 785 | Cy1 | H | H | H | H | H | An₈₇ | CN | O |
| 786 | Cy1 | H | H | H | H | H | An₈₈ | CN | O |
| 787 | Cy1 | H | H | H | H | H | An₈₉ | CN | O |
| 788 | Cy1 | H | H | H | H | An₁ | CN | H | O |
| 789 | Cy1 | H | H | H | H | An₂ | CN | H | O |
| 790 | Cy1 | H | H | H | H | An₃ | CN | H | O |
| 791 | Cy1 | H | H | H | H | An₄ | CN | H | O |
| 792 | Cy1 | H | H | H | H | An₅ | CN | H | O |
| 793 | Cy1 | H | H | H | H | An₆ | CN | H | O |
| 794 | Cy1 | H | H | H | H | An₇ | CN | H | O |
| 795 | Cy1 | H | H | H | H | An₈ | CN | H | O |
| 796 | Cy1 | H | H | H | H | An₉ | CN | H | O |
| 797 | Cy1 | H | H | H | H | An₁₀ | CN | H | O |
| 798 | Cy1 | H | H | H | H | An₁₁ | CN | H | O |
| 799 | Cy1 | H | H | H | H | An₁₂ | CN | H | O |
| 800 | Cy1 | H | H | H | H | An₁₃ | CN | H | O |
| 801 | Cy1 | H | H | H | H | An₁₄ | CN | H | O |
| 802 | Cy1 | H | H | H | H | An₁₅ | CN | H | O |
| 803 | Cy1 | H | H | H | H | An₁₆ | CN | H | O |
| 804 | Cy1 | H | H | H | H | An₁₇ | CN | H | O |
| 805 | Cy1 | H | H | H | H | An₁₈ | CN | H | O |
| 806 | Cy1 | H | H | H | H | An₁₉ | CN | H | O |
| 807 | Cy1 | H | H | H | H | An₂₀ | CN | H | O |
| 808 | Cy1 | H | H | H | H | An₂₁ | CN | H | O |
| 809 | Cy1 | H | H | H | H | An₂₂ | CN | H | O |
| 810 | Cy1 | H | H | H | H | An₂₃ | CN | H | O |
| 811 | Cy1 | H | H | H | H | An₂₄ | CN | H | O |
| 812 | Cy1 | H | H | H | H | An₂₅ | CN | H | O |
| 813 | Cy1 | H | H | H | H | An₂₆ | CN | H | O |
| 814 | Cy1 | H | H | H | H | An₂₇ | CN | H | O |
| 815 | Cy1 | H | H | H | H | An₂₈ | CN | H | O |
| 816 | Cy1 | H | H | H | H | An₂₉ | CN | H | O |
| 817 | Cy1 | H | H | H | H | An₃₀ | CN | H | O |
| 818 | Cy1 | H | H | H | H | An₃₁ | CN | H | O |
| 819 | Cy1 | H | H | H | H | An₃₂ | CN | H | O |
| 820 | Cy1 | H | H | H | H | An₃₃ | CN | H | O |
| 821 | Cy1 | H | H | H | H | An₃₄ | CN | H | O |
| 822 | Cy1 | H | H | H | H | An₃₅ | CN | H | O |
| 823 | Cy1 | H | H | H | H | An₃₆ | CN | H | O |
| 824 | Cy1 | H | H | H | H | An₃₇ | CN | H | O |
| 825 | Cy1 | H | H | H | H | An₃₈ | CN | H | O |
| 826 | Cy1 | H | H | H | H | An₃₉ | CN | H | O |
| 827 | Cy1 | H | H | H | H | An₄₀ | CN | H | O |
| 828 | Cy1 | H | H | H | H | An₄₁ | CN | H | O |
| 829 | Cy1 | H | H | H | H | An₄₂ | CN | H | O |
| 830 | Cy1 | H | H | H | H | An₄₃ | CN | H | O |
| 831 | Cy1 | H | H | H | H | An₄₄ | CN | H | O |
| 832 | Cy1 | H | H | H | H | An₄₅ | CN | H | O |
| 833 | Cy1 | H | H | H | H | An₄₆ | CN | H | O |
| 834 | Cy1 | H | H | H | H | An₄₇ | CN | H | O |
| 835 | Cy1 | H | H | H | H | An₄₈ | CN | H | O |
| 836 | Cy1 | H | H | H | H | An₄₉ | CN | H | O |
| 837 | Cy1 | H | H | H | H | An₅₀ | CN | H | O |
| 838 | Cy1 | H | H | H | H | An₅₁ | CN | H | O |
| 839 | Cy1 | H | H | H | H | An₅₂ | CN | H | O |
| 840 | Cy1 | H | H | H | H | An₅₃ | CN | H | O |
| 841 | Cy1 | H | H | H | H | An₅₄ | CN | H | O |
| 842 | Cy1 | H | H | H | H | An₅₅ | CN | H | O |
| 843 | Cy1 | H | H | H | H | An₅₆ | CN | H | O |
| 844 | Cy1 | H | H | H | H | An₅₇ | CN | H | O |
| 845 | Cy1 | H | H | H | H | An₅₈ | CN | H | O |
| 846 | Cy1 | H | H | H | H | An₅₉ | CN | H | O |
| 847 | Cy1 | H | H | H | H | An₆₀ | CN | H | O |
| 848 | Cy1 | H | H | H | H | An₆₁ | CN | H | O |
| 849 | Cy1 | H | H | H | H | An₆₂ | CN | H | O |
| 850 | Cy1 | H | H | H | H | An₆₃ | CN | H | O |
| 851 | Cy1 | H | H | H | H | An₆₄ | CN | H | O |
| 852 | Cy1 | H | H | H | H | An₆₅ | CN | H | O |
| 853 | Cy1 | H | H | H | H | An₆₆ | CN | H | O |
| 854 | Cy1 | H | H | H | H | An₆₇ | CN | H | O |
| 855 | Cy1 | H | H | H | H | An₆₈ | CN | H | O |
| 856 | Cy1 | H | H | H | H | An₆₉ | CN | H | O |
| 857 | Cy1 | H | H | H | H | An₇₀ | CN | H | O |
| 858 | Cy1 | H | H | H | H | An₇₁ | CN | H | O |
| 859 | Cy1 | H | H | H | H | An₇₂ | CN | H | O |
| 860 | Cy1 | H | H | H | H | An₇₃ | CN | H | O |
| 861 | Cy1 | H | H | H | H | An₇₄ | CN | H | O |
| 862 | Cy1 | H | H | H | H | An₇₅ | CN | H | O |
| 863 | Cy1 | H | H | H | H | An₇₆ | CN | H | O |
| 864 | Cy1 | H | H | H | H | An₇₇ | CN | H | O |
| 865 | Cy1 | H | H | H | H | An₇₈ | CN | H | O |
| 866 | Cy1 | H | H | H | H | An₇₉ | CN | H | O |
| 867 | Cy1 | H | H | H | H | An₈₀ | CN | H | O |
| 868 | Cy1 | H | H | H | H | An₈₁ | CN | H | O |
| 869 | Cy1 | H | H | H | H | An₈₂ | CN | H | O |
| 870 | Cy1 | H | H | H | H | An₈₃ | CN | H | O |
| 871 | Cy1 | H | H | H | H | An₈₄ | CN | H | O |
| 872 | Cy1 | H | H | H | H | An₈₅ | CN | H | O |
| 873 | Cy1 | H | H | H | H | An₈₆ | CN | H | O |
| 874 | Cy1 | H | H | H | H | An₈₇ | CN | H | O |
| 875 | Cy1 | H | H | H | H | An₈₈ | CN | H | O |
| 876 | Cy1 | H | H | H | H | An₈₉ | CN | H | O |
| 877 | Cy1 | H | H | H | An₁ | H | CN | H | O |
| 878 | Cy1 | H | H | H | An₁₀ | H | CN | H | O |
| 879 | Cy1 | H | H | H | An₁₃ | H | H | CN | O |
| 880 | Cy1 | H | H | H | An₃₁ | H | H | CN | O |
| 881 | Cy1 | H | H | H | An₃₅ | H | H | CN | O |
| 882 | Cy1 | H | H | An₁ | H | H | CN | H | O |
| 883 | Cy1 | H | H | An₁₀ | H | H | CN | H | O |
| 884 | Cy1 | H | H | An₁₃ | H | H | CN | H | O |
| 885 | Cy1 | H | H | An₃₁ | H | H | H | CN | O |
| 886 | Cy1 | H | H | An₃₅ | H | H | H | CN | O |
| 887 | Cy1 | CH₃ | H | H | H | H | CN | An₁ | O |
| 888 | Cy1 | CH₃ | H | H | H | H | CN | An₁₀ | O |
| 889 | Cy1 | CH₃ | H | H | H | H | CN | An₁₃ | O |
| 890 | Cy1 | CH₃ | H | H | H | H | CN | An₃₁ | O |
| 891 | Cy1 | CH₃ | H | H | H | H | CN | An₃₅ | O |
| 892 | Cy1 | CH₃ | H | H | H | An₁ | CN | H | O |
| 893 | Cy1 | H | CH₃ | H | H | H | CN | An₁ | O |
| 894 | Cy1 | H | CH₃ | H | H | H | CN | An₁₀ | O |
| 895 | Cy1 | H | CH₃ | H | H | H | CN | An₁₃ | O |
| 896 | Cy1 | H | CH₃ | H | H | H | CN | An₃₁ | O |
| 897 | Cy1 | H | CH₃ | H | H | H | CN | An₃₅ | O |
| 898 | Cy1 | H | CH₃ | H | H | An₁ | CN | H | O |
| 899 | Cy1 | CH₃ | CH₃ | H | H | H | CN | An₁ | O |
| 900 | Cy1 | CH₃ | CH₃ | H | H | H | CN | An₁₀ | O |
| 901 | Cy1 | CH₃ | CH₃ | H | H | H | CN | An₁₃ | O |
| 902 | Cy1 | CH₃ | CH₃ | H | H | H | CN | An₃₁ | O |
| 903 | Cy1 | CH₃ | CH₃ | H | H | H | CN | An₃₅ | O |
| 904 | Cy1 | CH₃ | CH₃ | H | H | An₁ | CN | H | O |
| 905 | Cy1 | CH₃ | H | H | H | H | An₁ | CN | O |
| 906 | Cy1 | CH₃ | H | H | H | H | An₁₀ | CN | O |
| 907 | Cy1 | CH₃ | H | H | H | H | An₁₃ | CN | O |
| 908 | Cy1 | CH₃ | H | H | H | H | An₃₁ | CN | O |
| 909 | Cy1 | CH₃ | H | H | H | H | An₃₅ | CN | O |
| 910 | Cy1 | H | CH₃ | H | H | H | An₁ | CN | O |
| 911 | Cy1 | H | CH₃ | H | H | H | An₁₀ | CN | O |
| 912 | Cy1 | H | CH₃ | H | H | H | An₁₃ | CN | O |
| 913 | Cy1 | H | CH₃ | H | H | H | An₃₁ | CN | O |
| 914 | Cy1 | H | CH₃ | H | H | H | An₃₅ | CN | O |
| 915 | Cy1 | CH₃ | CH₃ | H | H | H | An₁ | CN | O |
| 916 | Cy1 | CH₃ | CH₃ | H | H | H | An₁₀ | CN | O |
| 917 | Cy1 | CH₃ | CH₃ | H | H | H | An₁₃ | CN | O |
| 918 | Cy1 | CH₃ | CH₃ | H | H | H | An₃₁ | CN | O |
| 919 | Cy1 | CH₃ | CH₃ | H | H | H | An₃₅ | CN | O |
| 920 | Cy1 | *t*-Bu | H | H | H | H | CN | An₁ | O |
| 921 | Cy1 | *t*-Bu | H | H | H | H | CN | An₁₀ | O |
| 922 | Cy1 | *t*-Bu | H | H | H | H | CN | An₁₃ | O |
| 923 | Cy1 | *t*-Bu | H | H | H | H | CN | An₃₁ | O |
| 924 | Cy1 | *t*-Bu | H | H | H | H | CN | An₃₅ | O |
| 925 | Cy1 | *t*-Bu | H | H | H | An₁ | CN | H | O |
| 926 | Cy1 | H | *t*-Bu | H | H | H | CN | An₁ | O |
| 927 | Cy1 | H | *t*-Bu | H | H | H | CN | An₁₀ | O |
| 928 | Cy1 | H | *t*-Bu | H | H | H | CN | An₁₃ | O |
| 929 | Cy1 | H | *t*-Bu | H | H | H | CN | An₃₁ | O |
| 930 | Cy1 | H | *t*-Bu | H | H | H | CN | An₃₅ | O |
| 931 | Cy1 | H | *t*-Bu | H | H | An₁ | CN | H | O |
| 932 | Cy1 | *t*-Bu | H | H | H | H | An₁ | CN | O |
| 933 | Cy1 | *t*-Bu | H | H | H | H | An₁₀ | CN | O |
| 934 | Cy1 | *t*-Bu | H | H | H | H | An₁₃ | CN | O |
| 935 | Cy1 | *t*-Bu | H | H | H | H | An₃₁ | CN | O |
| 936 | Cy1 | *t*-Bu | H | H | H | H | An₃₅ | CN | O |
| 937 | Cy1 | H | *t*-Bu | H | H | H | An₁ | CN | O |
| 938 | Cy1 | H | *t*-Bu | H | H | H | An₁₀ | CN | O |
| 939 | Cy1 | H | *t*-Bu | H | H | H | An₁₃ | CN | O |
| 940 | Cy1 | H | *t*-Bu | H | H | H | An₃₁ | CN | O |
| 941 | Cy1 | H | *t*-Bu | H | H | H | An₃₅ | CN | O |
| 942 | Cy1 | *neo*-pent | H | H | H | H | CN | An₁ | O |
| 943 | Cy1 | *neo*-pent | H | H | H | H | CN | An₁₀ | O |
| 944 | Cy1 | *neo*-pent | H | H | H | H | CN | An₁₃ | O |
| 945 | Cy1 | *neo*-pent | H | H | H | H | CN | An₃₁ | O |
| 946 | Cy1 | *neo*-pent | H | H | H | H | CN | An₃₅ | O |
| 947 | Cy1 | *neo*-pent | H | H | H | An₁ | CN | H | O |
| 948 | Cy1 | H | *neo*-pent | H | H | H | CN | An₁ | O |
| 949 | Cy1 | H | *neo*-pent | H | H | H | CN | An₁₀ | O |
| 950 | Cy1 | H | *neo*-pent | H | H | H | CN | An₁₃ | O |
| 951 | Cy1 | H | *neo*-pent | H | H | H | CN | An₃₁ | O |
| 952 | Cy1 | H | *neo*-pent | H | H | H | CN | An₃₅ | O |
| 953 | Cy1 | H | *neo*-pent | H | H | An₁ | CN | H | O |
| 954 | Cy1 | *neo*-pent | H | H | H | H | An₁ | CN | O |
| 955 | Cy1 | *neo*-pent | H | H | H | H | An₁₀ | CN | O |
| 956 | Cy1 | *neo*-pent | H | H | H | H | An₁₃ | CN | O |
| 957 | Cy1 | *neo*-pent | H | H | H | H | An₃₁ | CN | O |
| 958 | Cy1 | *neo*-pent | H | H | H | H | An₃₅ | CN | O |
| 959 | Cy1 | H | *neo*-pent | H | H | H | An₁ | CN | O |
| 960 | Cy1 | H | *neo*-pent | H | H | H | An₁₀ | CN | O |
| 961 | Cy1 | H | *neo*-pent | H | H | H | An₁₃ | CN | O |
| 962 | Cy1 | H | *neo*-pent | H | H | H | An₃₁ | CN | O |
| 963 | Cy1 | H | *neo*-pent | H | H | H | An₃₅ | CN | O |
| 964 | Cy1 | CD₃ | H | H | H | H | CN | An₁ | O |
| 965 | Cy1 | H | CD₃ | H | H | H | CN | An₁ | O |
| 966 | Cy1 | CD₃ | CD₃ | H | H | H | CN | An₁ | O |
| 967 | Cy1 | CD₃ | CD₃ | H | H | An₁ | CN | H | O |
| 968 | Cy1 | CD₃ | D | H | H | H | CN | An₁ | O |
| 969 | Cy1 | CD₃ | D | H | H | H | CN | An₁₀ | O |
| 970 | Cy1 | CD₃ | D | H | H | H | CN | An₁₃ | O |
| 971 | Cy1 | CD₃ | D | H | H | H | CN | An₃₁ | O |
| 972 | Cy1 | CD₃ | D | H | H | H | CN | An₃₅ | O |
| 973 | Cy1 | CD₃ | D | H | H | An₁ | CN | H | O |
| 974 | Cy1 | D | CD₃ | H | H | H | CN | An₁ | O |
| 975 | Cy1 | D | CD₃ | H | H | H | CN | An₁₀ | O |
| 976 | Cy1 | D | CD₃ | H | H | H | CN | An₁₃ | O |
| 977 | Cy1 | D | CD₃ | H | H | H | CN | An₃₁ | O |
| 978 | Cy1 | D | CD₃ | H | H | H | CN | An₃₅ | O |
| 979 | Cy1 | D | CD₃ | H | H | An₁ | CN | H | O |
| 980 | Cy1 | CD₃ | D | H | H | H | An₁ | CN | O |
| 981 | Cy1 | CD₃ | D | H | H | H | An₁₀ | CN | O |
| 982 | Cy1 | CD₃ | D | H | H | H | An₁₃ | CN | O |
| 983 | Cy1 | CD₃ | D | H | H | H | An₃₁ | CN | O |
| 984 | Cy1 | CD₃ | D | H | H | H | An₃₅ | CN | O |
| 985 | Cy1 | D | CD₃ | H | H | H | An₁ | CN | O |
| 986 | Cy1 | D | CD₃ | H | H | H | An₁₀ | CN | O |
| 987 | Cy1 | D | CD₃ | H | H | H | An₁₃ | CN | O |
| 988 | Cy1 | D | CD₃ | H | H | H | An₃₁ | CN | O |
| 989 | Cy1 | D | CD₃ | H | H | H | An₃₅ | CN | O |
| 990 | Cy1 | H | H | H | H | TMS | CN | An₁₀ | O |
| 991 | Cy1 | H | H | H | H | TMG | CN | An₁₃ | O |
| 992 | Cy1 | H | H | H | H | TMS | CN | An₃₁ | O |
| 993 | Cy1 | H | H | H | H | TMG | CN | An₃₅ | O |
| 994 | Cy1 | H | H | H | H | An₃₅ | CN | D | O |
| 995 | Cy1 | H | H | H | H | D | An₁ | CN | O |
| 996 | Cy1 | H | H | H | H | TMS | An₁₀ | CN | O |
| 997 | Cy1 | H | H | H | H | TMG | An₁₃ | CN | O |
| 998 | Cy1 | H | H | H | H | TMS | An₃₁ | CN | O |
| 999 | Cy1 | H | H | H | H | TMG | An₃₅ | CN | O |
| 1000 | Cy1 | H | H | H | H | An₁ | CN | An₁ | O |
| 1001 | Cy1 | H | H | H | H | An₁₀ | CN | An₁ | O |
| 1002 | Cy1 | H | H | H | H | An₁₃ | CN | An₁ | O |
| 1003 | Cy1 | H | H | H | H | An₃₁ | CN | An₁ | O |
| 1004 | Cy1 | H | H | H | H | An₃₅ | CN | An₁ | O |
| 1005 | Cy1 | H | H | H | H | An₁ | An₁ | CN | O |
| 1006 | Cy1 | H | H | H | H | An₁ | An₁₀ | CN | O |
| 1007 | Cy1 | H | H | H | H | An₁ | An₁₃ | CN | O |
| 1008 | Cy1 | H | H | H | H | An₁ | An₃₁ | CN | O |
| 1009 | Cy1 | H | H | H | H | An₁ | An₃₅ | CN | O |
| 1010 | Cy1 | H | H | H | H | H | CN | An₁ | Se |
| 1011 | Cy1 | H | H | H | H | H | CN | An₁₀ | TMS |
| 1012 | Cy1 | H | H | H | H | H | CN | An₁₃ | TMG |
| 1013 | Cy1 | H | H | H | H | H | CN | An₃₁ | NPh |
| 1014 | Cy1 | H | H | H | H | H | CN | An₃₅ | TMS |
| 1015 | Cy1 | H | H | H | H | H | An₁ | CN | Se |
| 1016 | Cy1 | H | H | H | H | H | An₁₀ | CN | TMS |
| 1017 | Cy1 | H | H | H | H | H | An₁₃ | CN | TMG |
| 1018 | Cy1 | H | H | H | H | H | An₃₁ | CN | NPh |
| 1019 | Cy1 | H | H | H | H | H | An₃₅ | CN | TMG |
| 1020 | Cy1 | H | H | H | H | H | F | An₁ | O |
| 1021 | Cy1 | H | H | H | H | H | F | An₂ | O |
| 1022 | Cy1 | H | H | H | H | H | F | An₃ | O |
| 1023 | Cy1 | H | H | H | H | H | F | An₄ | O |
| 1024 | Cy1 | H | H | H | H | H | F | An₅ | O |
| 1025 | Cy1 | H | H | H | H | H | F | An₆ | O |
| 1026 | Cy1 | H | H | H | H | H | F | An₇ | O |
| 1027 | Cy1 | H | H | H | H | H | F | An₈ | O |
| 1028 | Cy1 | H | H | H | H | H | F | An₉ | O |
| 1029 | Cy1 | H | H | H | H | H | F | An₁₀ | O |
| 1030 | Cy1 | H | H | H | H | H | F | An₁₁ | O |
| 1031 | Cy1 | H | H | H | H | H | F | An₁₂ | O |
| 1032 | Cy1 | H | H | H | H | H | F | An₁₃ | O |
| 1033 | Cy1 | H | H | H | H | H | F | An₁₄ | O |
| 1034 | Cy1 | H | H | H | H | H | F | An₁₅ | O |
| 1035 | Cy1 | H | H | H | H | H | F | An₁₆ | O |
| 1036 | Cy1 | H | H | H | H | H | F | An₁₇ | O |
| 1037 | Cy1 | H | H | H | H | H | F | An₁₈ | O |
| 1038 | Cy1 | H | H | H | H | H | F | An₁₉ | O |
| 1039 | Cy1 | H | H | H | H | H | F | An₂₀ | O |
| 1040 | Cy1 | H | H | H | H | H | F | An₂₁ | O |
| 1041 | Cy1 | H | H | H | H | H | F | An₂₂ | O |
| 1042 | Cy1 | H | H | H | H | H | F | An₂₃ | O |
| 1043 | Cy1 | H | H | H | H | H | F | An₂₄ | O |
| 1044 | Cy1 | H | H | H | H | H | F | An₂₅ | O |
| 1045 | Cy1 | H | H | H | H | H | F | An₂₆ | O |
| 1046 | Cy1 | H | H | H | H | H | F | An₂₇ | O |
| 1047 | Cy1 | H | H | H | H | H | F | An₂₈ | O |
| 1048 | Cy1 | H | H | H | H | H | F | An₂₉ | O |
| 1049 | Cy1 | H | H | H | H | H | F | An₃₀ | O |
| 1050 | Cy1 | H | H | H | H | H | F | An₃₁ | O |
| 1051 | Cy1 | H | H | H | H | H | F | An₃₂ | O |
| 1052 | Cy1 | H | H | H | H | H | F | An₃₃ | O |
| 1053 | Cy1 | H | H | H | H | H | F | An₃₄ | O |
| 1054 | Cy1 | H | H | H | H | H | F | An₃₅ | O |
| 1055 | Cy1 | H | H | H | H | H | F | An₃₆ | O |
| 1056 | Cy1 | H | H | H | H | H | F | An₃₇ | O |
| 1057 | Cy1 | H | H | H | H | H | F | An₃₈ | O |
| 1058 | Cy1 | H | H | H | H | H | F | An₃₉ | O |
| 1059 | Cy1 | H | H | H | H | H | F | An₄₀ | O |
| 1060 | Cy1 | H | H | H | H | H | F | An₄₁ | O |
| 1061 | Cy1 | H | H | H | H | H | F | An₄₂ | O |
| 1062 | Cy1 | H | H | H | H | H | F | An₄₃ | O |
| 1063 | Cy1 | H | H | H | H | H | F | An₄₄ | O |
| 1064 | Cy1 | H | H | H | H | H | F | An₄₅ | O |
| 1065 | Cy1 | H | H | H | H | H | F | An₄₆ | O |
| 1066 | Cy1 | H | H | H | H | H | F | An₄₇ | O |
| 1067 | Cy1 | H | H | H | H | H | F | An₄₈ | O |
| 1068 | Cy1 | H | H | H | H | H | F | An₄₉ | O |
| 1069 | Cy1 | H | H | H | H | H | F | An₅₀ | O |
| 1070 | Cy1 | H | H | H | H | H | F | An₅₁ | O |
| 1071 | Cy1 | H | H | H | H | H | F | An₅₂ | O |
| 1072 | Cy1 | H | H | H | H | H | F | An₅₃ | O |
| 1073 | Cy1 | H | H | H | H | H | F | An₅₄ | O |
| 1074 | Cy1 | H | H | H | H | H | F | An₅₅ | O |
| 1075 | Cy1 | H | H | H | H | H | F | An₅₆ | O |
| 1076 | Cy1 | H | H | H | H | H | F | An₅₇ | O |
| 1077 | Cy1 | H | H | H | H | H | F | An₅₈ | O |
| 1078 | Cy1 | H | H | H | H | H | F | An₅₉ | O |
| 1079 | Cy1 | H | H | H | H | H | F | An₆₀ | O |
| 1080 | Cy1 | H | H | H | H | H | F | An₆₁ | O |
| 1081 | Cy1 | H | H | H | H | H | F | An₆₂ | O |
| 1082 | Cy1 | H | H | H | H | H | F | An₆₃ | O |
| 1083 | Cy1 | H | H | H | H | H | F | An₆₄ | O |
| 1084 | Cy1 | H | H | H | H | H | F | An₆₅ | O |
| 1085 | Cy1 | H | H | H | H | H | F | An₆₆ | O |
| 1086 | Cy1 | H | H | H | H | H | F | An₆₇ | O |
| 1087 | Cy1 | H | H | H | H | H | F | An₆₈ | O |
| 1088 | Cy1 | H | H | H | H | H | F | An₆₉ | O |
| 1089 | Cy1 | H | H | H | H | H | F | An₇₀ | O |
| 1090 | Cy1 | H | H | H | H | H | F | An₇₁ | O |
| 1091 | Cy1 | H | H | H | H | H | F | An₇₂ | O |
| 1092 | Cy1 | H | H | H | H | H | F | An₇₃ | O |
| 1093 | Cy1 | H | H | H | H | H | F | An₇₄ | O |
| 1094 | Cy1 | H | H | H | H | H | F | An₇₅ | O |
| 1095 | Cy1 | H | H | H | H | H | F | An₇₆ | O |
| 1096 | Cy1 | H | H | H | H | H | F | An₇₇ | O |
| 1097 | Cy1 | H | H | H | H | H | F | An₇₈ | O |
| 1098 | Cy1 | H | H | H | H | H | F | An₇₉ | O |
| 1099 | Cy1 | H | H | H | H | H | F | An₈ₒ | O |
| 1100 | Cy1 | H | H | H | H | H | F | An₈i | O |
| 1101 | Cy1 | H | H | H | H | H | F | An₈₂ | O |
| 1102 | Cy1 | H | H | H | H | H | F | An₈₃ | O |
| 1103 | Cy1 | H | H | H | H | H | F | An₈₄ | O |
| 1104 | Cy1 | H | H | H | H | H | F | An₈₅ | O |
| 1105 | Cy1 | H | H | H | H | H | F | An₈₆ | O |
| 1106 | Cy1 | H | H | H | H | H | F | An₈₇ | O |
| 1107 | Cy1 | H | H | H | H | H | F | An₈₈ | O |
| 1108 | Cy1 | H | H | H | H | H | F | An₈₉ | O |
| 1109 | Cy1 | H | H | H | H | An₁ | F | H | O |
| 1110 | Cy1 | H | H | H | H | An₂ | F | H | O |
| 1111 | Cy1 | H | H | H | H | An₃ | F | H | O |
| 1112 | Cy1 | H | H | H | H | An₄ | F | H | O |
| 1113 | Cy1 | H | H | H | H | An₅ | F | H | O |
| 1114 | Cy1 | H | H | H | H | An₆ | F | H | O |
| 1115 | Cy1 | H | H | H | H | An₇ | F | H | O |
| 1116 | Cy1 | H | H | H | H | An₈ | F | H | O |
| 1117 | Cy1 | H | H | H | H | An₉ | F | H | O |
| 1118 | Cy1 | H | H | H | H | An₁₀ | F | H | O |
| 1119 | Cy1 | H | H | H | H | An₁₁ | F | H | O |
| 1120 | Cy1 | H | H | H | H | An₁₂ | F | H | O |
| 1121 | Cy1 | H | H | H | H | An₁₃ | F | H | O |
| 1122 | Cy1 | H | H | H | H | An₁₄ | F | H | O |
| 1123 | Cy1 | H | H | H | H | An₁₅ | F | H | O |
| 1124 | Cy1 | H | H | H | H | An₁₆ | F | H | O |
| 1125 | Cy1 | H | H | H | H | An₁₇ | F | H | O |
| 1126 | Cy1 | H | H | H | H | An₁₈ | F | H | O |
| 1127 | Cy1 | H | H | H | H | An₁₉ | F | H | O |
| 1128 | Cy1 | H | H | H | H | An₂₀ | F | H | O |
| 1129 | Cy1 | H | H | H | H | An₂₁ | F | H | O |
| 1130 | Cy1 | H | H | H | H | An₂₂ | F | H | O |
| 1131 | Cy1 | H | H | H | H | An₂₃ | F | H | O |
| 1132 | Cy1 | H | H | H | H | An₂₄ | F | H | O |
| 1133 | Cy1 | H | H | H | H | An₂₅ | F | H | O |
| 1134 | Cy1 | H | H | H | H | An₂₆ | F | H | O |
| 1135 | Cy1 | H | H | H | H | An₂₇ | F | H | O |
| 1136 | Cy1 | H | H | H | H | An₂₈ | F | H | O |
| 1137 | Cy1 | H | H | H | H | An₂₉ | F | H | O |
| 1138 | Cy1 | H | H | H | H | An₃₀ | F | H | O |
| 1139 | Cy1 | H | H | H | H | An₃₁ | F | H | O |
| 1140 | Cy1 | H | H | H | H | An₃₂ | F | H | O |
| 1141 | Cy1 | H | H | H | H | An₃₃ | F | H | O |
| 1142 | Cy1 | H | H | H | H | An₃₄ | F | H | O |
| 1143 | Cy1 | H | H | H | H | An₃₅ | F | H | O |
| 1144 | Cy1 | H | H | H | H | An₃₆ | F | H | O |
| 1145 | Cy1 | H | H | H | H | An₃₇ | F | H | O |
| 1146 | Cy1 | H | H | H | H | An₃₈ | F | H | O |
| 1147 | Cy1 | H | H | H | H | An₃₉ | F | H | O |
| 1148 | Cy1 | H | H | H | H | An₄₀ | F | H | O |
| 1149 | Cy1 | H | H | H | H | An₄₁ | F | H | O |
| 1150 | Cy1 | H | H | H | H | An₄₂ | F | H | O |
| 1151 | Cy1 | H | H | H | H | An₄₃ | F | H | O |
| 1152 | Cy1 | H | H | H | H | An₄₄ | F | H | O |
| 1153 | Cy1 | H | H | H | H | An₄₅ | F | H | O |
| 1154 | Cy1 | H | H | H | H | An₄₆ | F | H | O |
| 1155 | Cy1 | H | H | H | H | An₄₇ | F | H | O |
| 1156 | Cy1 | H | H | H | H | An₄₈ | F | H | O |
| 1157 | Cy1 | H | H | H | H | An₄₉ | F | H | O |
| 1158 | Cy1 | H | H | H | H | An₅₀ | F | H | O |
| 1159 | Cy1 | H | H | H | H | An₅₁ | F | H | O |
| 1160 | Cy1 | H | H | H | H | An₅₂ | F | H | O |
| 1161 | Cy1 | H | H | H | H | An₅₃ | F | H | O |
| 1162 | Cy1 | H | H | H | H | An₅₄ | F | H | O |
| 1163 | Cy1 | H | H | H | H | An₅₅ | F | H | O |
| 1164 | Cy1 | H | H | H | H | An₅₆ | F | H | O |
| 1165 | Cy1 | H | H | H | H | An₅₇ | F | H | O |
| 1166 | Cy1 | H | H | H | H | An₅₈ | F | H | O |
| 1167 | Cy1 | H | H | H | H | An₅₉ | F | H | O |
| 1168 | Cy1 | H | H | H | H | An₆₀ | F | H | O |
| 1169 | Cy1 | H | H | H | H | An₆₁ | F | H | O |
| 1170 | Cy1 | H | H | H | H | An₆₂ | F | H | O |
| 1171 | Cy1 | H | H | H | H | An₆₃ | F | H | O |
| 1172 | Cy1 | H | H | H | H | An₆₄ | F | H | O |
| 1173 | Cy1 | H | H | H | H | An₆₅ | F | H | O |
| 1174 | Cy1 | H | H | H | H | An₆₆ | F | H | O |
| 1175 | Cy1 | H | H | H | H | An₆₇ | F | H | O |
| 1176 | Cy1 | H | H | H | H | An₆₈ | F | H | O |
| 1177 | Cy1 | H | H | H | H | An₆₉ | F | H | O |
| 1178 | Cy1 | H | H | H | H | An₇₀ | F | H | O |
| 1179 | Cy1 | H | H | H | H | An₇₁ | F | H | O |
| 1180 | Cy1 | H | H | H | H | An₇₂ | F | H | O |
| 1181 | Cy1 | H | H | H | H | An₇₃ | F | H | O |
| 1182 | Cy1 | H | H | H | H | An₇₄ | F | H | O |
| 1183 | Cy1 | H | H | H | H | An₇₅ | F | H | O |
| 1184 | Cy1 | H | H | H | H | An₇₆ | F | H | O |
| 1185 | Cy1 | H | H | H | H | An₇₇ | F | H | O |
| 1186 | Cy1 | H | H | H | H | An₇₈ | F | H | O |
| 1187 | Cy1 | H | H | H | H | An₇₉ | F | H | O |
| 1188 | Cy1 | H | H | H | H | An₈₀ | F | H | O |
| 1189 | Cy1 | H | H | H | H | An₈₁ | F | H | O |
| 1190 | Cy1 | H | H | H | H | An₈₂ | F | H | O |
| 1191 | Cy1 | H | H | H | H | An₈₃ | F | H | O |
| 1192 | Cy1 | H | H | H | H | An₈₄ | F | H | O |
| 1193 | Cy1 | H | H | H | H | An₈₅ | F | H | O |
| 1194 | Cy1 | H | H | H | H | An₈₆ | F | H | O |
| 1195 | Cy1 | H | H | H | H | An₈₇ | F | H | O |
| 1196 | Cy1 | H | H | H | H | An₈₈ | F | H | O |
| 1197 | Cy1 | H | H | H | H | An₈₉ | F | H | O |
| 1198 | Cy1 | H | H | H | H | H | An₁ | F | O |
| 1199 | Cy1 | H | H | H | H | H | An₁₀ | F | O |
| 1200 | Cy1 | H | H | H | H | H | An₁₃ | F | O |
| 1201 | Cy1 | H | H | H | H | H | An₃₁ | F | O |
| 1202 | Cy1 | H | H | H | H | H | An₃₅ | F | O |
| 1203 | Cy1 | H | H | H | An₁ | H | F | H | O |
| 1204 | Cy1 | H | H | H | An₁₀ | H | F | H | O |
| 1205 | Cy1 | H | H | H | An₁₃ | H | F | H | O |
| 1206 | Cy1 | H | H | H | An₃₁ | H | F | H | O |
| 1207 | Cy1 | H | H | H | An₃₅ | H | F | H | O |
| 1208 | Cy1 | H | H | An₁ | H | H | F | H | O |
| 1209 | Cy1 | H | H | An₁₀ | H | H | F | H | O |
| 1210 | Cy1 | H | H | An₁₃ | H | H | F | H | O |
| 1211 | Cy1 | H | H | An₃₁ | H | H | F | H | O |
| 1212 | Cy1 | H | H | An₃₅ | H | H | F | H | O |
| 1213 | Cy1 | CH₃ | H | H | H | H | F | An₁ | O |
| 1214 | Cy1 | CH₃ | H | H | H | H | F | An₁₀ | O |
| 1215 | Cy1 | CH₃ | H | H | H | H | F | An₁₃ | O |
| 1216 | Cy1 | CH₃ | H | H | H | H | F | An₃₁ | O |
| 1217 | Cy1 | CH₃ | H | H | H | H | F | An₃₅ | O |
| 1218 | Cy1 | CH₃ | H | H | H | An₁ | F | H | O |
| 1219 | Cy1 | H | CH₃ | H | H | H | F | An₁ | O |
| 1220 | Cy1 | H | CH₃ | H | H | H | F | An₁₀ | O |
| 1221 | Cy1 | H | CH₃ | H | H | H | F | An₁₃ | O |
| 1222 | Cy1 | H | CH₃ | H | H | H | F | An₃₁ | O |
| 1223 | Cy1 | H | CH₃ | H | H | H | F | An₃₅ | O |
| 1224 | Cy1 | H | CH₃ | H | H | An₁ | F | H | O |
| 1225 | Cy1 | CH₃ | CH₃ | H | H | H | F | An₁ | O |
| 1226 | Cy1 | CH₃ | CH₃ | H | H | H | F | An₁₀ | O |
| 1227 | Cy1 | CH₃ | CH₃ | H | H | H | F | An₁₃ | O |
| 1228 | Cy1 | CH₃ | CH₃ | H | H | H | F | An₃₁ | O |
| 1229 | Cy1 | CH₃ | CH₃ | H | H | H | F | An₃₅ | O |
| 1230 | Cy1 | CH₃ | CH₃ | H | H | An₁ | F | H | O |
| 1231 | Cy1 | *t*-Bu | H | H | H | H | F | An₁ | O |
| 1232 | Cy1 | *t*-Bu | H | H | H | H | F | An₁₀ | O |
| 1233 | Cy1 | *t*-Bu | H | H | H | H | F | An₁₃ | O |
| 1234 | Cy1 | *t*-Bu | H | H | H | H | F | An₃₁ | O |
| 1235 | Cy1 | *t*-Bu | H | H | H | H | F | An₃₅ | O |
| 1236 | Cy1 | *t*-Bu | H | H | H | An₁ | F | H | O |
| 1237 | Cy1 | H | *t*-Bu | H | H | H | F | An₁ | O |
| 1238 | Cy1 | H | *t*-Bu | H | H | H | F | An₁₀ | O |
| 1239 | Cy1 | H | *t*-Bu | H | H | H | F | An₁₃ | O |
| 1240 | Cy1 | H | *t*-Bu | H | H | H | F | An₃₁ | O |
| 1241 | Cy1 | H | *t*-Bu | H | H | H | F | An₃₅ | O |
| 1242 | Cy1 | H | *t*-Bu | H | H | An₁ | F | H | O |
| 1243 | Cy1 | *neo*-pent | H | H | H | H | F | An₁ | O |
| 1244 | Cy1 | *neo*-pent | H | H | H | H | F | An₁₀ | O |
| 1245 | Cy1 | *neo*-pent | H | H | H | H | F | An₁₃ | O |
| 1246 | Cy1 | *neo*-pent | H | H | H | H | F | An₃₁ | O |
| 1247 | Cy1 | *neo*-pent | H | H | H | H | F | An₃₅ | O |
| 1248 | Cy1 | *neo*-pent | H | H | H | An₁ | F | H | O |
| 1249 | Cy1 | H | *neo*-pent | H | H | H | F | An₁ | O |
| 1250 | Cy1 | H | *neo*-pent | H | H | H | F | An₁₀ | O |
| 1251 | Cy1 | H | *neo*-pent | H | H | H | F | An₁₃ | O |
| 1252 | Cy1 | H | *neo*-pent | H | H | H | F | An₃₁ | O |
| 1253 | Cy1 | H | *neo*-pent | H | H | H | F | An₃₅ | O |
| 1254 | Cy1 | H | *neo*-pent | H | H | H | F | H | O |
| 1255 | Cy1 | CD₃ | H | H | H | H | F | An₁ | O |
| 1256 | Cy1 | H | CD₃ | H | H | H | F | An₁ | O |
| 1257 | Cy1 | CD₃ | CD₃ | H | H | H | F | An₁ | O |
| 1258 | Cy1 | CD₃ | CD₃ | H | H | An₁ | F | H | O |
| 1259 | Cy1 | CD₃ | D | H | H | H | F | An₁ | O |
| 1260 | Cy1 | CD₃ | D | H | H | H | F | An₁₀ | O |
| 1261 | Cy1 | CD₃ | D | H | H | H | F | An₁₃ | O |
| 1262 | Cy1 | CD₃ | D | H | H | H | F | An₃₁ | O |
| 1263 | Cy1 | CD₃ | D | H | H | H | F | An₃₅ | O |
| 1264 | Cy1 | CD₃ | D | H | H | An₁ | F | H | O |
| 1265 | Cy1 | D | CD₃ | H | H | H | F | An₁ | O |
| 1266 | Cy1 | D | CD₃ | H | H | H | F | An₁₀ | O |
| 1267 | Cy1 | D | CD₃ | H | H | H | F | An₁₃ | O |
| 1268 | Cy1 | D | CD₃ | H | H | H | F | An₃₁ | O |
| 1269 | Cy1 | D | CD₃ | H | H | H | F | An₃₅ | O |
| 1270 | Cy1 | D | CD₃ | H | H | An₁ | F | H | O |
| 1271 | Cy1 | H | H | H | H | CH₃ | F | An₁ | O |
| 1272 | Cy1 | H | H | H | H | CD₃ | F | An₁₀ | O |
| 1273 | Cy1 | H | H | H | H | CH₃ | F | An₁₃ | O |
| 1274 | Cy1 | H | H | H | H | CD₃ | F | An₃₁ | O |
| 1275 | Cy1 | H | H | H | H | CH₃ | F | An₃₅ | O |
| 1276 | Cy1 | H | H | H | H | An₃₅ | F | CH₃ | O |
| 1277 | Cy1 | H | H | H | H | D | F | An₁ | O |
| 1278 | Cy1 | H | H | H | H | TMS | F | An₁₀ | O |
| 1279 | Cy1 | H | H | H | H | TMG | F | An₁₃ | O |
| 1280 | Cy1 | H | H | H | H | TMS | F | An₃₁ | O |
| 1281 | Cy1 | H | H | H | H | TMG | F | An₃₅ | O |
| 1282 | Cy1 | H | H | H | H | An₃₅ | F | D | O |
| 1283 | Cy1 | H | H | H | H | An₁ | F | An₁ | O |
| 1284 | Cy1 | H | H | H | H | An₁₀ | F | An₁ | O |
| 1285 | Cy1 | H | H | H | H | An₁₃ | F | An₁ | O |
| 1286 | Cy1 | H | H | H | H | An₃₁ | F | An₁ | O |
| 1287 | Cy1 | H | H | H | H | An₃₅ | F | An₁ | O |
| 1288 | Cy1 | H | H | H | H | H | F | An₁ | Se |
| 1289 | Cy1 | H | H | H | H | H | F | An₁₀ | TMS |
| 1290 | Cy1 | H | H | H | H | H | F | An₁₃ | TMG |
| 1291 | Cy1 | H | H | H | H | H | F | An₃₁ | NPh |
| 1292 | Cy1 | H | H | H | H | H | F | An₃₅ | TMS |
| 1293 | Cy2 | - | - | H | H | H | H | An₁ | O |
| 1294 | Cy2 | - | - | H | H | H | CN | An₁ | O |
| 1295 | Cy2 | - | - | H | H | H | F | An₁ | O |
| 1296 | Cy2 | - | - | H | H | H | CN | An₁₀ | O |
| 1297 | Cy2 | - | - | H | H | H | F | An₁₃ | O |
| 1298 | Cy2 | - | - | H | H | H | CN | An₃₁ | O |
| 1299 | Cy2 | - | - | H | H | H | F | An₃₅ | O |
| 1300 | Cy2 | - | - | H | H | H | An₁ | H | O |
| 1301 | Cy2 | - | - | H | H | H | An₁ | CN | O |
| 1302 | Cy2 | - | - | H | H | H | An10 | H | O |
| 1303 | Cy2 | - | - | H | H | H | An13 | CN | O |
| 1304 | Cy2 | - | - | H | H | H | An31 | H | O |
| 1305 | Cy2 | - | - | H | H | H | An35 | CN | O |
| 1306 | Cy3 | - | - | H | H | H | H | An₁ | O |
| 1307 | Cy3 | - | - | H | H | H | CN | An₁ | O |
| 1308 | Cy3 | - | - | H | H | H | F | An₁ | O |
| 1309 | Cy3 | - | - | H | H | H | CN | An₁₀ | O |
| 1310 | Cy3 | - | - | H | H | H | F | An₁₃ | O |
| 1311 | Cy3 | - | - | H | H | H | CN | An₃₁ | O |
| 1312 | Cy3 | - | - | H | H | H | F | An₃₅ | O |
| 1313 | Cy3 | - | - | H | H | H | An₁ | H | O |
| 1314 | Cy3 | - | - | H | H | H | An₁ | CN | O |
| 1315 | Cy3 | - | - | H | H | H | An10 | H | O |
| 1316 | Cy3 | - | - | H | H | H | An13 | CN | O |
| 1317 | Cy3 | - | - | H | H | H | An31 | H | O |
| 1318 | Cy3 | - | - | H | H | H | An35 | CN | O |
| 1319 | Cy4 | - | - | H | H | H | H | An₁ | O |
| 1320 | Cy4 | - | - | H | H | H | CN | An₁ | O |
| 1321 | Cy4 | - | - | H | H | H | F | An₁ | O |
| 1322 | Cy4 | - | - | H | H | H | CN | An₁₀ | O |
| 1323 | Cy4 | - | - | H | H | H | F | An₁₃ | O |
| 1324 | Cy4 | - | - | H | H | H | CN | An₃₁ | O |
| 1325 | Cy4 | - | - | H | H | H | F | An₃₅ | O |
| 1326 | Cy4 | - | - | H | H | H | An₁ | H | O |
| 1327 | Cy4 | - | - | H | H | H | An₁ | CN | O |
| 1328 | Cy4 | - | - | H | H | H | An10 | H | O |
| 1329 | Cy4 | - | - | H | H | H | An13 | CN | O |
| 1330 | Cy4 | - | - | H | H | H | An31 | H | O |
| 1331 | Cy4 | - | - | H | H | H | An35 | CN | O |
| 1332 | Cy5 | CH3 | - | H | H | H | H | An₁ | O |
| 1333 | Cy5 | CH3 | - | H | H | H | CN | An₁ | O |
| 1334 | Cy5 | CH3 | - | H | H | H | F | An₁ | O |
| 1335 | Cy5 | CH3 | - | H | H | H | CN | An₁₀ | O |
| 1336 | Cy5 | CH3 | - | H | H | H | F | An₁₃ | O |
| 1337 | Cy5 | CH3 | - | H | H | H | CN | An₃₁ | O |
| 1338 | Cy5 | CH3 | - | H | H | H | F | An₃₅ | O |
| 1339 | Cy5 | CH3 | - | H | H | H | An₁ | H | O |
| 1340 | Cy5 | CH3 | - | H | H | H | An₁ | CN | O |
| 1341 | Cy5 | CH3 | - | H | H | H | An10 | H | O |
| 1342 | Cy5 | CH3 | - | H | H | H | An13 | CN | O |
| 1343 | Cy5 | CH3 | - | H | H | H | An31 | H | O |
| 1344 | Cy5 | CH3 | - | H | H | H | An35 | CN | O |
| 1345 | Cy5 | Ph | - | H | H | H | H | An₁ | O |
| 1346 | Cy5 | Ph | - | H | H | H | CN | An₁ | O |
| 1347 | Cy5 | Ph | - | H | H | H | F | An₁ | O |
| 1348 | Cy5 | Ph | - | H | H | H | CN | An₁₀ | O |
| 1349 | Cy5 | Ph | - | H | H | H | F | An₁₃ | O |
| 1350 | Cy5 | Ph | - | H | H | H | CN | An₃₁ | O |
| 1351 | Cy5 | Ph | - | H | H | H | F | An₃₅ | O |
| 1352 | Cy5 | Ph | - | H | H | H | An₁ | H | O |
| 1353 | Cy5 | Ph | - | H | H | H | An₁ | CN | O |
| 1354 | Cy5 | Ph | - | H | H | H | An10 | H | O |
| 1355 | Cy5 | Ph | - | H | H | H | An13 | CN | O |
| 1356 | Cy5 | Ph | - | H | H | H | An31 | H | O |
| 1357 | Cy5 | Ph | - | H | H | H | An35 | CN | O |
| 1358 | Cy6 | - | - | H | H | H | H | An₁ | O |
| 1359 | Cy6 | - | - | H | H | H | CN | An₁ | O |
| 1360 | Cy6 | - | - | H | H | H | F | An₁ | O |
| 1361 | Cy6 | - | - | H | H | H | CN | An₁₀ | O |
| 1362 | Cy6 | - | - | H | H | H | F | An₁₃ | O |
| 1363 | Cy6 | - | - | H | H | H | CN | An₃₁ | O |
| 1364 | Cy6 | - | - | H | H | H | F | An₃₅ | O |
| 1365 | Cy6 | - | - | H | H | H | An₁ | H | O |
| 1366 | Cy6 | - | - | H | H | H | An₁ | CN | O |
| 1367 | Cy6 | - | - | H | H | H | An10 | H | O |
| 1368 | Cy6 | - | - | H | H | H | An13 | CN | O |
| 1369 | Cy6 | - | - | H | H | H | An31 | H | O |
| 1370 | Cy6 | - | - | H | H | H | An35 | CN | O |
| 1371 | Cy7 | CH3 | - | H | H | H | H | An₁ | O |
| 1372 | Cy7 | CH3 | - | H | H | H | CN | An₁ | O |
| 1373 | Cy7 | CH3 | - | H | H | H | F | An₁ | O |
| 1374 | Cy7 | CH3 | - | H | H | H | CN | An₁₀ | O |
| 1375 | Cy7 | CH3 | - | H | H | H | F | An₁₃ | O |
| 1376 | Cy7 | CH3 | - | H | H | H | CN | An₃₁ | O |
| 1377 | Cy7 | CH3 | - | H | H | H | F | An₃₅ | O |
| 1378 | Cy7 | CH3 | - | H | H | H | An₁ | H | O |
| 1379 | Cy7 | CH3 | - | H | H | H | An₁ | CN | O |
| 1380 | Cy7 | CH3 | - | H | H | H | An10 | H | O |
| 1381 | Cy7 | CH3 | - | H | H | H | An13 | CN | O |
| 1382 | Cy7 | CH3 | - | H | H | H | An31 | H | O |
| 1383 | Cy7 | CH3 | - | H | H | H | An35 | CN | O |
| 1384 | Cy7 | Ph | - | H | H | H | H | An₁ | O |
| 1385 | Cy7 | Ph | - | H | H | H | CN | An₁ | O |
| 1386 | Cy7 | Ph | - | H | H | H | F | An₁ | O |
| 1387 | Cy7 | Ph | - | H | H | H | CN | An₁₀ | O |
| 1388 | Cy7 | Ph | - | H | H | H | F | An₁₃ | O |
| 1389 | Cy7 | Ph | - | H | H | H | CN | An₃₁ | O |
| 1390 | Cy7 | Ph | - | H | H | H | F | An₃₅ | O |
| 1391 | Cy7 | Ph | - | H | H | H | An₁ | H | O |
| 1392 | Cy7 | Ph | - | H | H | H | An₁ | CN | O |
| 1393 | Cy7 | Ph | - | H | H | H | An10 | H | O |
| 1394 | Cy7 | Ph | - | H | H | H | An13 | CN | O |
| 1395 | Cy7 | Ph | - | H | H | H | An31 | H | O |
| 1396 | Cy7 | Ph | - | H | H | H | An35 | CN | O |
| 1397 | Cy8 | - | - | H | H | H | H | An₁ | O |
| 1398 | Cy8 | - | - | H | H | H | CN | An₁ | O |
| 1399 | Cy8 | - | - | H | H | H | F | An₁ | O |
| 1400 | Cy8 | - | - | H | H | H | CN | An₁₀ | O |
| 1401 | Cy8 | - | - | H | H | H | F | An₁₃ | O |
| 1402 | Cy8 | - | - | H | H | H | CN | An₃₁ | O |
| 1403 | Cy8 | - | - | H | H | H | F | An₃₅ | O |
| 1404 | Cy8 | - | - | H | H | H | An₁ | H | O |
| 1405 | Cy8 | - | - | H | H | H | An₁ | CN | O |
| 1406 | Cy8 | - | - | H | H | H | An10 | H | O |
| 1407 | Cy8 | - | - | H | H | H | An13 | CN | O |
| 1408 | Cy8 | - | - | H | H | H | An31 | H | O |
| 1409 | Cy8 | - | - | H | H | H | An35 | CN | O |
| 1410 | Cy9 | - | - | H | H | H | H | An₁ | O |
| 1411 | Cy9 | - | - | H | H | H | CN | An₁ | O |
| 1412 | Cy9 | - | - | H | H | H | F | An₁ | O |
| 1413 | Cy9 | - | - | H | H | H | CN | An₁₀ | O |
| 1414 | Cy9 | - | - | H | H | H | F | An₁₃ | O |
| 1415 | Cy9 | - | - | H | H | H | CN | An₃₁ | O |
| 1416 | Cy9 | - | - | H | H | H | F | An₃₅ | O |
| 1417 | Cy9 | - | - | H | H | H | An1 | H | O |
| 1418 | Cy9 | - | - | H | H | H | An1 | CN | O |
| 1419 | Cy9 | - | - | H | H | H | An10 | H | O |
| 1420 | Cy9 | - | - | H | H | H | An13 | CN | O |
| 1421 | Cy9 | - | - | H | H | H | An31 | H | O |
| 1422 | Cy9 | - | - | H | H | H | An35 | CN | O |
| 1423 | Cy1 | H | H | H | H | H | H | An₉₀ | O |
| 1424 | Cy1 | H | H | H | H | H | H | An₉₁ | O |
| 1425 | Cy1 | H | H | H | H | H | H | An₉₂ | O |
| 1426 | Cy1 | H | H | H | H | H | An90 | H | O |
| 1427 | Cy1 | H | H | H | H | H | An91 | H | O |
| 1428 | Cy1 | H | H | H | H | H | An92 | H | O |
| 1429 | Cy1 | H | H | H | H | An90 | H | H | O |
| 1430 | Cy1 | H | H | H | H | An91 | H | H | O |
| 1431 | Cy1 | H | H | H | H | An92 | H | H | O |
| 1432 | Cy1 | H | H | H | H | H | CN | An₉₀ | O |
| 1433 | Cy1 | H | H | H | H | H | CN | An₉₁ | O |
| 1434 | Cy1 | H | H | H | H | H | CN | An₉₂ | O |
| 1435 | Cy1 | H | H | H | H | H | F | An₉₀ | ○ |
| 1436 | Cy1 | H | H | H | H | H | F | An91 | O |
| 1437 | Cy1 | H | H | H | H | H | F | An₉₂ | O |
| 1438 | Cy1 | H | H | H | H | H | An90 | CN | O |
| 1439 | Cy1 | H | H | H | H | H | An91 | CN | O |
| 1440 | Cy1 | H | H | H | H | H | An92 | CN | O |
Lₐ₁₄₄₁ to Lₐ₁₅₁₄ each have a structure of 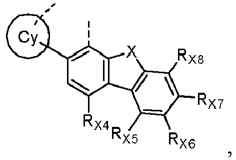 wherein X, Cy and R_{X4} to Rₓ₈ are selected from the atoms or groups listed in the following table:
| LₐNo. | Cy | Cy | | R_{X4} | R_{X5} | R_{X6} | R_{X7} | R_{X8} | X |
|---|---|---|---|---|---|---|---|---|---|
| | | R_{Y2} | R_{Y3} | | | | | | |
| | | | | | | | | | |
| 1441 | Cy1 | H | H | H | H | H | H | An₁ | O |
| 1442 | Cy1 | H | H | H | H | H | H | An₁₀ | O |
| 1443 | Cy1 | H | H | H | H | H | H | An₁₃ | O |
| 1444 | Cy1 | H | H | H | H | H | H | An₁₉ | O |
| 1445 | Cy1 | H | H | H | H | H | H | An₂₀ | O |
| 1446 | Cy1 | H | H | H | H | H | H | An₂₁ | O |
| 1447 | Cy1 | H | H | H | H | H | H | An₃₁ | O |
| 1448 | Cy1 | H | H | H | H | H | H | An₃₄ | O |
| 1449 | Cy1 | H | H | H | H | H | H | An₃₅ | O |
| 1450 | Cy1 | H | H | H | H | H | H | An₅₃ | O |
| 1451 | Cy1 | H | H | H | H | H | H | An₈₂ | O |
| 1452 | Cy1 | H | H | H | H | H | An₁ | H | O |
| 1453 | Cy1 | H | H | H | H | H | An₁₀ | H | O |
| 1454 | Cy1 | H | H | H | H | H | An₁₃ | H | O |
| 1455 | Cy1 | H | H | H | H | H | An₁₉ | H | O |
| 1456 | Cy1 | H | H | H | H | H | An₂₀ | H | O |
| 1457 | Cy1 | H | H | H | H | H | An₂₁ | H | O |
| 1458 | Cy1 | H | H | H | H | H | An₃₁ | H | O |
| 1459 | Cy1 | H | H | H | H | H | An₃₄ | H | O |
| 1460 | Cy1 | H | H | H | H | H | An₃₅ | H | O |
| 1461 | Cy1 | H | H | H | H | H | An₅₃ | H | O |
| 1462 | Cy1 | H | H | H | H | H | An₈₂ | H | O |
| 1463 | Cy1 | H | H | H | H | An₁ | H | H | O |
| 1464 | Cy1 | H | H | H | H | An₁₀ | H | H | O |
| 1465 | Cy1 | H | H | H | H | An₁₃ | H | H | O |
| 1466 | Cy1 | H | H | H | H | An₁₉ | H | H | O |
| 1467 | Cy1 | H | H | H | H | An₂₀ | H | H | O |
| 1468 | Cy1 | H | H | H | H | An₂₁ | H | H | O |
| 1469 | Cy1 | H | H | H | H | An₃₁ | H | H | O |
| 1470 | Cy1 | H | H | H | H | An₃₄ | H | H | O |
| 1471 | Cy1 | H | H | H | H | An₃₅ | H | H | O |
| 1472 | Cy1 | H | H | H | H | An₅₃ | H | H | O |
| 1473 | Cy1 | H | H | H | H | An₈₂ | H | H | O |
| 1474 | Cy1 | H | H | H | An₁ | H | H | H | O |
| 1475 | Cy1 | H | H | H | An₁₀ | H | H | H | O |
| 1476 | Cy1 | H | H | H | An₁₃ | H | H | H | O |
| 1477 | Cy1 | H | H | H | An₁₉ | H | H | H | O |
| 1478 | Cy1 | H | H | H | An₂₀ | H | H | H | O |
| 1479 | Cy1 | H | H | H | An₂₁ | H | H | H | O |
| 1480 | Cy1 | H | H | H | An₃₁ | H | H | H | O |
| 1481 | Cy1 | H | H | H | An₃₄ | H | H | H | O |
| 1482 | Cy1 | H | H | H | An₃₅ | H | H | H | O |
| 1483 | Cy1 | H | H | H | An₅₃ | H | H | H | O |
| 1484 | Cy1 | H | H | H | An₈₂ | H | H | H | O |
| 1485 | Cy1 | H | H | H | H | H | CN | An1 | O |
| 1486 | Cy1 | H | H | H | H | H | CN | An₁₀ | O |
| 1487 | Cy1 | H | H | H | H | H | CN | An₁₃ | O |
| 1488 | Cy1 | H | H | H | H | H | CN | An₁₉ | O |
| 1489 | Cy1 | H | H | H | H | H | CN | An₂₀ | O |
| 1490 | Cy1 | H | H | H | H | H | CN | An₂₁ | O |
| 1491 | Cy1 | H | H | H | H | H | CN | An₃₁ | O |
| 1492 | Cy1 | H | H | H | H | H | CN | An₃₄ | O |
| 1493 | Cy1 | H | H | H | H | H | CN | An₃₅ | O |
| 1494 | Cy1 | H | H | H | H | H | CN | An₅₃ | O |
| 1495 | Cy1 | H | H | H | H | H | CN | An₈₂ | O |
| 1496 | Cy1 | H | H | H | H | H | F | An₁ | O |
| 1497 | Cy1 | H | H | H | H | H | F | An₁₀ | O |
| 1498 | Cy1 | H | H | H | H | H | F | An₁₃ | O |
| 1499 | Cy1 | H | H | H | H | H | F | An₁₉ | O |
| 1500 | Cy1 | H | H | H | H | H | F | An₂₀ | O |
| 1501 | Cy1 | H | H | H | H | H | F | An₂₁ | O |
| 1502 | Cy1 | H | H | H | H | H | F | An₃₁ | O |
| 1503 | Cy1 | H | H | H | H | H | F | An₃₄ | O |
| 1504 | Cy1 | H | H | H | H | H | F | An₃₅ | O |
| 1505 | Cy1 | H | H | H | H | H | F | An₅₃ | O |
| 1506 | Cy1 | H | H | H | H | H | F | An₈₂ | O |
| 1507 | Cy1 | H | H | H | H | H | H | An₁ | s |
| 1508 | Cy1 | H | H | H | H | H | An₁ | H | s |
| 1509 | Cy1 | H | H | H | H | An₁ | H | H | s |
| 1510 | Cy1 | H | H | H | H | H | An₁ | H | s |
| 1511 | Cy1 | H | H | H | H | An₁ | H | H | s |
| 1512 | Cy1 | H | H | H | An₁ | H | H | H | S |
| 1513 | Cy1 | H | H | H | H | H | CN | An₁ | s |
| 1514 | Cy1 | H | H | H | H | H | F | An₁ | s |
Lₐ₁₅₁₅ to Lₐ₁₅₈₈ each have a structure of 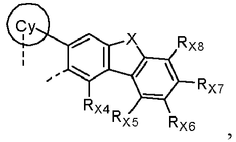 wherein X, Cy and R_{X4} to Rₓ₈ are selected from the atoms or groups listed in the following table:
| LₐNo. | Cy | Cy | | R_{X4} | R_{X5} | R_{X6} | R_{X7} | R_{X8} | X |
|---|---|---|---|---|---|---|---|---|---|
| | | R_{Y2} | R_{Y3} | | | | | | |
| 1515 | Cy1 | H | H | H | H | H | H | An₁ | O |
| 1516 | Cy1 | H | H | H | H | H | H | An₁₀ | O |
| 1517 | Cy1 | H | H | H | H | H | H | An₁₃ | O |
| 1518 | Cy1 | H | H | H | H | H | H | An₁₉ | O |
| 1519 | Cy1 | H | H | H | H | H | H | An₂₀ | O |
| 1520 | Cy1 | H | H | H | H | H | H | An₂₁ | O |
| 1521 | Cy1 | H | H | H | H | H | H | An₃₁ | O |
| 1522 | Cy1 | H | H | H | H | H | H | An₃₄ | O |
| 1523 | Cy1 | H | H | H | H | H | H | An₃₅ | O |
| 1524 | Cy1 | H | H | H | H | H | H | An₅₃ | O |
| 1525 | Cy1 | H | H | H | H | H | H | An₈₂ | O |
| 1526 | Cy1 | H | H | H | H | H | An₁ | H | O |
| 1527 | Cy1 | H | H | H | H | H | An₁₀ | H | O |
| 1528 | Cy1 | H | H | H | H | H | An₁₃ | H | O |
| 1529 | Cy1 | H | H | H | H | H | An₁₉ | H | O |
| 1530 | Cy1 | H | H | H | H | H | An₂₀ | H | O |
| 1531 | Cy1 | H | H | H | H | H | An₂₁ | H | O |
| 1532 | Cy1 | H | H | H | H | H | An₃₁ | H | O |
| 1533 | Cy1 | H | H | H | H | H | An₃₄ | H | O |
| 1534 | Cy1 | H | H | H | H | H | An₃₅ | H | O |
| 1535 | Cy1 | H | H | H | H | H | An₅₃ | H | O |
| 1536 | Cy1 | H | H | H | H | H | An₈₂ | H | O |
| 1537 | Cy1 | H | H | H | H | An₁ | H | H | O |
| 1538 | Cy1 | H | H | H | H | An₁₀ | H | H | O |
| 1539 | Cy1 | H | H | H | H | An₁₃ | H | H | O |
| 1540 | Cy1 | H | H | H | H | An₁₉ | H | H | O |
| 1541 | Cy1 | H | H | H | H | An₂₀ | H | H | O |
| 1542 | Cy1 | H | H | H | H | An₂₁ | H | H | O |
| 1543 | Cy1 | H | H | H | H | An₃₁ | H | H | O |
| 1544 | Cy1 | H | H | H | H | An₃₄ | H | H | O |
| 1545 | Cy1 | H | H | H | H | An₃₅ | H | H | O |
| 1546 | Cy1 | H | H | H | H | An₅₃ | H | H | O |
| 1547 | Cy1 | H | H | H | H | An₈₂ | H | H | O |
| 1548 | Cy1 | H | H | H | An₁ | H | H | H | O |
| 1549 | Cy1 | H | H | H | An₁₀ | H | H | H | O |
| 1550 | Cy1 | H | H | H | An₁₃ | H | H | H | O |
| 1551 | Cy1 | H | H | H | An₁₉ | H | H | H | O |
| 1552 | Cy1 | H | H | H | An₂₀ | H | H | H | O |
| 1553 | Cy1 | H | H | H | An₂₁ | H | H | H | O |
| 1554 | Cy1 | H | H | H | An₃₁ | H | H | H | O |
| 1555 | Cy1 | H | H | H | An₃₄ | H | H | H | O |
| 1556 | Cy1 | H | H | H | An₃₅ | H | H | H | O |
| 1557 | Cy1 | H | H | H | An₅₃ | H | H | H | O |
| 1558 | Cy1 | H | H | H | An₈₂ | H | H | H | O |
| 1559 | Cy1 | H | H | H | H | H | CN | An₁ | O |
| 1560 | Cy1 | H | H | H | H | H | CN | An₁₀ | O |
| 1561 | Cy1 | H | H | H | H | H | CN | An₁₃ | O |
| 1562 | Cy1 | H | H | H | H | H | CN | An₁₉ | O |
| 1563 | Cy1 | H | H | H | H | H | CN | An₂₀ | O |
| 1564 | Cy1 | H | H | H | H | H | CN | An₂₁ | O |
| 1565 | Cy1 | H | H | H | H | H | CN | An₃₁ | O |
| 1566 | Cy1 | H | H | H | H | H | CN | An₃₄ | O |
| 1567 | Cy1 | H | H | H | H | H | CN | An₃₅ | O |
| 1568 | Cy1 | H | H | H | H | H | CN | An₅₃ | O |
| 1569 | Cy1 | H | H | H | H | H | CN | An₈₂ | O |
| 1570 | Cy1 | H | H | H | H | H | F | An₁ | O |
| 1571 | Cy1 | H | H | H | H | H | F | An₁₀ | O |
| 1572 | Cy1 | H | H | H | H | H | F | An₁₃ | O |
| 1573 | Cy1 | H | H | H | H | H | F | An₁₉ | O |
| 1574 | Cy1 | H | H | H | H | H | F | An₂₀ | O |
| 1575 | Cy1 | H | H | H | H | H | F | An₂₁ | O |
| 1576 | Cy1 | H | H | H | H | H | F | An₃₁ | O |
| 1577 | Cy1 | H | H | H | H | H | F | An₃₄ | O |
| 1578 | Cy1 | H | H | H | H | H | F | An₃₅ | O |
| 1579 | Cy1 | H | H | H | H | H | F | An₅₃ | O |
| 1580 | Cy1 | H | H | H | H | H | F | An₈₂ | O |
| 1581 | Cy1 | H | H | H | H | H | H | An₁ | s |
| 1582 | Cy1 | H | H | H | H | H | An₁ | H | s |
| 1583 | Cy1 | H | H | H | H | An₁ | H | H | s |
| 1584 | Cy1 | H | H | H | H | H | An₁ | H | s |
| 1585 | Cy1 | H | H | H | H | An₁ | H | H | s |
| 1586 | Cy1 | H | H | H | An₁ | H | H | H | s |
| 1587 | Cy1 | H | H | H | H | H | CN | An₁ | s |
| 1588 | Cy1 | H | H | H | H | H | F | An₁ | s |
Lₐ₁₅₈₉ to Lₐ₁₆₆₂ each have a structure of 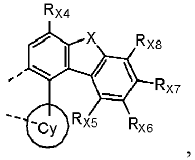 wherein X, Cy and R_{X4} to R_{X8} are selected from the atoms or groups listed in the following table:
| LₐNo. | Cy | Cy | | R_{X4} | R_{X5} | Rₓ₆ | R_{X7} | R_{X8} | X |
|---|---|---|---|---|---|---|---|---|---|
| | | R_{Y2} | R_{Y3} | | | | | | |
| 1589 | Cy1 | H | H | H | H | H | H | An₁ | O |
| 1590 | Cy1 | H | H | H | H | H | H | An₁₀ | O |
| 1591 | Cy1 | H | H | H | H | H | H | An₁₃ | O |
| 1592 | Cy1 | H | H | H | H | H | H | An₁₉ | O |
| 1593 | Cy1 | H | H | H | H | H | H | An₂₀ | O |
| 1594 | Cy1 | H | H | H | H | H | H | An₂₁ | O |
| 1595 | Cy1 | H | H | H | H | H | H | An₃₁ | O |
| 1596 | Cy1 | H | H | H | H | H | H | An₃₄ | O |
| 1597 | Cy1 | H | H | H | H | H | H | An₃₅ | O |
| 1598 | Cy1 | H | H | H | H | H | H | An₅₃ | O |
| 1599 | Cy1 | H | H | H | H | H | H | An₈₂ | O |
| 1600 | Cy1 | H | H | H | H | H | An₁ | H | O |
| 1601 | Cy1 | H | H | H | H | H | An₁₀ | H | O |
| 1602 | Cy1 | H | H | H | H | H | An₁₃ | H | O |
| 1603 | Cy1 | H | H | H | H | H | An₁₉ | H | O |
| 1604 | Cy1 | H | H | H | H | H | An₂₀ | H | O |
| 1605 | Cy1 | H | H | H | H | H | An₂₁ | H | O |
| 1606 | Cy1 | H | H | H | H | H | An₃₁ | H | O |
| 1607 | Cy1 | H | H | H | H | H | An₃₄ | H | O |
| 1608 | Cy1 | H | H | H | H | H | An₃₅ | H | O |
| 1609 | Cy1 | H | H | H | H | H | An₅₃ | H | O |
| 1610 | Cy1 | H | H | H | H | H | An₈₂ | H | O |
| 1611 | Cy1 | H | H | H | H | An₁ | H | H | O |
| 1612 | Cy1 | H | H | H | H | An₁₀ | H | H | O |
| 1613 | Cy1 | H | H | H | H | An₁₃ | H | H | O |
| 1614 | Cy1 | H | H | H | H | An₁₉ | H | H | O |
| 1615 | Cy1 | H | H | H | H | An₂₀ | H | H | O |
| 1616 | Cy1 | H | H | H | H | An₂₁ | H | H | O |
| 1617 | Cy1 | H | H | H | H | An₃₁ | H | H | O |
| 1618 | Cy1 | H | H | H | H | An₃₄ | H | H | O |
| 1619 | Cy1 | H | H | H | H | An₃₅ | H | H | O |
| 1620 | Cy1 | H | H | H | H | An₅₃ | H | H | O |
| 1621 | Cy1 | H | H | H | H | An₈₂ | H | H | O |
| 1622 | Cy1 | H | H | H | An₁ | H | H | H | O |
| 1623 | Cy1 | H | H | H | An₁₀ | H | H | H | O |
| 1624 | Cy1 | H | H | H | An₁₃ | H | H | H | O |
| 1625 | Cy1 | H | H | H | An₁₉ | H | H | H | O |
| 1626 | Cy1 | H | H | H | An₂₀ | H | H | H | O |
| 1627 | Cy1 | H | H | H | An₂₁ | H | H | H | O |
| 1628 | Cy1 | H | H | H | An₃₁ | H | H | H | O |
| 1629 | Cy1 | H | H | H | An₃₄ | H | H | H | O |
| 1630 | Cy1 | H | H | H | An₃₅ | H | H | H | O |
| 1631 | Cy1 | H | H | H | An₅₃ | H | H | H | O |
| 1632 | Cy1 | H | H | H | An₈₂ | H | H | H | O |
| 1633 | Cy1 | H | H | H | H | H | CN | An₁ | O |
| 1634 | Cy1 | H | H | H | H | H | CN | An₁₀ | O |
| 1635 | Cy1 | H | H | H | H | H | CN | An₁₃ | O |
| 1636 | Cy1 | H | H | H | H | H | CN | An₁₉ | O |
| 1637 | Cy1 | H | H | H | H | H | CN | An₂₀ | O |
| 1638 | Cy1 | H | H | H | H | H | CN | An₂₁ | O |
| 1639 | Cy1 | H | H | H | H | H | CN | An₃₁ | O |
| 1640 | Cy1 | H | H | H | H | H | CN | An₃₄ | O |
| 1641 | Cy1 | H | H | H | H | H | CN | An₃₅ | O |
| 1642 | Cy1 | H | H | H | H | H | CN | An₅₃ | O |
| 1643 | Cy1 | H | H | H | H | H | CN | An₈₂ | O |
| 1644 | Cy1 | H | H | H | H | H | F | An₁ | O |
| 1645 | Cy1 | H | H | H | H | H | F | Anᵢo | O |
| 1646 | Cy1 | H | H | H | H | H | F | An₁₃ | O |
| 1647 | Cy1 | H | H | H | H | H | F | An₁₉ | O |
| 1648 | Cy1 | H | H | H | H | H | F | An₂₀ | O |
| 1649 | Cy1 | H | H | H | H | H | F | An₂₁ | O |
| 1650 | Cy1 | H | H | H | H | H | F | An₃₁ | O |
| 1651 | Cy1 | H | H | H | H | H | F | An₃₄ | O |
| 1652 | Cy1 | H | H | H | H | H | F | An₃₅ | O |
| 1653 | Cy1 | H | H | H | H | H | F | An₅₃ | O |
| 1654 | Cy1 | H | H | H | H | H | F | An₈₂ | O |
| 1655 | Cy1 | H | H | H | H | H | H | An₁ | s |
| 1656 | Cy1 | H | H | H | H | H | An₁ | H | s |
| 1657 | Cy1 | H | H | H | H | An₁ | H | H | s |
| 1658 | Cy1 | H | H | H | H | H | An₁ | H | s |
| 1659 | Cy1 | H | H | H | H | An₁ | H | H | s |
| 1660 | Cy1 | H | H | H | An₁ | H | H | H | s |
| 1661 | Cy1 | H | H | H | H | H | CN | An₁ | s |
| 1662 | Cy1 | H | H | H | H | H | F | An₁ | s |
Lₐ₁₆₆₃ to Lₐ₁₇₃₆ each have a structure of 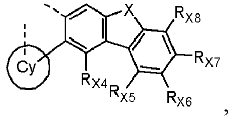 wherein X, Cy and R_{X4} to Rₓ₈ are selected from the atoms or groups listed in the following table:
| LₐNo. | Cy | Cy | | R_{X4} | R_{X5} | Rₓ₆ | Rₓ₇ | R_{X8} | X |
|---|---|---|---|---|---|---|---|---|---|
| | | R_{Y2} | R_{Y3} | | | | | | |
| 1663 | Cy1 | H | H | H | H | H | H | An₁ | O |
| 1664 | Cy1 | H | H | H | H | H | H | An₁₀ | O |
| 1665 | Cy1 | H | H | H | H | H | H | An₁₃ | O |
| 1666 | Cy1 | H | H | H | H | H | H | An₁₉ | O |
| 1667 | Cy1 | H | H | H | H | H | H | An₂₀ | O |
| 1668 | Cy1 | H | H | H | H | H | H | An₂₁ | O |
| 1669 | Cy1 | H | H | H | H | H | H | An₃₁ | O |
| 1670 | Cy1 | H | H | H | H | H | H | An₃₄ | O |
| 1671 | Cy1 | H | H | H | H | H | H | An₃₅ | O |
| 1672 | Cy1 | H | H | H | H | H | H | An₅₃ | O |
| 1673 | Cy1 | H | H | H | H | H | H | An₈₂ | O |
| 1674 | Cy1 | H | H | H | H | H | An₁ | H | O |
| 1675 | Cy1 | H | H | H | H | H | An₁₀ | H | O |
| 1676 | Cy1 | H | H | H | H | H | An₁₃ | H | O |
| 1677 | Cy1 | H | H | H | H | H | An₁₉ | H | O |
| 1678 | Cy1 | H | H | H | H | H | An₂₀ | H | O |
| 1679 | Cy1 | H | H | H | H | H | An₂₁ | H | O |
| 1680 | Cy1 | H | H | H | H | H | An₃₁ | H | O |
| 1681 | Cy1 | H | H | H | H | H | An₃₄ | H | O |
| 1682 | Cy1 | H | H | H | H | H | An₃₅ | H | O |
| 1683 | Cy1 | H | H | H | H | H | An₅₃ | H | O |
| 1684 | Cy1 | H | H | H | H | H | An₈₂ | H | O |
| 1685 | Cy1 | H | H | H | H | An₁ | H | H | O |
| 1686 | Cy1 | H | H | H | H | An₁₀ | H | H | O |
| 1687 | Cy1 | H | H | H | H | An₁₃ | H | H | O |
| 1688 | Cy1 | H | H | H | H | An₁₉ | H | H | O |
| 1689 | Cy1 | H | H | H | H | An₂₀ | H | H | O |
| 1690 | Cy1 | H | H | H | H | An₂₁ | H | H | O |
| 1691 | Cy1 | H | H | H | H | An₃₁ | H | H | O |
| 1692 | Cy1 | H | H | H | H | An₃₄ | H | H | O |
| 1693 | Cy1 | H | H | H | H | An₃₅ | H | H | O |
| 1694 | Cy1 | H | H | H | H | An₅₃ | H | H | O |
| 1695 | Cy1 | H | H | H | H | An₈₂ | H | H | O |
| 1696 | Cy1 | H | H | H | An₁ | H | H | H | O |
| 1697 | Cy1 | H | H | H | An₁₀ | H | H | H | O |
| 1698 | Cy1 | H | H | H | An₁₃ | H | H | H | O |
| 1699 | Cy1 | H | H | H | An₁₉ | H | H | H | O |
| 1700 | Cy1 | H | H | H | An₂₀ | H | H | H | O |
| 1701 | Cy1 | H | H | H | An₂₁ | H | H | H | O |
| 1702 | Cy1 | H | H | H | An₃₁ | H | H | H | O |
| 1703 | Cy1 | H | H | H | An₃₄ | H | H | H | O |
| 1704 | Cy1 | H | H | H | An₃₅ | H | H | H | O |
| 1705 | Cy1 | H | H | H | An₅₃ | H | H | H | O |
| 1706 | Cy1 | H | H | H | An₈₂ | H | H | H | O |
| 1707 | Cy1 | H | H | H | H | H | CN | An₁ | O |
| 1708 | Cy1 | H | H | H | H | H | CN | An₁₀ | O |
| 1709 | Cy1 | H | H | H | H | H | CN | An₁₃ | O |
| 1710 | Cy1 | H | H | H | H | H | CN | An₁₉ | O |
| 1711 | Cy1 | H | H | H | H | H | CN | An₂₀ | O |
| 1712 | Cy1 | H | H | H | H | H | CN | An₂₁ | O |
| 1713 | Cy1 | H | H | H | H | H | CN | An₃₁ | O |
| 1714 | Cy1 | H | H | H | H | H | CN | An₃₄ | O |
| 1715 | Cy1 | H | H | H | H | H | CN | An₃₅ | O |
| 1716 | Cy1 | H | H | H | H | H | CN | An₅₃ | O |
| 1717 | Cy1 | H | H | H | H | H | CN | An₈₂ | O |
| 1718 | Cy1 | H | H | H | H | H | F | An₁ | O |
| 1719 | Cy1 | H | H | H | H | H | F | An₁₀ | O |
| 1720 | Cy1 | H | H | H | H | H | F | An₁₃ | O |
| 1721 | Cy1 | H | H | H | H | H | F | An₁₉ | O |
| 1722 | Cy1 | H | H | H | H | H | F | An₂₀ | O |
| 1723 | Cy1 | H | H | H | H | H | F | An₂₁ | O |
| 1724 | Cy1 | H | H | H | H | H | F | An₃₁ | O |
| 1725 | Cy1 | H | H | H | H | H | F | An₃₄ | O |
| 1726 | Cy1 | H | H | H | H | H | F | An₃₅ | O |
| 1727 | Cy1 | H | H | H | H | H | F | An₅₃ | O |
| 1728 | Cy1 | H | H | H | H | H | F | An₈₂ | O |
| 1729 | Cy1 | H | H | H | H | H | H | An₁ | s |
| 1730 | Cy1 | H | H | H | H | H | An₁ | H | s |
| 1731 | Cy1 | H | H | H | H | An₁ | H | H | S |
| 1732 | Cy1 | H | H | H | H | H | An₁ | H | s |
| 1733 | Cy1 | H | H | H | H | An₁ | H | H | S |
| 1734 | Cy1 | H | H | H | An₁ | H | H | H | S |
| 1735 | Cy1 | H | H | H | H | H | CN | An₁ | S |
| 1736 | Cy1 | H | H | H | H | H | F | An₁ | S |
Lₐ₁₇₃₇ to Lₐ₁₇₆₀ each have a structure of 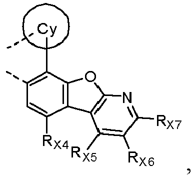 wherein Cy and R_{X4} to R_{X7} are selected from the atoms or groups listed in the following table:
| LₐNo. | Cy | Cy | | R_{X4} | R_{X5} | R_{X6} | R_{X7} |
|---|---|---|---|---|---|---|---|
| | | R_{Y2} | R_{Y3} | | | | |
| 1737 | Cy1 | H | H | H | H | H | An₁ |
| 1738 | Cy1 | H | H | H | H | H | An₁₀ |
| 1739 | Cy1 | H | H | H | H | H | An₃₁ |
| 1740 | Cy1 | H | H | H | H | H | An₃₄ |
| 1741 | Cy1 | H | H | H | H | An₁ | H |
| 1742 | Cy1 | H | H | H | H | An₁₀ | H |
| 1743 | Cy1 | H | H | H | H | An₃₁ | H |
| 1744 | Cy1 | H | H | H | H | An₃₄ | H |
| 1745 | Cy1 | H | H | H | An₁ | H | H |
| 1746 | Cy1 | H | H | H | An₁₀ | H | H |
| 1747 | Cy1 | H | H | H | An₃₁ | H | H |
| 1748 | Cy1 | H | H | H | An₃₄ | H | H |
| 1749 | Cy1 | H | H | An₁ | H | H | H |
| 1750 | Cy1 | H | H | An₁₀ | H | H | H |
| 1751 | Cy1 | H | H | An₃₁ | H | H | H |
| 1752 | Cy1 | H | H | An₃₄ | H | H | H |
| 1753 | Cy1 | H | H | H | H | An₁ | CN |
| 1754 | Cy1 | H | H | H | H | An₁₀ | CN |
| 1755 | Cy1 | H | H | H | H | An₃₁ | CN |
| 1756 | Cy1 | H | H | H | H | An₃₄ | CN |
| 1757 | Cy1 | H | H | H | H | An₁ | F |
| 1758 | Cy1 | H | H | H | H | An₁₀ | F |
| 1759 | Cy1 | H | H | H | H | An₃₁ | F |
| 1760 | Cy1 | H | H | H | H | An₃₄ | F |
Lₐ₁₇₆₁ to Lₐ₁₇₈₄ each have a structure of 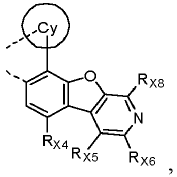 wherein X, Cy, R_{X4} to R_{X6} and R_{X8} are selected from the atoms or groups listed in the following table:
| Lₐ No. | Cy | Cy | | R_{X4} | R_{X5} | R_{X6} | R_{X8} |
|---|---|---|---|---|---|---|---|
| | | R_{Y2} | R_{Y3} | | | | |
| 1761 | Cy1 | H | H | H | H | H | An₁ |
| 1762 | Cy1 | H | H | H | H | H | An₁₀ |
| 1763 | Cy1 | H | H | H | H | H | An₃₁ |
| 1764 | Cy1 | H | H | H | H | H | An₃₄ |
| 1765 | Cy1 | H | H | H | H | An₁ | H |
| 1766 | Cy1 | H | H | H | H | An₁₀ | H |
| 1767 | Cy1 | H | H | H | H | An₃₁ | H |
| 1768 | Cy1 | H | H | H | H | An₃₄ | H |
| 1769 | Cy1 | H | H | H | An₁ | H | H |
| 1770 | Cy1 | H | H | H | An₁₀ | H | H |
| 1771 | Cy1 | H | H | H | An₃₁ | H | H |
| 1772 | Cy1 | H | H | H | An₃₄ | H | H |
| 1773 | Cy1 | H | H | An₁ | H | H | H |
| 1774 | Cy1 | H | H | An₁₀ | H | H | H |
| 1775 | Cy1 | H | H | An₃₁ | H | H | H |
| 1776 | Cy1 | H | H | An₃₄ | H | H | H |
| 1777 | Cy1 | H | H | H | H | An₁ | CN |
| 1778 | Cy1 | H | H | H | H | An₁₀ | CN |
| 1779 | Cy1 | H | H | H | H | An₃₁ | CN |
| 1780 | Cy1 | H | H | H | H | An₃₄ | CN |
| 1781 | Cy1 | H | H | H | H | An₁ | F |
| 1782 | Cy1 | H | H | H | H | An₁₀ | F |
| 1783 | Cy1 | H | H | H | H | An₃₁ | F |
| 1784 | Cy1 | H | H | H | H | An₃₄ | F |
Lₐ₁₇₈₅ to Lₐ₁₈₀₈ each have a structure of 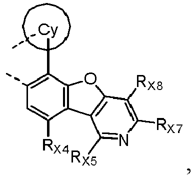 wherein Cy, R_{X4}, R_{X5}, R_{X7} and R_{X8} are selected from the atoms or groups listed in the following table:
| Lₐ No. | Cy | Cy | | R_{X4} | R_{X5} | R_{X7} | R_{X8} |
|---|---|---|---|---|---|---|---|
| | | R_{Y2} | R_{Y3} | | | | |
| 1785 | Cy1 | H | H | H | H | H | An₁ |
| 1786 | Cy1 | H | H | H | H | H | An₁₀ |
| 1787 | Cy1 | H | H | H | H | H | An₃₁ |
| 1788 | Cy1 | H | H | H | H | H | An₃₄ |
| 1789 | Cy1 | H | H | H | H | An₁ | H |
| 1790 | Cy1 | H | H | H | H | An₁₀ | H |
| 1791 | Cy1 | H | H | H | H | An₃₁ | H |
| 1792 | Cy1 | H | H | H | H | An₃₄ | H |
| 1793 | Cy1 | H | H | H | An₁ | H | H |
| 1794 | Cy1 | H | H | H | An₁₀ | H | H |
| 1795 | Cy1 | H | H | H | An₃₁ | H | H |
| 1796 | Cy1 | H | H | H | An₃₄ | H | H |
| 1797 | Cy1 | H | H | An₁ | H | H | H |
| 1798 | Cy1 | H | H | An₁₀ | H | H | H |
| 1799 | Cy1 | H | H | An₃₁ | H | H | H |
| 1800 | Cy1 | H | H | An₃₄ | H | H | H |
| 1801 | Cy1 | H | H | H | H | CN | An₁ |
| 1802 | Cy1 | H | H | H | H | CN | An₁₀ |
| 1803 | Cy1 | H | H | H | H | CN | An₃₁ |
| 1804 | Cy1 | H | H | H | H | CN | An₃₄ |
| 1805 | Cy1 | H | H | H | H | F | An₁ |
| 1806 | Cy1 | H | H | H | H | F | An₁₀ |
| 1807 | Cy1 | H | H | H | H | F | An₃₁ |
| 1808 | Cy1 | H | H | H | H | F | An₃₄ |
Lₐ₁₈₀₉ to Lₐ₁₈₃₂ each have a structure of 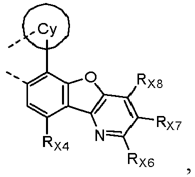 wherein Cy, R_{X4} and R_{X6} to R_{X8} are selected from the atoms or groups listed in the following table:
| Lₐ No. | Cy | Cy | | R_{X4} | R_{X6} | R_{X7} | R_{X8} |
|---|---|---|---|---|---|---|---|
| | | R_{Y2} | R_{Y3} | | | | |
| 1809 | Cy1 | H | H | H | H | H | An₁ |
| 1810 | Cy1 | H | H | H | H | H | An₁₀ |
| 1811 | Cy1 | H | H | H | H | H | An₃₁ |
| 1812 | Cy1 | H | H | H | H | H | An₃₄ |
| 1813 | Cy1 | H | H | H | H | An₁ | H |
| 1814 | Cy1 | H | H | H | H | An₁₀ | H |
| 1815 | Cy1 | H | H | H | H | An₃₁ | H |
| 1816 | Cy1 | H | H | H | H | An₃₄ | H |
| 1817 | Cy1 | H | H | H | An₁ | H | H |
| 1818 | Cy1 | H | H | H | An₁₀ | H | H |
| 1819 | Cy1 | H | H | H | An₃₁ | H | H |
| 1820 | Cy1 | H | H | H | An₃₄ | H | H |
| 1821 | Cy1 | H | H | An₁ | H | H | H |
| 1822 | Cy1 | H | H | An₁₀ | H | H | H |
| 1823 | Cy1 | H | H | An₃₁ | H | H | H |
| 1824 | Cy1 | H | H | An₃₄ | H | H | H |
| 1825 | Cy1 | H | H | H | H | CN | An₁ |
| 1826 | Cy1 | H | H | H | H | CN | An₁₀ |
| 1827 | Cy1 | H | H | H | H | CN | An₃₁ |
| 1828 | Cy1 | H | H | H | H | CN | An₃₄ |
| 1829 | Cy1 | H | H | H | H | F | An₁ |
| 1830 | Cy1 | H | H | H | H | F | An₁₀ |
| 1831 | Cy1 | H | H | H | H | F | An₃₁ |
| 1832 | Cy1 | H | H | H | H | F | An₃₄ |
wherein in the above table, Cy1 to Cy9 have the following structures: 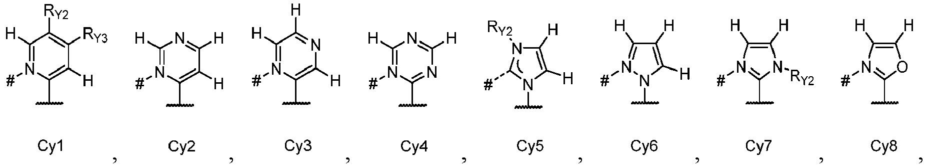 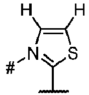 Cy9 ; wherein in Cy1 to Cy9, "#" represents a position where the metal M is joined, and " 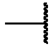 " represents a position where X₁, X₂, X₃ or X₄ is joined; and
in the above table, TMS represents trimethylsilyl, and TMG represents trimethylgermanyl; 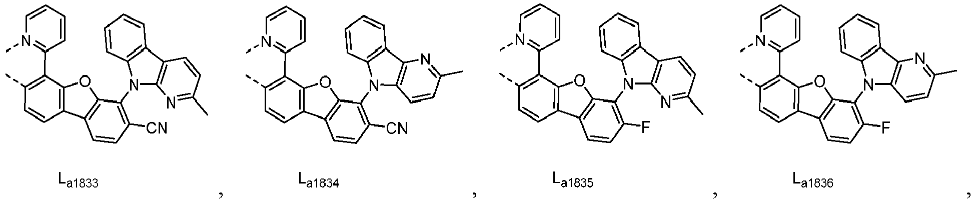 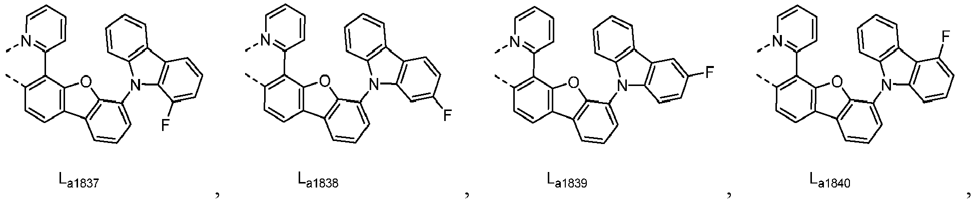 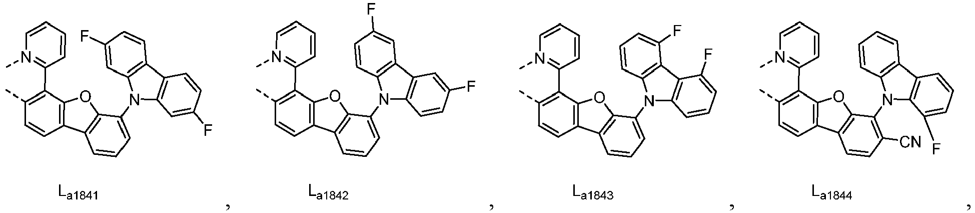 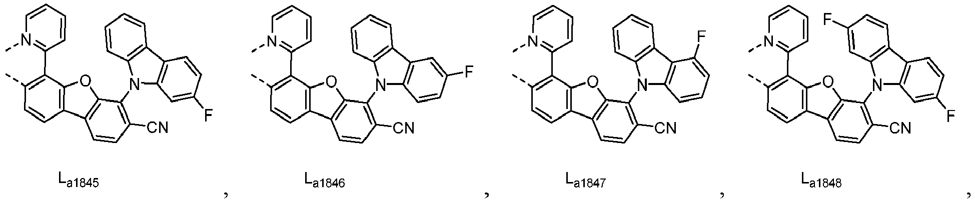 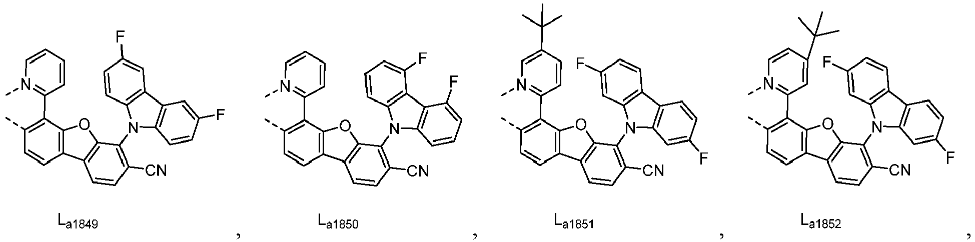 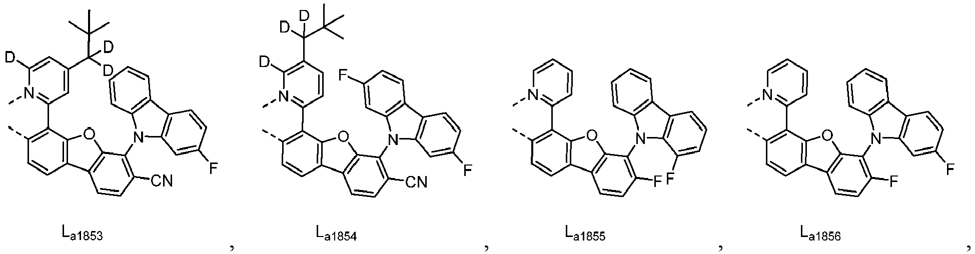 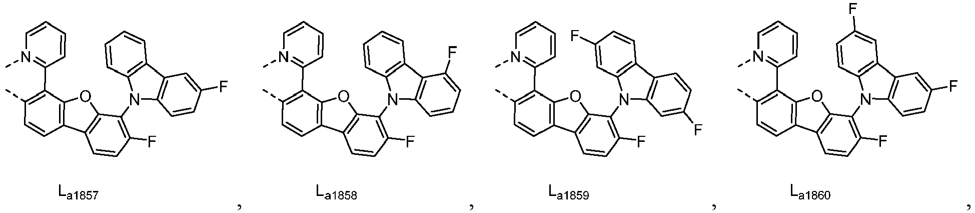 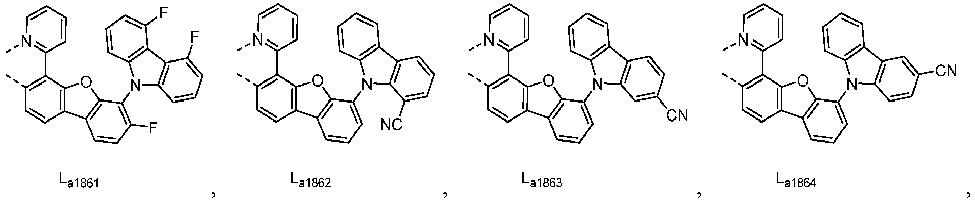 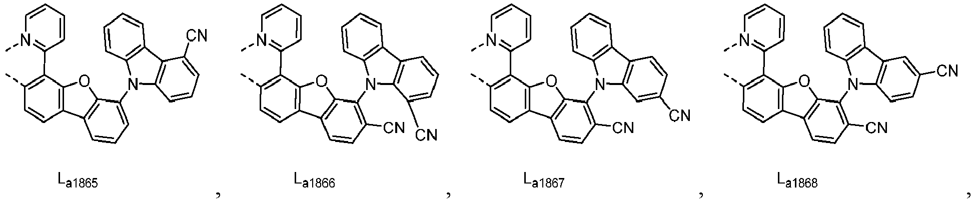 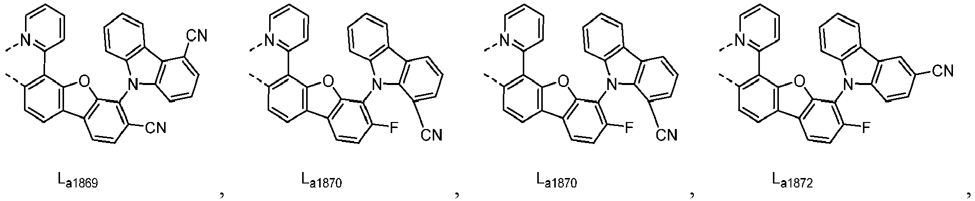 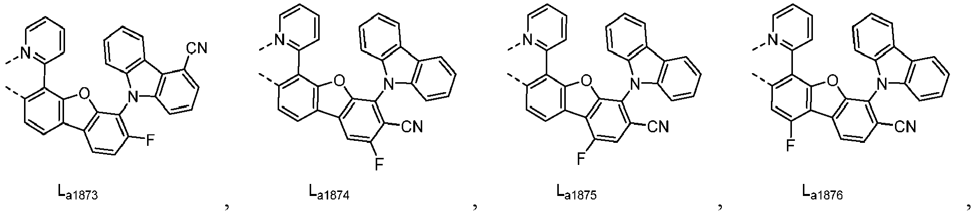 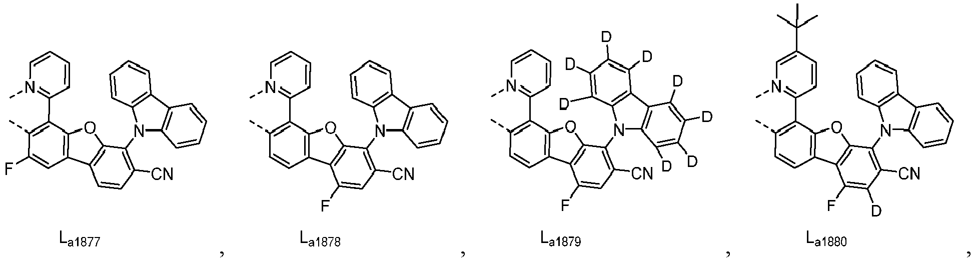 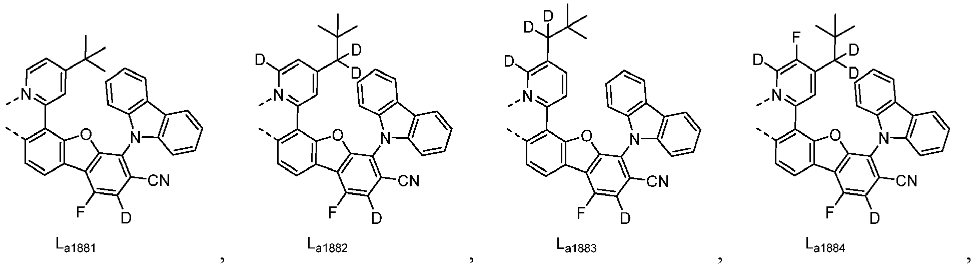 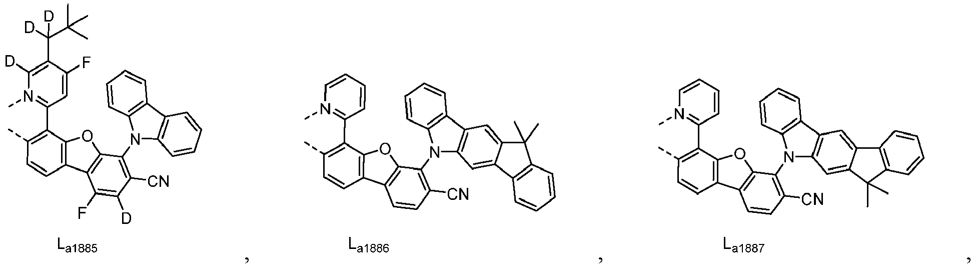 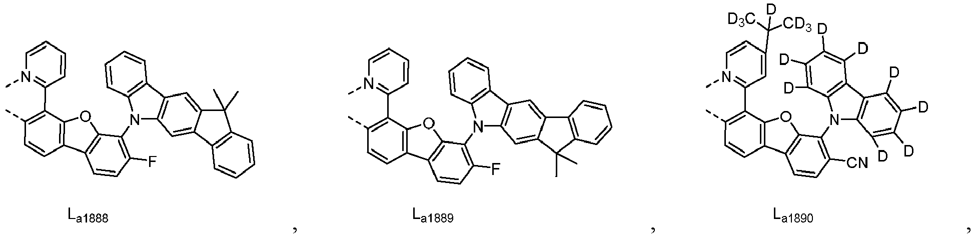 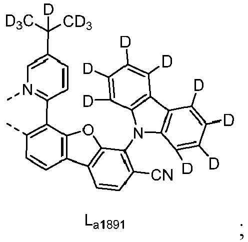
wherein optionally, hydrogen atoms in Lₐ₁ to Lₐ₁₈₉₁ can be partially or fully substituted with deuterium.

12. The metal complex according to claim 11, wherein L_{b} is, at each occurrence identically or differently, selected from the group consisting of the following: 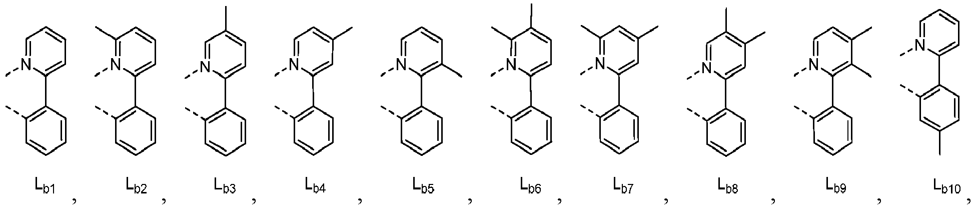 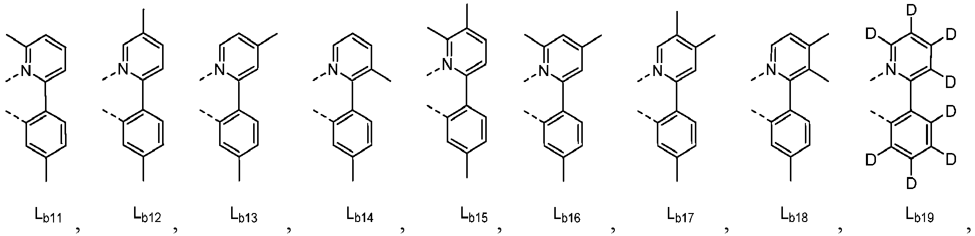 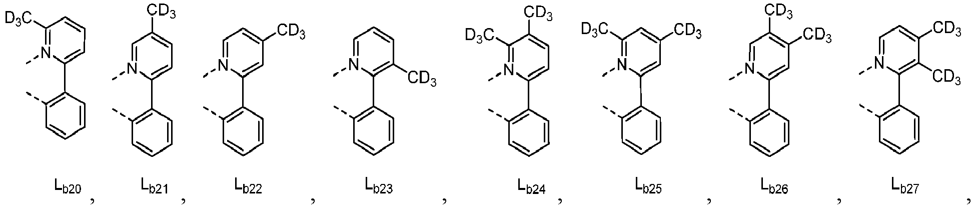 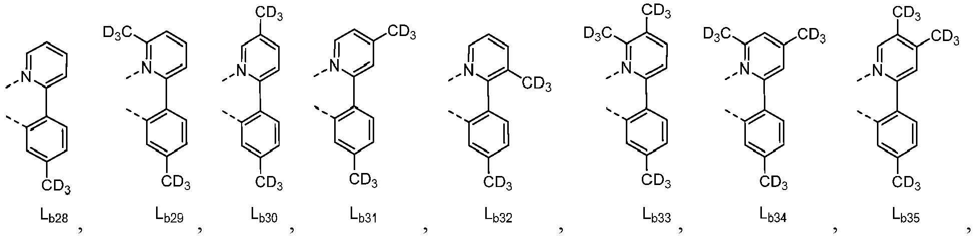 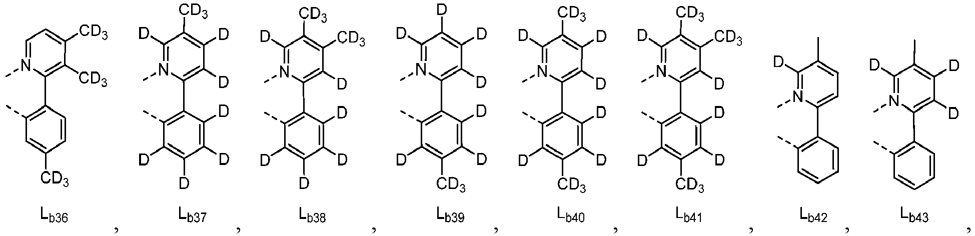 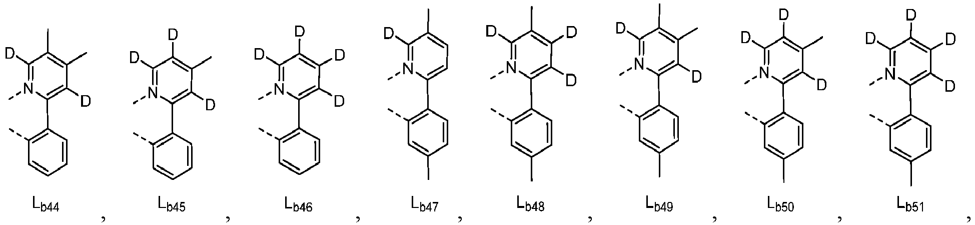 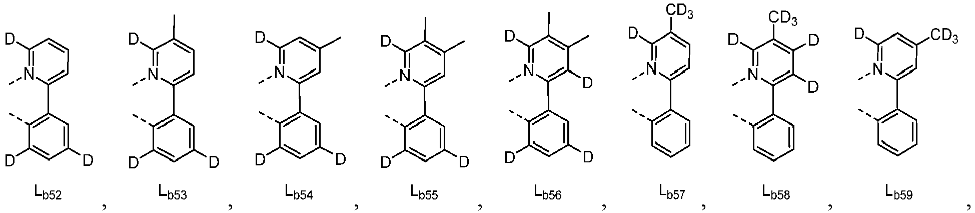 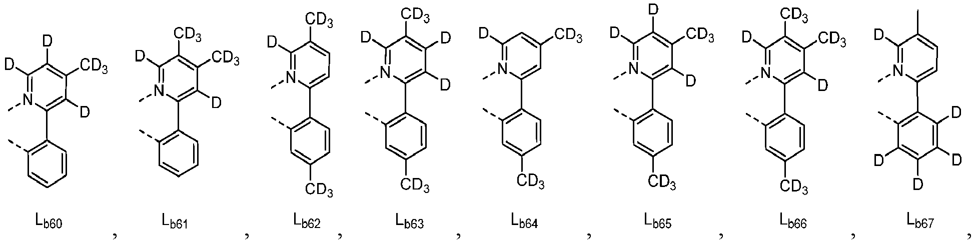 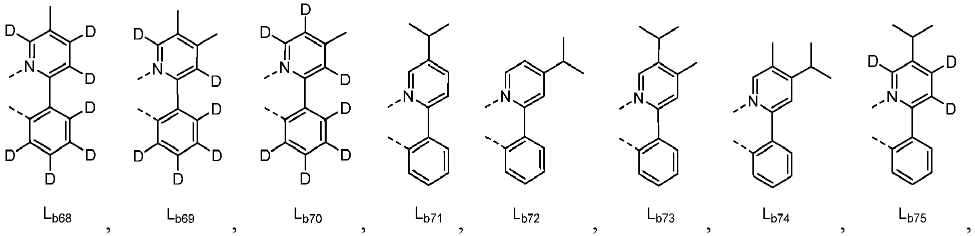 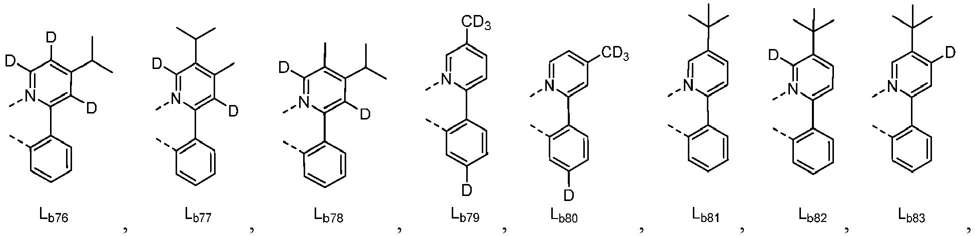 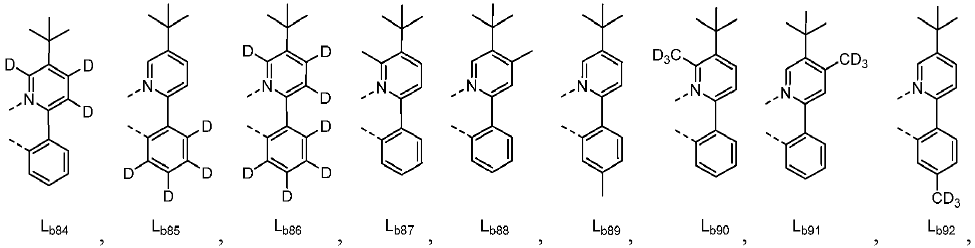 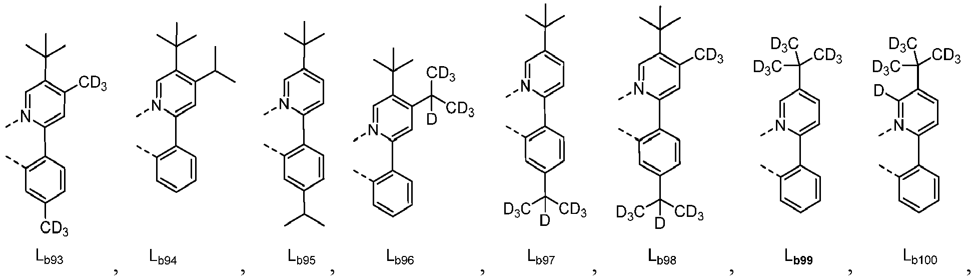 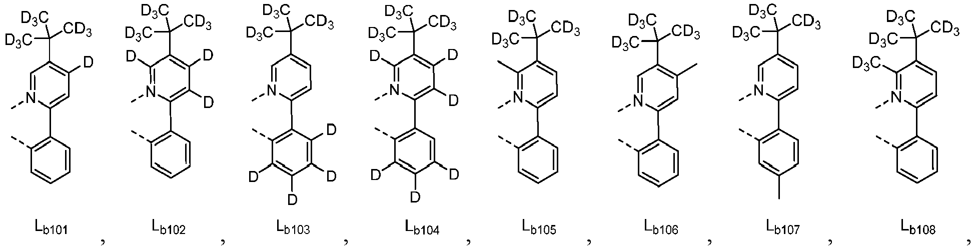 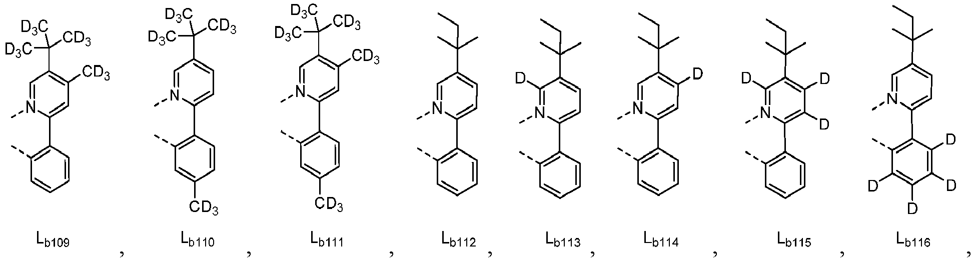 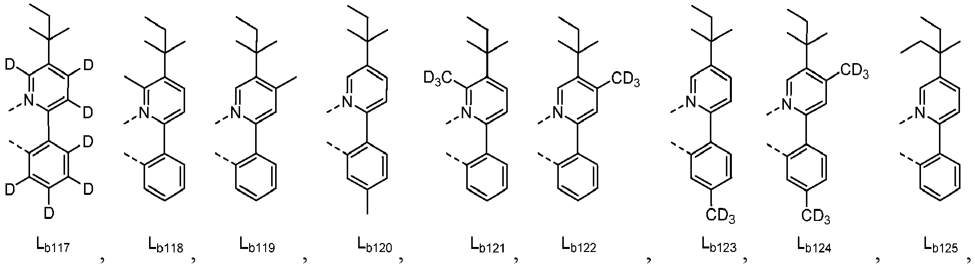 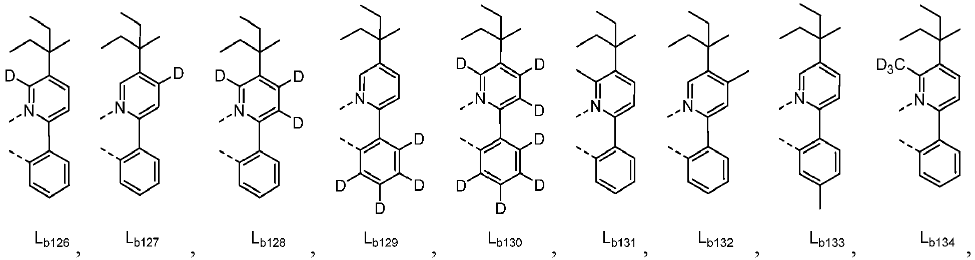 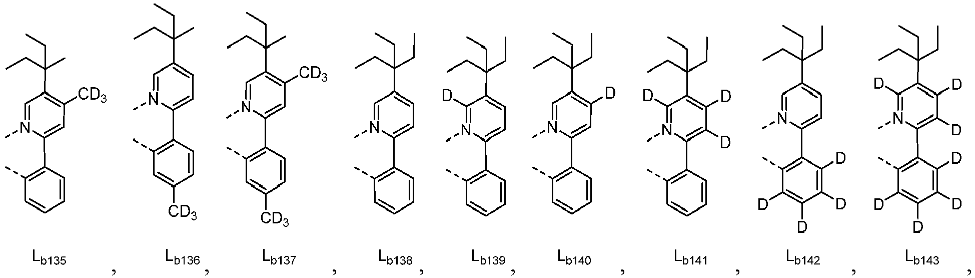 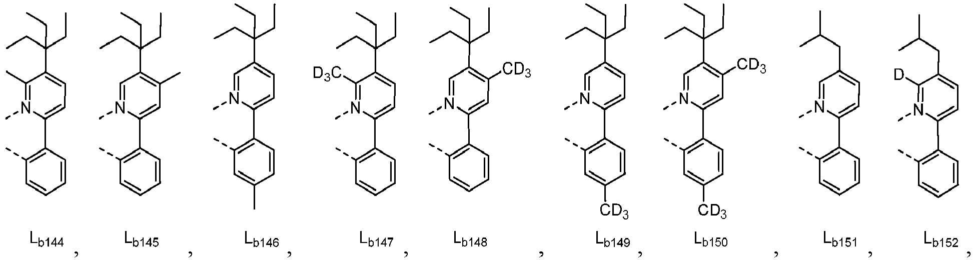 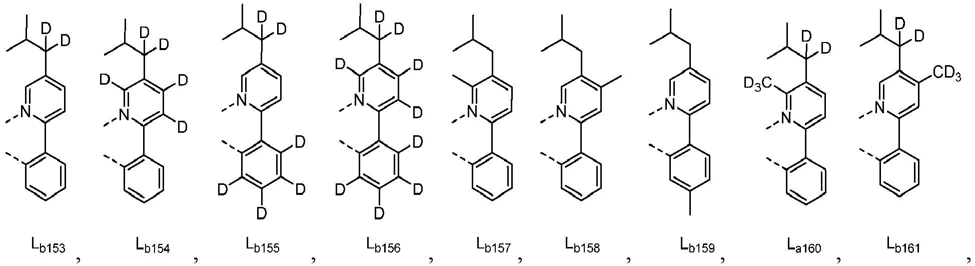 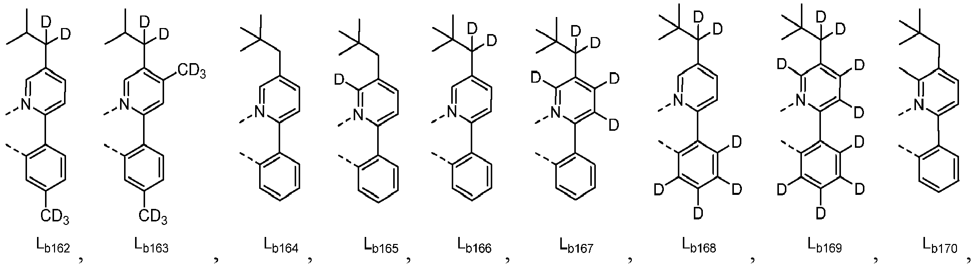 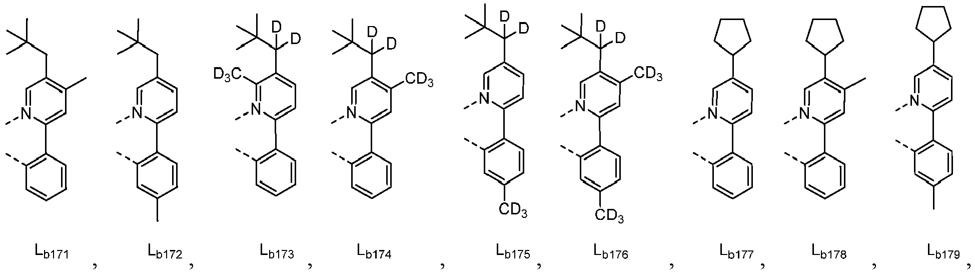 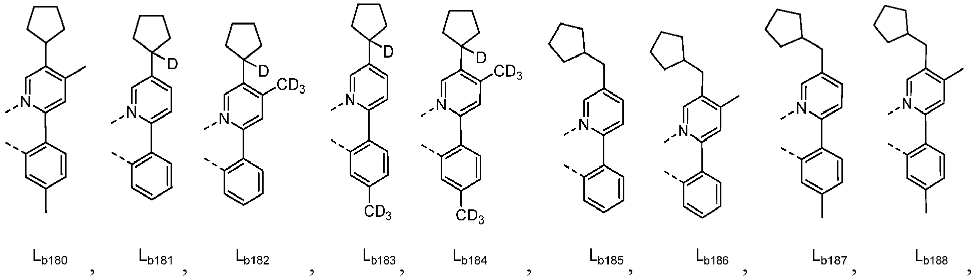 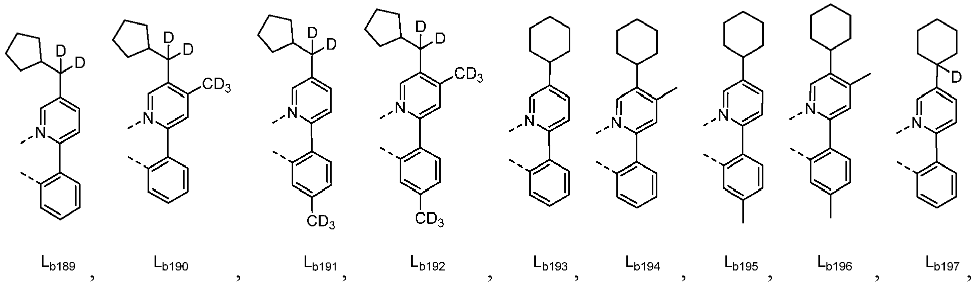 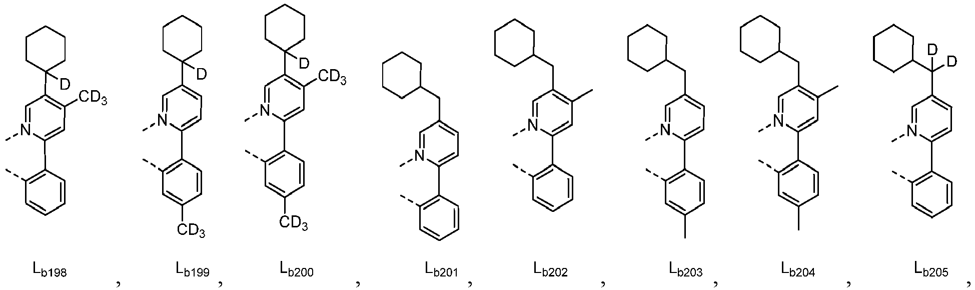 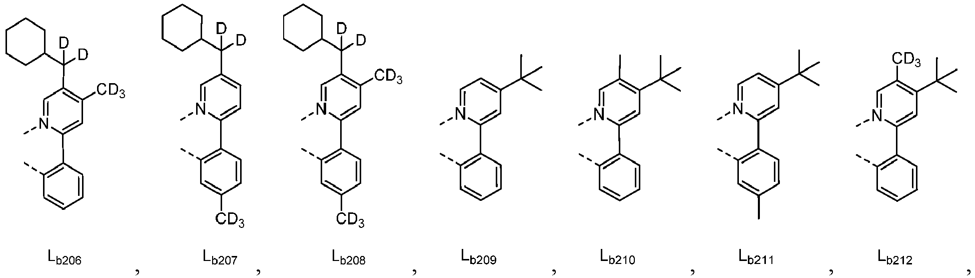 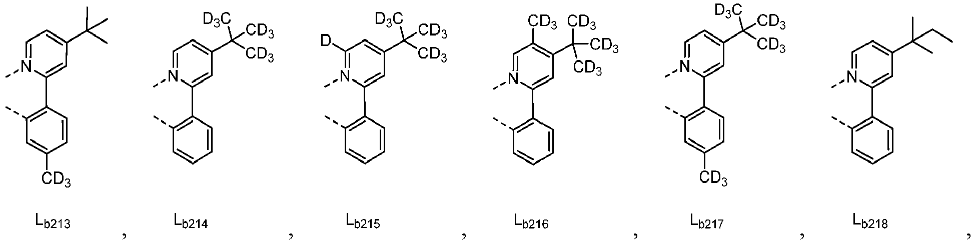 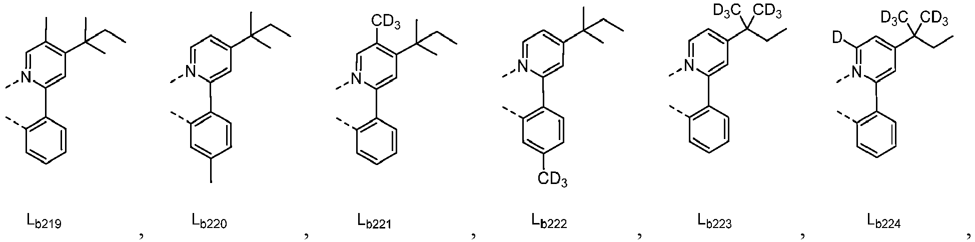 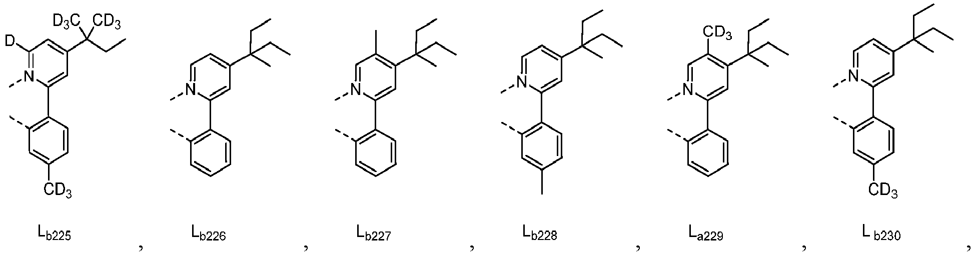 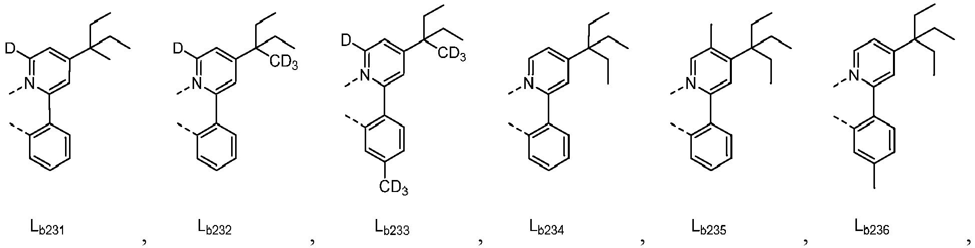 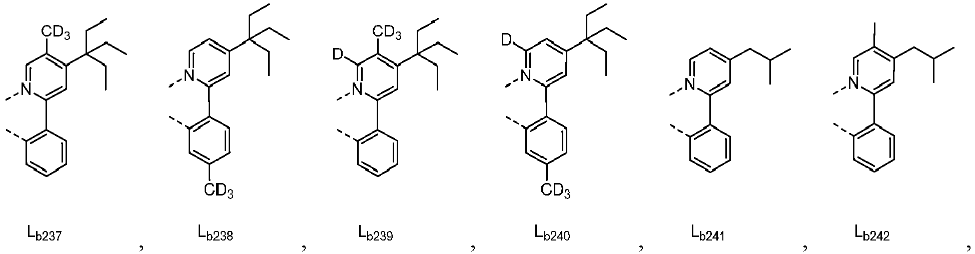 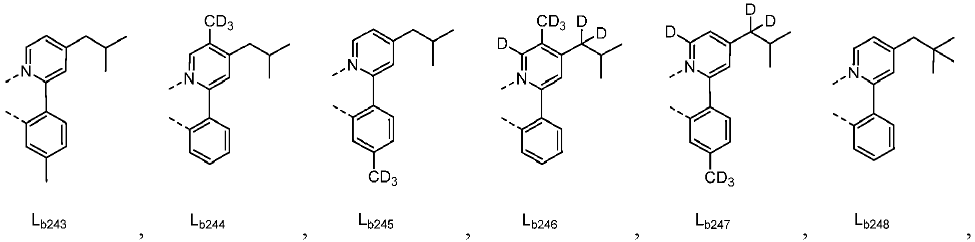 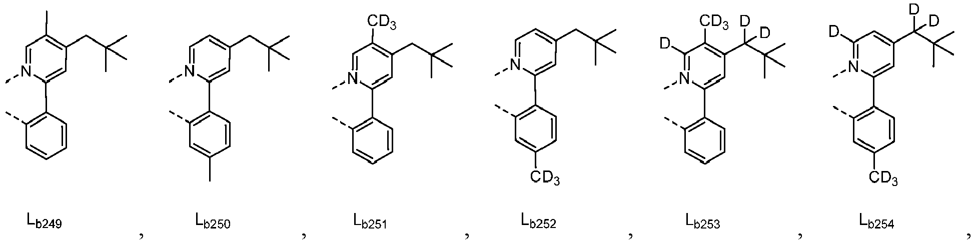 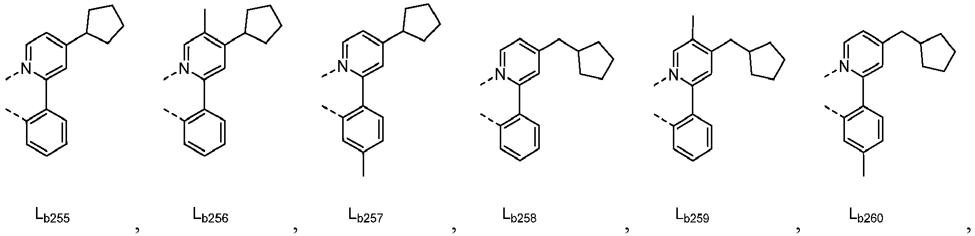 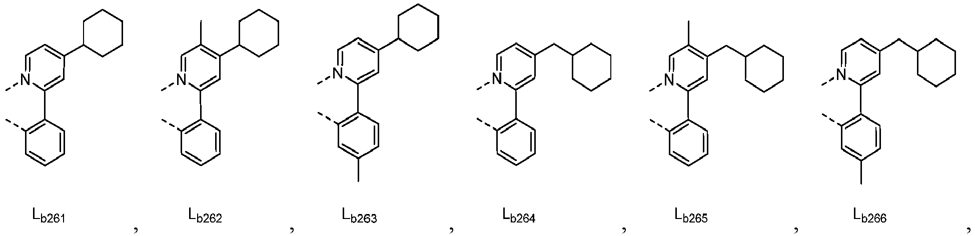 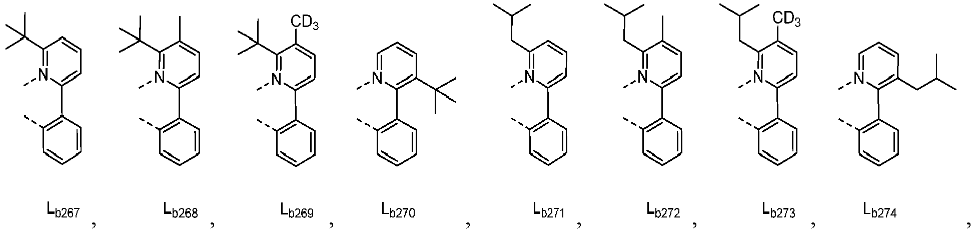 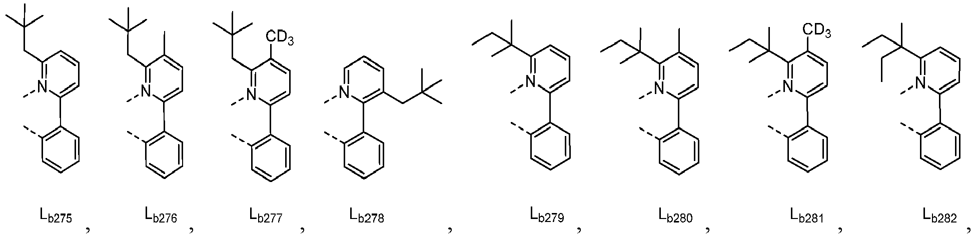 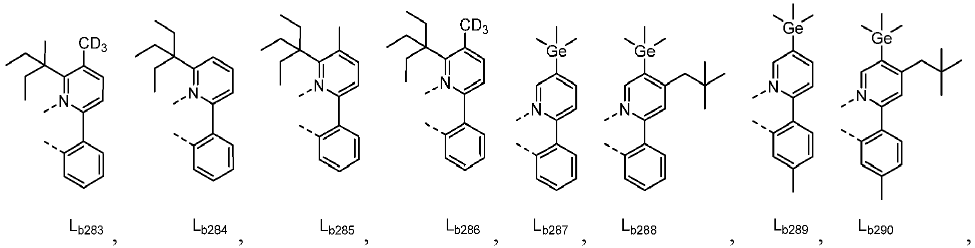 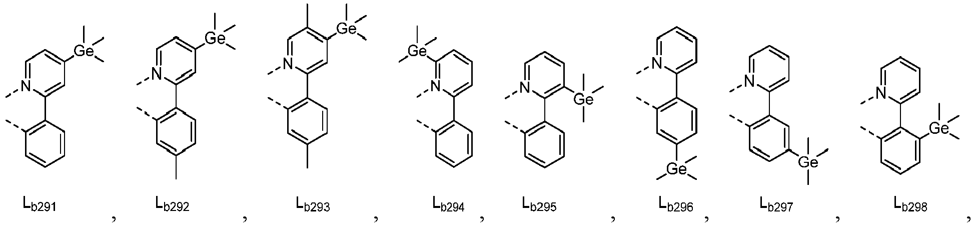 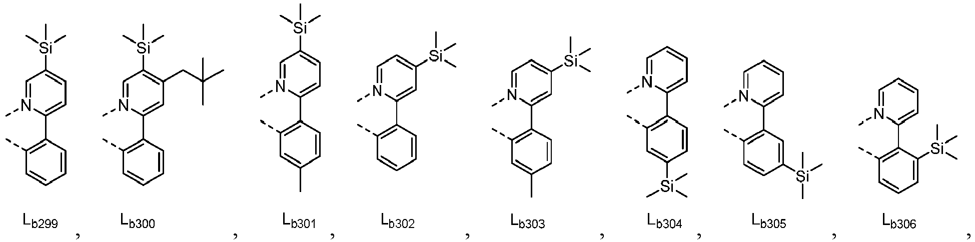 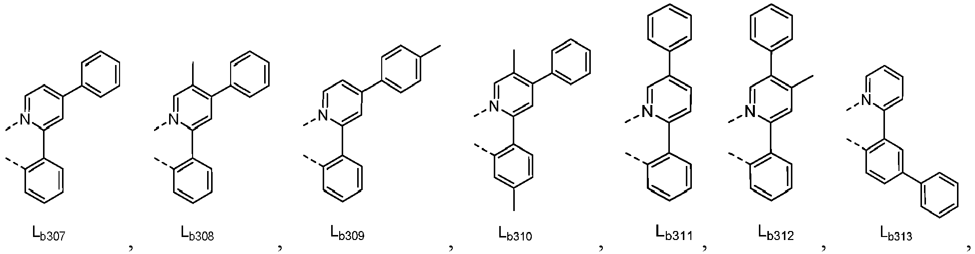 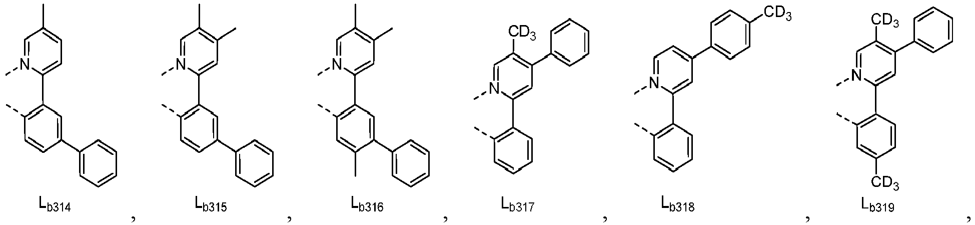 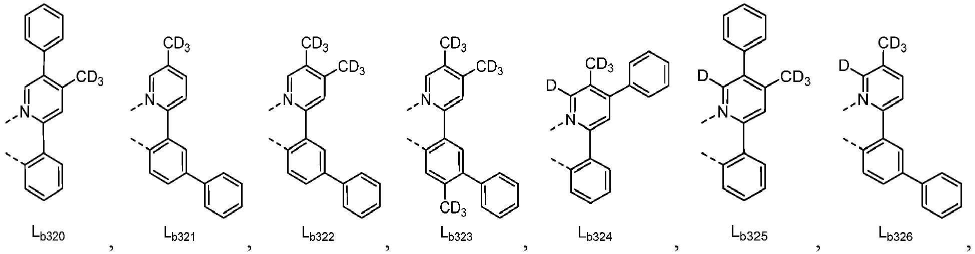 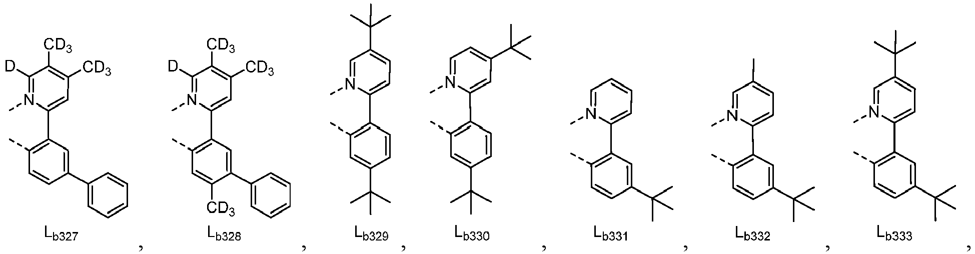 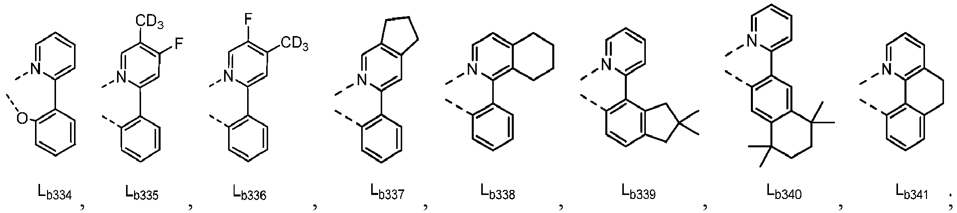
wherein optionally, hydrogen atoms in L_{b1} to L_{b341} can be partially or fully substituted with deuterium;
wherein L_{c} is, at each occurrence identically or differently, selected from the group consisting of the following:

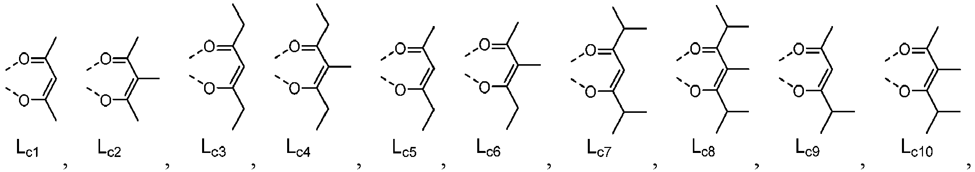

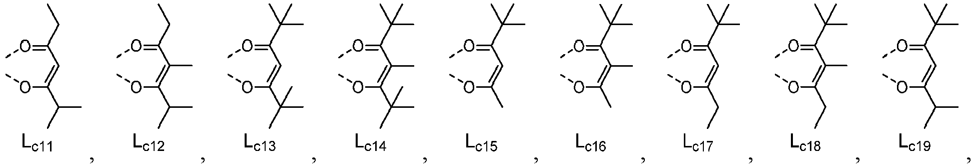

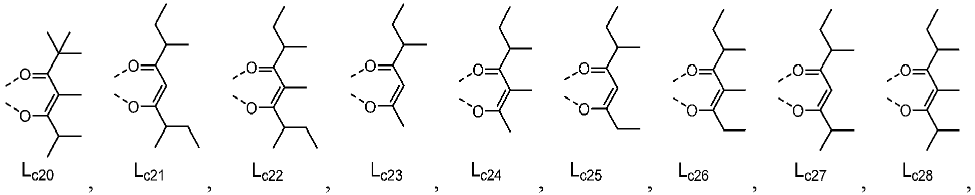

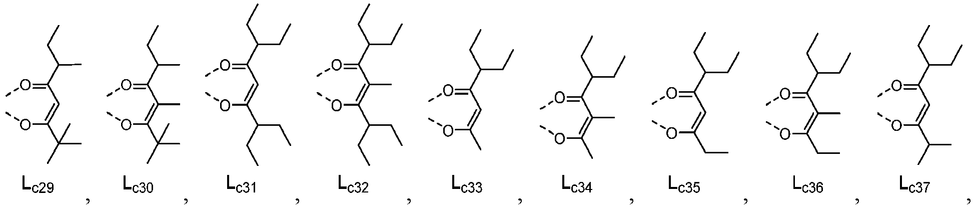

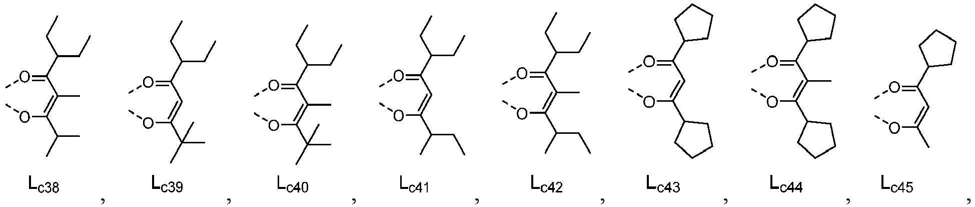

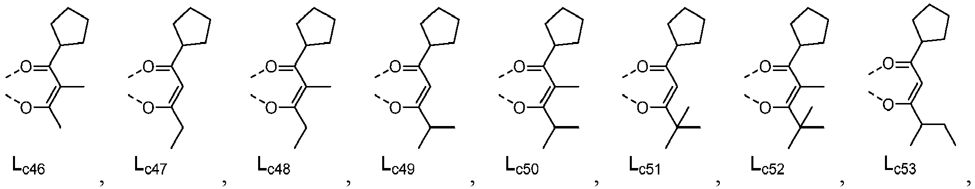

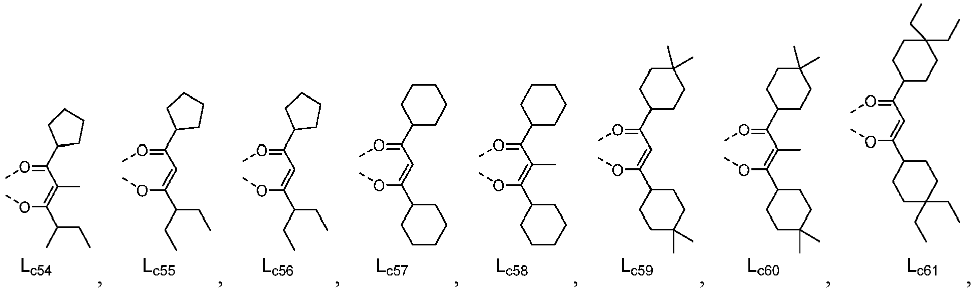

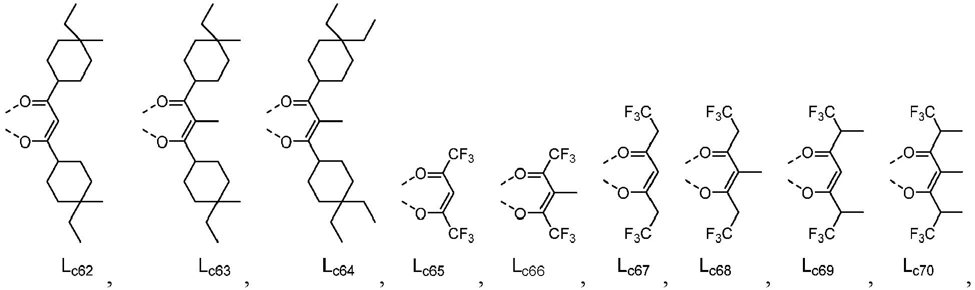

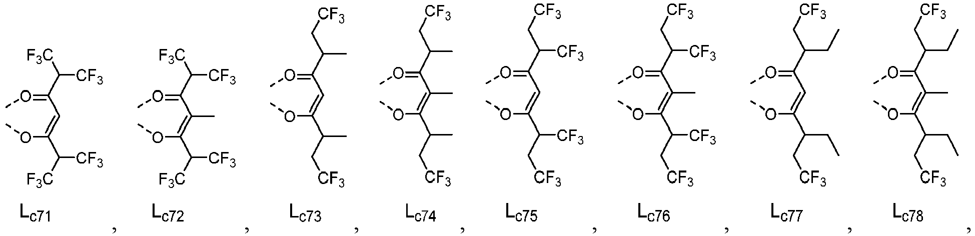

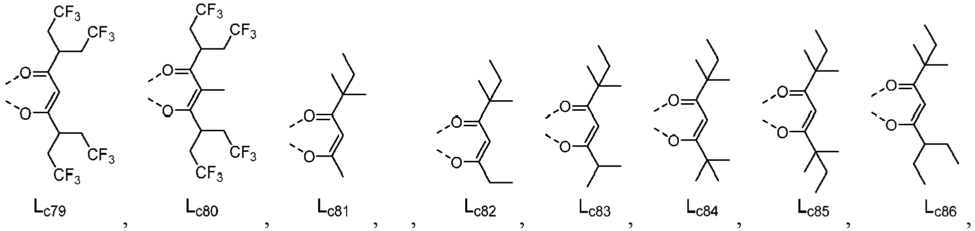

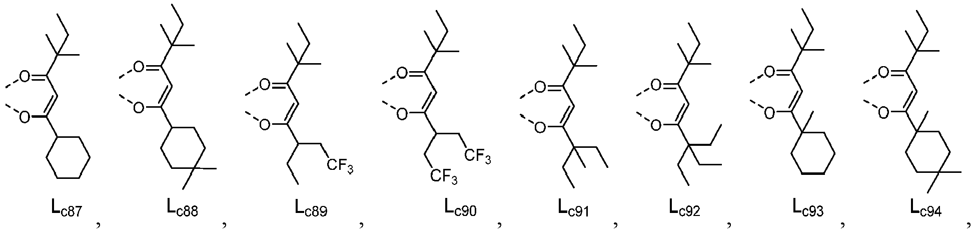

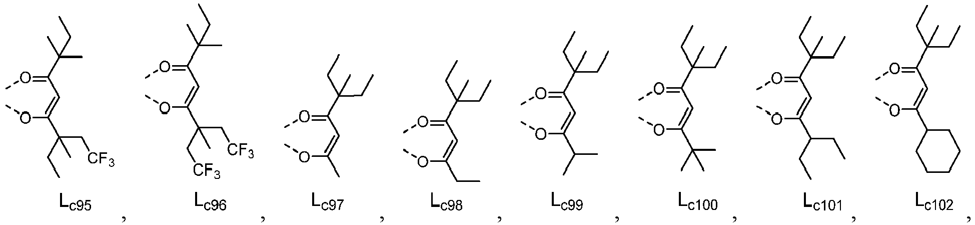

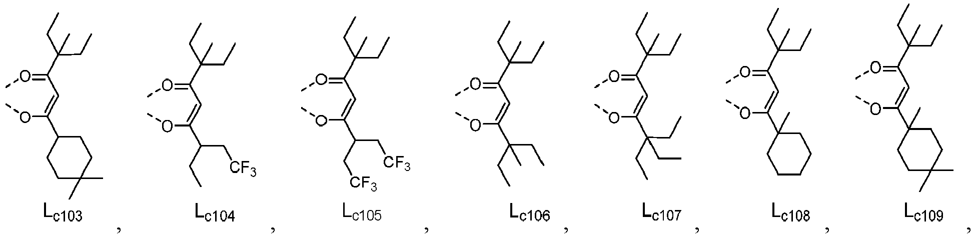

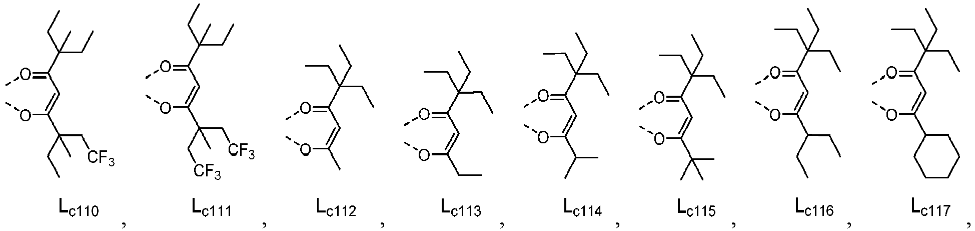

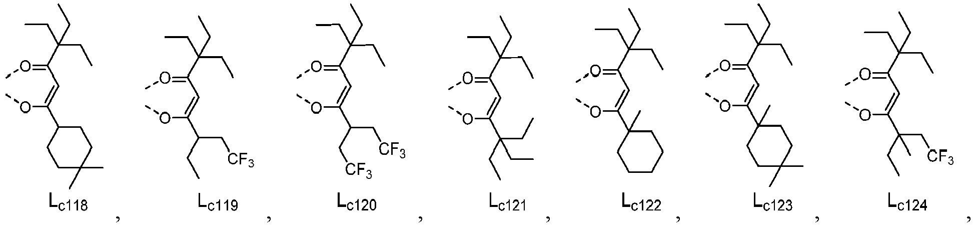

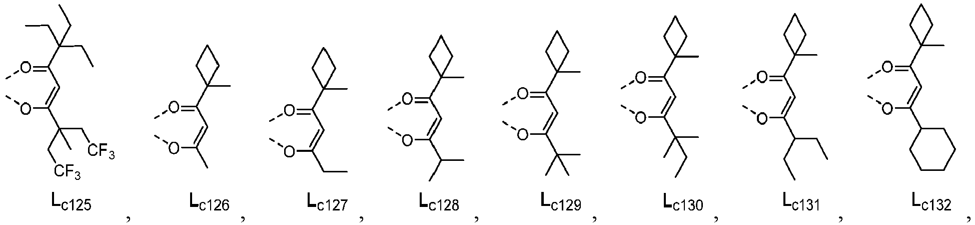

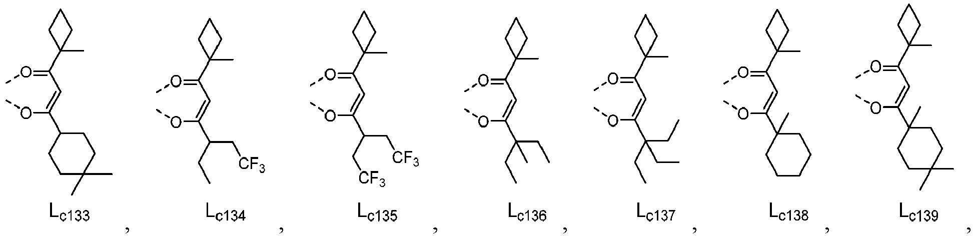

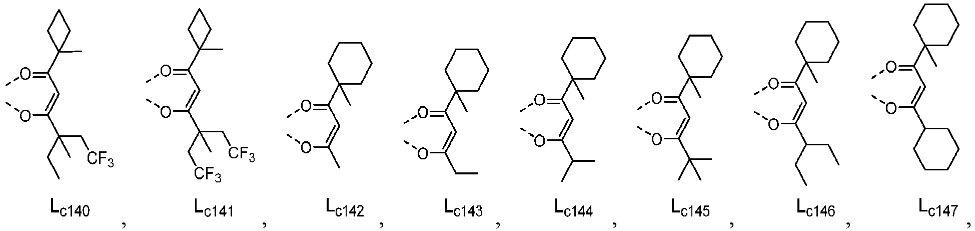

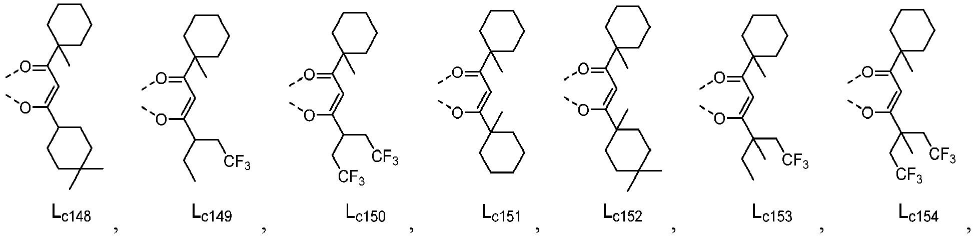

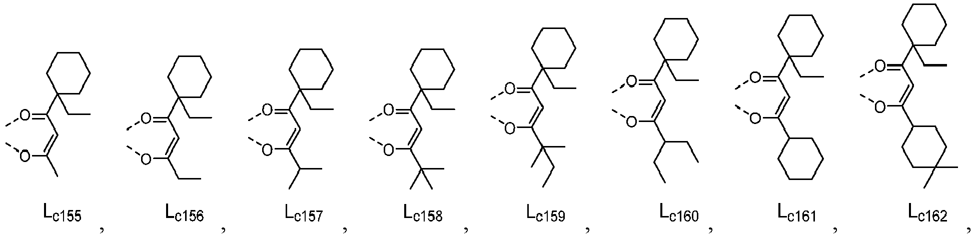

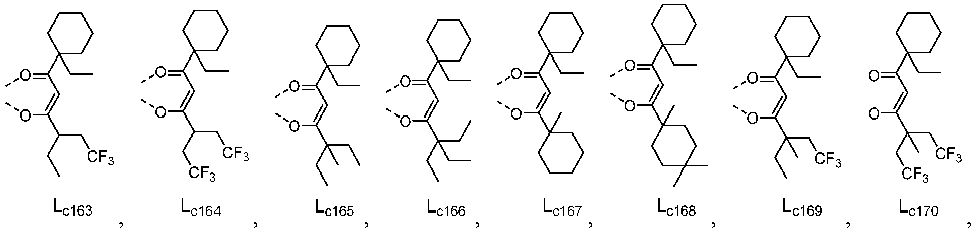

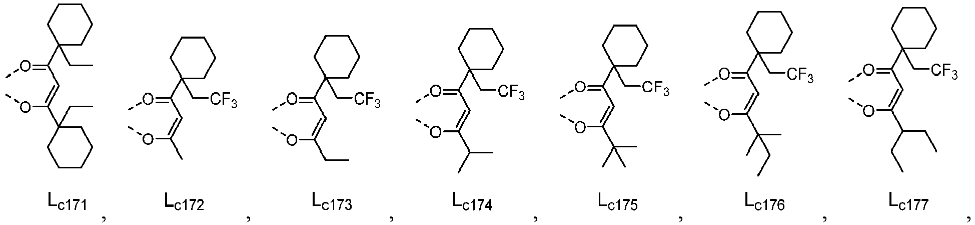

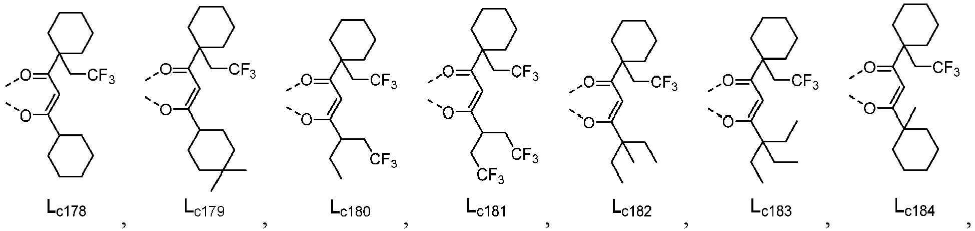

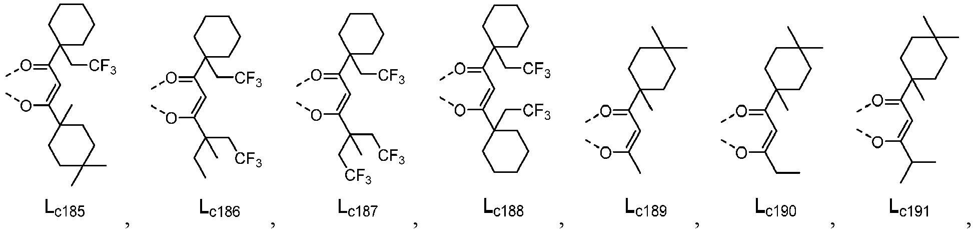

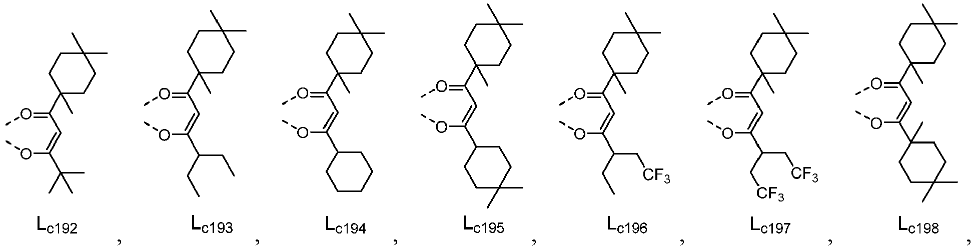

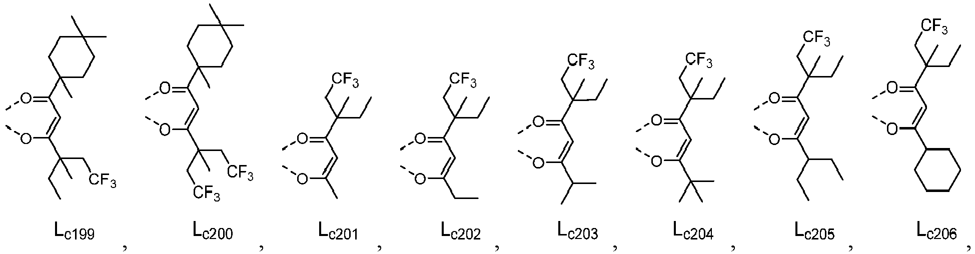

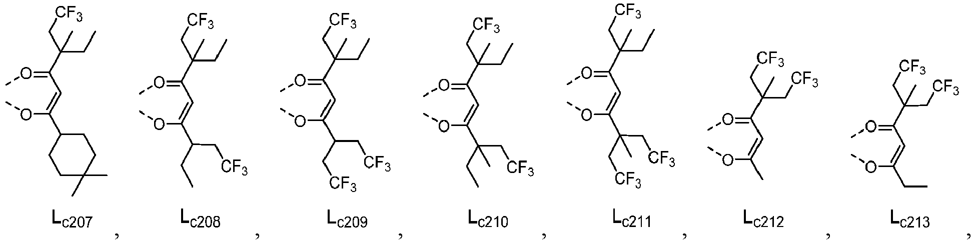

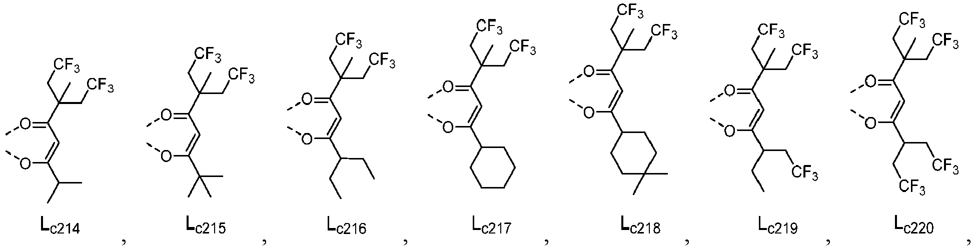

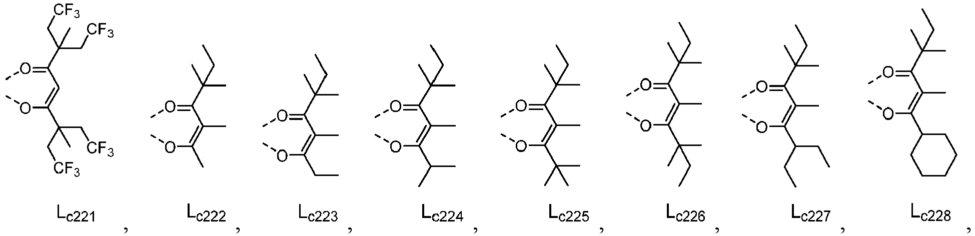

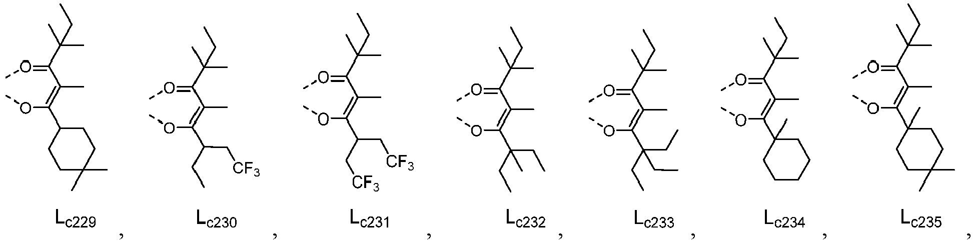

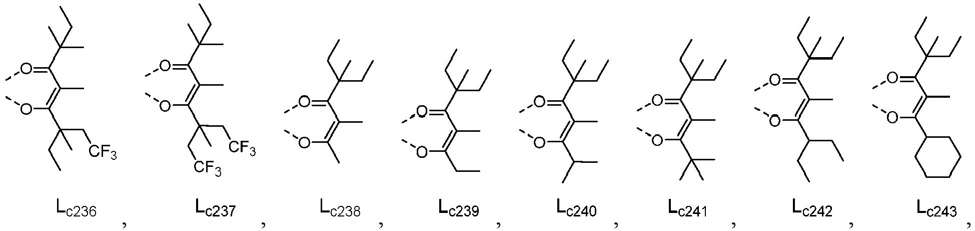

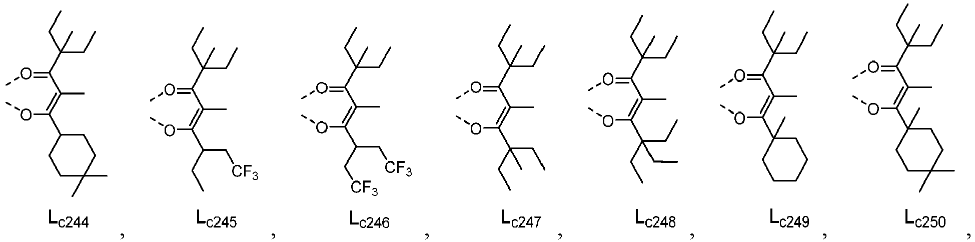

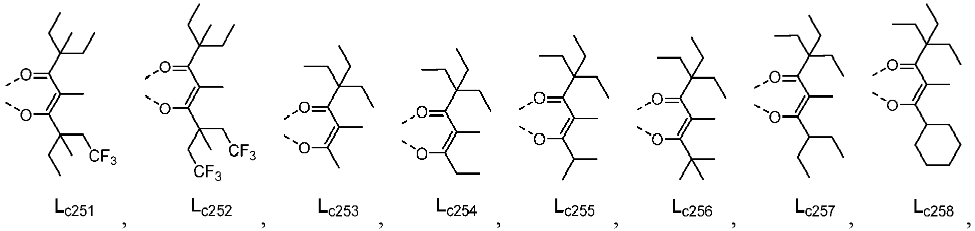

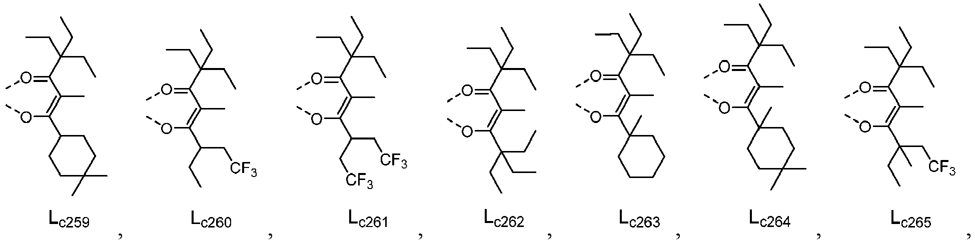

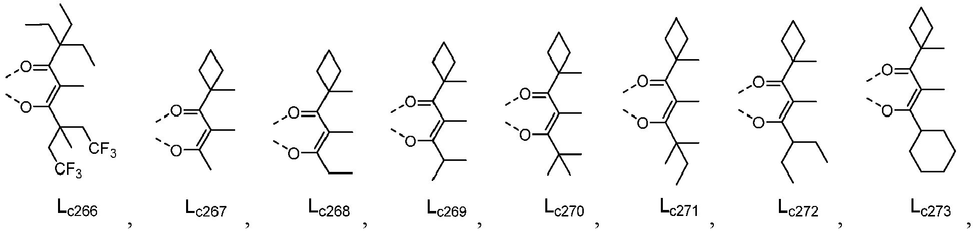

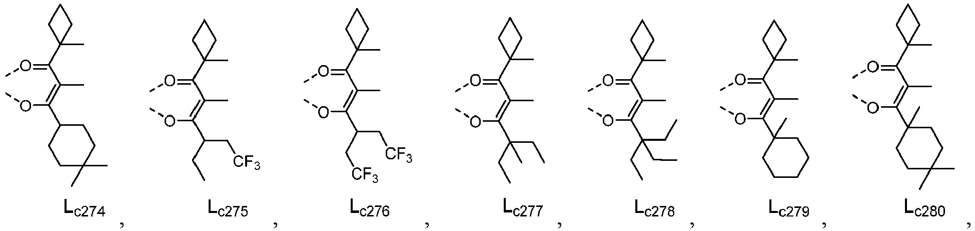

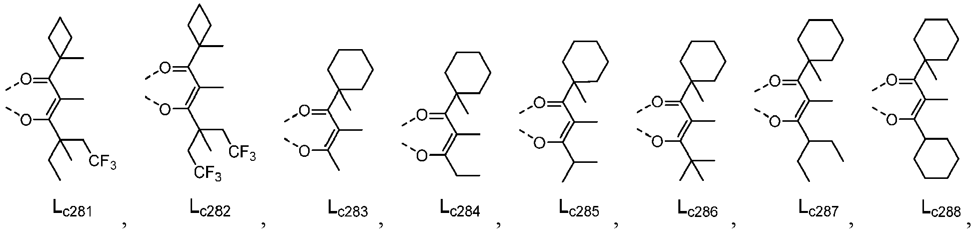

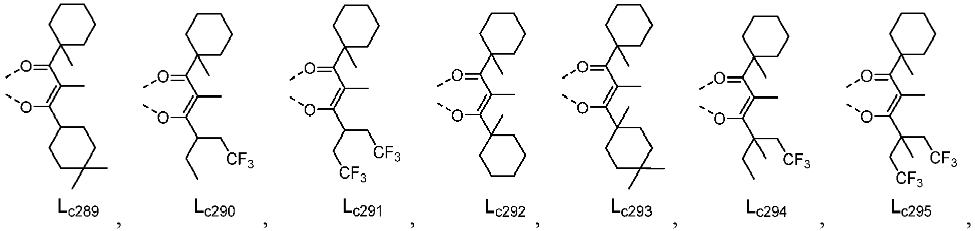

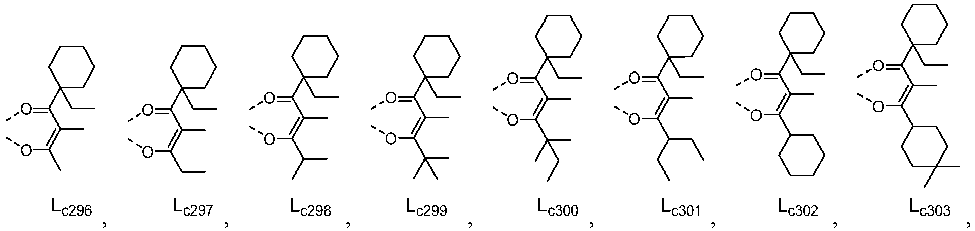

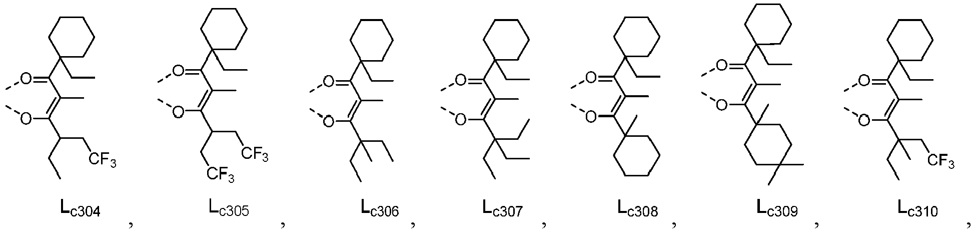

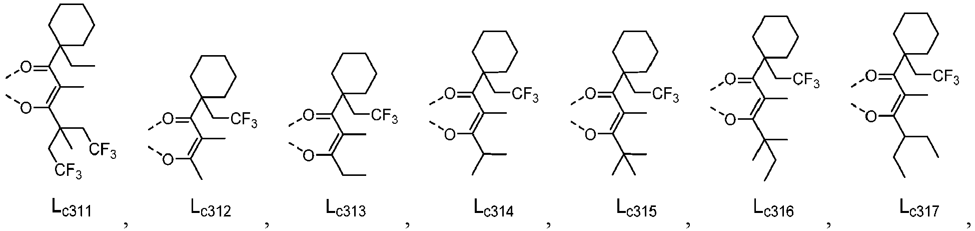

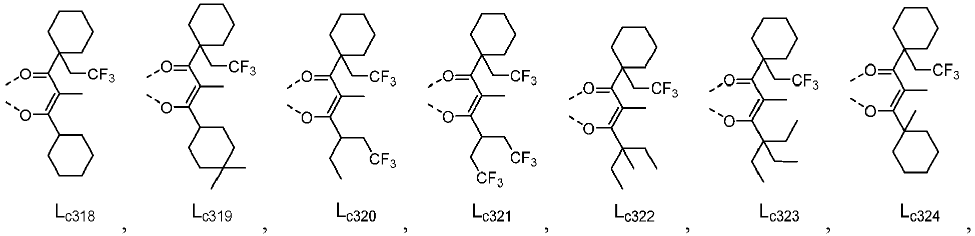

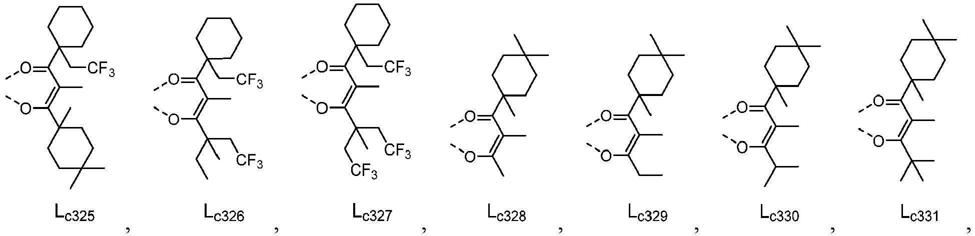

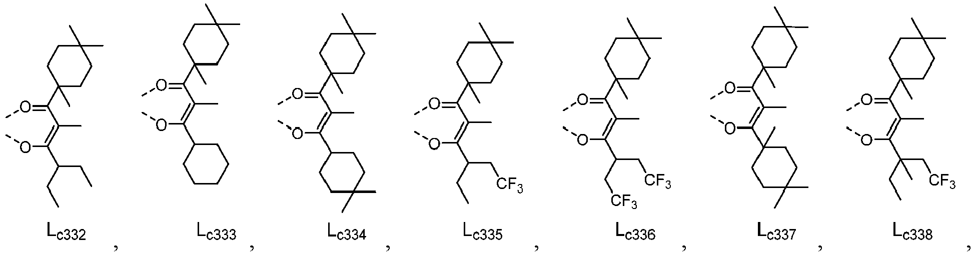

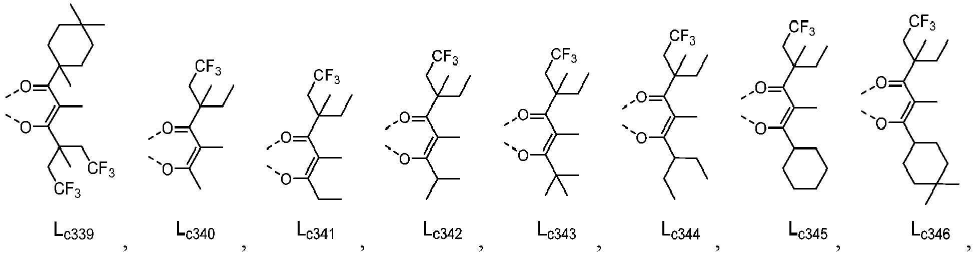

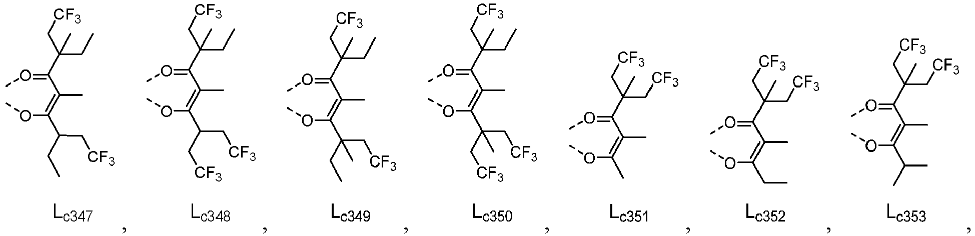

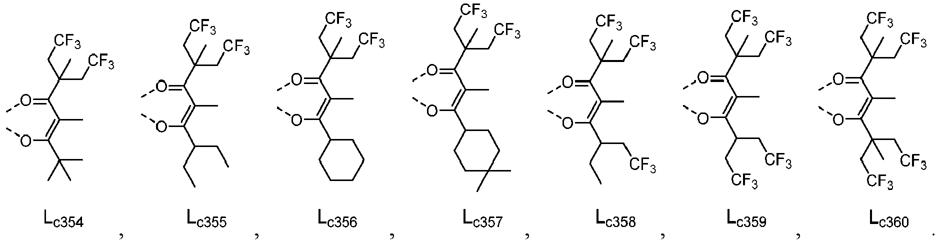

13. The metal complex according to claim 12, wherein the metal complex is selected from the group consisting of Metal Complex 1 to Metal Complex 1646;
wherein Metal Complex 1 to Metal Complex 1364 each have a structure of IrLₐ(L_{b})₂, wherein the two L_{b} are the same or different, and Lₐ and the two L_{b} respectively correspond to the structures listed in the following table:
| **Metal Complex** | **Lₐ** | **L_{b}** | **L_{b}** | **Metal Complex** | **Lₐ** | **L_{b}** | **L_{b}** |
|---|---|---|---|---|---|---|---|
| 1 | Lₐ₁ | L_{b1} | L_{b1} | 2 | Lₐ₂ | L_{b1} | L_{b1} |
| 3 | Lₐ₃ | L_{b1} | L_{b1} | 4 | Lₐ₄ | L_{b1} | L_{b1} |
| 5 | Lₐ₅ | L_{b1} | L_{b1} | 6 | Lₐ₆ | L_{b1} | L_{b1} |
| 7 | Lₐ₇ | L_{b1} | L_{b1} | 8 | Lₐ₈ | L_{b1} | L_{b1} |
| 9 | Lₐ₉ | L_{b1} | L_{b1} | 10 | Lₐ₁₀ | L_{b1} | L_{b1} |
| 11 | Lₐ₁₃ | L_{b1} | L_{b1} | 12 | Lₐ₁₉ | L_{b1} | L_{b1} |
| 13 | Lₐ₂₀ | L_{b1} | L_{b1} | 14 | Lₐ₂₁ | L_{b1} | L_{b1} |
| 15 | Lₐ₃₁ | L_{b1} | L_{b1} | 16 | Lₐ₃₂ | L_{b1} | L_{b1} |
| 17 | Lₐ₃₃ | L_{b1} | L_{b1} | 18 | Lₐ₃₄ | L_{b1} | L_{b1} |
| 19 | Lₐ₃₅ | L_{b1} | L_{b1} | 20 | Lₐ₅₃ | L_{b1} | L_{b1} |
| 21 | Lₐ₅₇ | L_{b1} | L_{b1} | 22 | Lₐ₅₈ | L_{b1} | L_{b1} |
| 23 | Lₐ₆₁ | L_{b1} | L_{b1} | 24 | Lₐ₈₂ | L_{b1} | L_{b1} |
| 25 | Lₐ₈₃ | L_{b1} | L_{b1} | 26 | Lₐ₈₄ | L_{b1} | L_{b1} |
| 27 | Lₐ₈₇ | L_{b1} | L_{b1} | 28 | Lₐ₈₈ | L_{b1} | L_{b1} |
| 29 | Lₐ₉₀ | L_{b1} | L_{b1} | 30 | Lₐ₉₁ | L_{b1} | L_{b1} |
| 31 | Lₐ₉₉ | L_{b1} | L_{b1} | 32 | Lₐ₁₀₂ | L_{b1} | L_{b1} |
| 33 | Lₐ₁₀₈ | L_{b1} | L_{b1} | 34 | Lₐ₁₀₉ | L_{b1} | L_{b1} |
| 35 | Lₐ₁₁₀ | L_{b1} | L_{b1} | 36 | Lₐ₁₂₀ | L_{b1} | L_{b1} |
| 37 | Lₐ₁₂₁ | L_{b1} | L_{b1} | 38 | Lₐ₁₂₂ | L_{b1} | L_{b1} |
| 39 | Lₐ₁₂₃ | L_{b1} | L_{b1} | 40 | Lₐ₁₂₄ | L_{b1} | L_{b1} |
| 41 | Lₐ₁₄₂ | L_{b1} | L_{b1} | 42 | Lₐ₁₄₆ | L_{b1} | L_{b1} |
| 43 | Lₐ₁₅₀ | L_{b1} | L_{b1} | 44 | Lₐ₁₇₁ | L_{b1} | L_{b1} |
| 45 | Lₐ₁₇₂ | L_{b1} | L_{b1} | 46 | Lₐ₁₇₃ | L_{b1} | L_{b1} |
| 47 | Lₐ₁₇₆ | L_{b1} | L_{b1} | 48 | Lₐ₁₇₇ | L_{b1} | L_{b1} |
| 49 | Lₐ₁₇₉ | L_{b1} | L_{b1} | 50 | Lₐ₁₈₀ | L_{b1} | L_{b1} |
| 51 | Lₐ₂₆₈ | L_{b1} | L_{b1} | 52 | Lₐ₂₆₉ | L_{b1} | L_{b1} |
| 53 | Lₐ₂₇₃ | L_{b1} | L_{b1} | 54 | Lₐ₂₇₄ | L_{b1} | L_{b1} |
| 55 | Lₐ₃₆₃ | L_{b1} | L_{b1} | 56 | Lₐ₃₆₄ | L_{b1} | L_{b1} |
| 57 | Lₐ₃₆₇ | L_{b1} | L_{b1} | 58 | Lₐ₃₆₈ | L_{b1} | L_{b1} |
| 59 | Lₐ₃₇₂ | L_{b1} | L_{b1} | 60 | Lₐ₃₇₃ | L_{b1} | L_{b1} |
| 61 | Lₐ₃₇₄ | L_{b1} | L_{b1} | 62 | Lₐ₃₇₅ | L_{b1} | L_{b1} |
| 63 | Lₐ₃₉₂ | L_{b1} | L_{b1} | 64 | Lₐ₃₉₃ | L_{b1} | L_{b1} |
| 65 | Lₐ₅₈₁ | L_{b1} | L_{b1} | 66 | Lₐ₅₈₂ | L_{b1} | L_{b1} |
| 67 | Lₐ₅₉₀ | L_{b1} | L_{b1} | 68 | Lₐ₅₉₁ | L_{b1} | L_{b1} |
| 69 | Lₐ₆₁₀ | L_{b1} | L_{b1} | 70 | Lₐ₆₁₁ | L_{b1} | L_{b1} |
| 71 | Lₐ₆₁₂ | L_{b1} | L_{b1} | 72 | Lₐ₆₁₃ | L_{b1} | L_{b1} |
| 73 | Lₐ₆₁₆ | L_{b1} | L_{b1} | 74 | Lₐ₆₁₇ | L_{b1} | L_{b1} |
| 75 | Lₐ₆₁₈ | L_{b1} | L_{b1} | 76 | Lₐ₆₁₉ | L_{b1} | L_{b1} |
| 77 | Lₐ₆₂₂ | L_{b1} | L_{b1} | 78 | Lₐ₆₂₄ | L_{b1} | L_{b1} |
| 79 | Lₐ₆₂₅ | L_{b1} | L_{b1} | 80 | Lₐ₆₂₇ | L_{b1} | L_{b1} |
| 81 | Lₐ₆₂₈ | L_{b1} | L_{b1} | 82 | Lₐ₆₂₉ | L_{b1} | L_{b1} |
| 83 | Lₐ₆₃₀ | L_{b1} | L_{b1} | 84 | Lₐ₆₃₁ | L_{b1} | L_{b1} |
| 85 | Lₐ₆₃₂ | L_{b1} | L_{b1} | 86 | Lₐ₆₄₀ | L_{b1} | L_{b1} |
| 87 | Lₐ₆₄₁ | L_{b1} | L_{b1} | 88 | Lₐ₆₄₂ | L_{b1} | L_{b1} |
| 89 | Lₐ₆₄₃ | L_{b1} | L_{b1} | 90 | Lₐ₆₄₄ | L_{b1} | L_{b1} |
| 91 | Lₐ₆₄₅ | L_{b1} | L_{b1} | 92 | Lₐ₆₅₆ | L_{b1} | L_{b1} |
| 93 | Lₐ₆₆₂ | L_{b1} | L_{b1} | 94 | Lₐ₆₆₄ | L_{b1} | L_{b1} |
| 95 | Lₐ₆₆₅ | L_{b1} | L_{b1} | 96 | Lₐ₆₆₆ | L_{b1} | L_{b1} |
| 97 | Lₐ₆₆₇ | L_{b1} | L_{b1} | 98 | Lₐ₆₉₀ | L_{b1} | L_{b1} |
| 99 | Lₐ₆₉₁ | L_{b1} | L_{b1} | 100 | Lₐ₆₉₂ | L_{b1} | L_{b1} |
| 101 | Lₐ₆₉₃ | L_{b1} | L_{b1} | 102 | Lₐ₆₉₈ | L_{b1} | L_{b1} |
| 103 | Lₐ₆₉₉ | L_{b1} | L_{b1} | 104 | Lₐ₇₀₀ | L_{b1} | L_{b1} |
| 105 | Lₐ₇₀₁ | L_{b1} | L_{b1} | 106 | Lₐ₇₀₂ | L_{b1} | L_{b1} |
| 107 | Lₐ₇₀₃ | L_{b1} | L_{b1} | 108 | Lₐ₇₀₄ | L_{b1} | L_{b1} |
| 109 | Lₐ₇₀₈ | L_{b1} | L_{b1} | 110 | Lₐ₇₁₁ | L_{b1} | L_{b1} |
| 111 | Lₐ₇₁₇ | L_{b1} | L_{b1} | 112 | Lₐ₇₁₈ | L_{b1} | L_{b1} |
| 113 | Lₐ₇₁₉ | L_{b1} | L_{b1} | 114 | Lₐ₇₂₉ | L_{b1} | L_{b1} |
| 115 | Lₐ₇₃₀ | L_{b1} | L_{b1} | 116 | Lₐ₇₃₁ | L_{b1} | L_{b1} |
| 117 | Lₐ₇₃₂ | L_{b1} | L_{b1} | 118 | Lₐ₇₃₃ | L_{b1} | L_{b1} |
| 119 | Lₐ₇₈₈ | L_{b1} | L_{b1} | 120 | Lₐ₇₈₉ | L_{b1} | L_{b1} |
| 121 | Lₐ₇₉₂ | L_{b1} | L_{b1} | 122 | Lₐ₇₉₄ | L_{b1} | L_{b1} |
| 123 | Lₐ₈₇₇ | L_{b1} | L_{b1} | 124 | Lₐ₈₇₈ | L_{b1} | L_{b1} |
| 125 | Lₐ₈₇₉ | L_{b1} | L_{b1} | 126 | Lₐ₈₈₀ | L_{b1} | L_{b1} |
| 127 | Lₐ₈₈₅ | L_{b1} | L_{b1} | 128 | Lₐ₈₈₆ | L_{b1} | L_{b1} |
| 129 | Lₐ₈₉₉ | L_{b1} | L_{b1} | 130 | Lₐ₉₀₀ | L_{b1} | L_{b1} |
| 131 | Lₐ₉₁₅ | L_{b1} | L_{b1} | 132 | Lₐ₉₁₆ | L_{b1} | L_{b1} |
| 133 | Lₐ₉₂₀ | L_{b1} | L_{b1} | 134 | Lₐ₉₂₁ | L_{b1} | L_{b1} |
| 135 | Lₐ₉₂₂ | L_{b1} | L_{b1} | 136 | Lₐ₉₂₃ | L_{b1} | L_{b1} |
| 137 | Lₐ₉₂₆ | L_{b1} | L_{b1} | 138 | Lₐ₉₂₇ | L_{b1} | L_{b1} |
| 139 | Lₐ₉₂₈ | L_{b1} | L_{b1} | 140 | Lₐ₉₂₉ | L_{b1} | L_{b1} |
| 141 | Lₐ₉₃₂ | L_{b1} | L_{b1} | 142 | Lₐ₉₃₃ | L_{b1} | L_{b1} |
| 143 | Lₐ₁₀₂₀ | L_{b1} | L_{b1} | 144 | Lₐ₁₀₂₁ | L_{b1} | L_{b1} |
| 145 | Lₐ₁₀₂₂ | L_{b1} | L_{b1} | 146 | Lₐ₁₀₂₃ | L_{b1} | L_{b1} |
| 147 | Lₐ₁₀₂₅ | L_{b1} | L_{b1} | 148 | Lₐ₁₀₂₆ | L_{b1} | L_{b1} |
| 149 | Lₐ₁₀₂₈ | L_{b1} | L_{b1} | 150 | Lₐ₁₀₂₉ | L_{b1} | L_{b1} |
| 151 | Lₐ₁₀₃₀ | L_{b1} | L_{b1} | 152 | Lₐ₁₀₃₄ | L_{b1} | L_{b1} |
| 153 | Lₐ₁₀₃₈ | L_{b1} | L_{b1} | 154 | Lₐ₁₀₄₀ | L_{b1} | L_{b1} |
| 155 | Lₐ₁₀₄₆ | L_{b1} | L_{b1} | 156 | Lₐ₁₀₄₈ | L_{b1} | L_{b1} |
| 157 | Lₐ₁₀₅₅ | L_{b1} | L_{b1} | 158 | Lₐ₁₀₅₆ | L_{b1} | L_{b1} |
| 159 | Lₐ₁₃₃₃ | L_{b1} | L_{b1} | 160 | Lₐ₁₃₃₄ | L_{b1} | L_{b1} |
| 161 | Lₐ₁₃₄₀ | L_{b1} | L_{b1} | 162 | Lₐ₁₃₄₁ | L_{b1} | L_{b1} |
| 163 | Lₐ₁₃₇₁ | L_{b1} | L_{b1} | 164 | Lₐ₁₃₇₂ | L_{b1} | L_{b1} |
| 165 | Lₐ₁₃₇₃ | L_{b1} | L_{b1} | 166 | Lₐ₁₃₇₄ | L_{b1} | L_{b1} |
| 167 | Lₐ₁₄₂₃ | L_{b1} | L_{b1} | 168 | Lₐ₁₄₂₄ | L_{b1} | L_{b1} |
| 169 | Lₐ₁₄₂₆ | L_{b1} | L_{b1} | 170 | Lₐ₁₄₂₇ | L_{b1} | L_{b1} |
| 171 | Lₐ₁₄₃₂ | L_{b1} | L_{b1} | 172 | Lₐ₁₄₃₃ | L_{b1} | L_{b1} |
| 173 | Lₐ₁₄₃₅ | L_{b1} | L_{b1} | 174 | Lₐ₁₄₃₆ | L_{b1} | L_{b1} |
| 175 | Lₐ₁ | L_{b3} | L_{b3} | 176 | Lₐ₂ | L_{b3} | L_{b3} |
| 177 | Lₐ₃ | L_{b3} | L_{b3} | 178 | Lₐ₄ | L_{b3} | L_{b3} |
| 179 | Lₐ₅ | L_{b3} | L_{b3} | 180 | Lₐ₆ | L_{b3} | L_{b3} |
| 181 | Lₐ₇ | L_{b3} | L_{b3} | 182 | Lₐ₈ | L_{b3} | L_{b3} |
| 183 | Lₐ₉ | L_{b3} | L_{b3} | 184 | Lₐ₁₀ | L_{b3} | L_{b3} |
| 185 | Lₐ₁₃ | L_{b3} | L_{b3} | 186 | Lₐ₁₉ | L_{b3} | L_{b3} |
| 187 | Lₐ₂₀ | L_{b3} | L_{b3} | 188 | Lₐ₂₁ | L_{b3} | L_{b3} |
| 189 | Lₐ₃₁ | L_{b3} | L_{b3} | 190 | Lₐ₃₂ | L_{b3} | L_{b3} |
| 191 | Lₐ₃₃ | L_{b3} | L_{b3} | 192 | Lₐ₃₄ | L_{b3} | L_{b3} |
| 193 | Lₐ₃₅ | L_{b3} | L_{b3} | 194 | Lₐ₅₃ | L_{b3} | L_{b3} |
| 195 | Lₐ₅₇ | L_{b3} | L_{b3} | 196 | Lₐ₅₈ | L_{b3} | L_{b3} |
| 197 | Lₐ₆₁ | L_{b3} | L_{b3} | 198 | Lₐ₈₂ | L_{b3} | L_{b3} |
| 199 | Lₐ₈₃ | L_{b3} | L_{b3} | 200 | Lₐ₈₄ | L_{b3} | L_{b3} |
| 201 | Lₐ₈₇ | L_{b3} | L_{b3} | 202 | Lₐ₈₈ | L_{b3} | L_{b3} |
| 203 | Lₐ₉₀ | L_{b3} | L_{b3} | 204 | Lₐ₉₁ | L_{b3} | L_{b3} |
| 205 | Lₐ₉₉ | L_{b3} | L_{b3} | 206 | Lₐ₁₀₂ | L_{b3} | L_{b3} |
| 207 | Lₐ₁₀₈ | L_{b3} | L_{b3} | 208 | Lₐ₁₀₉ | L_{b3} | L_{b3} |
| 209 | Lₐ₁₁₀ | L_{b3} | L_{b3} | 210 | Lₐ₁₂₀ | L_{b3} | L_{b3} |
| 211 | Lₐ₁₂₁ | L_{b3} | L_{b3} | 212 | Lₐ₁₂₂ | L_{b3} | L_{b3} |
| 213 | Lₐ₁₂₃ | L_{b3} | L_{b3} | 214 | Lₐ₁₂₄ | L_{b3} | L_{b3} |
| 215 | Lₐ₁₄₂ | L_{b3} | L_{b3} | 216 | Lₐ₁₄₆ | L_{b3} | L_{b3} |
| 217 | Lₐ₁₅₀ | L_{b3} | L_{b3} | 218 | Lₐ₁₇₁ | L_{b3} | L_{b3} |
| 219 | Lₐ₁₇₂ | L_{b3} | L_{b3} | 220 | Lₐ₁₇₃ | L_{b3} | L_{b3} |
| 221 | Lₐ₁₇₆ | L_{b3} | L_{b3} | 222 | Lₐ₁₇₇ | L_{b3} | L_{b3} |
| 223 | Lₐ₁₇₉ | L_{b3} | L_{b3} | 224 | Lₐ₁₈₀ | L_{b3} | L_{b3} |
| 225 | Lₐ₂₆₈ | L_{b3} | L_{b3} | 226 | Lₐ₂₆₉ | L_{b3} | L_{b3} |
| 227 | Lₐ₂₇₃ | L_{b3} | L_{b3} | 228 | Lₐ₂₇₄ | L_{b3} | L_{b3} |
| 229 | Lₐ₃₆₃ | L_{b3} | L_{b3} | 230 | Lₐ₃₆₄ | L_{b3} | L_{b3} |
| 231 | Lₐ₃₆₇ | L_{b3} | L_{b3} | 232 | Lₐ₃₆₈ | L_{b3} | L_{b3} |
| 233 | Lₐ₃₇₂ | L_{b3} | L_{b3} | 234 | Lₐ₃₇₃ | L_{b3} | L_{b3} |
| 235 | Lₐ₃₇₄ | L_{b3} | L_{b3} | 236 | Lₐ₃₇₅ | L_{b3} | L_{b3} |
| 237 | Lₐ₃₉₂ | L_{b3} | L_{b3} | 238 | Lₐ₃₉₃ | L_{b3} | L_{b3} |
| 239 | Lₐ₅₈₁ | L_{b3} | L_{b3} | 240 | Lₐ₅₈₂ | L_{b3} | L_{b3} |
| 241 | Lₐ₅₉₀ | L_{b3} | L_{b3} | 242 | Lₐ₅₉₁ | L_{b3} | L_{b3} |
| 243 | Lₐ₆₁₀ | L_{b3} | L_{b3} | 244 | Lₐ₆₁₁ | L_{b3} | L_{b3} |
| 245 | Lₐ₆₁₂ | L_{b3} | L_{b3} | 246 | Lₐ₆₁₃ | L_{b3} | L_{b3} |
| 247 | Lₐ₆₁₆ | L_{b3} | L_{b3} | 248 | Lₐ₆₁₇ | L_{b3} | L_{b3} |
| 249 | Lₐ₆₁₈ | L_{b3} | L_{b3} | 250 | Lₐ₆₁₉ | L_{b3} | L_{b3} |
| 251 | Lₐ₆₂₂ | L_{b3} | L_{b3} | 252 | Lₐ₆₂₄ | L_{b3} | L_{b3} |
| 253 | Lₐ₆₂₅ | L_{b3} | L_{b3} | 254 | Lₐ₆₂₇ | L_{b3} | L_{b3} |
| 255 | Lₐ₆₂₈ | L_{b3} | L_{b3} | 256 | Lₐ₆₂₉ | L_{b3} | L_{b3} |
| 257 | Lₐ₆₃₀ | L_{b3} | L_{b3} | 258 | Lₐ₆₃₁ | L_{b3} | L_{b3} |
| 259 | Lₐ₆₃₂ | L_{b3} | L_{b3} | 260 | Lₐ₆₄₀ | L_{b3} | L_{b3} |
| 261 | Lₐ₆₄₁ | L_{b3} | L_{b3} | 262 | Lₐ₆₄₂ | L_{b3} | L_{b3} |
| 263 | Lₐ₆₄₃ | L_{b3} | L_{b3} | 264 | Lₐ₆₄₄ | L_{b3} | L_{b3} |
| 265 | Lₐ₆₄₅ | L_{b3} | L_{b3} | 266 | Lₐ₆₅₆ | L_{b3} | L_{b3} |
| 267 | Lₐ₆₆₂ | L_{b3} | L_{b3} | 268 | Lₐ₆₆₄ | L_{b3} | L_{b3} |
| 269 | Lₐ₆₆₅ | L_{b3} | L_{b3} | 270 | Lₐ₆₆₆ | L_{b3} | L_{b3} |
| 271 | Lₐ₆₆₇ | L_{b3} | L_{b3} | 272 | Lₐ₆₉₀ | L_{b3} | L_{b3} |
| 273 | Lₐ₆₉₁ | L_{b3} | L_{b3} | 274 | Lₐ₆₉₂ | L_{b3} | L_{b3} |
| 275 | Lₐ₆₉₃ | L_{b3} | L_{b3} | 276 | Lₐ₆₉₈ | L_{b3} | L_{b3} |
| 277 | Lₐ₆₉₉ | L_{b3} | L_{b3} | 278 | Lₐ₇₀₀ | L_{b3} | L_{b3} |
| 279 | Lₐ₇₀₁ | L_{b3} | L_{b3} | 280 | Lₐ₇₀₂ | L_{b3} | L_{b3} |
| 281 | Lₐ₇₀₃ | L_{b3} | L_{b3} | 282 | Lₐ₇₀₄ | L_{b3} | L_{b3} |
| 283 | Lₐ₇₀₈ | L_{b3} | L_{b3} | 284 | Lₐ₇₁₁ | L_{b3} | L_{b3} |
| 285 | Lₐ₇₁₇ | L_{b3} | L_{b3} | 286 | Lₐ₇₁₈ | L_{b3} | L_{b3} |
| 287 | Lₐ₇₁₉ | L_{b3} | L_{b3} | 288 | Lₐ₇₂₉ | L_{b3} | L_{b3} |
| 289 | Lₐ₇₃₀ | L_{b3} | L_{b3} | 290 | Lₐ₇₃₁ | L_{b3} | L_{b3} |
| 291 | Lₐ₇₃₂ | L_{b3} | L_{b3} | 292 | Lₐ₇₃₃ | L_{b3} | L_{b3} |
| 293 | Lₐ₇₈₈ | L_{b3} | L_{b3} | 294 | Lₐ₇₈₉ | L_{b3} | L_{b3} |
| 295 | Lₐ₇₉₂ | L_{b3} | L_{b3} | 296 | Lₐ₇₉₄ | L_{b3} | L_{b3} |
| 297 | Lₐ₈₇₇ | L_{b3} | L_{b3} | 298 | Lₐ₈₇₈ | L_{b3} | L_{b3} |
| 299 | Lₐ₈₇₉ | L_{b3} | L_{b3} | 300 | Lₐ₈₈₀ | L_{b3} | L_{b3} |
| 301 | Lₐ₈₈₅ | L_{b3} | L_{b3} | 302 | Lₐ₈₈₆ | L_{b3} | L_{b3} |
| 303 | Lₐ₈₉₉ | L_{b3} | L_{b3} | 304 | Lₐ₉₀₀ | L_{b3} | L_{b3} |
| 305 | Lₐ₉₁₅ | L_{b3} | L_{b3} | 306 | Lₐ₉₁₆ | L_{b3} | L_{b3} |
| 307 | Lₐ₉₂₀ | L_{b3} | L_{b3} | 308 | Lₐ₉₂₁ | L_{b3} | L_{b3} |
| 309 | Lₐ₉₂₂ | L_{b3} | L_{b3} | 310 | Lₐ₉₂₃ | L_{b3} | L_{b3} |
| 311 | Lₐ₉₂₆ | L_{b3} | L_{b3} | 312 | Lₐ₉₂₇ | L_{b3} | L_{b3} |
| 313 | Lₐ₉₂₈ | L_{b3} | L_{b3} | 314 | Lₐ₉₂₉ | L_{b3} | L_{b3} |
| 315 | Lₐ₉₃₂ | L_{b3} | L_{b3} | 316 | Lₐ₉₃₃ | L_{b3} | L_{b3} |
| 317 | Lₐ₁₀₂₀ | L_{b3} | L_{b3} | 318 | Lₐ₁₀₂₁ | L_{b3} | L_{b3} |
| 319 | Lₐ₁₀₂₂ | L_{b3} | L_{b3} | 320 | Lₐ₁₀₂₃ | L_{b3} | L_{b3} |
| 321 | Lₐ₁₀₂₅ | L_{b3} | L_{b3} | 322 | Lₐ₁₀₂₆ | L_{b3} | L_{b3} |
| 323 | Lₐ₁₀₂₈ | L_{b3} | L_{b3} | 324 | Lₐ₁₀₂₉ | L_{b3} | L_{b3} |
| 325 | Lₐ₁₀₃₀ | L_{b3} | L_{b3} | 326 | Lₐ₁₀₃₄ | L_{b3} | L_{b3} |
| 327 | Lₐ₁₀₃₈ | L_{b3} | L_{b3} | 328 | Lₐ₁₀₄₀ | L_{b3} | L_{b3} |
| 329 | Lₐ₁₀₄₆ | L_{b3} | L_{b3} | 330 | Lₐ₁₀₄₈ | L_{b3} | L_{b3} |
| 331 | Lₐ₁₀₅₅ | L_{b3} | L_{b3} | 332 | Lₐ₁₀₅₆ | L_{b3} | L_{b3} |
| 333 | Lₐ₁₃₃₃ | L_{b3} | L_{b3} | 334 | Lₐ₁₃₃₄ | L_{b3} | L_{b3} |
| 335 | Lₐ₁₃₄₀ | L_{b3} | L_{b3} | 336 | Lₐ₁₃₄₁ | L_{b3} | L_{b3} |
| 337 | Lₐ₁₃₇₁ | L_{b3} | L_{b3} | 338 | Lₐ₁₃₇₂ | L_{b3} | L_{b3} |
| 339 | Lₐ₁₃₇₃ | L_{b3} | L_{b3} | 340 | Lₐ₁₃₇₄ | L_{b3} | L_{b3} |
| 341 | Lₐ₁₄₂₃ | L_{b3} | L_{b3} | 342 | Lₐ₁₄₂₄ | L_{b3} | L_{b3} |
| 343 | Lₐ₁₄₂₆ | L_{b3} | L_{b3} | 344 | Lₐ₁₄₂₇ | L_{b3} | L_{b3} |
| 345 | Lₐ₁₄₃₂ | L_{b3} | L_{b3} | 346 | Lₐ₁₄₃₃ | L_{b3} | L_{b3} |
| 347 | Lₐ₁₄₃₅ | L_{b3} | L_{b3} | 348 | Lₐ₁₄₃₆ | L_{b3} | L_{b3} |
| 349 | Lₐ₁ | L_{b8} | L_{b8} | 350 | Lₐ₂ | L_{b8} | L_{b8} |
| 351 | Lₐ₃ | L_{b8} | L_{b8} | 352 | Lₐ₄ | L_{b8} | L_{b8} |
| 353 | Lₐ₅ | L_{b8} | L_{b8} | 354 | Lₐ₆ | L_{b8} | L_{b8} |
| 355 | Lₐ₇ | L_{b8} | L_{b8} | 356 | Lₐ₈ | L_{b8} | L_{b8} |
| 357 | Lₐ₉ | L_{b8} | L_{b8} | 358 | Lₐ₁₀ | L_{b8} | L_{b8} |
| 359 | Lₐ₁₃ | L_{b8} | L_{b8} | 360 | Lₐ₁₉ | L_{b8} | L_{b8} |
| 361 | Lₐ₂₀ | L_{b8} | L_{b8} | 362 | Lₐ₂₁ | L_{b8} | L_{b8} |
| 363 | Lₐ₃₁ | L_{b8} | L_{b8} | 364 | Lₐ₃₂ | L_{b8} | L_{b8} |
| 365 | Lₐ₃₃ | L_{b8} | L_{b8} | 366 | Lₐ₃₄ | L_{b8} | L_{b8} |
| 367 | Lₐ₃₅ | L_{b8} | L_{b8} | 368 | Lₐ₅₃ | L_{b8} | L_{b8} |
| 369 | Lₐ₅₇ | L_{b8} | L_{b8} | 370 | Lₐ₅₈ | L_{b8} | L_{b8} |
| 371 | Lₐ₆₁ | L_{b8} | L_{b8} | 372 | Lₐ₈₂ | L_{b8} | L_{b8} |
| 373 | Lₐ₈₃ | L_{b8} | L_{b8} | 374 | Lₐ₈₄ | L_{b8} | L_{b8} |
| 375 | Lₐ₈₇ | L_{b8} | L_{b8} | 376 | Lₐ₈₈ | L_{b8} | L_{b8} |
| 377 | Lₐ₉₀ | L_{b8} | L_{b8} | 378 | Lₐ₉₁ | L_{b8} | L_{b8} |
| 379 | Lₐ₉₉ | L_{b8} | L_{b8} | 380 | Lₐ₁₀₂ | L_{b8} | L_{b8} |
| 381 | Lₐ₁₀₈ | L_{b8} | L_{b8} | 382 | Lₐ₁₀₉ | L_{b8} | L_{b8} |
| 383 | Lₐ₁₁₀ | L_{b8} | L_{b8} | 384 | Lₐ₁₂₀ | L_{b8} | L_{b8} |
| 385 | Lₐ₁₂₁ | L_{b8} | L_{b8} | 386 | Lₐ₁₂₂ | L_{b8} | L_{b8} |
| 387 | Lₐ₁₂₃ | L_{b8} | L_{b8} | 388 | Lₐ₁₂₄ | L_{b8} | L_{b8} |
| 389 | Lₐ₁₄₂ | L_{b8} | L_{b8} | 390 | Lₐ₁₄₆ | L_{b8} | L_{b8} |
| 391 | Lₐ₁₅₀ | L_{b8} | L_{b8} | 392 | Lₐ₁₇₁ | L_{b8} | L_{b8} |
| 393 | Lₐ₁₇₂ | L_{b8} | L_{b8} | 394 | Lₐ₁₇₃ | L_{b8} | L_{b8} |
| 395 | Lₐ₁₇₆ | L_{b8} | L_{b8} | 396 | Lₐ₁₇₇ | L_{b8} | L_{b8} |
| 397 | Lₐ₁₇₉ | L_{b8} | L_{b8} | 398 | Lₐ₁₈₀ | L_{b8} | L_{b8} |
| 399 | Lₐ₂₆₈ | L_{b8} | L_{b8} | 400 | Lₐ₂₆₉ | L_{b8} | L_{b8} |
| 401 | Lₐ₂₇₃ | L_{b8} | L_{b8} | 402 | Lₐ₂₇₄ | L_{b8} | L_{b8} |
| 403 | Lₐ₃₆₃ | L_{b8} | L_{b8} | 404 | Lₐ₃₆₄ | L_{b8} | L_{b8} |
| 405 | Lₐ₃₆₇ | L_{b8} | L_{b8} | 406 | Lₐ₃₆₈ | L_{b8} | L_{b8} |
| 407 | Lₐ₃₇₂ | L_{b8} | L_{b8} | 408 | Lₐ₃₇₃ | L_{b8} | L_{b8} |
| 409 | Lₐ₃₇₄ | L_{b8} | L_{b8} | 410 | Lₐ₃₇₅ | L_{b8} | L_{b8} |
| 411 | Lₐ₃₉₂ | L_{b8} | L_{b8} | 412 | Lₐ₃₉₃ | L_{b8} | L_{b8} |
| 413 | Lₐ₅₈₁ | L_{b8} | L_{b8} | 414 | Lₐ₅₈₂ | L_{b8} | L_{b8} |
| 415 | Lₐ₅₉₀ | L_{b8} | L_{b8} | 416 | Lₐ₅₉₁ | L_{b8} | L_{b8} |
| 417 | Lₐ₆₁₀ | L_{b8} | L_{b8} | 418 | Lₐ₆₁₁ | L_{b8} | L_{b8} |
| 419 | Lₐ₆₁₂ | L_{b8} | L_{b8} | 420 | Lₐ₆₁₃ | L_{b8} | L_{b8} |
| 421 | Lₐ₆₁₆ | L_{b8} | L_{b8} | 422 | Lₐ₆₁₇ | L_{b8} | L_{b8} |
| 423 | Lₐ₆₁₈ | L_{b8} | L_{b8} | 424 | Lₐ₆₁₉ | L_{b8} | L_{b8} |
| 425 | Lₐ₆₂₂ | L_{b8} | L_{b8} | 426 | Lₐ₆₂₄ | L_{b8} | L_{b8} |
| 427 | Lₐ₆₂₅ | L_{b8} | L_{b8} | 428 | Lₐ₆₂₇ | L_{b8} | L_{b8} |
| 429 | Lₐ₆₂₈ | L_{b8} | L_{b8} | 430 | Lₐ₆₂₉ | L_{b8} | L_{b8} |
| 431 | Lₐ₆₃₀ | L_{b8} | L_{b8} | 432 | Lₐ₆₃₁ | L_{b8} | L_{b8} |
| 433 | Lₐ₆₃₂ | L_{b8} | L_{b8} | 434 | Lₐ₆₄₀ | L_{b8} | L_{b8} |
| 435 | Lₐ₆₄₁ | L_{b8} | L_{b8} | 436 | Lₐ₆₄₂ | L_{b8} | L_{b8} |
| 437 | Lₐ₆₄₃ | L_{b8} | L_{b8} | 438 | Lₐ₆₄₄ | L_{b8} | L_{b8} |
| 439 | Lₐ₆₄₅ | L_{b8} | L_{b8} | 440 | Lₐ₆₅₆ | L_{b8} | L_{b8} |
| 441 | Lₐ₆₆₂ | L_{b8} | L_{b8} | 442 | Lₐ₆₆₄ | L_{b8} | L_{b8} |
| 443 | Lₐ₆₆₅ | L_{b8} | L_{b8} | 444 | Lₐ₆₆₆ | L_{b8} | L_{b8} |
| 445 | Lₐ₆₆₇ | L_{b8} | L_{b8} | 446 | Lₐ₆₉₀ | L_{b8} | L_{b8} |
| 447 | Lₐ₆₉₁ | L_{b8} | L_{b8} | 448 | Lₐ₆₉₂ | L_{b8} | L_{b8} |
| 449 | Lₐ₆₉₃ | L_{b8} | L_{b8} | 450 | Lₐ₆₉₈ | L_{b8} | L_{b8} |
| 451 | Lₐ₆₉₉ | L_{b8} | L_{b8} | 452 | Lₐ₇₀₀ | L_{b8} | L_{b8} |
| 453 | Lₐ₇₀₁ | L_{b8} | L_{b8} | 454 | Lₐ₇₀₂ | L_{b8} | L_{b8} |
| 455 | Lₐ₇₀₃ | L_{b8} | L_{b8} | 456 | Lₐ₇₀₄ | L_{b8} | L_{b8} |
| 457 | Lₐ₇₀₈ | L_{b8} | L_{b8} | 458 | Lₐ₇₁₁ | L_{b8} | L_{b8} |
| 459 | Lₐ₇₁₇ | L_{b8} | L_{b8} | 460 | Lₐ₇₁₈ | L_{b8} | L_{b8} |
| 461 | Lₐ₇₁₉ | L_{b8} | L_{b8} | 462 | Lₐ₇₂₉ | L_{b8} | L_{b8} |
| 463 | Lₐ₇₃₀ | L_{b8} | L_{b8} | 464 | Lₐ₇₃₁ | L_{b8} | L_{b8} |
| 465 | Lₐ₇₃₂ | L_{b8} | L_{b8} | 466 | Lₐ₇₃₃ | L_{b8} | L_{b8} |
| 467 | Lₐ₇₈₈ | L_{b8} | L_{b8} | 468 | Lₐ₇₈₉ | L_{b8} | L_{b8} |
| 469 | Lₐ₇₉₂ | L_{b8} | L_{b8} | 470 | Lₐ₇₉₄ | L_{b8} | L_{b8} |
| 471 | Lₐ₈₇₇ | L_{b8} | L_{b8} | 472 | Lₐ₈₇₈ | L_{b8} | L_{b8} |
| 473 | Lₐ₈₇₉ | L_{b8} | L_{b8} | 474 | Lₐ₈₈₀ | L_{b8} | L_{b8} |
| 475 | Lₐ₈₈₅ | L_{b8} | L_{b8} | 476 | Lₐ₈₈₆ | L_{b8} | L_{b8} |
| 477 | Lₐ₈₉₉ | L_{b8} | L_{b8} | 478 | Lₐ₉₀₀ | L_{b8} | L_{b8} |
| 479 | Lₐ₉₁₅ | L_{b8} | L_{b8} | 480 | Lₐ₉₁₆ | L_{b8} | L_{b8} |
| 481 | Lₐ₉₂₀ | L_{b8} | L_{b8} | 482 | Lₐ₉₂₁ | L_{b8} | L_{b8} |
| 483 | Lₐ₉₂₂ | L_{b8} | L_{b8} | 484 | Lₐ₉₂₃ | L_{b8} | L_{b8} |
| 485 | Lₐ₉₂₆ | L_{b8} | L_{b8} | 486 | Lₐ₉₂₇ | L_{b8} | L_{b8} |
| 487 | Lₐ₉₂₈ | L_{b8} | L_{b8} | 488 | Lₐ₉₂₉ | L_{b8} | L_{b8} |
| 489 | Lₐ₉₃₂ | L_{b8} | L_{b8} | 490 | Lₐ₉₃₃ | L_{b8} | L_{b8} |
| 491 | Lₐ₁₀₂₀ | L_{b8} | L_{b8} | 492 | Lₐ₁₀₂₁ | L_{b8} | L_{b8} |
| 493 | Lₐ₁₀₂₂ | L_{b8} | L_{b8} | 494 | Lₐ₁₀₂₃ | L_{b8} | L_{b8} |
| 495 | Lₐ₁₀₂₅ | L_{b8} | L_{b8} | 496 | Lₐ₁₀₂₆ | L_{b8} | L_{b8} |
| 497 | Lₐ₁₀₂₈ | L_{b8} | L_{b8} | 498 | Lₐ₁₀₂₉ | L_{b8} | L_{b8} |
| 499 | Lₐ₁₀₃₀ | L_{b8} | L_{b8} | 500 | Lₐ₁₀₃₄ | L_{b8} | L_{b8} |
| 501 | Lₐ₁₀₃₈ | L_{b8} | L_{b8} | 502 | Lₐ₁₀₄₀ | L_{b8} | L_{b8} |
| 503 | Lₐ₁₀₄₆ | L_{b8} | L_{b8} | 504 | Lₐ₁₀₄₈ | L_{b8} | L_{b8} |
| 505 | Lₐ₁₀₅₅ | L_{b8} | L_{b8} | 506 | Lₐ₁₀₅₆ | L_{b8} | L_{b8} |
| 507 | Lₐ₁₃₃₃ | L_{b8} | L_{b8} | 508 | Lₐ₁₃₃₄ | L_{b8} | L_{b8} |
| 509 | Lₐ₁₃₄₀ | L_{b8} | L_{b8} | 510 | Lₐ₁₃₄₁ | L_{b8} | L_{b8} |
| 511 | Lₐ₁₃₇₁ | L_{b8} | L_{b8} | 512 | Lₐ₁₃₇₂ | L_{b8} | L_{b8} |
| 513 | Lₐ₁₃₇₃ | L_{b8} | L_{b8} | 514 | Lₐ₁₃₇₄ | L_{b8} | L_{b8} |
| 515 | Lₐ₁₄₂₃ | L_{b8} | L_{b8} | 516 | Lₐ₁₄₂₄ | L_{b8} | L_{b8} |
| 517 | Lₐ₁₄₂₆ | L_{b8} | L_{b8} | 518 | Lₐ₁₄₂₇ | L_{b8} | L_{b8} |
| 519 | Lₐ₁₄₃₂ | L_{b8} | L_{b8} | 520 | Lₐ₁₄₃₃ | L_{b8} | L_{b8} |
| 521 | Lₐ₁₄₃₅ | L_{b8} | L_{b8} | 522 | Lₐ₁₄₃₆ | L_{b8} | L_{b8} |
| 523 | Lₐ₁ | L_{b17} | L_{b17} | 524 | Lₐ₂ | L_{b17} | L_{b17} |
| 525 | Lₐ₃ | L_{b17} | L_{b17} | 526 | Lₐ₄ | L_{b17} | L_{b17} |
| 527 | Lₐ₅ | L_{b17} | L_{b17} | 528 | Lₐ₆ | L_{b17} | L_{b17} |
| 529 | Lₐ₇ | L_{b17} | L_{b17} | 530 | Lₐ₈ | L_{b17} | L_{b17} |
| 531 | Lₐ₉ | L_{b17} | L_{b17} | 532 | Lₐ₁₀ | L_{b17} | L_{b17} |
| 533 | Lₐ₁₃ | L_{b17} | L_{b17} | 534 | Lₐ₁₉ | L_{b17} | L_{b17} |
| 535 | Lₐ₂₀ | L_{b17} | L_{b17} | 536 | Lₐ₂₁ | L_{b17} | L_{b17} |
| 537 | Lₐ₃₁ | L_{b17} | L_{b17} | 538 | Lₐ₃₂ | L_{b17} | L_{b17} |
| 539 | Lₐ₃₃ | L_{b17} | L_{b17} | 540 | Lₐ₃₄ | L_{b17} | L_{b17} |
| 541 | Lₐ₃₅ | L_{b17} | L_{b17} | 542 | Lₐ₅₃ | L_{b17} | L_{b17} |
| 543 | Lₐ₅₇ | L_{b17} | L_{b17} | 544 | Lₐ₅₈ | L_{b17} | L_{b17} |
| 545 | Lₐ₆₁ | L_{b17} | L_{b17} | 546 | Lₐ₈₂ | L_{b17} | L_{b17} |
| 547 | Lₐ₈₃ | L_{b17} | L_{b17} | 548 | Lₐ₈₄ | L_{b17} | L_{b17} |
| 549 | Lₐ₈₇ | L_{b17} | L_{b17} | 550 | Lₐ₈₈ | L_{b17} | L_{b17} |
| 551 | Lₐ₉₀ | L_{b17} | L_{b17} | 552 | Lₐ₉₁ | L_{b17} | L_{b17} |
| 553 | Lₐ₉₉ | L_{b17} | L_{b17} | 554 | Lₐ₁₀₂ | L_{b17} | L_{b17} |
| 555 | Lₐ₁₀₈ | L_{b17} | L_{b17} | 556 | Lₐ₁₀₉ | L_{b17} | L_{b17} |
| 557 | Lₐ₁₁₀ | L_{b17} | L_{b17} | 558 | Lₐ₁₂₀ | L_{b17} | L_{b17} |
| 559 | Lₐ₁₂₁ | L_{b17} | L_{b17} | 560 | Lₐ₁₂₂ | L_{b17} | L_{b17} |
| 561 | Lₐ₁₂₃ | L_{b17} | L_{b17} | 562 | Lₐ₁₂₄ | L_{b17} | L_{b17} |
| 563 | Lₐ₁₄₂ | L_{b17} | L_{b17} | 564 | Lₐ₁₄₆ | L_{b17} | L_{b17} |
| 565 | Lₐ₁₅₀ | L_{b17} | L_{b17} | 566 | Lₐ₁₇₁ | L_{b17} | L_{b17} |
| 567 | Lₐ₁₇₂ | L_{b17} | L_{b17} | 568 | Lₐ₁₇₃ | L_{b17} | L_{b17} |
| 569 | Lₐ₁₇₆ | L_{b17} | L_{b17} | 570 | Lₐ₁₇₇ | L_{b17} | L_{b17} |
| 571 | Lₐ₁₇₉ | L_{b17} | L_{b17} | 572 | Lₐ₁₈₀ | L_{b17} | L_{b17} |
| 573 | Lₐ₂₆₈ | L_{b17} | L_{b17} | 574 | Lₐ₂₆₉ | L_{b17} | L_{b17} |
| 575 | Lₐ₂₇₃ | L_{b17} | L_{b17} | 576 | Lₐ₂₇₄ | L_{b17} | L_{b17} |
| 577 | Lₐ₃₆₃ | L_{b17} | L_{b17} | 578 | Lₐ₃₆₄ | L_{b17} | L_{b17} |
| 579 | Lₐ₃₆₇ | L_{b17} | L_{b17} | 580 | Lₐ₃₆₈ | L_{b17} | L_{b17} |
| 581 | Lₐ₃₇₂ | L_{b17} | L_{b17} | 582 | Lₐ₃₇₃ | L_{b17} | L_{b17} |
| 583 | Lₐ₃₇₄ | L_{b17} | L_{b17} | 584 | Lₐ₃₇₅ | L_{b17} | L_{b17} |
| 585 | Lₐ₃₉₂ | L_{b17} | L_{b17} | 586 | Lₐ₃₉₃ | L_{b17} | L_{b17} |
| 587 | Lₐ₅₈₁ | L_{b17} | L_{b17} | 588 | Lₐ₅₈₂ | L_{b17} | L_{b17} |
| 589 | Lₐ₅₉₀ | L_{b17} | L_{b17} | 590 | Lₐ₅₉₁ | L_{b17} | L_{b17} |
| 591 | Lₐ₆₁₀ | L_{b17} | L_{b17} | 592 | Lₐ₆₁₁ | L_{b17} | L_{b17} |
| 593 | Lₐ₆₁₂ | L_{b17} | L_{b17} | 594 | Lₐ₆₁₃ | L_{b17} | L_{b17} |
| 595 | Lₐ₆₁₆ | L_{b17} | L_{b17} | 596 | Lₐ₆₁₇ | L_{b17} | L_{b17} |
| 597 | Lₐ₆₁₈ | L_{b17} | L_{b17} | 598 | Lₐ₆₁₉ | L_{b17} | L_{b17} |
| 599 | Lₐ₆₂₂ | L_{b17} | L_{b17} | 600 | Lₐ₆₂₄ | L_{b17} | L_{b17} |
| 601 | Lₐ₆₂₅ | L_{b17} | L_{b17} | 602 | Lₐ₆₂₇ | L_{b17} | L_{b17} |
| 603 | Lₐ₆₂₈ | L_{b17} | L_{b17} | 604 | Lₐ₆₂₉ | L_{b17} | L_{b17} |
| 605 | Lₐ₆₃₀ | L_{b17} | L_{b17} | 606 | Lₐ₆₃₁ | L_{b17} | L_{b17} |
| 607 | Lₐ₆₃₂ | L_{b17} | L_{b17} | 608 | Lₐ₆₄₀ | L_{b17} | L_{b17} |
| 609 | Lₐ₆₄₁ | L_{b17} | L_{b17} | 610 | Lₐ₆₄₂ | L_{b17} | L_{b17} |
| 611 | Lₐ₆₄₃ | L_{b17} | L_{b17} | 612 | Lₐ₆₄₄ | L_{b17} | L_{b17} |
| 613 | Lₐ₆₄₅ | L_{b17} | L_{b17} | 614 | Lₐ₆₅₆ | L_{b17} | L_{b17} |
| 615 | Lₐ₆₆₂ | L_{b17} | L_{b17} | 616 | Lₐ₆₆₄ | L_{b17} | L_{b17} |
| 617 | Lₐ₆₆₅ | L_{b17} | L_{b17} | 618 | Lₐ₆₆₆ | L_{b17} | L_{b17} |
| 619 | Lₐ₆₆₇ | L_{b17} | L_{b17} | 620 | Lₐ₆₉₀ | L_{b17} | L_{b17} |
| 621 | Lₐ₆₉₁ | L_{b17} | L_{b17} | 622 | Lₐ₆₉₂ | L_{b17} | L_{b17} |
| 623 | Lₐ₆₉₃ | L_{b17} | L_{b17} | 624 | Lₐ₆₉₈ | L_{b17} | L_{b17} |
| 625 | Lₐ₆₉₉ | L_{b17} | L_{b17} | 626 | Lₐ₇₀₀ | L_{b17} | L_{b17} |
| 627 | Lₐ₇₀₁ | L_{b17} | L_{b17} | 628 | Lₐ₇₀₂ | L_{b17} | L_{b17} |
| 629 | Lₐ₇₀₃ | L_{b17} | L_{b17} | 630 | Lₐ₇₀₄ | L_{b17} | L_{b17} |
| 631 | Lₐ₇₀₈ | L_{b17} | L_{b17} | 632 | Lₐ₇₁₁ | L_{b17} | L_{b17} |
| 633 | Lₐ₇₁₇ | L_{b17} | L_{b17} | 634 | Lₐ₇₁₈ | L_{b17} | L_{b17} |
| 635 | Lₐ₇₁₉ | L_{b17} | L_{b17} | 636 | Lₐ₇₂₉ | L_{b17} | L_{b17} |
| 637 | Lₐ₇₃₀ | L_{b17} | L_{b17} | 638 | Lₐ₇₃₁ | L_{b17} | L_{b17} |
| 639 | Lₐ₇₃₂ | L_{b17} | L_{b17} | 640 | Lₐ₇₃₃ | L_{b17} | L_{b17} |
| 641 | Lₐ₇₈₈ | L_{b17} | L_{b17} | 642 | Lₐ₇₈₉ | L_{b17} | L_{b17} |
| 643 | Lₐ₇₉₂ | L_{b17} | L_{b17} | 644 | Lₐ₇₉₄ | L_{b17} | L_{b17} |
| 645 | Lₐ₈₇₇ | L_{b17} | L_{b17} | 646 | Lₐ₈₇₈ | L_{b17} | L_{b17} |
| 647 | Lₐ₈₇₉ | L_{b17} | L_{b17} | 648 | Lₐ₈₈₀ | L_{b17} | L_{b17} |
| 649 | Lₐ₈₈₅ | L_{b17} | L_{b17} | 650 | Lₐ₈₈₆ | L_{b17} | L_{b17} |
| 651 | Lₐ₈₉₉ | L_{b17} | L_{b17} | 652 | Lₐ₉₀₀ | L_{b17} | L_{b17} |
| 653 | Lₐ₉₁₅ | L_{b17} | L_{b17} | 654 | Lₐ₉₁₆ | L_{b17} | L_{b17} |
| 655 | Lₐ₉₂₀ | L_{b17} | L_{b17} | 656 | Lₐ₉₂₁ | L_{b17} | L_{b17} |
| 657 | Lₐ₉₂₂ | L_{b17} | L_{b17} | 658 | Lₐ₉₂₃ | L_{b17} | L_{b17} |
| 659 | Lₐ₉₂₆ | L_{b17} | L_{b17} | 660 | Lₐ₉₂₇ | L_{b17} | L_{b17} |
| 661 | Lₐ₉₂₈ | L_{b17} | L_{b17} | 662 | Lₐ₉₂₉ | L_{b17} | L_{b17} |
| 663 | Lₐ₉₃₂ | L_{b17} | L_{b17} | 664 | Lₐ₉₃₃ | L_{b17} | L_{b17} |
| 665 | Lₐ₁₀₂₀ | L_{b17} | L_{b17} | 666 | Lₐ₁₀₂₁ | L_{b17} | L_{b17} |
| 667 | Lₐ₁₀₂₂ | L_{b17} | L_{b17} | 668 | Lₐ₁₀₂₃ | L_{b17} | L_{b17} |
| 669 | Lₐ₁₀₂₅ | L_{b17} | L_{b17} | 670 | Lₐ₁₀₂₆ | L_{b17} | L_{b17} |
| 671 | Lₐ₁₀₂₈ | L_{b17} | L_{b17} | 672 | Lₐ₁₀₂₉ | L_{b17} | L_{b17} |
| 673 | Lₐ₁₀₃₀ | L_{b17} | L_{b17} | 674 | Lₐ₁₀₃₄ | L_{b17} | L_{b17} |
| 675 | Lₐ₁₀₃₈ | L_{b17} | L_{b17} | 676 | Lₐ₁₀₄₀ | L_{b17} | L_{b17} |
| 677 | Lₐ₁₀₄₆ | L_{b17} | L_{b17} | 678 | Lₐ₁₀₄₈ | L_{b17} | L_{b17} |
| 679 | Lₐ₁₀₅₅ | L_{b17} | L_{b17} | 680 | Lₐ₁₀₅₆ | L_{b17} | L_{b17} |
| 681 | Lₐ₁₃₃₃ | L_{b17} | L_{b17} | 682 | Lₐ₁₃₃₄ | L_{b17} | L_{b17} |
| 683 | Lₐ₁₃₄₀ | L_{b17} | L_{b17} | 684 | Lₐ₁₃₄₁ | L_{b17} | L_{b17} |
| 685 | Lₐ₁₃₇₁ | L_{b17} | L_{b17} | 686 | Lₐ₁₃₇₂ | L_{b17} | L_{b17} |
| 687 | Lₐ₁₃₇₃ | L_{b17} | L_{b17} | 688 | Lₐ₁₃₇₄ | L_{b17} | L_{b17} |
| 689 | Lₐ₁₄₂₃ | L_{b17} | L_{b17} | 690 | Lₐ₁₄₂₄ | L_{b17} | L_{b17} |
| 691 | Lₐ₁₄₂₆ | L_{b17} | L_{b17} | 692 | Lₐ₁₄₂₇ | L_{b17} | L_{b17} |
| 693 | Lₐ₁₄₃₂ | L_{b17} | L_{b17} | 694 | Lₐ₁₄₃₃ | L_{b17} | L_{b17} |
| 695 | Lₐ₁₄₃₅ | L_{b17} | L_{b17} | 696 | Lₐ₁₄₃₆ | L_{b17} | L_{b17} |
| 697 | Lₐ₁ | L_{b81} | L_{b81} | 698 | Lₐ₂ | L_{b81} | L_{b81} |
| 699 | Lₐ₃ | L_{b81} | L_{b81} | 700 | Lₐ₄ | L_{b81} | L_{b81} |
| 701 | Lₐ₅ | L_{b81} | L_{b81} | 702 | Lₐ₆ | L_{b81} | L_{b81} |
| 703 | Lₐ₇ | L_{b81} | L_{b81} | 704 | Lₐ₈ | L_{b81} | L_{b81} |
| 705 | Lₐ₉ | L_{b81} | L_{b81} | 706 | Lₐ₁₀ | L_{b81} | L_{b81} |
| 707 | Lₐ₁₃ | L_{b81} | L_{b81} | 708 | Lₐ₁₉ | L_{b81} | L_{b81} |
| 709 | Lₐ₂₀ | L_{b81} | L_{b81} | 710 | Lₐ₂₁ | L_{b81} | L_{b81} |
| 711 | Lₐ₃₁ | L_{b81} | L_{b81} | 712 | Lₐ₃₂ | L_{b81} | L_{b81} |
| 713 | Lₐ₃₃ | L_{b81} | L_{b81} | 714 | Lₐ₃₄ | L_{b81} | L_{b81} |
| 715 | Lₐ₃₅ | L_{b81} | L_{b81} | 716 | Lₐ₅₃ | L_{b81} | L_{b81} |
| 717 | Lₐ₅₇ | L_{b81} | L_{b81} | 718 | Lₐ₅₈ | L_{b81} | L_{b81} |
| 719 | Lₐ₆₁ | L_{b81} | L_{b81} | 720 | Lₐ₈₂ | L_{b81} | L_{b81} |
| 721 | Lₐ₈₃ | L_{b81} | L_{b81} | 722 | Lₐ₈₄ | L_{b81} | L_{b81} |
| 723 | Lₐ₈₇ | L_{b81} | L_{b81} | 724 | Lₐ₈₈ | L_{b81} | L_{b81} |
| 725 | Lₐ₉₀ | L_{b81} | L_{b81} | 726 | Lₐ₉₁ | L_{b81} | L_{b81} |
| 727 | Lₐ₉₉ | L_{b81} | L_{b81} | 728 | Lₐ₁₀₂ | L_{b81} | L_{b81} |
| 729 | Lₐ₁₀₈ | L_{b81} | L_{b81} | 730 | Lₐ₁₀₉ | L_{b81} | L_{b81} |
| 731 | Lₐ₁₁₀ | L_{b81} | L_{b81} | 732 | Lₐ₁₂₀ | L_{b81} | L_{b81} |
| 733 | Lₐ₁₂₁ | L_{b81} | L_{b81} | 734 | Lₐ₁₂₂ | L_{b81} | L_{b81} |
| 735 | Lₐ₁₂₃ | L_{b81} | L_{b81} | 736 | Lₐ₁₂₄ | L_{b81} | L_{b81} |
| 737 | Lₐ₁₄₂ | L_{b81} | L_{b81} | 738 | Lₐ₁₄₆ | L_{b81} | L_{b81} |
| 739 | Lₐ₁₅₀ | L_{b81} | L_{b81} | 740 | Lₐ₁₇₁ | L_{b81} | L_{b81} |
| 741 | Lₐ₁₇₂ | L_{b81} | L_{b81} | 742 | Lₐ₁₇₃ | L_{b81} | L_{b81} |
| 743 | Lₐ₁₇₆ | L_{b81} | L_{b81} | 744 | Lₐ₁₇₇ | L_{b81} | L_{b81} |
| 745 | Lₐ₁₇₉ | L_{b81} | L_{b81} | 746 | Lₐ₁₈₀ | L_{b81} | L_{b81} |
| 747 | Lₐ₂₆₈ | L_{b81} | L_{b81} | 748 | Lₐ₂₆₉ | L_{b81} | L_{b81} |
| 749 | Lₐ₂₇₃ | L_{b81} | L_{b81} | 750 | Lₐ₂₇₄ | L_{b81} | L_{b81} |
| 751 | Lₐ₃₆₃ | L_{b81} | L_{b81} | 752 | Lₐ₃₆₄ | L_{b81} | L_{b81} |
| 753 | Lₐ₃₆₇ | L_{b81} | L_{b81} | 754 | Lₐ₃₆₈ | L_{b81} | L_{b81} |
| 755 | Lₐ₃₇₂ | L_{b81} | L_{b81} | 756 | Lₐ₃₇₃ | L_{b81} | L_{b81} |
| 757 | Lₐ₃₇₄ | L_{b81} | L_{b81} | 758 | Lₐ₃₇₅ | L_{b81} | L_{b81} |
| 759 | Lₐ₃₉₂ | L_{b81} | L_{b81} | 760 | Lₐ₃₉₃ | L_{b81} | L_{b81} |
| 761 | Lₐ₅₈₁ | L_{b81} | L_{b81} | 762 | Lₐ₅₈₂ | L_{b81} | L_{b81} |
| 763 | Lₐ₅₉₀ | L_{b81} | L_{b81} | 764 | Lₐ₅₉₁ | L_{b81} | L_{b81} |
| 765 | Lₐ₆₁₀ | L_{b81} | L_{b81} | 766 | Lₐ₆₁₁ | L_{b81} | L_{b81} |
| 767 | Lₐ₆₁₂ | L_{b81} | L_{b81} | 768 | Lₐ₆₁₃ | L_{b81} | L_{b81} |
| 769 | Lₐ₆₁₆ | L_{b81} | L_{b81} | 770 | Lₐ₆₁₇ | L_{b81} | L_{b81} |
| 771 | Lₐ₆₁₈ | L_{b81} | L_{b81} | 772 | Lₐ₆₁₉ | L_{b81} | L_{b81} |
| 773 | Lₐ₆₂₂ | L_{b81} | L_{b81} | 774 | Lₐ₆₂₄ | L_{b81} | L_{b81} |
| 775 | Lₐ₆₂₅ | L_{b81} | L_{b81} | 776 | Lₐ₆₂₇ | L_{b81} | L_{b81} |
| 777 | Lₐ₆₂₈ | L_{b81} | L_{b81} | 778 | Lₐ₆₂₉ | L_{b81} | L_{b81} |
| 779 | Lₐ₆₃₀ | L_{b81} | L_{b81} | 780 | Lₐ₆₃₁ | L_{b81} | L_{b81} |
| 781 | Lₐ₆₃₂ | L_{b81} | L_{b81} | 782 | Lₐ₆₄₀ | L_{b81} | L_{b81} |
| 783 | Lₐ₆₄₁ | L_{b81} | L_{b81} | 784 | Lₐ₆₄₂ | L_{b81} | L_{b81} |
| 785 | Lₐ₆₄₃ | L_{b81} | L_{b81} | 786 | Lₐ₆₄₄ | L_{b81} | L_{b81} |
| 787 | Lₐ₆₄₅ | L_{b81} | L_{b81} | 788 | Lₐ₆₅₆ | L_{b81} | L_{b81} |
| 789 | Lₐ₆₆₂ | L_{b81} | L_{b81} | 790 | Lₐ₆₆₄ | L_{b81} | L_{b81} |
| 791 | Lₐ₆₆₅ | L_{b81} | L_{b81} | 792 | Lₐ₆₆₆ | L_{b81} | L_{b81} |
| 793 | Lₐ₆₆₇ | L_{b81} | L_{b81} | 794 | Lₐ₆₉₀ | L_{b81} | L_{b81} |
| 795 | Lₐ₆₉₁ | L_{b81} | L_{b81} | 796 | Lₐ₆₉₂ | L_{b81} | L_{b81} |
| 797 | Lₐ₆₉₃ | L_{b81} | L_{b81} | 798 | Lₐ₆₉₈ | L_{b81} | L_{b81} |
| 799 | Lₐ₆₉₉ | L_{b81} | L_{b81} | 800 | Lₐ₇₀₀ | L_{b81} | L_{b81} |
| 801 | Lₐ₇₀₁ | L_{b81} | L_{b81} | 802 | Lₐ₇₀₂ | L_{b81} | L_{b81} |
| 803 | Lₐ₇₀₃ | L_{b81} | L_{b81} | 804 | Lₐ₇₀₄ | L_{b81} | L_{b81} |
| 805 | Lₐ₇₀₈ | L_{b81} | L_{b81} | 806 | Lₐ₇₁₁ | L_{b81} | L_{b81} |
| 807 | Lₐ₇₁₇ | L_{b81} | L_{b81} | 808 | Lₐ₇₁₈ | L_{b81} | L_{b81} |
| 809 | Lₐ₇₁₉ | L_{b81} | L_{b81} | 810 | Lₐ₇₂₉ | L_{b81} | L_{b81} |
| 811 | Lₐ₇₃₀ | L_{b81} | L_{b81} | 812 | Lₐ₇₃₁ | L_{b81} | L_{b81} |
| 813 | Lₐ₇₃₂ | L_{b81} | L_{b81} | 814 | Lₐ₇₃₃ | L_{b81} | L_{b81} |
| 815 | Lₐ₇₈₈ | L_{b81} | L_{b81} | 816 | Lₐ₇₈₉ | L_{b81} | L_{b81} |
| 817 | Lₐ₇₉₂ | L_{b81} | L_{b81} | 818 | Lₐ₇₉₄ | L_{b81} | L_{b81} |
| 819 | Lₐ₈₇₇ | L_{b81} | L_{b81} | 820 | Lₐ₈₇₈ | L_{b81} | L_{b81} |
| 821 | Lₐ₈₇₉ | L_{b81} | L_{b81} | 822 | Lₐ₈₈₀ | L_{b81} | L_{b81} |
| 823 | Lₐ₈₈₅ | L_{b81} | L_{b81} | 824 | Lₐ₈₈₆ | L_{b81} | L_{b81} |
| 825 | Lₐ₈₉₉ | L_{b81} | L_{b81} | 826 | Lₐ₉₀₀ | L_{b81} | L_{b81} |
| 827 | Lₐ₉₁₅ | L_{b81} | L_{b81} | 828 | Lₐ₉₁₆ | L_{b81} | L_{b81} |
| 829 | Lₐ₉₂₀ | L_{b81} | L_{b81} | 830 | Lₐ₉₂₁ | L_{b81} | L_{b81} |
| 831 | Lₐ₉₂₂ | L_{b81} | L_{b81} | 832 | Lₐ₉₂₃ | L_{b81} | L_{b81} |
| 833 | Lₐ₉₂₆ | L_{b81} | L_{b81} | 834 | Lₐ₉₂₇ | L_{b81} | L_{b81} |
| 835 | Lₐ₉₂₈ | L_{b81} | L_{b81} | 836 | Lₐ₉₂₉ | L_{b81} | L_{b81} |
| 837 | Lₐ₉₃₂ | L_{b81} | L_{b81} | 838 | Lₐ₉₃₃ | L_{b81} | L_{b81} |
| 839 | Lₐ₁₀₂₀ | L_{b81} | L_{b81} | 840 | Lₐ₁₀₂₁ | L_{b81} | L_{b81} |
| 841 | Lₐ₁₀₂₂ | L_{b81} | L_{b81} | 842 | Lₐ₁₀₂₃ | L_{b81} | L_{b81} |
| 843 | Lₐ₁₀₂₅ | L_{b81} | L_{b81} | 844 | Lₐ₁₀₂₆ | L_{b81} | L_{b81} |
| 845 | Lₐ₁₀₂₈ | L_{b81} | L_{b81} | 846 | Lₐ₁₀₂₉ | L_{b81} | L_{b81} |
| 847 | Lₐ₁₀₃₀ | L_{b81} | L_{b81} | 848 | Lₐ₁₀₃₄ | L_{b81} | L_{b81} |
| 849 | Lₐ₁₀₃₈ | L_{b81} | L_{b81} | 850 | Lₐ₁₀₄₀ | L_{b81} | L_{b81} |
| 851 | Lₐ₁₀₄₆ | L_{b81} | L_{b81} | 852 | Lₐ₁₀₄₈ | L_{b81} | L_{b81} |
| 853 | Lₐ₁₀₅₅ | L_{b81} | L_{b81} | 854 | Lₐ₁₀₅₆ | L_{b81} | L_{b81} |
| 855 | Lₐ₁₃₃₃ | L_{b81} | L_{b81} | 856 | Lₐ₁₃₃₄ | L_{b81} | L_{b81} |
| 857 | Lₐ₁₃₄₀ | L_{b81} | L_{b81} | 858 | Lₐ₁₃₄₁ | L_{b81} | L_{b81} |
| 859 | Lₐ₁₃₇₁ | L_{b81} | L_{b81} | 860 | Lₐ₁₃₇₂ | L_{b81} | L_{b81} |
| 861 | Lₐ₁₃₇₃ | L_{b81} | L_{b81} | 862 | Lₐ₁₃₇₄ | L_{b81} | L_{b81} |
| 863 | Lₐ₁₄₂₃ | L_{b81} | L_{b81} | 864 | Lₐ₁₄₂₄ | L_{b81} | L_{b81} |
| 865 | Lₐ₁₄₂₆ | L_{b81} | L_{b81} | 866 | Lₐ₁₄₂₇ | L_{b81} | L_{b81} |
| 867 | Lₐ₁₄₃₂ | L_{b81} | L_{b81} | 868 | Lₐ₁₄₃₃ | L_{b81} | L_{b81} |
| 869 | Lₐ₁₄₃₅ | L_{b81} | L_{b81} | 870 | Lₐ₁₄₃₆ | L_{b81} | L_{b81} |
| 871 | Lₐ₁ | L_{b329} | L_{b329} | 872 | Lₐ₂ | L_{b329} | L_{b329} |
| 873 | Lₐ₃ | L_{b329} | L_{b329} | 874 | Lₐ₄ | L_{b329} | L_{b329} |
| 875 | Lₐ₅ | L_{b329} | L_{b329} | 876 | Lₐ₆ | L_{b329} | L_{b329} |
| 877 | Lₐ₇ | L_{b329} | L_{b329} | 878 | Lₐ₈ | L_{b329} | L_{b329} |
| 879 | Lₐ₉ | L_{b329} | L_{b329} | 880 | Lₐ₁₀ | L_{b329} | L_{b329} |
| 881 | Lₐ₁₃ | L_{b329} | L_{b329} | 882 | Lₐ₁₉ | L_{b329} | L_{b329} |
| 883 | Lₐ₂₀ | L_{b329} | L_{b329} | 884 | Lₐ₂₁ | L_{b329} | L_{b329} |
| 885 | Lₐ₃₁ | L_{b329} | L_{b329} | 886 | Lₐ₃₂ | L_{b329} | L_{b329} |
| 887 | Lₐ₃₃ | L_{b329} | L_{b329} | 888 | Lₐ₃₄ | L_{b329} | L_{b329} |
| 889 | Lₐ₃₅ | L_{b329} | L_{b329} | 890 | Lₐ₅₃ | L_{b329} | L_{b329} |
| 891 | Lₐ₅₇ | L_{b329} | L_{b329} | 892 | Lₐ₅₈ | L_{b329} | L_{b329} |
| 893 | Lₐ₆₁ | L_{b329} | L_{b329} | 894 | Lₐ₈₂ | L_{b329} | L_{b329} |
| 895 | Lₐ₈₃ | L_{b329} | L_{b329} | 896 | Lₐ₈₄ | L_{b329} | L_{b329} |
| 897 | Lₐ₈₇ | L_{b329} | L_{b329} | 898 | Lₐ₈₈ | L_{b329} | L_{b329} |
| 899 | Lₐ₉₀ | L_{b329} | L_{b329} | 900 | Lₐ₉₁ | L_{b329} | L_{b329} |
| 901 | Lₐ₉₉ | L_{b329} | L_{b329} | 902 | Lₐ₁₀₂ | L_{b329} | L_{b329} |
| 903 | Lₐ₁₀₈ | L_{b329} | L_{b329} | 904 | Lₐ₁₀₉ | L_{b329} | L_{b329} |
| 905 | Lₐ₁₁₀ | L_{b329} | L_{b329} | 906 | Lₐ₁₂₀ | L_{b329} | L_{b329} |
| 907 | Lₐ₁₂₁ | L_{b329} | L_{b329} | 908 | Lₐ₁₂₂ | L_{b329} | L_{b329} |
| 909 | Lₐ₁₂₃ | L_{b329} | L_{b329} | 910 | Lₐ₁₂₄ | L_{b329} | L_{b329} |
| 911 | Lₐ₁₄₂ | L_{b329} | L_{b329} | 912 | Lₐ₁₄₆ | L_{b329} | L_{b329} |
| 913 | Lₐ₁₅₀ | L_{b329} | L_{b329} | 914 | Lₐ₁₇₁ | L_{b329} | L_{b329} |
| 915 | Lₐ₁₇₂ | L_{b329} | L_{b329} | 916 | Lₐ₁₇₃ | L_{b329} | L_{b329} |
| 917 | Lₐ₁₇₆ | L_{b329} | L_{b329} | 918 | Lₐ₁₇₇ | L_{b329} | L_{b329} |
| 919 | Lₐ₁₇₉ | L_{b329} | L_{b329} | 920 | Lₐ₁₈₀ | L_{b329} | L_{b329} |
| 921 | Lₐ₂₆₈ | L_{b329} | L_{b329} | 922 | Lₐ₂₆₉ | L_{b329} | L_{b329} |
| 923 | Lₐ₂₇₃ | L_{b329} | L_{b329} | 924 | Lₐ₂₇₄ | L_{b329} | L_{b329} |
| 925 | Lₐ₃₆₃ | L_{b329} | L_{b329} | 926 | Lₐ₃₆₄ | L_{b329} | L_{b329} |
| 927 | Lₐ₃₆₇ | L_{b329} | L_{b329} | 928 | Lₐ₃₆₈ | L_{b329} | L_{b329} |
| 929 | Lₐ₃₇₂ | L_{b329} | L_{b329} | 930 | Lₐ₃₇₃ | L_{b329} | L_{b329} |
| 931 | Lₐ₃₇₄ | L_{b329} | L_{b329} | 932 | Lₐ₃₇₅ | L_{b329} | L_{b329} |
| 933 | Lₐ₃₉₂ | L_{b329} | L_{b329} | 934 | Lₐ₃₉₃ | L_{b329} | L_{b329} |
| 935 | Lₐ₅₈₁ | L_{b329} | L_{b329} | 936 | Lₐ₅₈₂ | L_{b329} | L_{b329} |
| 937 | Lₐ₅₉₀ | L_{b329} | L_{b329} | 938 | Lₐ₅₉₁ | L_{b329} | L_{b329} |
| 939 | Lₐ₆₁₀ | L_{b329} | L_{b329} | 940 | Lₐ₆₁₁ | L_{b329} | L_{b329} |
| 941 | Lₐ₆₁₂ | L_{b329} | L_{b329} | 942 | Lₐ₆₁₃ | L_{b329} | L_{b329} |
| 943 | Lₐ₆₁₆ | L_{b329} | L_{b329} | 944 | Lₐ₆₁₇ | L_{b329} | L_{b329} |
| 945 | Lₐ₆₁₈ | L_{b329} | L_{b329} | 946 | Lₐ₆₁₉ | L_{b329} | L_{b329} |
| 947 | Lₐ₆₂₂ | L_{b329} | L_{b329} | 948 | Lₐ₆₂₄ | L_{b329} | L_{b329} |
| 949 | Lₐ₆₂₅ | L_{b329} | L_{b329} | 950 | Lₐ₆₂₇ | L_{b329} | L_{b329} |
| 951 | Lₐ₆₂₈ | L_{b329} | L_{b329} | 952 | Lₐ₆₂₉ | L_{b329} | L_{b329} |
| 953 | Lₐ₆₃₀ | L_{b329} | L_{b329} | 954 | Lₐ₆₃₁ | L_{b329} | L_{b329} |
| 955 | Lₐ₆₃₂ | L_{b329} | L_{b329} | 956 | Lₐ₆₄₀ | L_{b329} | L_{b329} |
| 957 | Lₐ₆₄₁ | L_{b329} | L_{b329} | 958 | Lₐ₆₄₂ | L_{b329} | L_{b329} |
| 959 | Lₐ₆₄₃ | L_{b329} | L_{b329} | 960 | Lₐ₆₄₄ | L_{b329} | L_{b329} |
| 961 | Lₐ₆₄₅ | L_{b329} | L_{b329} | 962 | Lₐ₆₅₆ | L_{b329} | L_{b329} |
| 963 | Lₐ₆₆₂ | L_{b329} | L_{b329} | 964 | Lₐ₆₆₄ | L_{b329} | L_{b329} |
| 965 | Lₐ₆₆₅ | L_{b329} | L_{b329} | 966 | Lₐ₆₆₆ | L_{b329} | L_{b329} |
| 967 | Lₐ₆₆₇ | L_{b329} | L_{b329} | 968 | Lₐ₆₉₀ | L_{b329} | L_{b329} |
| 969 | Lₐ₆₉₁ | L_{b329} | L_{b329} | 970 | Lₐ₆₉₂ | L_{b329} | L_{b329} |
| 971 | Lₐ₆₉₃ | L_{b329} | L_{b329} | 972 | Lₐ₆₉₈ | L_{b329} | L_{b329} |
| 973 | Lₐ₆₉₉ | L_{b329} | L_{b329} | 974 | Lₐ₇₀₀ | L_{b329} | L_{b329} |
| 975 | Lₐ₇₀₁ | L_{b329} | L_{b329} | 976 | Lₐ₇₀₂ | L_{b329} | L_{b329} |
| 977 | Lₐ₇₀₃ | L_{b329} | L_{b329} | 978 | Lₐ₇₀₄ | L_{b329} | L_{b329} |
| 979 | Lₐ₇₀₈ | L_{b329} | L_{b329} | 980 | Lₐ₇₁₁ | L_{b329} | L_{b329} |
| 981 | Lₐ₇₁₇ | L_{b329} | L_{b329} | 982 | Lₐ₇₁₈ | L_{b329} | L_{b329} |
| 983 | Lₐ₇₁₉ | L_{b329} | L_{b329} | 984 | Lₐ₇₂₉ | L_{b329} | L_{b329} |
| 985 | Lₐ₇₃₀ | L_{b329} | L_{b329} | 986 | Lₐ₇₃₁ | L_{b329} | L_{b329} |
| 987 | Lₐ₇₃₂ | L_{b329} | L_{b329} | 988 | Lₐ₇₃₃ | L_{b329} | L_{b329} |
| 989 | Lₐ₇₈₈ | L_{b329} | L_{b329} | 990 | Lₐ₇₈₉ | L_{b329} | L_{b329} |
| 991 | Lₐ₇₉₂ | L_{b329} | L_{b329} | 992 | Lₐ₇₉₄ | L_{b329} | L_{b329} |
| 993 | Lₐ₈₇₇ | L_{b329} | L_{b329} | 994 | Lₐ₈₇₈ | L_{b329} | L_{b329} |
| 995 | Lₐ₈₇₉ | L_{b329} | L_{b329} | 996 | Lₐ₈₈₀ | L_{b329} | L_{b329} |
| 997 | Lₐ₈₈₅ | L_{b329} | L_{b329} | 998 | Lₐ₈₈₆ | L_{b329} | L_{b329} |
| 999 | Lₐ₈₉₉ | L_{b329} | L_{b329} | 1000 | Lₐ₉₀₀ | L_{b329} | L_{b329} |
| 1001 | Lₐ₉₁₅ | L_{b329} | L_{b329} | 1002 | Lₐ₉₁₆ | L_{b329} | L_{b329} |
| 1003 | Lₐ₉₂₀ | L_{b329} | L_{b329} | 1004 | Lₐ₉₂₁ | L_{b329} | L_{b329} |
| 1005 | Lₐ₉₂₂ | L_{b329} | L_{b329} | 1006 | Lₐ₉₂₃ | L_{b329} | L_{b329} |
| 1007 | Lₐ₉₂₆ | L_{b329} | L_{b329} | 1008 | Lₐ₉₂₇ | L_{b329} | L_{b329} |
| 1009 | Lₐ₉₂₈ | L_{b329} | L_{b329} | 1010 | Lₐ₉₂₉ | L_{b329} | L_{b329} |
| 1011 | Lₐ₉₃₂ | L_{b329} | L_{b329} | 1012 | Lₐ₉₃₃ | L_{b329} | L_{b329} |
| 1013 | Lₐ₁₀₂₀ | L_{b329} | L_{b329} | 1014 | Lₐ₁₀₂₁ | L_{b329} | L_{b329} |
| 1015 | Lₐ₁₀₂₂ | L_{b329} | L_{b329} | 1016 | Lₐ₁₀₂₃ | L_{b329} | L_{b329} |
| 1017 | Lₐ₁₀₂₅ | L_{b329} | L_{b329} | 1018 | Lₐ₁₀₂₆ | L_{b329} | L_{b329} |
| 1019 | Lₐ₁₀₂₈ | L_{b329} | L_{b329} | 1020 | Lₐ₁₀₂₉ | L_{b329} | L_{b329} |
| 1021 | Lₐ₁₀₃₀ | L_{b329} | L_{b329} | 1022 | Lₐ₁₀₃₄ | L_{b329} | L_{b329} |
| 1023 | Lₐ₁₀₃₈ | L_{b329} | L_{b329} | 1024 | Lₐ₁₀₄₀ | L_{b329} | L_{b329} |
| 1025 | Lₐ₁₀₄₆ | L_{b329} | L_{b329} | 1026 | Lₐ₁₀₄₈ | L_{b329} | L_{b329} |
| 1027 | Lₐ₁₀₅₅ | L_{b329} | L_{b329} | 1028 | Lₐ₁₀₅₆ | L_{b329} | L_{b329} |
| 1029 | Lₐ₁₃₃₃ | L_{b329} | L_{b329} | 1030 | Lₐ₁₃₃₄ | L_{b329} | L_{b329} |
| 1031 | Lₐ₁₃₄₀ | L_{b329} | L_{b329} | 1032 | Lₐ₁₃₄₁ | L_{b329} | L_{b329} |
| 1033 | Lₐ₁₃₇₁ | L_{b329} | L_{b329} | 1034 | Lₐ₁₃₇₂ | L_{b329} | L_{b329} |
| 1035 | Lₐ₁₃₇₃ | L_{b329} | L_{b329} | 1036 | Lₐ₁₃₇₄ | L_{b329} | L_{b329} |
| 1037 | Lₐ₁₄₂₃ | L_{b329} | L_{b329} | 1038 | Lₐ₁₄₂₄ | L_{b329} | L_{b329} |
| 1039 | Lₐ₁₄₂₆ | L_{b329} | L_{b329} | 1040 | Lₐ₁₄₂₇ | L_{b329} | L_{b329} |
| 1041 | Lₐ₁₄₃₂ | L_{b329} | L_{b329} | 1042 | Lₐ₁₄₃₃ | L_{b329} | L_{b329} |
| 1043 | Lₐ₁₄₃₅ | L_{b329} | L_{b329} | 1044 | Lₐ₁₄₃₆ | L_{b329} | L_{b329} |
| 1045 | Lₐ₁ | L_{b333} | L_{b333} | 1046 | Lₐ₂ | L_{b333} | L_{b333} |
| 1047 | Lₐ₃ | L_{b333} | L_{b333} | 1048 | Lₐ₄ | L_{b333} | L_{b333} |
| 1049 | Lₐ₅ | L_{b333} | L_{b333} | 1050 | Lₐ₆ | L_{b333} | L_{b333} |
| 1051 | Lₐ₇ | L_{b333} | L_{b333} | 1052 | Lₐ₈ | L_{b333} | L_{b333} |
| 1053 | Lₐ₉ | L_{b333} | L_{b333} | 1054 | Lₐ₁₀ | L_{b333} | L_{b333} |
| 1055 | Lₐ₁₃ | L_{b333} | L_{b333} | 1056 | Lₐ₁₉ | L_{b333} | L_{b333} |
| 1057 | Lₐ₂₀ | L_{b333} | L_{b333} | 1058 | Lₐ₂₁ | L_{b333} | L_{b333} |
| 1059 | Lₐ₃₁ | L_{b333} | L_{b333} | 1060 | Lₐ₃₂ | L_{b333} | L_{b333} |
| 1061 | Lₐ₃₃ | L_{b333} | L_{b333} | 1062 | Lₐ₃₄ | L_{b333} | L_{b333} |
| 1063 | Lₐ₃₅ | L_{b333} | L_{b333} | 1064 | Lₐ₅₃ | L_{b333} | L_{b333} |
| 1065 | Lₐ₅₇ | L_{b333} | L_{b333} | 1066 | Lₐ₅₈ | L_{b333} | L_{b333} |
| 1067 | Lₐ₆₁ | L_{b333} | L_{b333} | 1068 | Lₐ₈₂ | L_{b333} | L_{b333} |
| 1069 | Lₐ₈₃ | L_{b333} | L_{b333} | 1070 | Lₐ₈₄ | L_{b333} | L_{b333} |
| 1071 | Lₐ₈₇ | L_{b333} | L_{b333} | 1072 | Lₐ₈₈ | L_{b333} | L_{b333} |
| 1073 | Lₐ₉₀ | L_{b333} | L_{b333} | 1074 | Lₐ₉₁ | L_{b333} | L_{b333} |
| 1075 | Lₐ₉₉ | L_{b333} | L_{b333} | 1076 | Lₐ₁₀₂ | L_{b333} | L_{b333} |
| 1077 | Lₐ₁₀₈ | L_{b333} | L_{b333} | 1078 | Lₐ₁₀₉ | L_{b333} | L_{b333} |
| 1079 | Lₐ₁₁₀ | L_{b333} | L_{b333} | 1080 | Lₐ₁₂₀ | L_{b333} | L_{b333} |
| 1081 | Lₐ₁₂₁ | L_{b333} | L_{b333} | 1082 | Lₐ₁₂₂ | L_{b333} | L_{b333} |
| 1083 | Lₐ₁₂₃ | L_{b333} | L_{b333} | 1084 | Lₐ₁₂₄ | L_{b333} | L_{b333} |
| 1085 | Lₐ₁₄₂ | L_{b333} | L_{b333} | 1086 | Lₐ₁₄₆ | L_{b333} | L_{b333} |
| 1087 | Lₐ₁₅₀ | L_{b333} | L_{b333} | 1088 | Lₐ₁₇₁ | L_{b333} | L_{b333} |
| 1089 | Lₐ₁₇₂ | L_{b333} | L_{b333} | 1090 | Lₐ₁₇₃ | L_{b333} | L_{b333} |
| 1091 | Lₐ₁₇₆ | L_{b333} | L_{b333} | 1092 | Lₐ₁₇₇ | L_{b333} | L_{b333} |
| 1093 | Lₐ₁₇₉ | L_{b333} | L_{b333} | 1094 | Lₐ₁₈₀ | L_{b333} | L_{b333} |
| 1095 | Lₐ₂₆₈ | L_{b333} | L_{b333} | 1096 | Lₐ₂₆₉ | L_{b333} | L_{b333} |
| 1097 | Lₐ₂₇₃ | L_{b333} | L_{b333} | 1098 | Lₐ₂₇₄ | L_{b333} | L_{b333} |
| 1099 | Lₐ₃₆₃ | L_{b333} | L_{b333} | 1100 | Lₐ₃₆₄ | L_{b333} | L_{b333} |
| 1101 | Lₐ₃₆₇ | L_{b333} | L_{b333} | 1102 | Lₐ₃₆₈ | L_{b333} | L_{b333} |
| 1103 | Lₐ₃₇₂ | L_{b333} | L_{b333} | 1104 | Lₐ₃₇₃ | L_{b333} | L_{b333} |
| 1105 | Lₐ₃₇₄ | L_{b333} | L_{b333} | 1106 | Lₐ₃₇₅ | L_{b333} | L_{b333} |
| 1107 | Lₐ₃₉₂ | L_{b333} | L_{b333} | 1108 | Lₐ₃₉₃ | L_{b333} | L_{b333} |
| 1109 | Lₐ₅₈₁ | L_{b333} | L_{b333} | 1110 | Lₐ₅₈₂ | L_{b333} | L_{b333} |
| 1111 | Lₐ₅₉₀ | L_{b333} | L_{b333} | 1112 | Lₐ₅₉₁ | L_{b333} | L_{b333} |
| 1113 | Lₐ₆₁₀ | L_{b333} | L_{b333} | 1114 | Lₐ₆₁₁ | L_{b333} | L_{b333} |
| 1115 | Lₐ₆₁₂ | L_{b333} | L_{b333} | 1116 | Lₐ₆₁₃ | L_{b333} | L_{b333} |
| 1117 | Lₐ₆₁₆ | L_{b333} | L_{b333} | 1118 | Lₐ₆₁₇ | L_{b333} | L_{b333} |
| 1119 | Lₐ₆₁₈ | L_{b333} | L_{b333} | 1120 | Lₐ₆₁₉ | L_{b333} | L_{b333} |
| 1121 | Lₐ₆₂₂ | L_{b333} | L_{b333} | 1122 | Lₐ₆₂₄ | L_{b333} | L_{b333} |
| 1123 | Lₐ₆₂₅ | L_{b333} | L_{b333} | 1124 | Lₐ₆₂₇ | L_{b333} | L_{b333} |
| 1125 | Lₐ₆₂₈ | L_{b333} | L_{b333} | 1126 | Lₐ₆₂₉ | L_{b333} | L_{b333} |
| 1127 | Lₐ₆₃₀ | L_{b333} | L_{b333} | 1128 | Lₐ₆₃₁ | L_{b333} | L_{b333} |
| 1129 | Lₐ₆₃₂ | L_{b333} | L_{b333} | 1130 | Lₐ₆₄₀ | L_{b333} | L_{b333} |
| 1131 | Lₐ₆₄₁ | L_{b333} | L_{b333} | 1132 | Lₐ₆₄₂ | L_{b333} | L_{b333} |
| 1133 | Lₐ₆₄₃ | L_{b333} | L_{b333} | 1134 | Lₐ₆₄₄ | L_{b333} | L_{b333} |
| 1135 | Lₐ₆₄₅ | L_{b333} | L_{b333} | 1136 | Lₐ₆₅₆ | L_{b333} | L_{b333} |
| 1137 | Lₐ₆₆₂ | L_{b333} | L_{b333} | 1138 | Lₐ₆₆₄ | L_{b333} | L_{b333} |
| 1139 | Lₐ₆₆₅ | L_{b333} | L_{b333} | 1140 | Lₐ₆₆₆ | L_{b333} | L_{b333} |
| 1141 | Lₐ₆₆₇ | L_{b333} | L_{b333} | 1142 | Lₐ₆₉₀ | L_{b333} | L_{b333} |
| 1143 | Lₐ₆₉₁ | L_{b333} | L_{b333} | 1144 | Lₐ₆₉₂ | L_{b333} | L_{b333} |
| 1145 | Lₐ₆₉₃ | L_{b333} | L_{b333} | 1146 | Lₐ₆₉₈ | L_{b333} | L_{b333} |
| 1147 | Lₐ₆₉₉ | L_{b333} | L_{b333} | 1148 | Lₐ₇₀₀ | L_{b333} | L_{b333} |
| 1149 | Lₐ₇₀₁ | L_{b333} | L_{b333} | 1150 | Lₐ₇₀₂ | L_{b333} | L_{b333} |
| 1151 | Lₐ₇₀₃ | L_{b333} | L_{b333} | 1152 | Lₐ₇₀₄ | L_{b333} | L_{b333} |
| 1153 | Lₐ₇₀₈ | L_{b333} | L_{b333} | 1154 | Lₐ₇₁₁ | L_{b333} | L_{b333} |
| 1155 | Lₐ₇₁₇ | L_{b333} | L_{b333} | 1156 | Lₐ₇₁₈ | L_{b333} | L_{b333} |
| 1157 | Lₐ₇₁₉ | L_{b333} | L_{b333} | 1158 | Lₐ₇₂₉ | L_{b333} | L_{b333} |
| 1159 | Lₐ₇₃₀ | L_{b333} | L_{b333} | 1160 | Lₐ₇₃₁ | L_{b333} | L_{b333} |
| 1161 | Lₐ₇₃₂ | L_{b333} | L_{b333} | 1162 | Lₐ₇₃₃ | L_{b333} | L_{b333} |
| 1163 | Lₐ₇₈₈ | L_{b333} | L_{b333} | 1164 | Lₐ₇₈₉ | L_{b333} | L_{b333} |
| 1165 | Lₐ₇₉₂ | L_{b333} | L_{b333} | 1166 | Lₐ₇₉₄ | L_{b333} | L_{b333} |
| 1167 | Lₐ₈₇₇ | L_{b333} | L_{b333} | 1168 | Lₐ₈₇₈ | L_{b333} | L_{b333} |
| 1169 | Lₐ₈₇₉ | L_{b333} | L_{b333} | 1170 | Lₐ₈₈₀ | L_{b333} | L_{b333} |
| 1171 | Lₐ₈₈₅ | L_{b333} | L_{b333} | 1172 | Lₐ₈₈₆ | L_{b333} | L_{b333} |
| 1173 | Lₐ₈₉₉ | L_{b333} | L_{b333} | 1174 | Lₐ₉₀₀ | L_{b333} | L_{b333} |
| 1175 | Lₐ₉₁₅ | L_{b333} | L_{b333} | 1176 | Lₐ₉₁₆ | L_{b333} | L_{b333} |
| 1177 | Lₐ₉₂₀ | L_{b333} | L_{b333} | 1178 | Lₐ₉₂₁ | L_{b333} | L_{b333} |
| 1179 | Lₐ₉₂₂ | L_{b333} | L_{b333} | 1180 | Lₐ₉₂₃ | L_{b333} | L_{b333} |
| 1181 | Lₐ₉₂₆ | L_{b333} | L_{b333} | 1182 | Lₐ₉₂₇ | L_{b333} | L_{b333} |
| 1183 | Lₐ₉₂₈ | L_{b333} | L_{b333} | 1184 | Lₐ₉₂₉ | L_{b333} | L_{b333} |
| 1185 | Lₐ₉₃₂ | L_{b333} | L_{b333} | 1186 | Lₐ₉₃₃ | L_{b333} | L_{b333} |
| 1187 | Lₐ₁₀₂₀ | L_{b333} | L_{b333} | 1188 | Lₐ₁₀₂₁ | L_{b333} | L_{b333} |
| 1189 | Lₐ₁₀₂₂ | L_{b333} | L_{b333} | 1190 | Lₐ₁₀₂₃ | L_{b333} | L_{b333} |
| 1191 | Lₐ₁₀₂₅ | L_{b333} | L_{b333} | 1192 | Lₐ₁₀₂₆ | L_{b333} | L_{b333} |
| 1193 | Lₐ₁₀₂₈ | L_{b333} | L_{b333} | 1194 | Lₐ₁₀₂₉ | L_{b333} | L_{b333} |
| 1195 | Lₐ₁₀₃₀ | L_{b333} | L_{b333} | 1196 | Lₐ₁₀₃₄ | L_{b333} | L_{b333} |
| 1197 | Lₐ₁₀₃₈ | L_{b333} | L_{b333} | 1198 | Lₐ₁₀₄₀ | L_{b333} | L_{b333} |
| 1199 | Lₐ₁₀₄₆ | L_{b333} | L_{b333} | 1200 | Lₐ₁₀₄₈ | L_{b333} | L_{b333} |
| 1201 | Lₐ₁₀₅₅ | L_{b333} | L_{b333} | 1202 | Lₐ₁₀₅₆ | L_{b333} | L_{b333} |
| 1203 | Lₐ₁₃₃₃ | L_{b333} | L_{b333} | 1204 | Lₐ₁₃₃₄ | L_{b333} | L_{b333} |
| 1205 | Lₐ₁₃₄₀ | L_{b333} | L_{b333} | 1206 | Lₐ₁₃₄₁ | L_{b333} | L_{b333} |
| 1207 | Lₐ₁₃₇₁ | L_{b333} | L_{b333} | 1208 | Lₐ₁₃₇₂ | L_{b333} | L_{b333} |
| 1209 | Lₐ₁₃₇₃ | L_{b333} | L_{b333} | 1210 | Lₐ₁₃₇₄ | L_{b333} | L_{b333} |
| 1211 | Lₐ₁₄₂₃ | L_{b333} | L_{b333} | 1212 | Lₐ₁₄₂₄ | L_{b333} | L_{b333} |
| 1213 | Lₐ₁₄₂₆ | L_{b333} | L_{b333} | 1214 | Lₐ₁₄₂₇ | L_{b333} | L_{b333} |
| 1215 | Lₐ₁₄₃₂ | L_{b333} | L_{b333} | 1216 | Lₐ₁₄₃₃ | L_{b333} | L_{b333} |
| 1217 | Lₐ₁₄₃₅ | L_{b333} | L_{b333} | 1218 | Lₐ₁₄₃₆ | L_{b333} | L_{b333} |
| 1219 | Lₐ₁ | L_{b12} | L_{b12} | 1220 | Lₐ₂ | L_{b12} | L_{b12} |
| 1221 | Lₐ₆₁₀ | L_{b12} | L_{b12} | 1222 | Lₐ₆₁₁ | L_{b12} | L_{b12} |
| 1223 | Lₐ₆₉₉ | L_{b12} | L_{b12} | 1224 | Lₐ₇₀₀ | L_{b12} | L_{b12} |
| 1225 | Lₐ₁₀₂₀ | L_{b12} | L_{b12} | 1226 | Lₐ₁₀₂₁ | L_{b12} | L_{b12} |
| 1227 | Lₐ₁₄₄₁ | L_{b12} | L_{b12} | 1228 | Lₐ₁₄₈₅ | L_{b12} | L_{b12} |
| 1229 | Lₐ₁₅₁₅ | L_{b12} | L_{b12} | 1230 | Lₐ₁₅₅₉ | L_{b12} | L_{b12} |
| 1231 | Lₐ₁₅₈₉ | L_{b12} | L_{b12} | 1232 | Lₐ₁₆₃₃ | L_{b12} | L_{b12} |
| 1233 | Lₐ₁₆₆₃ | L_{b12} | L_{b12} | 1234 | Lₐ₁₇₀₇ | L_{b12} | L_{b12} |
| 1235 | Lₐ₁₇₃₇ | L_{b12} | L_{b12} | 1236 | Lₐ₁₇₆₁ | L_{b12} | L_{b12} |
| 1237 | Lₐ₁₇₈₅ | L_{b12} | L_{b12} | 1238 | Lₐ₁₈₀₁ | L_{b12} | L_{b12} |
| 1239 | Lₐ₁ | L_{b21} | L_{b21} | 1240 | Lₐ₂ | L_{b21} | L_{b21} |
| 1241 | Lₐ₆₁₀ | L_{b21} | L_{b21} | 1242 | Lₐ₆₁₁ | L_{b21} | L_{b21} |
| 1243 | Lₐ₆₉₉ | L_{b21} | L_{b21} | 1244 | Lₐ₇₀₀ | L_{b21} | L_{b21} |
| 1245 | Lₐ₁₀₂₀ | L_{b21} | L_{b21} | 1246 | Lₐ₁₀₂₁ | L_{b21} | L_{b21} |
| 1247 | Lₐ₁₄₄₁ | L_{b21} | L_{b21} | 1248 | Lₐ₁₄₈₅ | L_{b21} | L_{b21} |
| 1249 | Lₐ₁₅₁₅ | L_{b21} | L_{b21} | 1250 | Lₐ₁₅₅₉ | L_{b21} | L_{b21} |
| 1251 | Lₐ₁₅₈₉ | L_{b21} | L_{b21} | 1252 | Lₐ₁₆₃₃ | L_{b21} | L_{b21} |
| 1253 | Lₐ₁₆₆₃ | L_{b21} | L_{b21} | 1254 | Lₐ₁₇₀₇ | L_{b21} | L_{b21} |
| 1255 | Lₐ₁₇₃₇ | L_{b21} | L_{b21} | 1256 | Lₐ₁₇₆₁ | L_{b21} | L_{b21} |
| 1257 | Lₐ₁₇₈₅ | L_{b21} | L_{b21} | 1258 | Lₐ₁₈₀₁ | L_{b21} | L_{b21} |
| 1259 | Lₐ₁ | L_{b35} | L_{b35} | 1260 | Lₐ₂ | L_{b35} | L_{b35} |
| 1261 | Lₐ₆₁₀ | L_{b35} | L_{b35} | 1262 | Lₐ₆₁₁ | L_{b35} | L_{b35} |
| 1263 | Lₐ₆₉₉ | L_{b35} | L_{b35} | 1264 | Lₐ₇₀₀ | L_{b35} | L_{b35} |
| 1265 | Lₐ₁₀₂₀ | L_{b35} | L_{b35} | 1266 | Lₐ₁₀₂₁ | L_{b35} | L_{b35} |
| 1267 | Lₐ₁₄₄₁ | L_{b35} | L_{b35} | 1268 | Lₐ₁₄₈₅ | L_{b35} | L_{b35} |
| 1269 | Lₐ₁₅₁₅ | L_{b35} | L_{b35} | 1270 | Lₐ₁₅₅₉ | L_{b35} | L_{b35} |
| 1271 | Lₐ₁₅₈₉ | L_{b35} | L_{b35} | 1272 | Lₐ₁₆₃₃ | L_{b35} | L_{b35} |
| 1273 | Lₐ₁₆₆₃ | L_{b35} | L_{b35} | 1274 | Lₐ₁₇₀₇ | L_{b35} | L_{b35} |
| 1275 | Lₐ₁₇₃₇ | L_{b35} | L_{b35} | 1276 | Lₐ₁₇₆₁ | L_{b35} | L_{b35} |
| 1277 | Lₐ₁₇₈₅ | L_{b35} | L_{b35} | 1278 | Lₐ₁₈₀₁ | L_{b35} | L_{b35} |
| 1279 | Lₐ₁ | L_{b73} | L_{b73} | 1280 | Lₐ₂ | L_{b73} | L_{b73} |
| 1281 | Lₐ₆₁₀ | L_{b73} | L_{b73} | 1282 | Lₐ₆₁₁ | L_{b73} | L_{b73} |
| 1283 | Lₐ₆₉₉ | L_{b73} | L_{b73} | 1284 | Lₐ₇₀₀ | L_{b73} | L_{b73} |
| 1285 | Lₐ₁₀₂₀ | L_{b73} | L_{b73} | 1286 | Lₐ₁₀₂₁ | L_{b73} | L_{b73} |
| 1287 | Lₐ₁₄₄₁ | L_{b73} | L_{b73} | 1288 | Lₐ₁₄₈₅ | L_{b73} | L_{b73} |
| 1289 | Lₐ₁₅₁₅ | L_{b73} | L_{b73} | 1290 | Lₐ₁₅₅₉ | L_{b73} | L_{b73} |
| 1291 | Lₐ₁₅₈₉ | L_{b73} | L_{b73} | 1292 | Lₐ₁₆₃₃ | L_{b73} | L_{b73} |
| 1293 | Lₐ₁₆₆₃ | L_{b73} | L_{b73} | 1294 | Lₐ₁₇₀₇ | L_{b73} | L_{b73} |
| 1295 | Lₐ₁₇₃₇ | L_{b73} | L_{b73} | 1296 | Lₐ₁₇₆₁ | L_{b73} | L_{b73} |
| 1297 | Lₐ₁₇₈₅ | L_{b73} | L_{b73} | 1298 | Lₐ₁₈₀₁ | L_{b73} | L_{b73} |
| 1299 | Lₐ₁ | L_{b164} | L_{b164} | 1300 | Lₐ₂ | L_{b164} | L_{b164} |
| 1301 | Lₐ₆₁₀ | L_{b164} | L_{b164} | 1302 | Lₐ₆₁₁ | L_{b164} | L_{b164} |
| 1303 | Lₐ₆₉₉ | L_{b164} | L_{b164} | 1304 | Lₐ₇₀₀ | L_{b164} | L_{b164} |
| 1305 | Lₐ₁₀₂₀ | L_{b164} | L_{b164} | 1306 | Lₐ₁₀₂₁ | L_{b164} | L_{b164} |
| 1307 | Lₐ₁₄₄₁ | L_{b164} | L_{b164} | 1308 | Lₐ₁₄₈₅ | L_{b164} | L_{b164} |
| 1309 | Lₐ₁₅₁₅ | L_{b164} | L_{b164} | 1310 | Lₐ₁₅₅₉ | L_{b164} | L_{b164} |
| 1311 | Lₐ₁₅₈₉ | L_{b164} | L_{b164} | 1312 | Lₐ₁₆₃₃ | L_{b164} | L_{b164} |
| 1313 | Lₐ₁₆₆₃ | L_{b164} | L_{b164} | 1314 | Lₐ₁₇₀₇ | L_{b164} | L_{b164} |
| 1315 | Lₐ₁₇₃₇ | L_{b164} | L_{b164} | 1316 | Lₐ₁₇₆₁ | L_{b164} | L_{b164} |
| 1317 | Lₐ₁₇₈₅ | L_{b164} | L_{b164} | 1318 | Lₐ₁₈₀₁ | L_{b164} | L_{b164} |
| 1319 | Lₐ₁ | L_{b308} | L_{b308} | 1320 | Lₐ₂ | L_{b308} | L_{b308} |
| 1321 | Lₐ₆₁₀ | L_{b308} | L_{b308} | 1322 | Lₐ₆₁₁ | L_{b308} | L_{b308} |
| 1323 | Lₐ₆₉₉ | L_{b308} | L_{b308} | 1324 | Lₐ₇₀₀ | L_{b308} | L_{b308} |
| 1325 | Lₐ₁₀₂₀ | L_{b308} | L_{b308} | 1326 | Lₐ₁₀₂₁ | L_{b308} | L_{b308} |
| 1327 | Lₐ₁₄₄₁ | L_{b308} | L_{b308} | 1328 | Lₐ₁₄₈₅ | L_{b308} | L_{b308} |
| 1329 | Lₐ₁₅₁₅ | L_{b308} | L_{b308} | 1330 | Lₐ₁₅₅₉ | L_{b308} | L_{b308} |
| 1331 | Lₐ₁₅₈₉ | L_{b308} | L_{b308} | 1332 | Lₐ₁₆₃₃ | L_{b308} | L_{b308} |
| 1333 | Lₐ₁₆₆₃ | L_{b308} | L_{b308} | 1334 | Lₐ₁₇₀₇ | L_{b308} | L_{b308} |
| 1335 | Lₐ₁₇₃₇ | L_{b308} | L_{b308} | 1336 | Lₐ₁₇₆₁ | L_{b308} | L_{b308} |
| 1337 | Lₐ₁₇₈₅ | L_{b164} | L_{b164} | 1338 | Lₐ₁₈₀₁ | L_{b308} | L_{b308} |
| 1339 | Lₐ₁ | L_{b316} | L_{b316} | 1340 | Lₐ₂ | L_{b308} | L_{b308} |
| 1341 | Lₐ₆₁₀ | L_{b316} | L_{b316} | 1342 | Lₐ₆₁₁ | L_{b316} | L_{b316} |
| 1343 | Lₐ₆₉₉ | L_{b316} | L_{b316} | 1344 | Lₐ₇₀₀ | L_{b316} | L_{b316} |
| 1345 | Lₐ₁₀₂₀ | L_{b316} | L_{b316} | 1346 | Lₐ₁₀₂₁ | L_{b316} | L_{b316} |
| 1347 | Lₐ₁₄₄₁ | L_{b316} | L_{b316} | 1348 | Lₐ₁₄₈₅ | L_{b316} | L_{b316} |
| 1349 | Lₐ₁₅₁₅ | L_{b316} | L_{b316} | 1350 | Lₐ₁₅₅₉ | L_{b316} | L_{b316} |
| 1351 | Lₐ₁₅₈₉ | L_{b316} | L_{b316} | 1352 | Lₐ₁₆₃₃ | L_{b316} | L_{b316} |
| 1353 | Lₐ₁₆₆₃ | L_{b316} | L_{b316} | 1354 | Lₐ₁₇₀₇ | L_{b316} | L_{b316} |
| 1355 | Lₐ₁₇₃₇ | L_{b316} | L_{b316} | 1356 | Lₐ₁₇₆₁ | L_{b316} | L_{b316} |
| 1357 | Lₐ₁₇₈₅ | L_{b316} | L_{b316} | 1358 | Lₐ₁₈₀₁ | L_{b316} | L_{b316} |
| 1359 | Lₐ₁ | L_{b316} | L_{b316} | 1360 | Lₐ₆₁₀ | L_{b81} | L_{b329} |
| 1361 | Lₐ₆₄₃ | L_{b81} | L_{b329} | 1362 | Lₐ₆₉₉ | L_{b81} | L_{b329} |
| 1363 | Lₐ₁₀₂₀ | L_{b81} | L_{b329} | 1364 | Lₐ₁₄₃₂ | L_{b81} | L_{b329} |
wherein Metal Complex 1365 to Metal Complex 1382 each have a structure of Ir(Lₐ)₂L_{b}, wherein the two Lₐ are the same or different, and the two Lₐ and L_{b} respectively correspond to the structures listed in the following table:
| **Metal Complex** | **Lₐ** | **Lₐ** | **L_{b}** | **Metal Complex** | **Lₐ** | **Lₐ** | **L_{b}** |
|---|---|---|---|---|---|---|---|
| 1365 | Lₐ₁ | Lₐ₁ | L_{b81} | 1366 | Lₐ₁ | Lₐ₁ | L_{b329} |
| 1367 | Lₐ₆₁₀ | Lₐ₆₁₀ | L_{b81} | 1368 | Lₐ₆₁₀ | Lₐ₆₁₀ | L_{b329} |
| 1369 | Lₐ₆₄₃ | Lₐ₆₄₃ | L_{b81} | 1370 | Lₐ₆₄₃ | Lₐ₆₄₃ | L_{b329} |
| 1371 | Lₐ₆₉₉ | Lₐ₆₉₉ | L_{b81} | 1372 | Lₐ₆₉₉ | Lₐ₆₉₉ | L_{b329} |
| 1373 | Lₐ₁₀₂₀ | Lₐ₁₀₂₀ | L_{b81} | 1374 | Lₐ₁₀₂₀ | Lₐ₁₀₂₀ | L_{b329} |
| 1375 | Lₐ₁₄₃₂ | Lₐ₁₄₃₂ | L_{b81} | 1376 | Lₐ₁₄₃₂ | Lₐ₁₄₃₂ | L_{b329} |
| 1377 | Lₐ₁ | Lₐ₆₁₀ | L_{b81} | 1378 | Lₐ₆₁₀ | Lₐ₆₄₃ | L_{b81} |
| 1379 | Lₐ₆₁₀ | Lₐ₆₉₉ | L_{b81} | 1380 | Lₐ₆₁₀ | Lₐ₁₄₃₂ | L_{b81} |
| 1381 | Lₐ₆₄₃ | Lₐ₆₉₉ | L_{b329} | 1382 | Lₐ₆₄₃ | Lₐ₁₄₃₂ | L_{b329} |
wherein Metal Complex 1383 to Metal Complex 1562 each have a structure of Ir(Lₐ)₂L_{c}, wherein the two Lₐ are the same or different, and the two Lₐ and L_{c} respectively correspond to the structures listed in the following table:
| **Metal Complex** | **Lₐ** | **Lₐ** | **L_{c}** | **Metal Complex** | **Lₐ** | **Lₐ** | **L_{c}** |
|---|---|---|---|---|---|---|---|
| 1383 | Lₐ₁ | Lₐ₁ | L_{c31} | 1384 | Lₐ₂ | Lₐ₂ | L_{c31} |
| 1385 | Lₐ₃ | Lₐ₃ | L_{c31} | 1386 | Lₐ₄ | Lₐ₄ | L_{c31} |
| 1387 | Lₐ₅ | Lₐ₅ | L_{c31} | 1388 | Lₐ₆ | Lₐ₆ | L_{c31} |
| 1389 | Lₐ₇ | Lₐ₇ | L_{c31} | 1390 | Lₐ₈ | Lₐ₈ | L_{c31} |
| 1391 | Lₐ₉ | Lₐ₉ | L_{c31} | 1392 | Lₐ₁₀ | Lₐ₁₀ | L_{c31} |
| 1393 | Lₐ₁₃ | Lₐ₁₃ | L_{c31} | 1394 | Lₐ₁₉ | Lₐ₁₉ | L_{c31} |
| 1395 | Lₐ₂₀ | Lₐ₂₀ | L_{c31} | 1396 | Lₐ₂₁ | Lₐ₂₁ | L_{c31} |
| 1397 | Lₐ₃₁ | Lₐ₃₁ | L_{c31} | 1398 | Lₐ₃₂ | Lₐ₃₂ | L_{c31} |
| 1399 | Lₐ₃₃ | Lₐ₃₃ | L_{c31} | 1400 | Lₐ₃₄ | Lₐ₃₄ | L_{c31} |
| 1401 | Lₐ₃₅ | Lₐ₃₅ | L_{c31} | 1402 | Lₐ₅₃ | Lₐ₅₃ | L_{c31} |
| 1403 | Lₐ₅₇ | Lₐ₅₇ | L_{c31} | 1404 | Lₐ₅₈ | Lₐ₅₈ | L_{c31} |
| 1405 | Lₐ₆₁ | Lₐ₆₁ | L_{c31} | 1406 | Lₐ₈₂ | Lₐ₈₂ | L_{c31} |
| 1407 | Lₐ₈₃ | Lₐ₈₃ | L_{c31} | 1408 | Lₐ₈₄ | Lₐ₈₄ | L_{c31} |
| 1409 | Lₐ₈₇ | Lₐ₈₇ | L_{c31} | 1410 | Lₐ₈₈ | Lₐ₈₈ | L_{c31} |
| 1411 | Lₐ₉₀ | Lₐ₉₀ | L_{c31} | 1412 | Lₐ₉₁ | Lₐ₉₁ | L_{c31} |
| 1413 | Lₐ₉₉ | Lₐ₉₉ | L_{c31} | 1414 | Lₐ₁₀₂ | Lₐ₁₀₂ | L_{c31} |
| 1415 | Lₐ₁₀₈ | Lₐ₁₀₈ | L_{c31} | 1416 | Lₐ₁₀₉ | Lₐ₁₀₉ | L_{c31} |
| 1417 | Lₐ₁₀₀ | Lₐ₁₁₀ | L_{c31} | 1418 | Lₐ₁₂₀ | Lₐ₁₂₀ | L_{c31} |
| 1419 | Lₐ₁₂₁ | Lₐ₁₂₁ | L_{c31} | 1420 | Lₐ₁₂₂ | Lₐ₁₂₂ | L_{c31} |
| 1421 | Lₐ₁₂₃ | Lₐ₁₂₃ | L_{c31} | 1422 | Lₐ₁₂₄ | Lₐ₁₂₄ | L_{c31} |
| 1423 | Lₐ₁₄₂ | Lₐ₁₄₂ | L_{c31} | 1424 | Lₐ₁₄₆ | Lₐ₁₄₆ | L_{c31} |
| 1425 | Lₐ₁₅₀ | Lₐ₁₅₀ | L_{c31} | 1426 | Lₐ₁₇₁ | Lₐ₁₇₁ | L_{c31} |
| 1427 | Lₐ₁₇₂ | Lₐ₁₇₂ | L_{c31} | 1428 | Lₐ₁₇₃ | Lₐ₁₇₃ | L_{c31} |
| 1429 | Lₐ₁₇₆ | Lₐ₁₇₆ | L_{c31} | 1430 | Lₐ₁₇₇ | Lₐ₁₇₇ | L_{c31} |
| 1431 | Lₐ₁₇₉ | Lₐ₁₇₉ | L_{c31} | 1432 | Lₐ₁₈₀ | Lₐ₁₈₀ | L_{c31} |
| 1433 | Lₐ₂₆₈ | Lₐ₂₆₈ | L_{c31} | 1434 | Lₐ₂₆₉ | Lₐ₂₆₉ | L_{c31} |
| 1435 | Lₐ₂₇₃ | Lₐ₂₇₃ | L_{c31} | 1436 | Lₐ₂₇₄ | Lₐ₂₇₄ | L_{c31} |
| 1437 | Lₐ₃₆₃ | Lₐ₃₆₃ | L_{c31} | 1438 | Lₐ₃₆₄ | Lₐ₃₆₄ | L_{c31} |
| 1439 | Lₐ₃₆₇ | Lₐ₃₆₇ | L_{c31} | 1440 | Lₐ₃₆₈ | Lₐ₃₆₈ | L_{c31} |
| 1441 | Lₐ₃₇₂ | Lₐ₃₇₂ | L_{c31} | 1442 | Lₐ₃₇₃ | Lₐ₃₇₃ | L_{c31} |
| 1443 | Lₐ₃₇₄ | Lₐ₃₇₄ | L_{c31} | 1444 | Lₐ₃₇₅ | Lₐ₃₇₅ | L_{c31} |
| 1445 | Lₐ₃₉₂ | Lₐ₃₉₂ | L_{c31} | 1446 | Lₐ₃₉₃ | Lₐ₃₉₃ | L_{c31} |
| 1447 | Lₐ₅₈₁ | Lₐ₅₈₁ | L_{c31} | 1448 | Lₐ₅₈₂ | Lₐ₅₈₂ | L_{c31} |
| 1449 | Lₐ₅₉₀ | Lₐ₅₉₀ | L_{c31} | 1450 | Lₐ₅₉₁ | Lₐ₅₉₁ | L_{c31} |
| 1451 | Lₐ₆₁₀ | Lₐ₆₁₀ | L_{c31} | 1452 | Lₐ₆₁₁ | Lₐ₆₁₁ | L_{c31} |
| 1453 | Lₐ₆₁₂ | Lₐ₆₁₂ | L_{c31} | 1454 | Lₐ₆₁₃ | Lₐ₆₁₃ | L_{c31} |
| 1455 | Lₐ₆₁₆ | Lₐ₆₁₆ | L_{c31} | 1456 | Lₐ₆₁₇ | Lₐ₆₁₇ | L_{c31} |
| 1457 | Lₐ₆₁₈ | Lₐ₆₁₈ | L_{c31} | 1458 | Lₐ₆₁₉ | Lₐ₆₁₉ | L_{c31} |
| 1459 | Lₐ₆₂₂ | Lₐ₆₂₂ | L_{c31} | 1460 | Lₐ₆₂₄ | Lₐ₆₂₄ | L_{c31} |
| 1461 | Lₐ₆₂₅ | Lₐ₆₂₅ | L_{c31} | 1462 | Lₐ₆₂₇ | Lₐ₆₂₇ | L_{c31} |
| 1463 | Lₐ₆₂₈ | Lₐ₆₂₈ | L_{c31} | 1464 | Lₐ₆₂₉ | Lₐ₆₂₉ | L_{c31} |
| 1465 | Lₐ₆₃₀ | Lₐ₆₃₀ | L_{c31} | 1466 | Lₐ₆₃₁ | Lₐ₆₃₁ | L_{c31} |
| 1467 | Lₐ₆₃₂ | Lₐ₆₃₂ | L_{c31} | 1468 | Lₐ₆₄₀ | Lₐ₆₄₀ | L_{c31} |
| 1469 | Lₐ₆₄₁ | Lₐ₆₄₁ | L_{c31} | 1470 | Lₐ₆₄₂ | Lₐ₆₄₂ | L_{c31} |
| 1471 | Lₐ₆₄₃ | Lₐ₆₄₃ | L_{c31} | 1472 | Lₐ₆₄₄ | Lₐ₆₄₄ | L_{c31} |
| 1473 | Lₐ₆₄₅ | Lₐ₆₄₅ | L_{c31} | 1474 | Lₐ₆₅₆ | Lₐ₆₅₆ | L_{c31} |
| 1475 | Lₐ₆₆₂ | Lₐ₆₆₂ | L_{c31} | 1476 | Lₐ₆₆₄ | Lₐ₆₆₄ | L_{c31} |
| 1477 | Lₐ₆₆₅ | Lₐ₆₆₅ | L_{c31} | 1478 | Lₐ₆₆₆ | Lₐ₆₆₆ | L_{c31} |
| 1479 | Lₐ₆₆₇ | Lₐ₆₆₇ | L_{c31} | 1480 | Lₐ₆₉₀ | Lₐ₆₉₀ | L_{c31} |
| 1481 | Lₐ₆₉₁ | Lₐ₆₉₁ | L_{c31} | 1482 | Lₐ₆₉₂ | Lₐ₆₉₂ | L_{c31} |
| 1483 | Lₐ₆₉₃ | Lₐ₆₉₃ | L_{c31} | 1484 | Lₐ₆₉₈ | Lₐ₆₉₈ | L_{c31} |
| 1485 | Lₐ₆₉₉ | Lₐ₆₉₉ | L_{c31} | 1486 | Lₐ₇₀₀ | Lₐ₇₀₀ | L_{c31} |
| 1487 | Lₐ₇₀₁ | Lₐ₇₀₁ | L_{c31} | 1488 | Lₐ₇₀₂ | Lₐ₇₀₂ | L_{c31} |
| 1489 | Lₐ₇₀₃ | Lₐ₇₀₃ | L_{c31} | 1490 | Lₐ₇₀₄ | Lₐ₇₀₄ | L_{c31} |
| 1491 | Lₐ₇₀₈ | Lₐ₇₀₈ | L_{c31} | 1492 | Lₐ₇₁₁ | Lₐ₇₁₁ | L_{c31} |
| 1493 | Lₐ₇₁₇ | Lₐ₇₁₇ | L_{c31} | 1494 | Lₐ₇₁₈ | Lₐ₇₁₈ | L_{c31} |
| 1495 | Lₐ₇₁₉ | Lₐ₇₁₉ | L_{c31} | 1496 | Lₐ₇₂₉ | Lₐ₇₂₉ | L_{c31} |
| 1497 | Lₐ₇₃₀ | Lₐ₇₃₀ | L_{c31} | 1498 | Lₐ₇₃₁ | Lₐ₇₃₁ | L_{c31} |
| 1499 | Lₐ₇₃₂ | Lₐ₇₃₂ | L_{c31} | 1500 | Lₐ₇₃₃ | Lₐ₇₃₃ | L_{c31} |
| 1501 | Lₐ₇₈₈ | Lₐ₇₈₈ | L_{c31} | 1502 | Lₐ₇₈₉ | Lₐ₇₈₉ | L_{c31} |
| 1503 | Lₐ₇₉₂ | Lₐ₇₉₂ | L_{c31} | 1504 | Lₐ₇₉₄ | Lₐ₇₉₄ | L_{c31} |
| 1505 | Lₐ₈₇₇ | Lₐ₈₇₇ | L_{c31} | 1506 | Lₐ₈₇₈ | Lₐ₈₇₈ | L_{c31} |
| 1507 | Lₐ₈₇₉ | Lₐ₈₇₉ | L_{c31} | 1508 | Lₐ₈₈₀ | Lₐ₈₈₀ | L_{c31} |
| 1509 | Lₐ₈₈₅ | Lₐ₈₈₅ | L_{c31} | 1510 | Lₐ₈₈₆ | Lₐ₈₈₆ | L_{c31} |
| 1511 | Lₐ₈₉₉ | Lₐ₈₉₉ | L_{c31} | 1512 | Lₐ₉₀₀ | Lₐ₉₀₀ | L_{c31} |
| 1513 | Lₐ₉₁₅ | Lₐ₉₁₅ | L_{c31} | 1514 | Lₐ₉₁₆ | Lₐ₉₁₆ | L_{c31} |
| 1515 | Lₐ₉₂₀ | Lₐ₉₂₀ | L_{c31} | 1516 | Lₐ₉₂₁ | Lₐ₉₂₁ | L_{c31} |
| 1517 | Lₐ₉₂₂ | Lₐ₉₂₂ | L_{c31} | 1518 | Lₐ₉₂₃ | Lₐ₉₂₃ | L_{c31} |
| 1519 | Lₐ₉₂₆ | Lₐ₉₂₆ | L_{c31} | 1520 | Lₐ₉₂₇ | Lₐ₉₂₇ | L_{c31} |
| 1521 | Lₐ₉₂₈ | Lₐ₉₂₈ | L_{c31} | 1522 | Lₐ₉₂₉ | Lₐ₉₂₉ | L_{c31} |
| 1523 | Lₐ₉₃₂ | Lₐ₉₃₂ | L_{c31} | 1524 | Lₐ₉₃₃ | Lₐ₉₃₃ | L_{c31} |
| 1525 | Lₐ₁₀₂₀ | Lₐ₁₀₂₀ | L_{c31} | 1526 | Lₐ₁₀₂₁ | Lₐ₁₀₂₁ | L_{c31} |
| 1527 | Lₐ₁₀₂₂ | Lₐ₁₀₂₂ | L_{c31} | 1528 | Lₐ₁₀₂₃ | Lₐ₁₀₂₃ | L_{c31} |
| 1529 | Lₐ₁₀₂₅ | Lₐ₁₀₂₅ | L_{c31} | 1530 | Lₐ₁₀₂₆ | Lₐ₁₀₂₆ | L_{c31} |
| 1531 | Lₐ₁₀₂₈ | Lₐ₁₀₂₈ | L_{c31} | 1532 | Lₐ₁₀₂₉ | Lₐ₁₀₂₉ | L_{c31} |
| 1533 | Lₐ₁₀₃₀ | Lₐ₁₀₃₀ | L_{c31} | 1534 | Lₐ₁₀₃₄ | Lₐ₁₀₃₄ | L_{c31} |
| 1535 | Lₐ₁₀₃₈ | Lₐ₁₀₃₈ | L_{c31} | 1536 | Lₐ₁₀₄₀ | Lₐ₁₀₄₀ | L_{c31} |
| 1537 | Lₐ₁₀₄₆ | Lₐ₁₀₄₆ | L_{c31} | 1538 | Lₐ₁₀₄₈ | Lₐ₁₀₄₈ | L_{c31} |
| 1539 | Lₐ₁₀₅₅ | Lₐ₁₀₅₅ | L_{c31} | 1540 | Lₐ₁₀₅₆ | Lₐ₁₀₅₆ | L_{c31} |
| 1541 | Lₐ₁₃₃₃ | Lₐ₁₃₃₃ | L_{c31} | 1542 | Lₐ₁₃₃₄ | Lₐ₁₃₃₄ | L_{c31} |
| 1543 | Lₐ₁₃₄₀ | Lₐ₁₃₄₀ | L_{c31} | 1544 | Lₐ₁₃₄₁ | Lₐ₁₃₄₁ | L_{c31} |
| 1545 | Lₐ₁₃₇₁ | Lₐ₁₃₇₁ | L_{c31} | 1546 | Lₐ₁₃₇₂ | Lₐ₁₃₇₂ | L_{c31} |
| 1547 | Lₐ₁₃₇₃ | Lₐ₁₃₇₃ | L_{c31} | 1548 | Lₐ₁₃₇₄ | Lₐ₁₃₇₄ | L_{c31} |
| 1549 | Lₐ₁₄₂₃ | Lₐ₁₄₂₃ | L_{c31} | 1550 | Lₐ₁₄₂₄ | Lₐ₁₄₂₄ | L_{c31} |
| 1551 | Lₐ₁₄₂₆ | Lₐ₁₄₂₆ | L_{c31} | 1552 | Lₐ₁₄₂₇ | Lₐ₁₄₂₇ | L_{c31} |
| 1553 | Lₐ₁₄₃₂ | Lₐ₁₄₃₂ | L_{c31} | 1554 | Lₐ₁₄₃₃ | Lₐ₁₄₃₃ | L_{c31} |
| 1555 | Lₐ₁₄₃₅ | Lₐ₁₄₃₅ | L_{c31} | 1556 | Lₐ₁₄₃₆ | Lₐ₁₄₃₆ | L_{c31} |
| 1557 | Lₐ₁ | Lₐ₆₁₀ | L_{c31} | 1558 | Lₐ₆₁₀ | Lₐ₆₄₃ | L_{c31} |
| 1559 | Lₐ₆₁₀ | Lₐ₆₉₉ | L_{c31} | 1560 | Lₐ₆₁₀ | Lₐ₁₄₃₂ | L_{c31} |
| 1561 | Lₐ₆₄₃ | Lₐ₆₉₉ | L_{c31} | 1562 | Lₐ₆₄₃ | Lₐ₁₄₃₂ | L_{c31} |
wherein Metal Complex 1563 to Metal Complex 1568 each have a structure of Ir(Lₐ)₃, wherein the three Lₐ are the same or different, and the three Lₐ respectively correspond to the structures listed in the following table:
| **Metal Complex** | **Lₐ** | **Lₐ** | **Lₐ** | **Metal Complex** | **Lₐ** | **Lₐ** | **Lₐ** |
|---|---|---|---|---|---|---|---|
| 1563 | Lₐ₁ | Lₐ₁ | Lₐ₆₁₀ | 1564 | Lₐ₁ | Lₐ₁ | Lₐ₆₄₃ |
| 1565 | Lₐ₁ | Lₐ₆₁₀ | Lₐ₆₄₃ | 1566 | Lₐ₆₁₀ | Lₐ₆₄₃ | Lₐ₆₉₉ |
| 1567 | Lₐ₆₄₃ | Lₐ₆₉₉ | Lₐ₁₄₃₂ | 1568 | Lₐ₁ | Lₐ₆₁₀ | Lₐ₁₄₃₂ |
wherein Metal Complex 1569 to Metal Complex 1576 each have a structure of Ir(Lₐ)(L_{b})(L_{c}), and Lₐ, L_{b} and L_{c} respectively correspond to the structures listed in the following table:
| **Metal Complex** | **Lₐ** | **L_{b}** | **L_{c}** | **Metal Complex** | **Lₐ** | **L_{b}** | **L_{c}** |
|---|---|---|---|---|---|---|---|
| 1569 | Lₐ₁ | L_{b81} | L_{c31} | 1570 | Lₐ₆₁₀ | L_{b81} | L_{c31} |
| 1571 | Lₐ₆₉₉ | L_{b81} | L_{c31} | 1572 | Lₐ₁₀₂₀ | L_{b81} | L_{c31} |
| 1573 | Lₐ₁ | L_{b329} | L_{c31} | 1574 | Lₐ₁ | L_{b329} | L_{c31} |
| 1575 | Lₐ₆₉₉ | L_{b329} | L_{c31} | 1576 | Lₐ₆₉₉ | L_{b329} | L_{c31} |
wherein Metal Complex 1577 to Metal Complex 1646 each have the structure of IrLₐ(L_{b})₂, wherein the two L_{b} are the same, and Lₐ and the two L_{b} respectively correspond to the structures listed in the following table:
| **Metal Complex** | **Lₐ** | **L_{b}** | **Metal Complex** | **Lₐ** | **L_{b}** |
|---|---|---|---|---|---|
| 1577 | Lₐ₁₇₃₇ | L_{b1} | 1578 | Lₐ₁₇₃₈ | L_{b1} |
| 1579 | Lₐ₁₈₄₄ | L_{b81} | 1580 | Lₐ₁₈₄₅ | L_{b81} |
| 1581 | Lₐ₁₈₄₆ | L_{b81} | 1582 | Lₐ₁₈₄₇ | L_{b81} |
| 1583 | Lₐ₁₈₄₈ | L_{b81} | 1584 | Lₐ₁₈₄₉ | L_{b81} |
| 1585 | Lₐ₁₈₅₀ | L_{b81} | 1586 | Lₐ₁₈₅₁ | L_{b81} |
| 1587 | Lₐ₁₈₅₂ | L_{b81} | 1588 | Lₐ₁₈₅₃ | L_{b81} |
| 1589 | Lₐ₁₈₅₄ | L_{b81} | 1590 | Lₐ₁₈₅₅ | L_{b81} |
| 1591 | Lₐ₁₈₅₆ | L_{b81} | 1592 | Lₐ₁₈₅₇ | L_{b81} |
| 1593 | Lₐ₁₈₅₈ | L_{b81} | 1594 | Lₐ₁₈₅₉ | L_{b81} |
| 1595 | Lₐ₁₈₆₀ | L_{b81} | 1596 | Lₐ₁₈₆₁ | L_{b81} |
| 1597 | Lₐ₁₈₇₈ | L_{b81} | 1598 | Lₐ₁₈₇₉ | L_{b81} |
| 1599 | Lₐ₁₈₈₀ | L_{b81} | 1600 | Lₐ₁₈₈₁ | L_{b81} |
| 1601 | Lₐ₁₈₈₂ | L_{b81} | 1602 | Lₐ₁₈₈₃ | L_{b81} |
| 1603 | Lₐ₁₈₈₄ | L_{b81} | 1604 | Lₐ₁₈₈₅ | L_{b81} |
| 1605 | Lₐ₁₈₈₆ | L_{b81} | 1606 | Lₐ₁₈₈₇ | L_{b81} |
| 1607 | Lₐ₁₈₈₈ | L_{b81} | 1608 | Lₐ₁₈₈₉ | L_{b81} |
| 1609 | Lₐ₁₈₉₀ | L_{b81} | 1610 | Lₐ₁₈₉₁ | L_{b81} |
| 1611 | Lₐ₁₈₄₉ | L_{b329} | 1612 | Lₐ₁₈₆₇ | L_{b329} |
| 1613 | Lₐ₁₈₄₄ | L_{b333} | 1614 | Lₐ₁₈₄₅ | L_{b333} |
| 1615 | Lₐ₁₈₄₆ | L_{b333} | 1616 | Lₐ₁₈₄₇ | L_{b333} |
| 1617 | Lₐ₁₈₄₈ | L_{b333} | 1618 | Lₐ₁₈₄₉ | L_{b333} |
| 1619 | Lₐ₁₈₅₀ | L_{b333} | 1620 | Lₐ₁₈₅₁ | L_{b333} |
| 1621 | Lₐ₁₈₅₂ | L_{b333} | 1622 | Lₐ₁₈₅₃ | L_{b333} |
| 1623 | Lₐ₁₈₅₄ | L_{b333} | 1624 | Lₐ₁₈₅₅ | L_{b333} |
| 1625 | Lₐ₁₈₅₆ | L_{b333} | 1626 | Lₐ₁₈₅₇ | L_{b333} |
| 1627 | Lₐ₁₈₅₈ | L_{b333} | 1628 | Lₐ₁₈₅₉ | L_{b333} |
| 1629 | Lₐ₁₈₆₀ | L_{b333} | 1630 | Lₐ₁₈₆₁ | L_{b333} |
| 1631 | Lₐ₁₈₇₈ | L_{b333} | 1632 | Lₐ₁₈₇₉ | L_{b333} |
| 1633 | Lₐ₁₈₈₀ | L_{b333} | 1634 | Lₐ₁₈₈₁ | L_{b333} |
| 1635 | Lₐ₁₈₈₂ | L_{b333} | 1636 | Lₐ₁₈₈₃ | L_{b333} |
| 1637 | Lₐ₁₈₈₄ | L_{b333} | 1638 | Lₐ₁₈₈₅ | L_{b333} |
| 1639 | Lₐ₁₈₈₆ | L_{b333} | 1640 | Lₐ₁₈₈₇ | L_{b333} |
| 1641 | Lₐ₁₈₈₈ | L_{b333} | 1642 | Lₐ₁₈₈₉ | L_{b333} |
| 1643 | Lₐ₁₈₉₀ | L_{b333} | 1644 | Lₐ₁₈₉₁ | L_{b333} |
| 1645 | Lₐ₆₆₂ | L_{b335} | 1646 | Lₐ₁₀₇₂ | L_{b335} |
wherein optionally, hydrogens in the above Metal Complex 1 to Metal Complex 1646 can be partially or fully substituted with deuterium.

14. An electroluminescent device, comprising:
an anode,
a cathode, and
an organic layer disposed between the anode and the cathode, wherein at least one layer of the organic layer comprises the metal complex according to any one of claims 1 to 13;
preferably the organic layer comprising the metal complex is an emissive layer;
preferably, wherein the emissive layer further comprises a first host compound;
more preferably, the emissive layer further comprises a second host compound; and
most preferably, at least one of the host compounds comprises at least one chemical group selected from the group consisting of: benzene, pyridine, pyrimidine, triazine, carbazole, azacarbazole, indolocarbazole, dibenzothiophene, aza-dibenzothiophene, dibenzofuran, azadibenzofuran, dibenzoselenophene, triphenylene, azatriphenylene, fluorene, silafluorene, naphthalene, quinoline, isoquinoline, quinazoline, quinoxaline, phenanthrene, azaphenanthrene and combinations thereof.

15. A composition, comprising the metal complex according to any one of claims 1 to 13.
